(19) Europäisches Patentamt
European Patent Office
Office européen des brevets

(11) EP 3 358 639 B1

(12) EUROPEAN PATENT SPECIFICATION

(45) Date of publication and mention of the grant of the patent:
**06.04.2022 Bulletin 2022/14**

(21) Application number: **18151527.1**

(22) Date of filing: **12.01.2018**

(51) International Patent Classification (IPC):
***H01L 51/54*** *(2006.01)*

(52) Cooperative Patent Classification (CPC):
**H01L 51/5004; H01L 51/0085; H01L 51/5012; H01L 51/5016;** H01L 51/0072; H01L 2251/308; H01L 2251/552; H01L 2251/554

# (54) ORGANIC LIGHT-EMITTING DEVICE

ORGANISCHE LICHTEMITTIERENDE VORRICHTUNG

DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.01.2017 KR 20170007033**
**11.01.2018 KR 20180003976**

(43) Date of publication of application:
**08.08.2018 Bulletin 2018/32**

(73) Proprietors:
- **Samsung Electronics Co., Ltd.**
  **Gyeonggi-do 16677 (KR)**
- **Samsung SDI Co., Ltd.**
  **Gyeonggi-do (KR)**
- **Ewha University-Industry Collaboration Foundation**
  **Seoul 03760 (KR)**

(72) Inventors:
- **IHN, Soohang**
  **16678 Gyeonggi-do, (KR)**
- **YOU, Youngmin**
  **03760 Seoul (KR)**
- **NOH, Changho**
  **16678 Gyeonggi-do, (KR)**
- **KIM, Jongsoo**
  **16678 Gyeonggi-do, (KR)**
- **KIM, Jooghyuk**
  **16678 Gyeonggi-do, (KR)**
- **LEE, Namheon**
  **Gyeonggi-do (KR)**

(74) Representative: **Elkington and Fife LLP**
**Prospect House**
**8 Pembroke Road**
**Sevenoaks, Kent TN13 1XR (GB)**

(56) References cited:
**EP-A1- 2 966 146**
**JP-A- 2011 176 250**
**JP-A- 2012 175 025**
**US-A1- 2016 093 823**

- **CHAN SEOK OH ET AL: "Molecular design of host materials for high power efficiency in blue phosphorescent organic light-emitting diodes doped with an imidazole ligand based triplet emitter", JOURNAL OF MATERIALS CHEMISTRY C: MATERIALS FOR OPTICAL AND ELECTRONIC DEVICES, vol. 4, no. 17, 1 January 2016 (2016-01-01), pages 3792-3797, XP055485374, UK ISSN: 2050-7526, DOI: 10.1039/C5TC02595H**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 358 639 B1

## Description

### FIELD OF THE INVENTION

The present disclosure relates to an organic light-emitting device.

### BACKGROUND OF THE INVENTION

Organic light-emitting devices (OLEDs) are self-emission devices that have wide viewing angles, high contrast ratios, short response times, and excellent brightness, driving voltage, and response speed characteristics, and that produce full-color images.

A typical OLED includes an anode, a cathode, and an organic layer disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. Carriers, such as holes and electrons, recombine in the emission layer to produce excitons. These excitons transit from an excited state to a ground state, thereby generating light.

Various types of organic light emitting devices are known. However, there still remains a need in OLEDs having low driving voltage, high efficiency, high brightness, and long lifespan.

JP 2011-0176250 (A) discloses an organic electroluminescent element. JP2012-175025 (A) discloses an electroluminescent element. US 2016/093823 (A) discloses a light-emitting element containing a fluorescence-emitting material. EP 2 966 146 (A) discloses a condensed cyclic compound and a organic light-emitting device including the same.

### SUMMARY OF THE INVENTION

Provided is an organic light-emitting device including a host and a dopant satisfying predetermined conditions according to the claims so as to have long lifespan.

Additional aspects will be set forth in part in the description which follows and, in part, will be apparent from the description, or may be learned by practice of the presented embodiments.

### BRIEF DESCRIPTION OF THE DRAWING

These and/or other aspects will become apparent and more readily appreciated from the following description of the embodiments, taken in conjunction with the FIGURE which is a schematic cross-sectional view of an organic light-emitting device according to an embodiment.

### DETAILED DESCRIPTION OF THE EMBODIMENTS

Reference will now be made in detail to embodiments, examples of which are illustrated in the accompanying drawing, wherein like reference numerals refer to like elements throughout. In this regard, the present embodiments may have different forms and should not be construed as being limited to the descriptions set forth herein. Accordingly, the embodiments are merely described below, by referring to the figure, to explain aspects of the present disclosure. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

In an embodiment, an organic light-emitting device is provided. The organic light-emitting device includes:

a first electrode;
a second electrode facing the first electrode; and
an organic layer disposed between the first electrode and the second electrode,
wherein the organic layer includes an emission layer, and wherein the emission layer includes a host and a dopant.

The dopant is a phosphorescent dopant.

In the organic light-emitting device in which the dopant includes a phosphorescent dopant,

i) Conditions 1, 2, 3, and 4 are all satisfied or
ii) when Conditions 1 and 4 are satisfied and at least one of Conditions 2 and 3 is not satisfied, Condition 5-1 is be satisfied or
iii) when at least one of Conditions 1 and 4 is not satisfied and Conditions 2 and 3 are satisfied, Condition 6-1 is satisfied; or
iv) when at least one of Conditions 1 and 4 is not satisfied and at least one of Conditions 2 and 3 is not satisfied, Conditions 5-1 and 6-1 are both satisfied.

Condition 1

$$E^{*}_{ox,dopant} \geq E_{red,host}$$

Condition 2

$$E^{*}_{red,dopant} \leq E_{ox,host}$$

Condition 3

$$E_{ox,dopant} \geq E^{*}_{red,host}$$

Condition 4

$$E_{red,dopant} \leq E^{*}_{ox,host}$$

Condition 5-1

$$T1_{dopant}-0.4\ eV<|E_{red,host}-E_{ox,dopant}|<T1_{dopant}+0.3\ eV$$

(for example, $T1_{dopant}-0.3\ eV<|E_{red,host}-E_{ox,dopant}|<T1_{dopant}+0.3\ eV$)

Condition 6-1

$$T1_{dopant}-0.4\ eV<|E_{red,dopant}-E_{ox,host}|<T1_{dopant}+0.3\ eV$$

(for example, $T1_{dopant}-0.3\ eV<|E_{red,dopant}-E_{ox,host}|<T1_{dopant}+0.3\ eV$)
wherein "eV" denotes "electron volts".

In Conditions 1 to 6-1, "$E^*_{ox,dopant}$" represents an excited-state oxidation potential (expressed in electron volts, eV) of the dopant,

"$E^*_{red,dopant}$" represents an excited-state reduction potential (eV) of the dopant,
"$E_{ox,dopant}$" represents a ground-state oxidation potential (eV) of the dopant,
"$E_{red,dopant}$" represents a ground-state reduction potential (eV) of the dopant,
$E^*_{red,host}$" represents an excited-state reduction potential (eV) of the host,
"$E^*_{ox,host}$" represents an excited-state oxidation potential (eV) of the host,
"$E_{red,host}$" represents a ground-state reduction potential (eV) of the host,
"$E_{ox,host}$" represents a ground-state oxidation potential (eV) of the host,
$E^*_{ox,dopant}$ may be identical to $E_{ox,dopant}$-T1 dopant,
$E^*_{red,dopant}$ may be identical to $E_{red,dopant}$+T1 dopant,
$E^*_{ox,host}$ may be identical to $E_{ox,host}-S1_{host}$,
$E^*_{red,host}$ may be identical to $E_{red,host}+S1_{host}$,
"T1dopant" represents the lowest triplet energy level (eV) of the dopant,
"$S1_{host}$" represents the lowest singlet energy level (eV) of the host,
$E_{ox,dopant}$ and $E_{ox,host}$ may be measured by using cyclic voltammetry (CV),
$E_{red,dopant}$ and $E_{red,host}$ may be measured by using differential pulse voltammetry,
$T1_{dopant}$ is calculated from a photoluminescence (PL) spectrum of the dopant in solution, and
$S1_{host}$ may be calculated from a PL spectrum of the host in solution.

While not wishing to be bound by theory, it is understood that when the organic light-emitting device satisfies Conditions 1, 2, 3, and 4, reduction or oxidation of the host and/or the dopant in the emission layer through electron transfer may be substantially prevented, thereby substantially preventing generation of radical species in the emission layer. Since the radical species may cause various side reactions in the emission layer, the lifespan of the organic light-emitting device may be shortened.

In some embodiments, 1) when the dopant of the organic light-emitting device includes a phosphorescent dopant and at least one of Conditions 5-1 and 6-1 is satisfied in the organic light-emitting device; ) a limited degree of reduction or oxidation of the host and/or the dopant in the emission layer through electron transfer may occur, and ii) even when the reduction or oxidation of the host and/or the dopant in the emission layer through electron transfer occurs, back electron transfer may rapidly occur, which may facilitate rapid restoration of the host and/or the dopant to their/its original state before the reduction or oxidation. Accordingly, the reduction or oxidation of the host and/or the dopant in the emission layer through electron transfer may be substantially prevented and/or limited, thereby substantially preventing and/or limiting generation of radical species in the emission layer. Furthermore, re-excitation of the dopant may also be promoted.

While not wishing to be bound by theory, it is understood that when the organic light-emitting device satisfies the aforementioned conditions, generation of radical species in the emission layer may be substantially prevented and/or minimized, and thus, exciton quenching in the emission layer of the organic light-emitting device and electrochemical degradation and/or photochemical degradation of the host and the dopant in the emission layer may be substantially prevented and/or minimized. Therefore, the organic light-emitting device may have improved lifespan.

In one or more embodiments, the dopant of the organic light-emitting device includes a phosphorescent dopant, and in the organic light-emitting device, at least one of Conditions 5-1 and 6-1 may be satisfied.

In one or more embodiments, the dopant of the organic light-emitting device includes a phosphorescent dopant,

and in the organic light-emitting device, Conditions 1 and 3 may not be satisfied, and Conditions 2, 4, 5-1, and 6-1 may be satisfied.

In one or more embodiments, the dopant of the organic light-emitting device includes a phosphorescent dopant, and in the organic light-emitting device, Conditions 3 and 6-1 may not be satisfied, and Conditions 1, 2, 4, and 5-1 may be satisfied.

i) The host may include (e.g., consist of) a donor compound, or ii) the host may include (e.g., consist of) an acceptor compound.

The donor compound may include at least one selected from a carbazole-including ring, a dibenzofuran-including ring, a dibenzothiophene-including ring, an indenocarbazole-including ring, an indolocarbazole-including ring, a benzofurocarbazole-including ring, a benzothienocarbazole-including ring, an acridine-including ring, a dihydroacridine-including ring, and a tri-indolobenzene-including ring, and

the acceptor compound may include at least one selected from a carbazole-including ring, a dibenzofuran-including ring, a dibenzothiophene-including ring, an indenocarbazole-including ring, an indolocarbazole-including ring, a benzofurocarbazole-including ring, a benzothienocarbazole-including ring, a pyridine-including ring, a pyrimidine-including ring, and a triazine-including ring.

In some embodiments, the acceptor compound may include at least one electron withdrawing group,

wherein the electron withdrawing group may be selected from: -F, $-CFH_2$, $-CF_2H$, $-CF_3$, -CN, and $-NO_2$;
a $C_1$-$C_{60}$ alkyl group substituted with at least one selected from -F, $-CFH_2$, - $CF_2H$, $-CF_3$, -CN, and $-NO_2$;
a $C_1$-$C_{60}$ heteroaryl group and a monovalent non-aromatic condensed polycyclic heterocyclic group, each including *=N-*' as a ring-forming moiety; and
a $C_1$-$C_{60}$ heteroaryl group and a monovalent non-aromatic condensed polycyclic heterocyclic group, each including *=N-*' as a ring-forming moiety and each substituted with at least one selected from deuterium, -F, $-CFH_2$, - $CF_2H$, $-CF_3$, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, and a substituted or unsubstituted monovalent non-aromatic condensed heteropolycyclic group.

In an embodiment, the donor compound may be selected from compounds represented by Formula D-1, and the acceptor compound may be selected from compounds represented by Formulae A-1 and A-2:

Formula D-1 $Ar_1-(L_1)_{a1}-Ar_2$

Formula A-1 $Ar_{11}-(L_{11})_{a11}-Ar_{12}$

Formula A-2

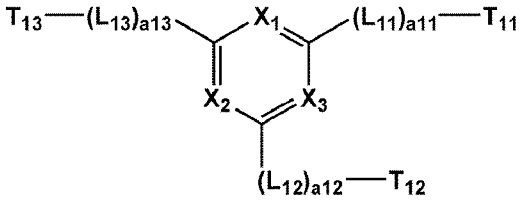

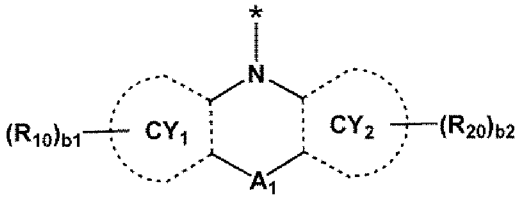

Formula 11

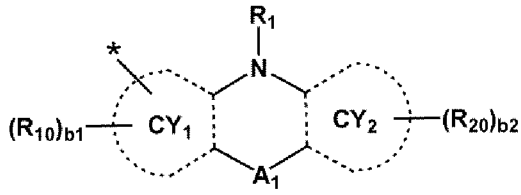

Formula 12

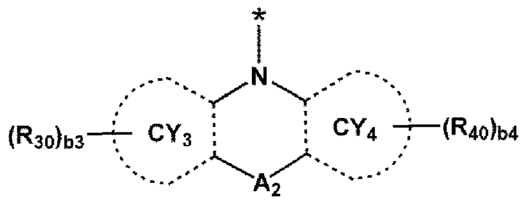

Formula 13

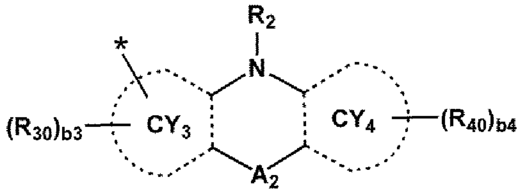

Formula 14

wherein, in Formulae D-1, A-1, A-2, and 11 to 14,

$Ar_1$ may be groups represented by Formulae 11 and 12,
$Ar_2$ may be selected from:

groups represented by Formulae 11 and 12, a phenyl group, a naphthyl group, and a benzimidazolyl group; and
a phenyl group, a naphthyl group, and a benzimidazolyl group, each substituted with at least one selected from deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a carbazolyl group, a dibenzofuranyl group, and a dibenzothiophenyl group,

$Ar_{11}$ and $Ar_{12}$ may each independently be selected from groups represented by Formulae 13 and 14,
$X_1$ may be N or $C(T_{14})$, $X_2$ may be N or $C(T_{15})$, and $X_3$ may be N or $C(T_{16})$, provided that at least one of $X_1$ to $X_3$ is N,
$L_1$ may be selected from:

a single bond, a phenylene group, a naphthylene group, a fluorenylene group,
a carbazolylene group, a dibenzofuranylene group, and a dibenzothiophenylene group; and
a phenylene group, a naphthylene group, a fluorenylene group, a carbazolylene group, a dibenzofuranylene group, and a dibenzothiophenylene group, each substituted with at least one selected from deuterium, a $C_1$-$C_{10}$ alkyl group, a $C_1$-$C_{10}$ alkoxy group, a phenyl group, a naphthyl group, a fluorenyl group, a carbazolyl group, a dibenzofuranyl group, a dibenzothiophenyl group, and $-Si(Q_{11})(Q_{12})(Q_{13})$,

$L_{11}$ to $L_{13}$ may each independently be selected from:

a single bond, a phenylene group, a pyridinylene group, a pyrimidinylene group, a pyrazinylene group, a pyridazinylene group, a triazinylene group, a naphthylene group, a fluorenylene group, a carbazolylene group, a dibenzofuranylene group, and a dibenzothiophenylene group; and
a phenylene group, a pyridinylene group, a pyrimidinylene group, a pyrazinylene group, a pyridazinylene group, a triazinylene group, a naphthylene group, a fluorenylene group, a carbazolylene group, a dibenzofuranylene

group, and a dibenzothiophenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, $-CF_3$, $-CF_2H$, $-CFH_2$, a phenyl group, a phenyl group substituted with a cyano group, a naphthyl group, a pyridinyl group, a pyrimidinyl group, a pyrazinyl group, a pyridazinyl group, a triazinyl group, a fluorenyl group, a carbazolyl group, a dibenzofuranyl group, a dibenzothiophenyl group, and $-Si(Q_{11})(Q_{12})(Q_{13})$,

a1 and a11 to a13 may each independently be an integer selected from 0 to 5; when a1 is 2 or greater, at least two $L_1$ groups may be identical to or different from each other; when a11 is 2 or greater, at least two $L_{11}$ groups may be identical to or different from each other; when a12 is 2 or greater, at least two $L_{12}$ groups may be identical to or different from each other; and when a13 is 2 or greater, at least two $L_{13}$ groups may be identical to or different from each other,
$CY_1$ to $CY_4$ may each independently be selected from a benzene group, a naphthalene group, a fluorene group, a carbazole group, a benzocarbazole group, an indolocarbazole group, a dibenzofuran group, and a dibenzothiophene group,
$A_1$ may be selected from
a single bond, a $C_1$-$C_4$ alkylene group, and a $C_2$-$C_4$ alkenylene group; and
a $C_1$-$C_4$ alkylene group and a $C_2$-$C_4$ alkenylene group, each substituted with at least one selected from deuterium, a $C_1$-$C_{10}$ alkyl group, a $C_1$-$C_{10}$ alkoxy group, a phenyl group, a naphthyl group, a fluorenyl group, a carbazolyl group, a dibenzofuranyl group, a dibenzothiophenyl group, and $-Si(Q_{21})(Q_{22})(Q_{23})$,
$A_2$ may be selected from:

a single bond, a $C_1$-$C_4$ alkylene group, and a $C_2$-$C_4$ alkenylene group; and
a $C_1$-$C_4$ alkylene group and a $C_2$-$C_4$ alkenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, a phenyl group, a naphthyl group, a pyridinyl group, a pyrimidinyl group, a pyrazinyl group, a pyridazinyl group, a triazinyl group, a fluorenyl group, a carbazolyl group, a dibenzofuranyl group, a dibenzothiophenyl group, and $-Si(Q_{21})(Q_{22})(Q_{23})$,

$R_1$, $R_{10}$, and $R_{20}$ may each independently be selected from:

hydrogen, deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group;
a $C_1$-$C_{20}$ alkyl group and a $C_1$-$C_{20}$ alkoxy group, each substituted with at least one selected from deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a carbazolyl group, a dibenzofuranyl group, and a dibenzothiophenyl group;
a phenyl group, a naphthyl group, a fluorenyl group, a carbazolyl group, a dibenzofuranyl group, and a dibenzothiophenyl group;
a phenyl group, a naphthyl group, a fluorenyl group, a carbazolyl group, a dibenzofuranyl group, and a dibenzothiophenyl group, each substituted with at least one selected from deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a carbazolyl group, a dibenzofuranyl group, and a dibenzothiophenyl group; and $-Si(Q_1)(Q_2)(Q_3)$,

$T_{11}$ to $T_{16}$, $R_2$, $R_{30}$, and $R_{40}$ may each independently be selected from hydrogen, deuterium, -F, -Cl, -Br, -I, a hydroxyl group, a cyano group (CN), a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or

unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, and -Si($Q_1$)($Q_2$)($Q_3$),

b1 to b4 may each independently be an integer selected from 0 to 10, and at least one substituent of the substituted $C_1$-$C_{60}$ alkyl group, substituted $C_2$-$C_{60}$ alkenyl group, substituted $C_2$-$C_{60}$ alkynyl group, substituted $C_3$-$C_{10}$ cycloalkyl group, substituted $C_1$-$C_{10}$ heterocycloalkyl group, substituted $C_3$-$C_{10}$ cycloalkenyl group, substituted $C_1$-$C_{10}$ heterocycloalkenyl group, substituted $C_6$-$C_{60}$ aryl group, substituted $C_6$-$C_{60}$ aryloxy group, substituted $C_6$-$C_{60}$ arylthio group, substituted $C_7$-$C_{60}$ arylalkyl group, substituted $C_1$-$C_{60}$ heteroaryl group, substituted $C_1$-$C_{60}$ heteroaryloxy group, substituted $C_1$-$C_{60}$ heteroarylthio group, substituted $C_2$-$C_{60}$ heteroarylalkyl group, substituted monovalent non-aromatic condensed polycyclic group, and substituted monovalent non-aromatic condensed heteropolycyclic group may be selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, and - Si($Q_{31}$)(Q32)(Q33),

wherein $Q_1$ to $Q_3$, $Q_{11}$ to $Q_{13}$, $Q_{21}$ to $Q_{23}$, and $Q_{31}$ to $Q_{33}$ may each independently be selected from hydrogen, deuterium, a $C_1$-$C_{60}$ alkyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group.

In some embodiments, in Formula D-1, $Ar_1$ may be selected from groups represented by Formulae 11-1 to 11-8 and 12-1 to 12-8,

in Formula D-1, $Ar_2$ may be selected from groups represented by Formulae 11-1 to 11-8 and 12-1 to 12-8, a phenyl group, a naphthyl group, and a benzimidazolyl group substituted with a phenyl group, and

in Formula A-1, $Ar_{11}$ and $Ar_{12}$ may each independently be selected from groups represented by Formulae 13-1 to 13-8 and 14-1 to 14-8:

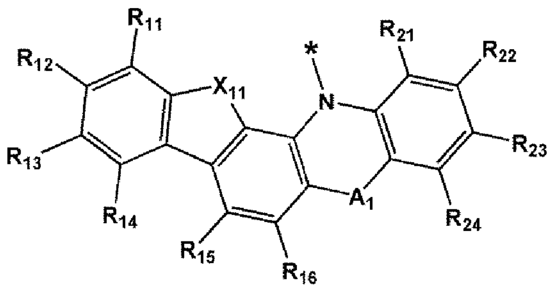

Formula 11-1

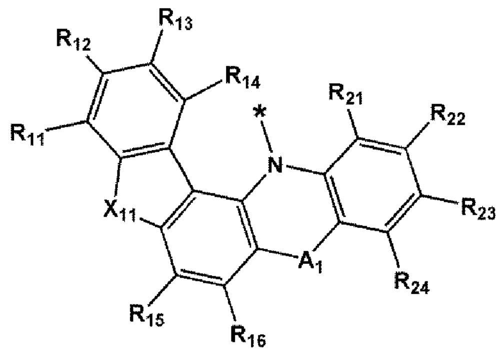

Formula 11-2

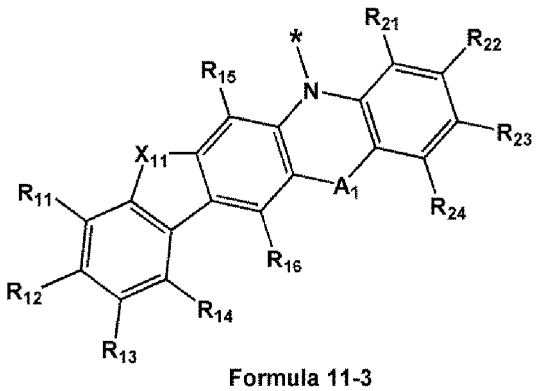

Formula 11-3

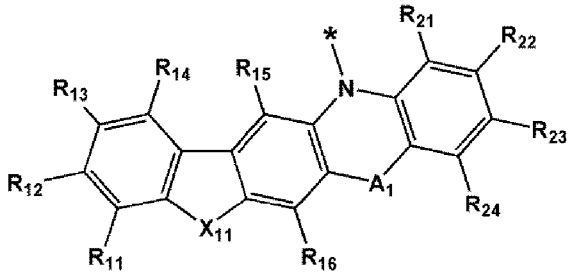

Formula 11-4

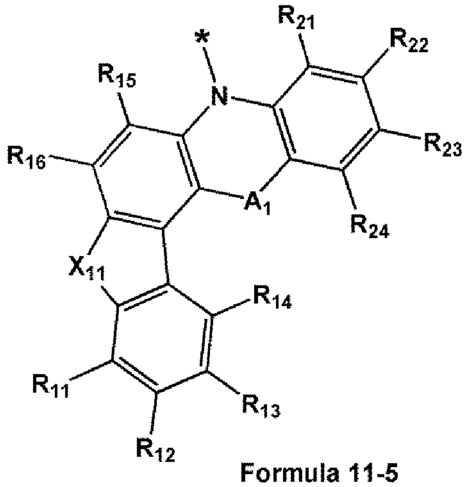

Formula 11-5

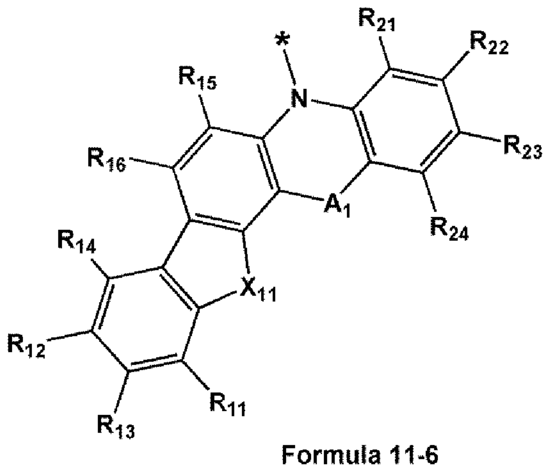

Formula 11-6

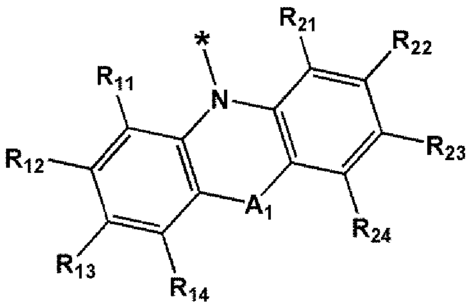

Formula 11-7

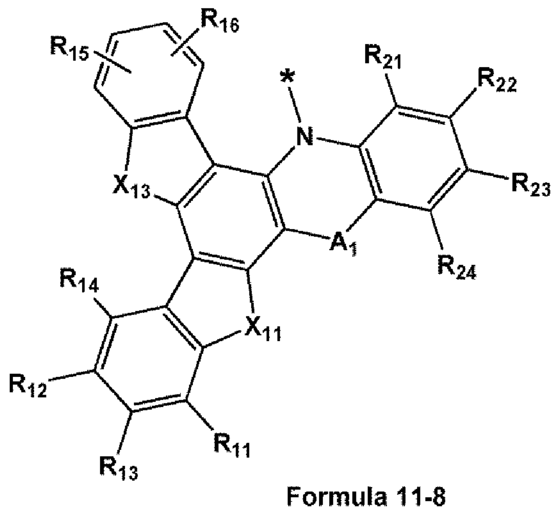

Formula 11-8

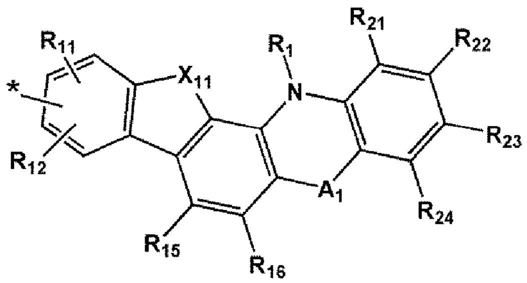

Formula 12-1

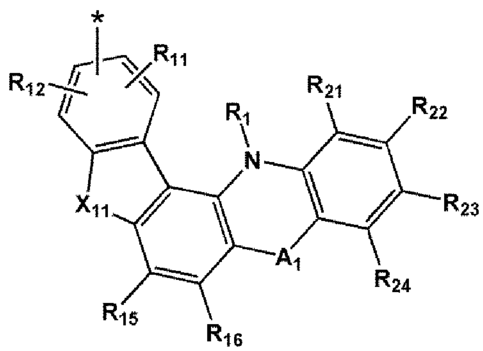

Formula 12-2

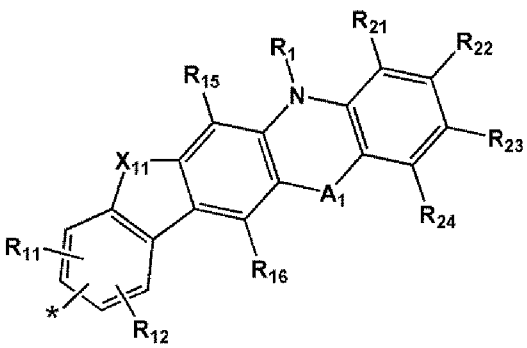

Formula 12-3

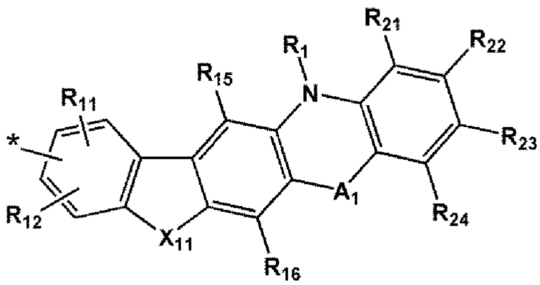

Formula 12-4

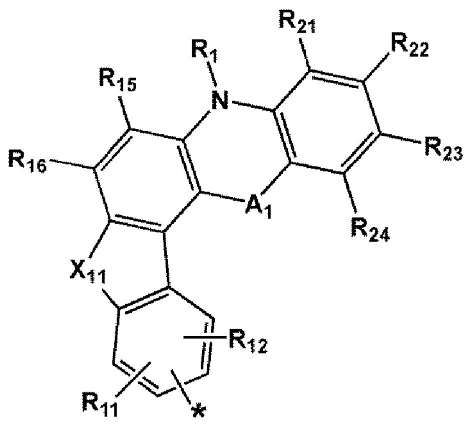

Formula 12-5

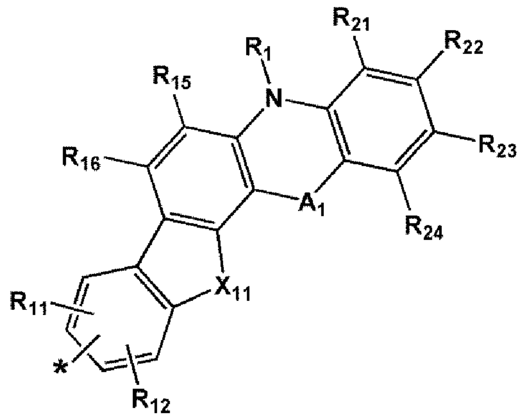

Formula 12-6

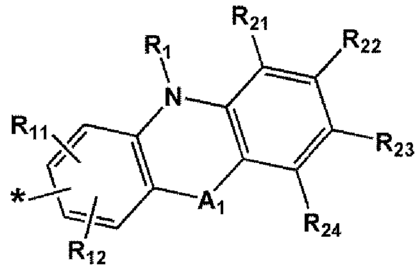

Formula 12-7

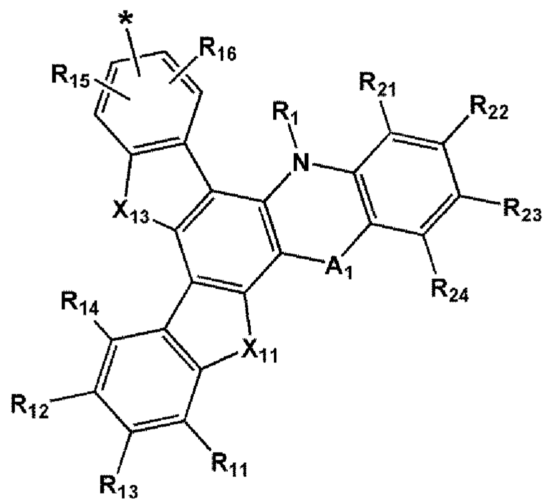

Formula 12-8

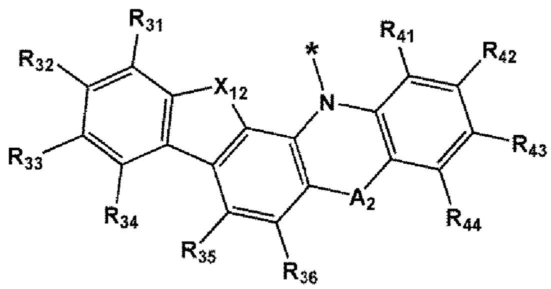

Formula 13-1

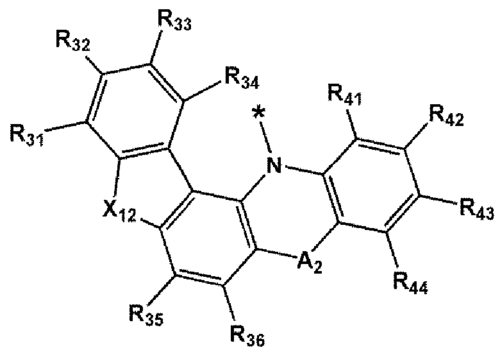

Formula 13-2

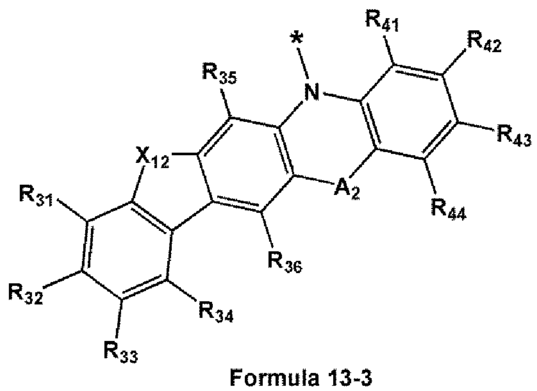

Formula 13-3

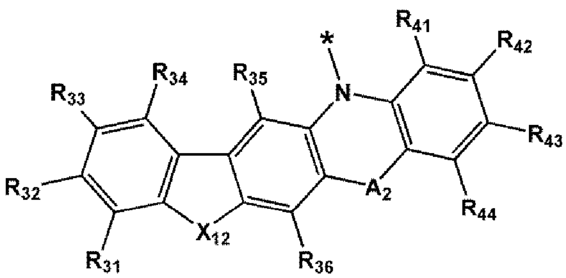

Formula 13-4

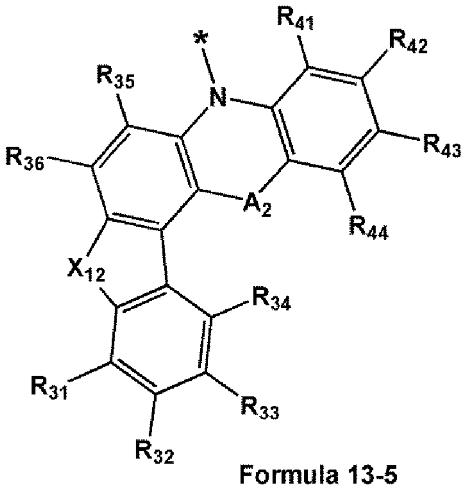

Formula 13-5

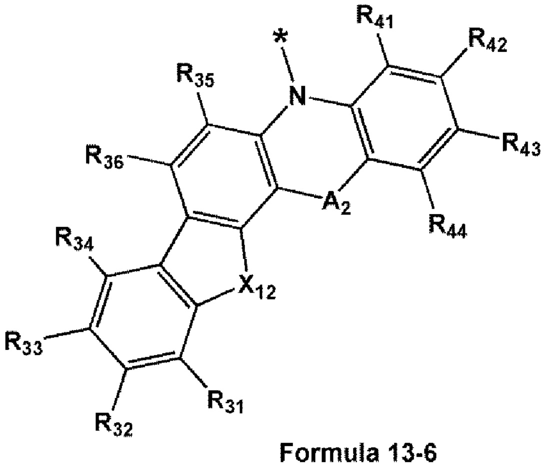

Formula 13-6

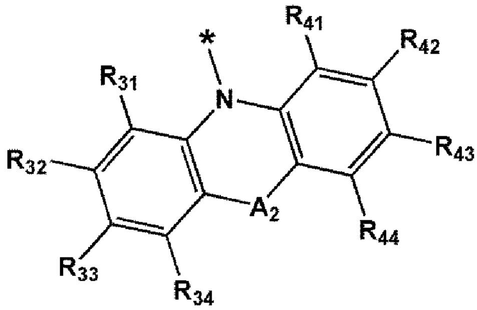

Formula 13-7

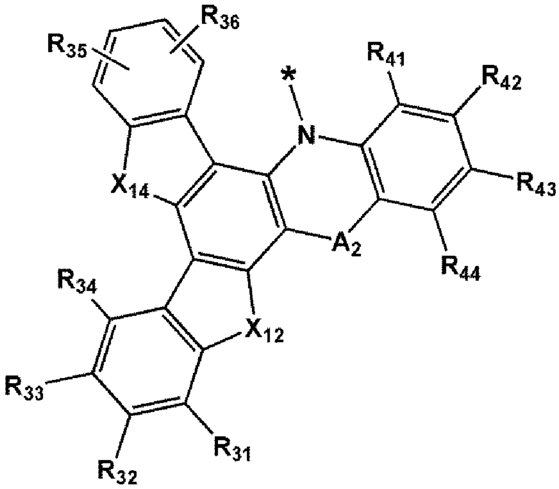

Formula 13-8

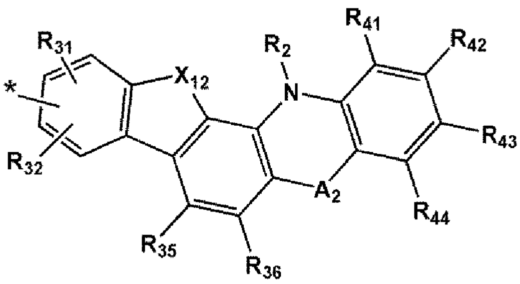

Formula 14-1

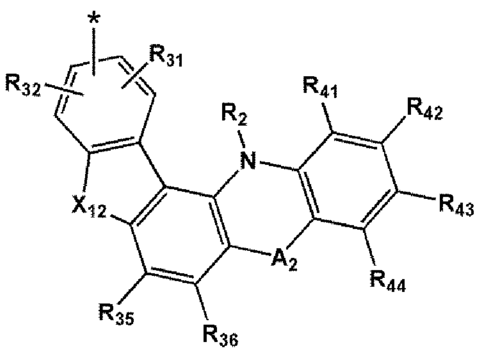

Formula 14-2

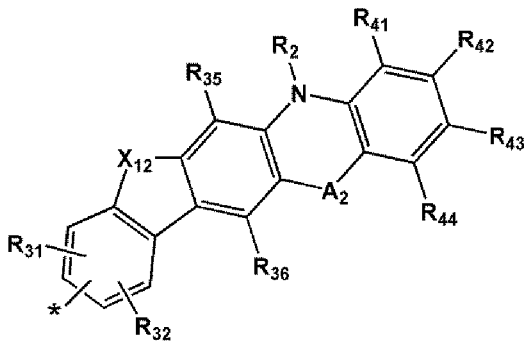

Formula 14-3

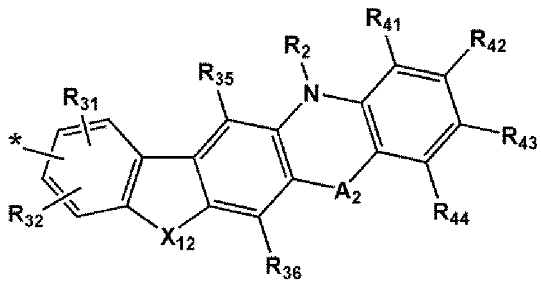

Formula 14-4

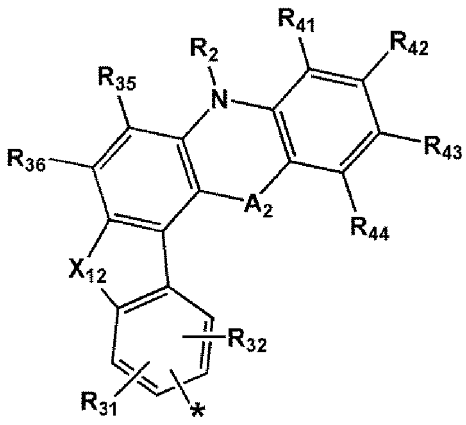

Formula 14-5

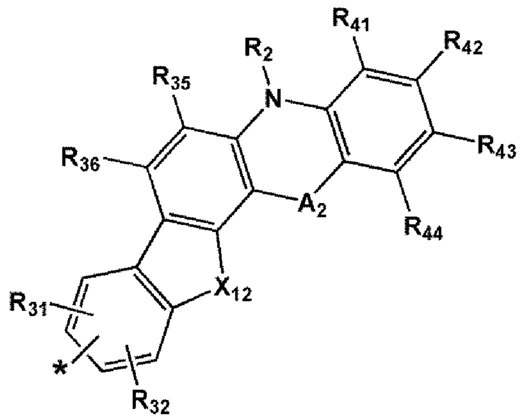

Formula 14-6

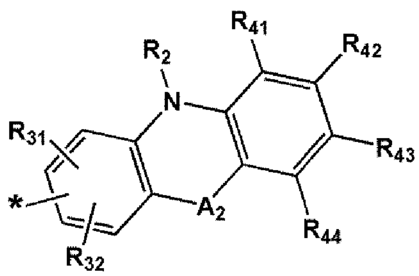

Formula 14-7

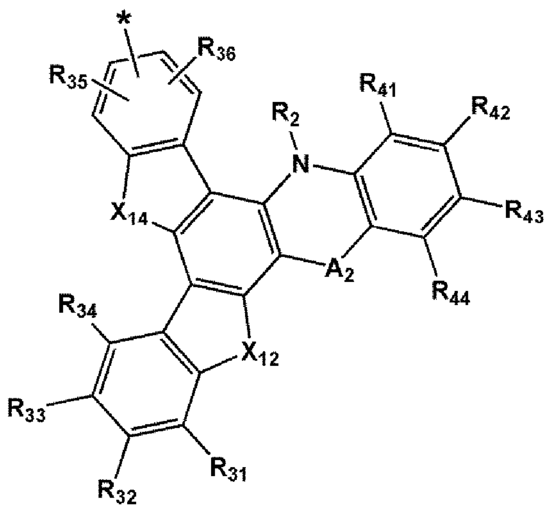

Formula 14-8

wherein, in Formulae 11-1 to 11-8, 12-1 to 12-8, 13-1 to 13-8, and 14-1 to 14-8,

$X_{11}$ and $X_{13}$ may each independently be $C(R_{17})(R_{18})$, $N(R_{19})$, O, or S,
$X_{12}$ and $X_{14}$ may each independently be $C(R_{37})(R_{38})$, $N(R_{39})$, O, or S,
$R_1$, $R_2$, $A_1$, and $A_2$ may be the same as those defined herein,
$R_{11}$ to $R_{19}$ may be the same as described herein with reference to $R_{10}$,
$R_{21}$ to $R_{24}$ may be the same as described herein with reference to $R_{20}$,
$R_{31}$ to $R_{39}$ may be the same as described herein with reference to $R_{30}$,

$R_{41}$ to $R_{44}$ may be the same as described herein with reference to $R_{40}$, and
* indicates a binding site to an adjacent atom.

In some embodiments, in Formulae 11, 12, 11-1 to 11-8, and 12-1 to 12-8, $A_1$ may be selected from:

a single bond, a $C_1$-$C_2$ alkylene group, and a $C_2$ alkenylene group; and
a $C_1$-$C_2$ alkylene group and a $C_2$ alkenylene group, each substituted with at least one selected from deuterium, a $C_1$-$C_{10}$ alkyl group, a $C_1$-$C_{10}$ alkoxy group, a phenyl group, a naphthyl group, a fluorenyl group, a carbazolyl group, a dibenzofuranyl group, a dibenzothiophenyl group, and -Si($Q_{21}$)($Q_{22}$)($Q_{23}$), in Formulae 13, 14, 13-1 to 13-8, and 14-1 to 14-8, $A_2$ may be selected from:

a single bond, a $C_1$-$C_2$ alkylene group, and a $C_2$ alkenylene group; and
a $C_1$-$C_2$ alkylene group and a $C_2$ alkenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, a phenyl group, a naphthyl group, a pyridinyl group, a pyrimidinyl group, a pyrazinyl group, a pyridazinyl group, a triazinyl group, a fluorenyl group, a carbazolyl group, a dibenzofuranyl group, a dibenzothiophenyl group, and -Si($Q_{21}$)($Q_{22}$)($Q_{23}$), and

in Formulae 13, 14, 13-1 to 13-8, and 14-1 to 14-8, $R_2$, $R_{30}$ to $R_{39}$, and $R_{40}$ to $R_{44}$ may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group;
a $C_1$-$C_{20}$ alkyl group and a $C_1$-$C_{20}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a carbazolyl group, a dibenzofuranyl group, and a dibenzothiophenyl group;
a phenyl group, a pyridinyl group, a pyrimidinyl group, a pyrazinyl group, a pyridazinyl group, a triazinyl group, a naphthyl group, a fluorenyl group, a carbazolyl group, a dibenzofuranyl group, and a dibenzothiophenyl group;
a phenyl group, a pyridinyl group, a pyrimidinyl group, a pyrazinyl group, a pyridazinyl group, a triazinyl group, a naphthyl group, a fluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a pyridinyl group, a pyrimidinyl group, a pyrazinyl group, a pyridazinyl group, a triazinyl group, a naphthyl group, a fluorenyl group, a carbazolyl group, a dibenzofuranyl group, and a dibenzothiophenyl group; and

-Si($Q_1$)($Q_2$)($Q_3$),

wherein $Q_1$ to $Q_3$ and $Q_{21}$ to $Q_{23}$ may each independently be selected from hydrogen, a $C_1$-$C_{10}$ alkyl group, a $C_1$-$C_{10}$ alkoxy group, a phenyl group, and a naphthyl group, but embodiments are not limited thereto.

In an embodiment, in Formula D-1, $Ar_1$ may be selected from groups represented by Formulae 15-1 to 15-17 and 16-1 to 16-8,

in Formula D-1, $Ar_2$ may be selected from groups represented by Formulae 15-1 to 15-17 and 16-1 to 16-8, a phenyl group, a naphthyl group, and an imidazolyl group substituted with a phenyl group, and
in Formula A-1, $Ar_{11}$ and $Ar_{12}$ may each independently be selected from groups represented by Formulae 17-1 to 17-3, but embodiments are not limited thereto:

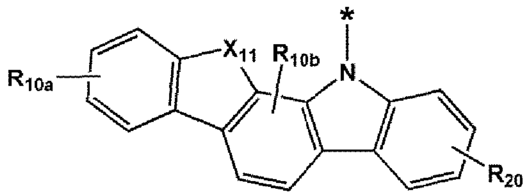

Formula 15-1

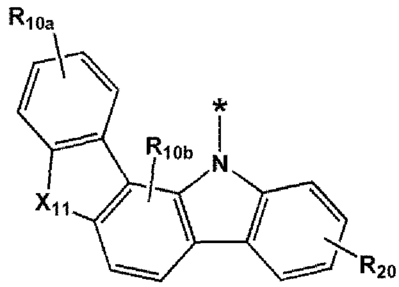

Formula 15-2

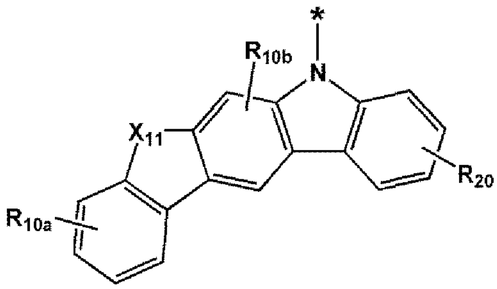

Formula 15-3

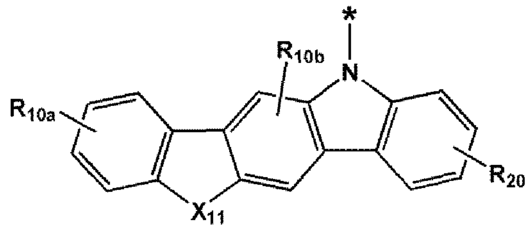

Formula 15-4

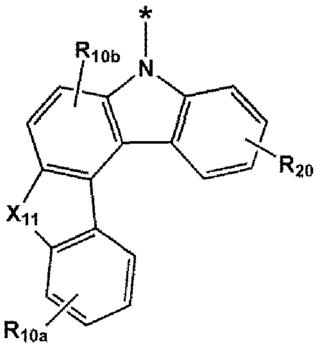

Formula 15-5

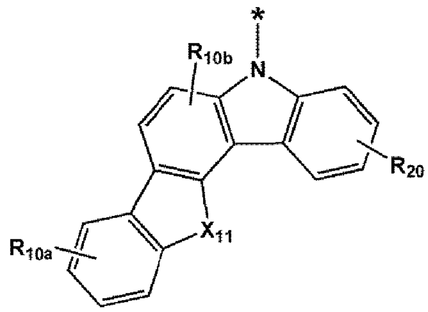

Formula 15-6

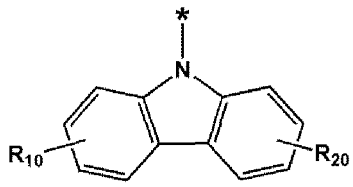

Formula 15-7

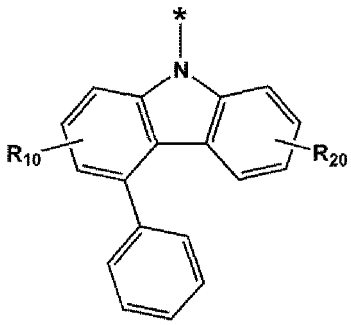

Formula 15-8

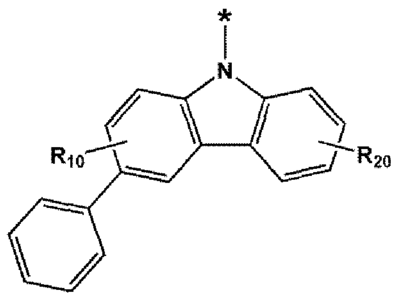

Formula 15-9

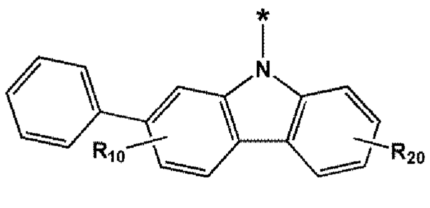

Formula 15-10

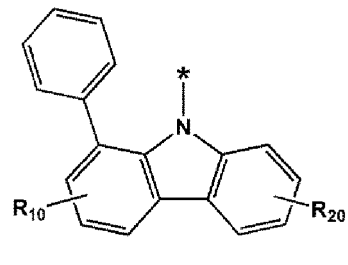

Formula 15-11

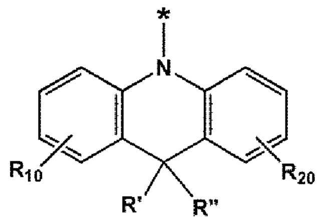

Formula 15-12

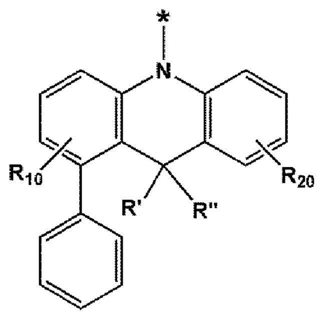

Formula 15-13

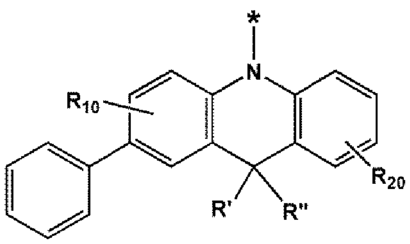

Formula 15-14

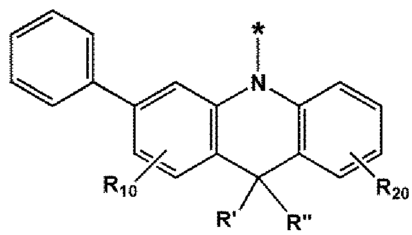

Formula 15-15

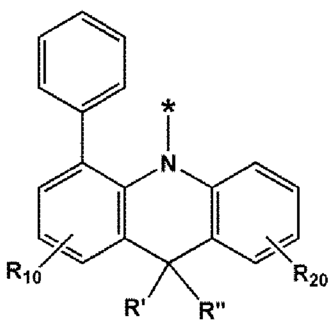

Formula 15-16

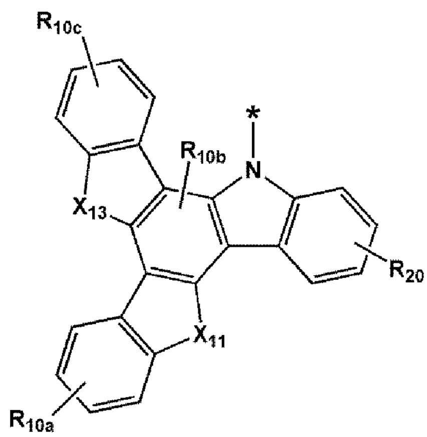

Formula 15-17

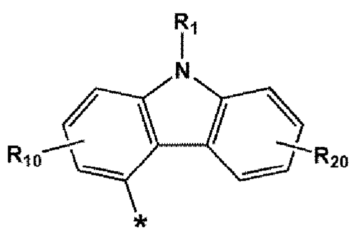

Formula 16-1

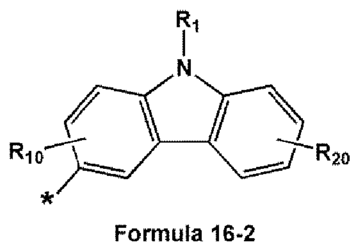

Formula 16-2

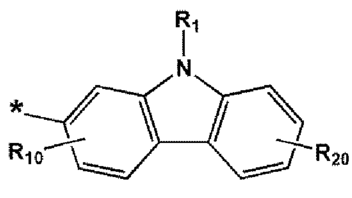

Formula 16-3

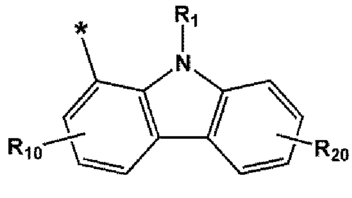

Formula 16-4

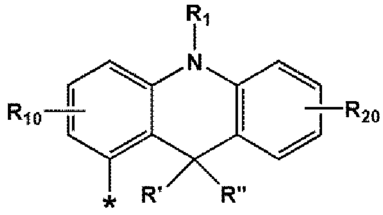

Formula 16-5

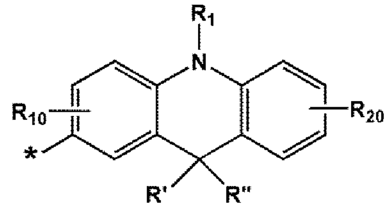

Formula 16-6

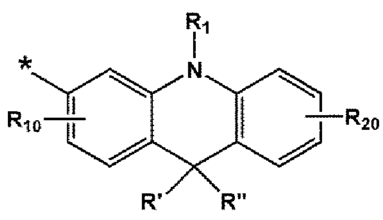

Formula 16-7

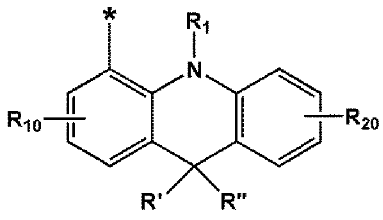

Formula 16-8

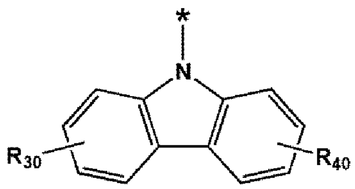

Formula 17-1

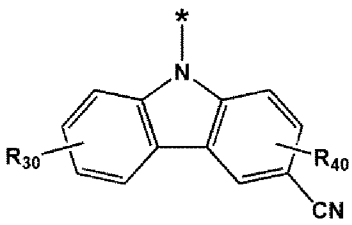

Formula 17-2

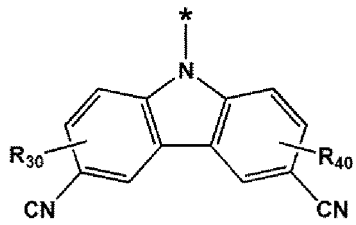

Formula 17-3

wherein, in Formulae 15-1 to 15-17, 16-1 to 16-18, and 17-1 to 17-3,
$X_{11}$ and $X_{13}$ may each independently be $C(R_{17})(R_{18})$, $N(R_{19})$, O, or S,
R' and R" may each independently be selected from hydrogen, deuterium, a $C_1$-$C_{10}$ alkyl group, a $C_1$-$C_{10}$ alkoxy group, a phenyl group, a naphthyl group, a fluorenyl group, a carbazolyl group, a dibenzofuranyl group, and a dibenzothiophenyl group,
$R_1$, $R_{10}$, $R_{20}$, $R_{30}$, and $R_{40}$ may be the same as those described herein, and
$R_{10a}$ to $R_{10c}$ may be the same as described herein with reference to $R_{10}$.

In some embodiments, in Formulae 15-1 to 15-17, 16-1 to 16-18, and 17-1 to 17-3,

$R_1$, $R_{10}$, $R_{10a}$ to $R_{10c}$, and $R_{20}$ may each independently be selected from hydrogen, deuterium, a $C_1$-$C_{10}$ alkyl group, a $C_1$-$C_{10}$ alkoxy group, a phenyl group, a naphthyl group, a fluorenyl group, a carbazolyl group, a dibenzofuranyl group, a dibenzothiophenyl group, and $-Si(Q_1)(Q_2)(Q_3)$, and $R_{30}$ and $R_{40}$ may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, $-CF_3$, $-CF_2H$, and $-CFH_2$;
a phenyl group, a pyridinyl group, a pyrimidinyl group, a pyrazinyl group, a pyridazinyl group, a triazinyl group, a naphthyl group, a fluorenyl group, a carbazolyl group, a dibenzofuranyl group, and a dibenzothiophenyl group;
a phenyl group, a pyridinyl group, a pyrimidinyl group, a pyrazinyl group, a pyridazinyl group, a triazinyl group, a naphthyl group, a fluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, $-CF_3$, $-CF_2H$, $-CFH_2$, a phenyl group, a pyridinyl group, a pyrimidinyl group, a pyrazinyl group, a pyridazinyl group, a triazinyl group, a naphthyl group, a fluorenyl group, a carbazolyl group, a dibenzofuranyl group, and a dibenzothiophenyl group; and

$$-Si(Q_1)(Q_2)(Q_3),$$

wherein $Q_1$ to $Q_3$ may each independently be selected from hydrogen, a $C_1$-$C_{10}$ alkyl group, a $C_1$-$C_{10}$ alkoxy group, a phenyl group, and a naphthyl group, but embodiments are not limited thereto.

In some embodiments,

i) the donor compound may be represented by Formula D-1 in which $L_1$ is a single bond; or
ii) the donor compound may be selected from compounds represented by Formulae D-1(1) to D-1 (52):

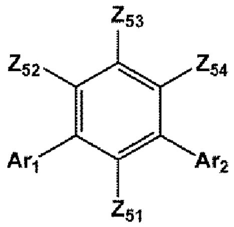

Formula D-1(1)

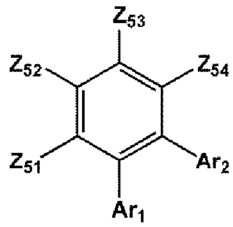

Formula D-1(2)

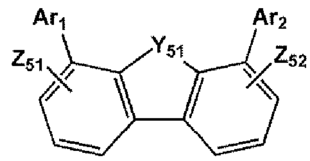

Formula D-1(3)

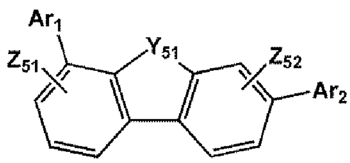

Formula D-1(4)

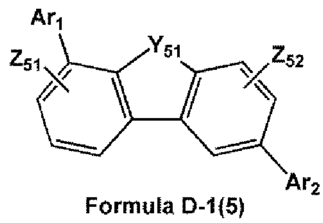

Formula D-1(5)

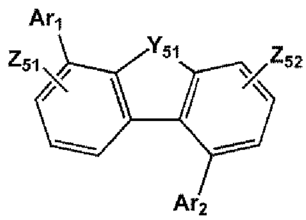

Formula D-1(6)

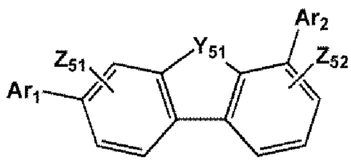

Formula D-1(7)

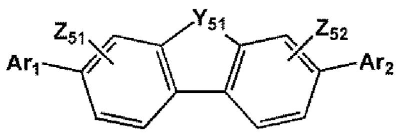

Formula D-1(8)

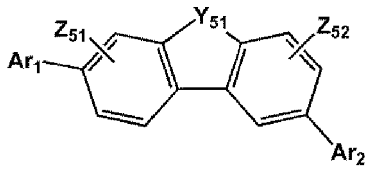

Formula D-1(9)

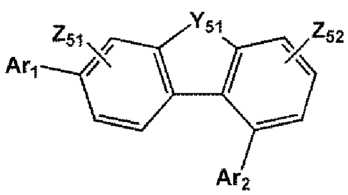

Formula D-1(10)

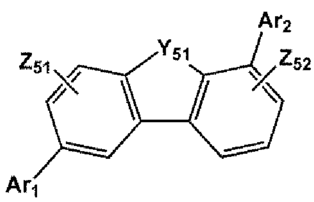

Formula D-1(11)

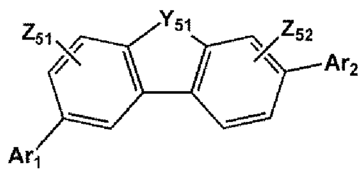

Formula D-1(12)

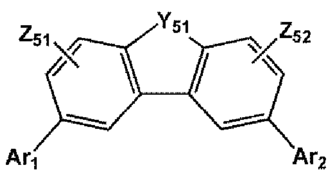

Formula D-1(13)

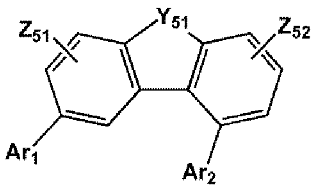

Formula D-1(14)

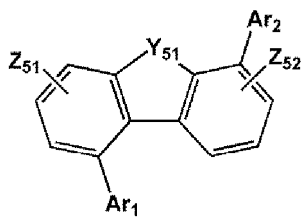

Formula D-1(15)

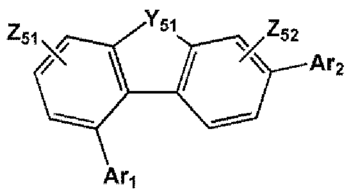

Formula D-1(16)

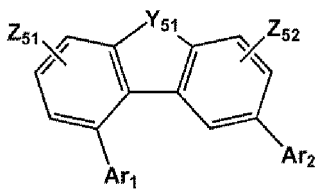

Formula D-1(17)

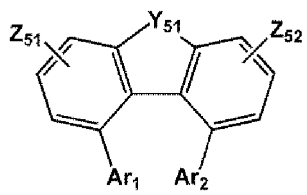

Formula D-1(18)

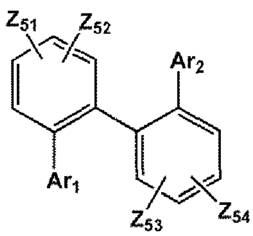

Formula D-1(19)

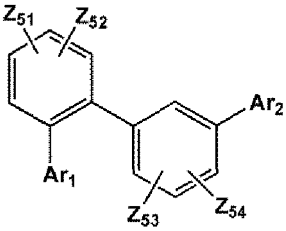

Formula D-1(20)

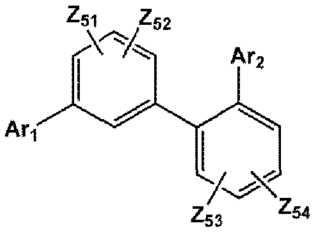

Formula D-1(21)

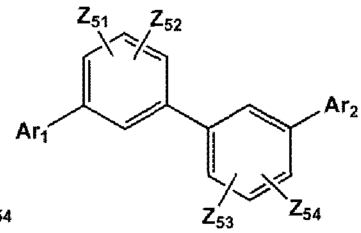

Formula D-1(22)

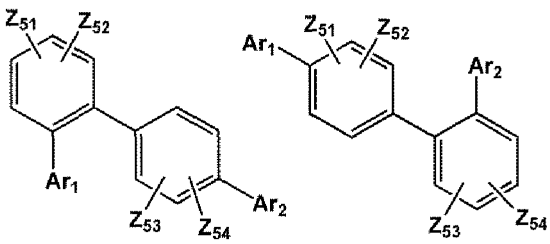

Formula D-1(23)

Formula D-1(24)

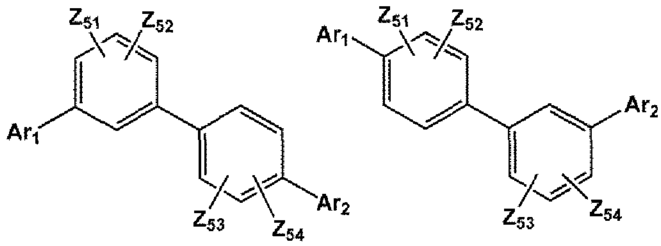

Formula D-1(25)

Formula D-1(26)

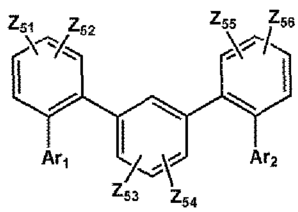

Formula D-1(27)

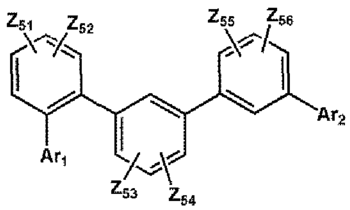

Formula D-1(28)

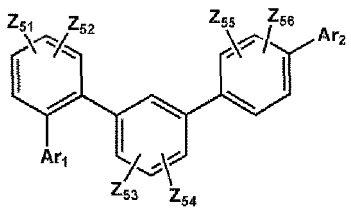

Formula D-1(29)

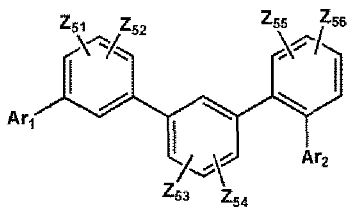

Formula D-1(30)

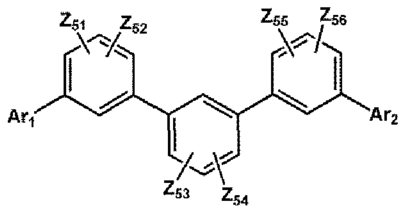

Formula D-1(31)

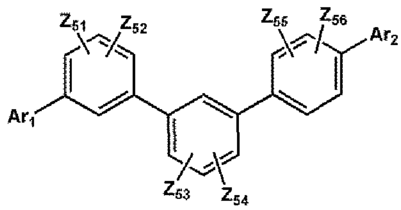

Formula D-1(32)

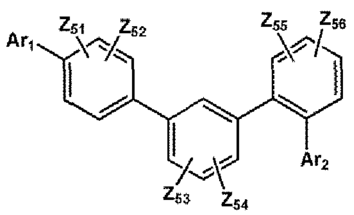

Formula D-1(33)

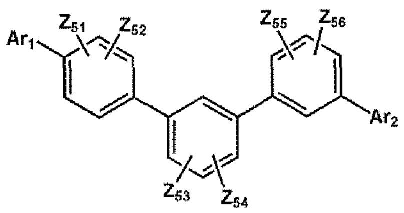

Formula D-1(34)

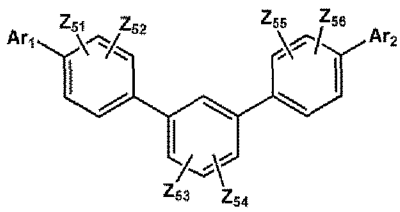

Formula D-1(35)

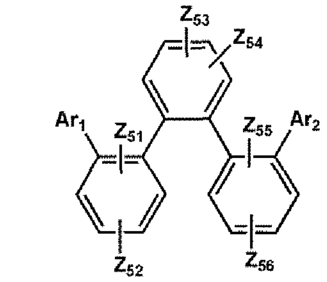
Formula D-1(36)

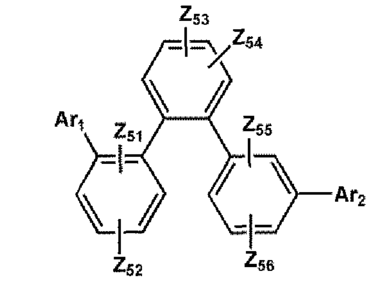
Formula D-1(37)

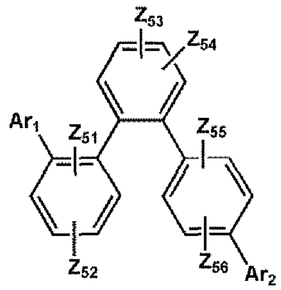
Formula D-1(38)

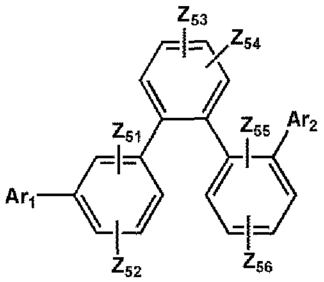
Formula D-1(39)

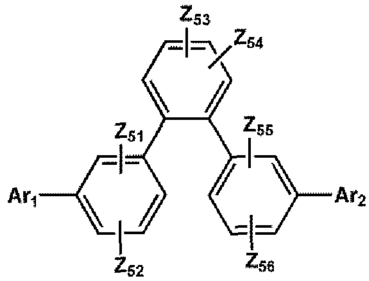
Formula D-1(40)

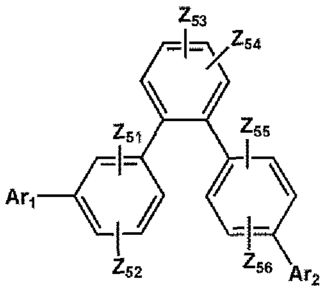
Formula D-1(41)

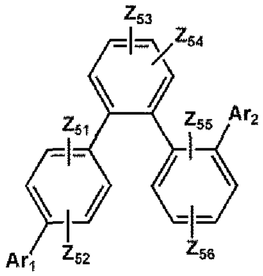
Formula D-1(42)

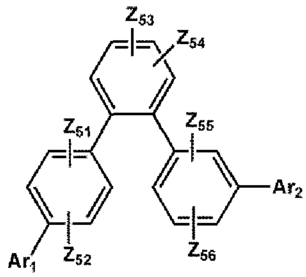
Formula D-1(43)

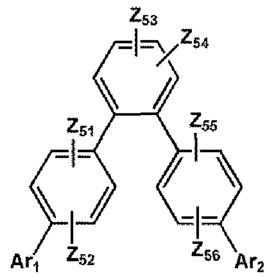
Formula D-1(44)

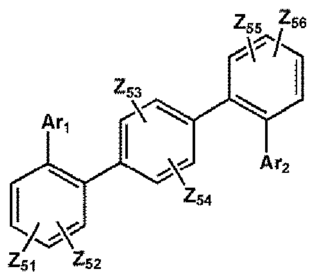
Formula D-1(45)

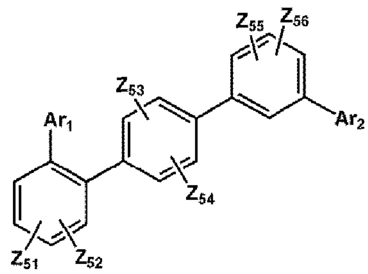
Formula D-1(46)

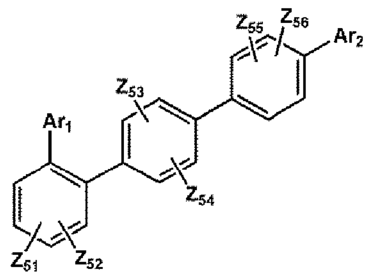
Formula D-1(47)

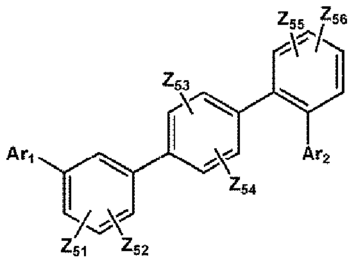
Formula D-1(48)

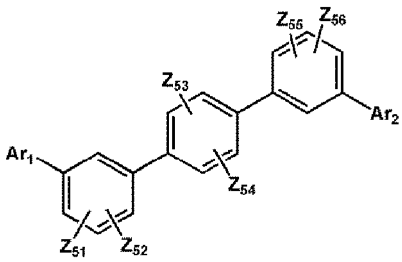
Formula D-1(49)

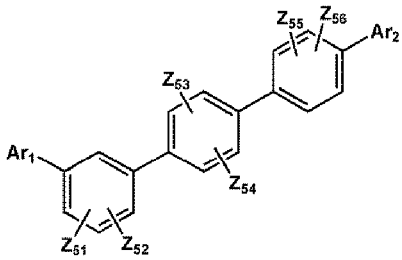
Formula D-1(50)

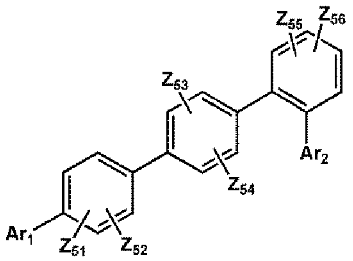
Formula D-1(51)

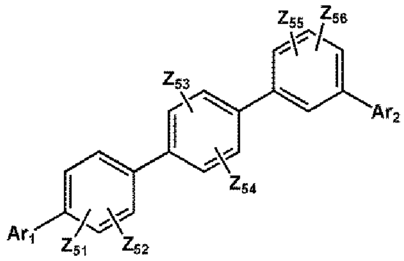
Formula D-1(52)

wherein, in Formulae D-1(1) to D-1(52),
$Ar_1$ and $Ar_2$ may be the same as those described herein,
$Y_{51}$ may be $C(Z_{53})(Z_{54})$, $N(Z_{55})$, O, or S, and
$Z_{51}$ to $Z_{56}$ may each independently be selected from hydrogen, deuterium, a $C_1$-$C_{10}$ alkyl group, a $C_1$-$C_{10}$ alkoxy group, a phenyl group, a naphthyl group, a fluorenyl group, a carbazolyl group, a dibenzofuranyl group, a dibenzothiophenyl group, and $-Si(Q_{11})(Q_{12})(Q_{13})$,
wherein $Q_{11}$ to $Q_{13}$ may each independently be selected from hydrogen, a $C_1$-$C_{10}$ alkyl group, a $C_1$-$C_{10}$ alkoxy group, a phenyl group, and a naphthyl group.

In some embodiments, in Formulae D-1(1) to D-1(52),

$Ar_1$ may be selected from groups represented by Formulae 11 and 12, and $Ar_2$ may be selected from:

groups represented by Formulae 11 and 12, a phenyl group, a naphthyl group, and a benzimidazolyl group; and a phenyl group, a naphthyl group, and a benzimidazolyl group, each substituted with at least one selected from deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a carbazolyl group, a dibenzofuranyl group, and a dibenzothiophenyl group.

In one or more embodiments, in Formulae D-1(1) to D-1(52),

$Ar_1$ may be selected from groups represented by Formulae 11-1 to 11-8 and 12-1 to 12-8,
$Ar_2$ may be selected from groups represented by Formulae 11-1 to 11-8 and 12-1 to 12-8, a phenyl group, a naphthyl group, and a benzimidazolyl group substituted with a phenyl group, but embodiments are not limited thereto.

In Formulae A-1 and A-2, $L_{11}$ to $L_{13}$ may each independently be selected from groups represented by Formulae 3-1 to 3-56, and i) at least one $L_{11}$ in the number of a11, ii) at least one $L_{12}$ in the number of a12, and iii) at least one $L_{13}$ in the number of a13 may each independently be selected from groups represented by Formulae 3-15 to 3-56:

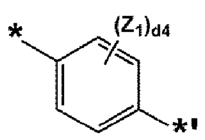
Formula 3-1

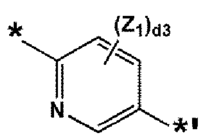
Formula 3-2

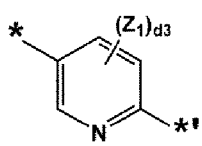
Formula 3-3

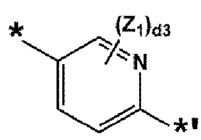
Formula 3-4

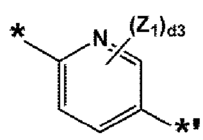
Formula 3-5

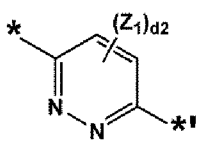
Formula 3-6

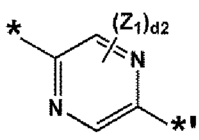
Formula 3-7

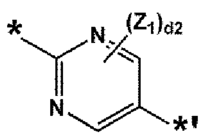
Formula 3-8

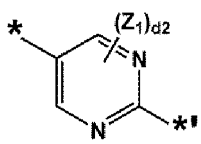
Formula 3-9

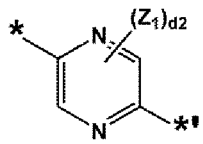
Formula 3-10

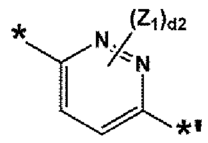
Formula 3-11

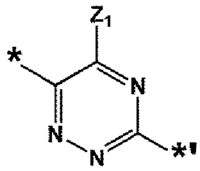
Formula 3-12

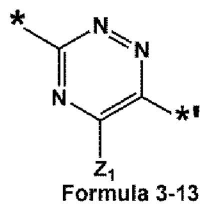
Formula 3-13

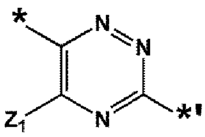
Formula 3-14

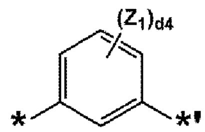
Formula 3-15

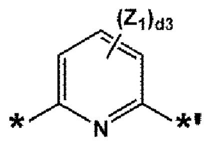
Formula 3-16

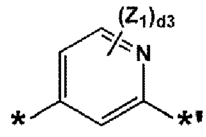
Formula 3-17

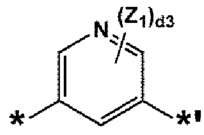
Formula 3-18

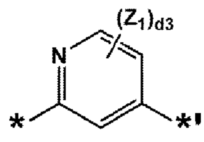
Formula 3-19

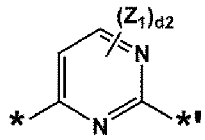
Formula 3-20

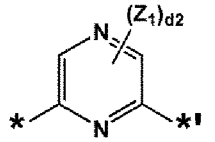
Formula 3-21

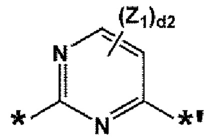
Formula 3-22

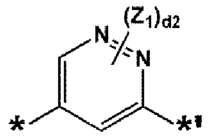
Formula 3-23

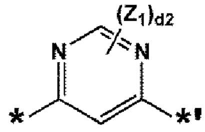
Formula 3-24

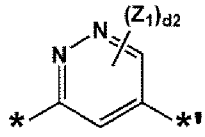
Formula 3-25

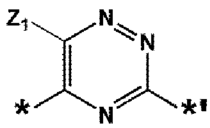
Formula 3-26

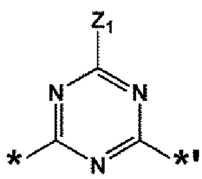
Formula 3-27

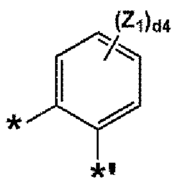
Formula 3-28

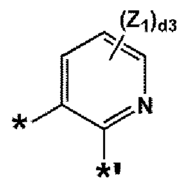
Formula 3-29

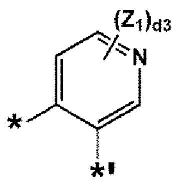
Formula 3-30

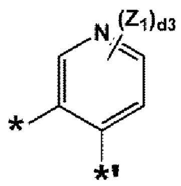
Formula 3-31

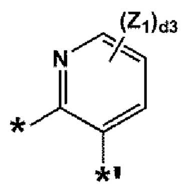
Formula 3-32

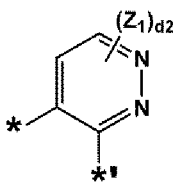
Formula 3-33

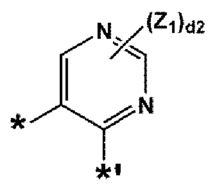
Formula 3-34

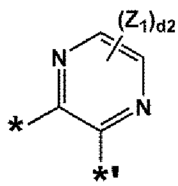
Formula 3-35

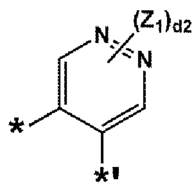
Formula 3-36

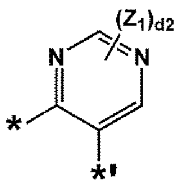
Formula 3-37

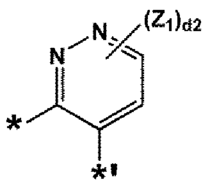
Formula 3-38

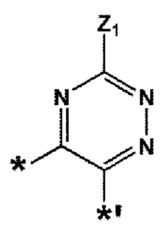
Formula 3-39

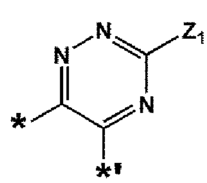
Formula 3-40

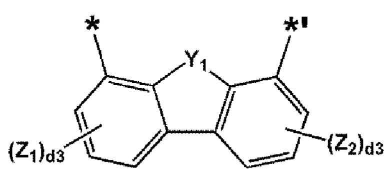
Formula 3-41

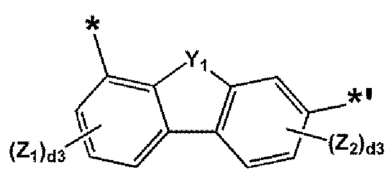
Formula 3-42

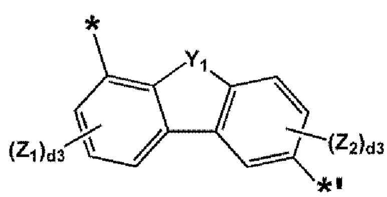
Formula 3-43

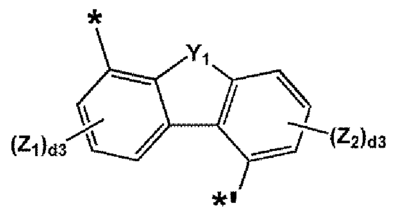

Formula 3-44

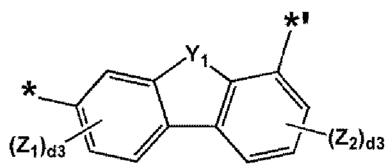

Formula 3-45

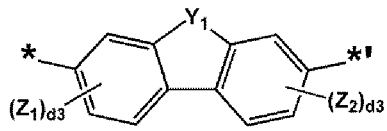

Formula 3-46

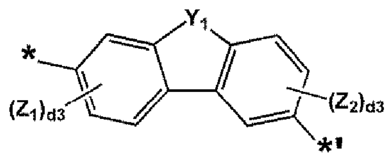

Formula 3-47

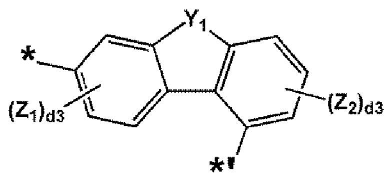

Formula 3-48

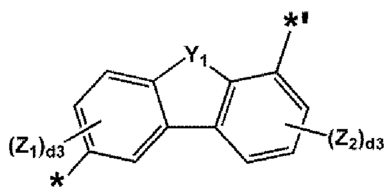

Formula 3-49

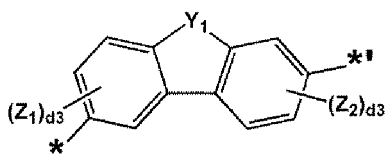

Formula 3-50

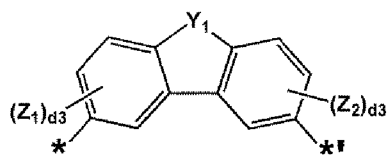

Formula 3-51

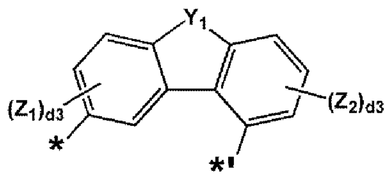

Formula 3-52

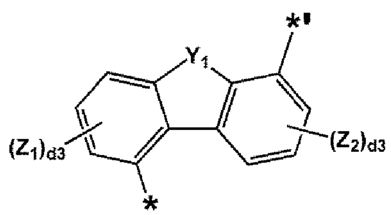

Formula 3-53

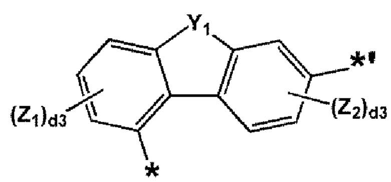

Formula 3-54

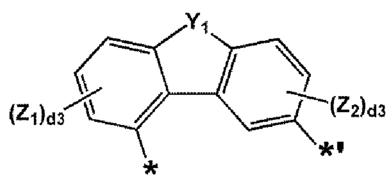

Formula 3-55

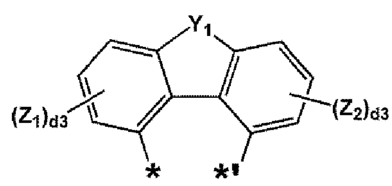

Formula 3-56

wherein, in Formulae 3-1 to 3-56,

$Y_1$ may be selected from O, S, $C(Z_3)(Z_4)$, and $N(Z_5)$,

$Z_1$ to $Z_5$ may each independently be selected from hydrogen, deuterium, -F, - Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, $-CF_3$, $- CF_2H$, $-CFH_2$, a phenyl group, a phenyl group substituted with a cyano group, a naphthyl group, a pyridinyl group, a pyrimidinyl group, a pyrazinyl group, a pyridazinyl group, a triazinyl group, a fluorenyl group, a carbazolyl group, a dibenzofuranyl group, a dibenzothiophenyl group, and $-Si(Q_{11})(Q_{12})(Q_{13})$, wherein $Q_{11}$ to $Q_{13}$ may each independently be selected from hydrogen, a $C_1$-$C_{10}$ alkyl group, a $C_1$-$C_{10}$ alkoxy group, a phenyl group, a naphthyl group, a pyridinyl group, a pyrimidinyl group, a pyrazinyl group, a pyridazinyl group, a triazinyl group, a fluorenyl group, a carbazolyl group, a dibenzofuranyl group, and a dibenzothiophenyl group, and

d4 may be an integer selected from 0 to 4,

d3 may be an integer selected from 0 to 3,

d2 may be an integer selected from 0 to 2, and
* and *' each indicate a binding site to an adjacent atom.

In one or more embodiments, in Formulae A-1 and A-2, groups represented by *-$(L_{11})_{a11}$-*', *-$(L_{12})_{a12}$-*', and *-$(L_{13})_{a13}$-*' may be selected from groups represented by Formulae 4-1 to 4-39:

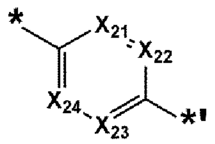
Formula 4-1

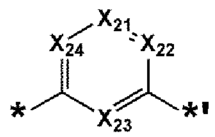
Formula 4-2

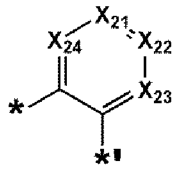
Formula 4-3

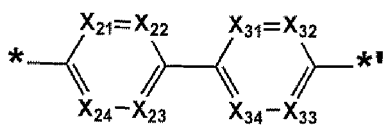
Formula 4-4

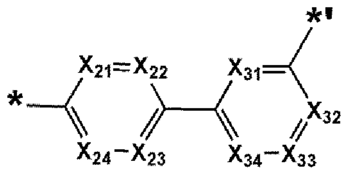
Formula 4-5

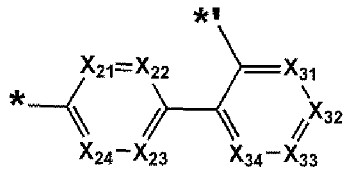
Formula 4-6

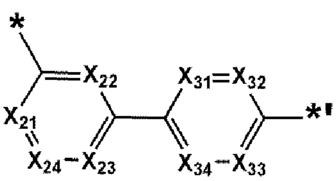
Formula 4-7

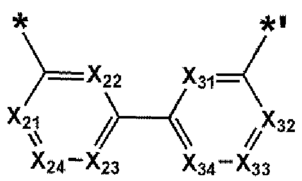
Formula 4-8

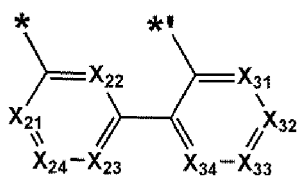
Formula 4-9

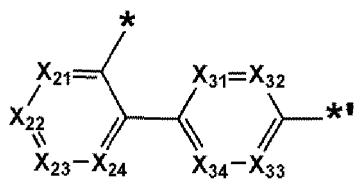
Formula 4-10

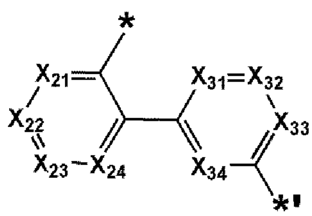
Formula 4-11

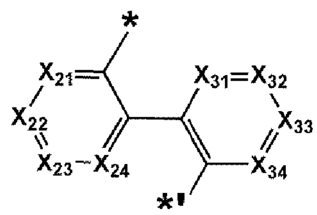
Formula 4-12

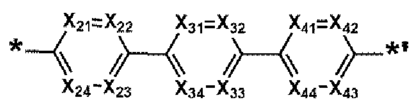
Formula 4-13

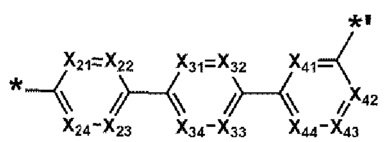
Formula 4-14

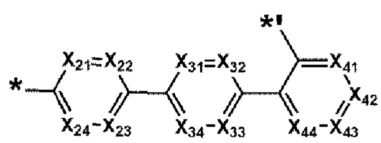
Formula 4-15

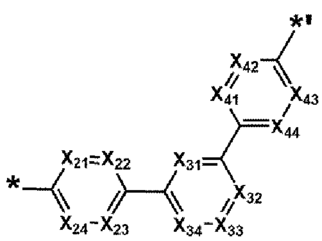
Formula 4-16

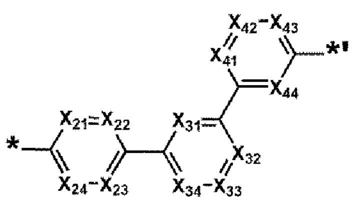
Formula 4-17

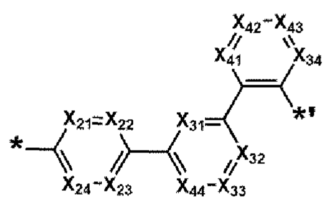
Formula 4-18

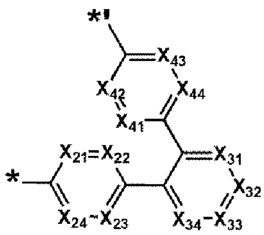

Formula 4-19

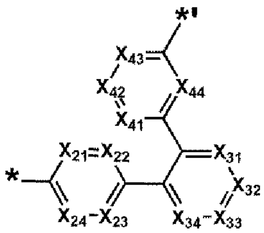

Formula 4-20

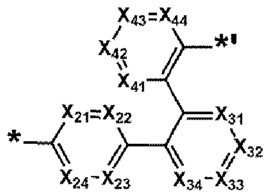

Formula 4-21

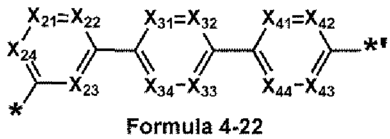

Formula 4-22

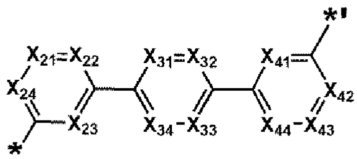

Formula 4-23

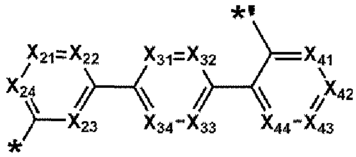

Formula 4-24

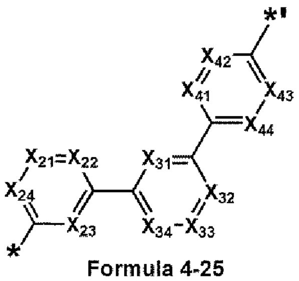

Formula 4-25

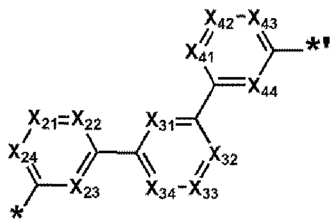

Formula 4-26

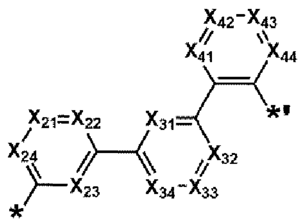

Formula 4-27

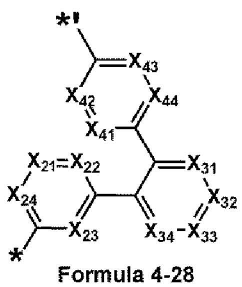

Formula 4-28

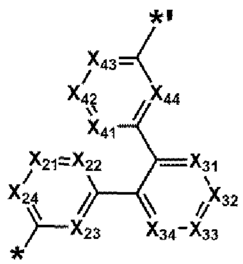

Formula 4-29

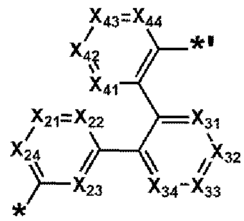

Formula 4-30

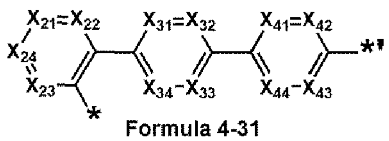

Formula 4-31

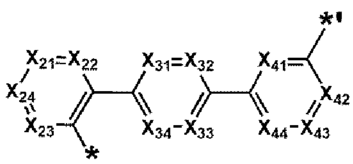

Formula 4-32

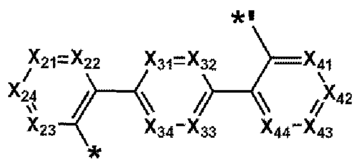

Formula 4-33

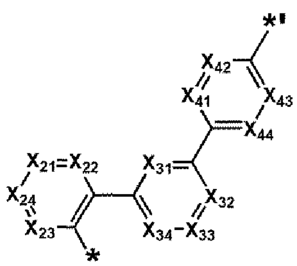

Formula 4-34

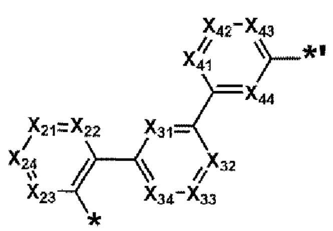

Formula 4-35

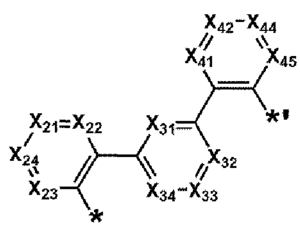

Formula 4-36

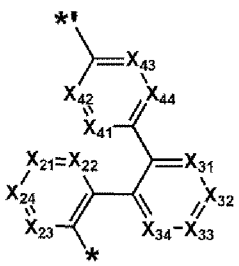
Formula 4-37

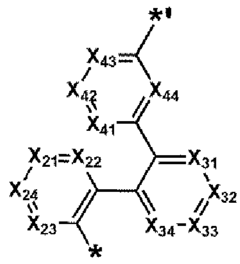
Formula 4-38

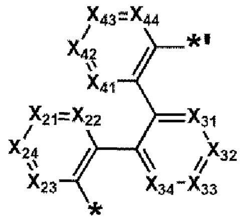
Formula 4-39

wherein, in Formulae 4-1 to 4-39,

$X_{21}$ may be N or $C(Z_{21})$, $X_{22}$ may be N or $C(Z_{22})$, $X_{23}$ may be N or $C(Z_{23})$, $X_{24}$ may be N or $C(Z_{24})$, $X_{31}$ may be N or $C(Z_{31})$, $X_{32}$ may be N or $C(Z_{32})$, $X_{33}$ may be N or $C(Z_{33})$, $X_{34}$ may be N or $C(Z_{34})$, $X_{41}$ may be N or $C(Z_{41})$, $X_{42}$ may be N or $C(Z_{42})$, $X_{43}$ may be N or $C(Z_{43})$, and $X_{44}$ may be N or $C(Z_{44})$, provided that at least one of $X_{21}$ to $X_{24}$ is not N, at least one of $X_{31}$ to $X_{34}$ is not N, and at least one of $X_{41}$ to $X_{44}$ is not N,

$Z_{21}$ to $Z_{24}$, $Z_{31}$ to $Z_{34}$, and $Z_{41}$ to $Z_{44}$ may each independently be selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, $-CF_3$, $-CF_2H$, $-CFH_2$, a phenyl group, a phenyl group substituted with a cyano group, a naphthyl group, a pyridinyl group, a pyrimidinyl group, a pyrazinyl group, a pyridazinyl group, a triazinyl group, a fluorenyl group, a carbazolyl group, a dibenzofuranyl group, a dibenzothiophenyl group, and $-Si(Q_{11})(Q_{12})(Q_{13})$,

wherein $Q_{11}$ to $Q_{13}$ may each independently be selected from hydrogen, a $C_1$-$C_{10}$ alkyl group, a $C_1$-$C_{10}$ alkoxy group, a phenyl group, a naphthyl group, a pyridinyl group, a pyrimidinyl group, a pyrazinyl group, a pyridazinyl group, a triazinyl group, a fluorenyl group, a carbazolyl group, a dibenzofuranyl group, and a dibenzothiophenyl group, and

* and *' each indicate a binding site to an adjacent atom.

In Formula A-2, $T_{11}$ to $T_{16}$ may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, $-CF_3$, $-CF_2H$, and $-CFH_2$;

a $C_1$-$C_{10}$ alkyl group and a $C_1$-$C_{10}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-CF_3$, $-CF_2H$, and $-CFH_2$;

a phenyl group, a naphthyl group, a pyridinyl group, a pyrimidinyl group, a pyrazinyl group, a pyridazinyl group, a triazinyl group, a fluorenyl group, a carbazolyl group, a dibenzofuranyl group, and a dibenzothiophenyl group;

a phenyl group, a naphthyl group, a pyridinyl group, a pyrimidinyl group, a pyrazinyl group, a pyridazinyl group, a triazinyl group, a fluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, $-CF_3$, $-CF_2H$, $-CFH_2$, a phenyl group, a naphthyl group, a pyridinyl group, a pyrimidinyl group, a pyrazinyl group, a pyridazinyl group, a triazinyl group, a fluorenyl group, a carbazolyl group, a dibenzofuranyl group, and a dibenzothiophenyl group; and

$$-Si(Q_1)(Q_2)(Q_3),$$

wherein $Q_1$ to $Q_3$ may each independently be selected from hydrogen, a $C_1$-$C_{10}$ alkyl group, a $C_1$-$C_{10}$ alkoxy group, a phenyl group, a naphthyl group, a pyridinyl group, a pyrimidinyl group, a pyrazinyl group, a pyridazinyl group, a triazinyl group, a fluorenyl group, a carbazolyl group, a dibenzofuranyl group, and a dibenzothiophenyl group.

In some embodiments, in Formula A-2, $T_{11}$ to $T_{16}$ may each independently be selected from:

hydrogen, deuterium, -F, a cyano group, a $C_1$-$C_{10}$ alkyl group, a $C_1$-$C_{10}$ alkoxy group, -CF3, $-CF_2H$, and $-CFH_2$;
a $C_1$-$C_{10}$ alkyl group and a $C_1$-$C_{10}$ alkoxy group, each substituted with at least one selected from deuterium, -F, a cyano group, $-CF_3$, $-CF_2H$, and $-CFH_2$;
a phenyl group, a pyridinyl group, a pyrimidinyl group, a triazinyl group, a carbazolyl group, a dibenzofuranyl group, and a dibenzothiophenyl group;
a phenyl group, a pyridinyl group, a pyrimidinyl group, a triazinyl group, a carbazolyl group, a dibenzofuranyl group, and a dibenzothiophenyl group, each substituted with at least one selected from deuterium, -F, a cyano group, a $C_1$-$C_{10}$ alkyl group, a $C_1$-$C_{10}$ alkoxy group, $-CF_3$, $-CF_2H$, $-CFH_2$, a phenyl group, a pyridinyl group, a pyrimidinyl group, a triazinyl group, a carbazolyl group, a dibenzofuranyl group, and a dibenzothiophenyl group; and

$-Si(Q_1)(Q_2)(Q_3)$,

wherein $Q_1$ to $Q_3$ may each independently be selected from hydrogen, a $C_1$-$C_{10}$ alkyl group, a $C_1$-$C_{10}$ alkoxy group, a phenyl group, a pyridinyl group, a pyrimidinyl group, a triazinyl group, a carbazolyl group, a dibenzofuranyl group, and a dibenzothiophenyl group.

In one or more embodiments,

i) the acceptor compound may be represented by Formula A-, in which $Ar_{11}$ and $Ar_{12}$are each independently selected from groups represented by Formulae 17-1 to 17-3, and at least one of $Ar_{11}$ and $Ar_{12}$ is selected from groups represented by Formulae 17-2 and 17-3;
ii) the acceptor compound may be represented by Formula A-1 in which $L_{11}$ is selected from groups represented by Formulae 3-15 and 3-28, and at least one $L_{11}$ in the number of a11 is selected from groups represented by Formulae 6-1 to 6-4; or
iii) the acceptor compound may be represented by Formula A-2 in which $X_1$ to $X_3$are each N, but embodiments are not limited thereto.

In some embodiments, the donor compound may be selected from Compounds D1 to D17, and the acceptor compound may be selected from Compounds A1 to A11, but embodiments are not limited thereto:

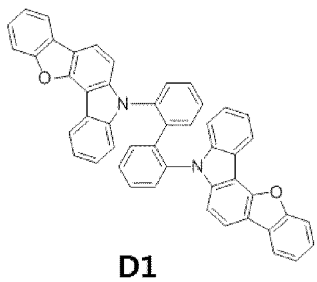

D1

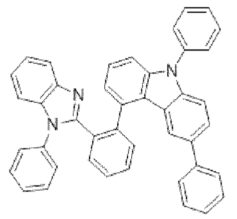

D2

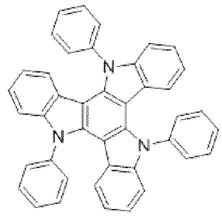

D3

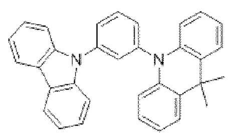

D4

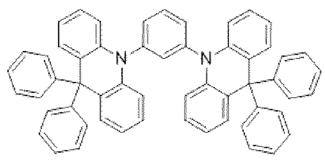

D5

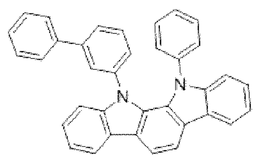

D6

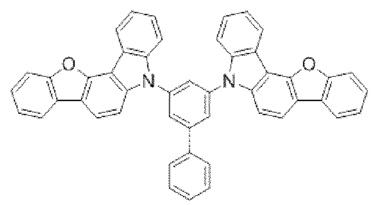

D7

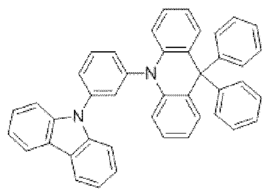

D8

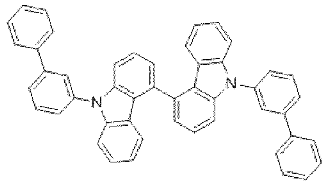

D9

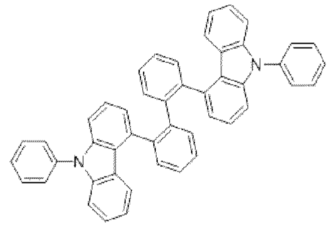

D10

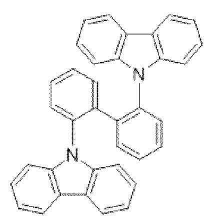

D11

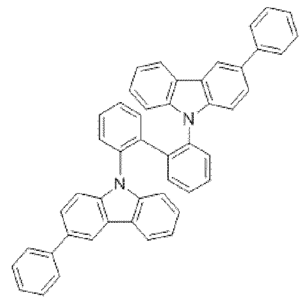

D12

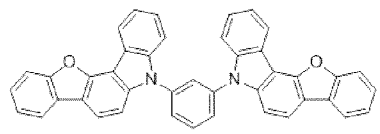

D13

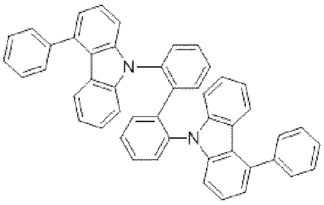

D14

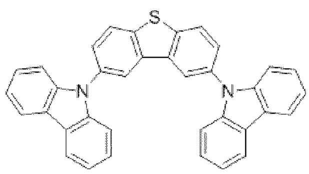

D15

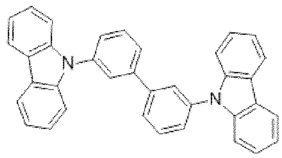

D16

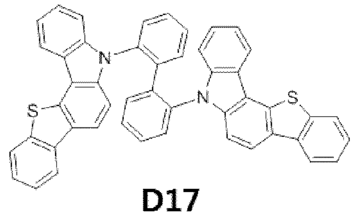

D17

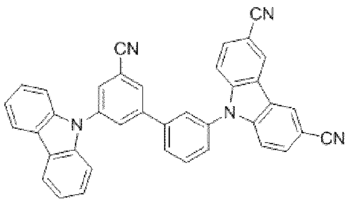

A1

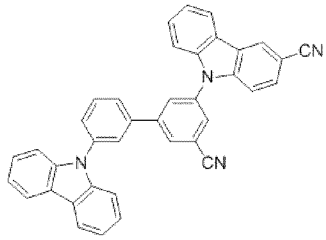

A2

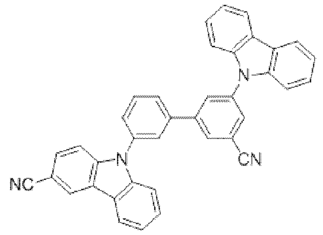

A3

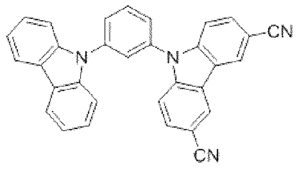

A4

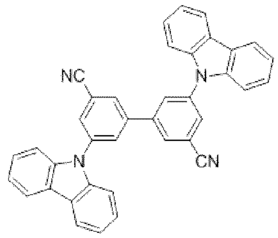

A5

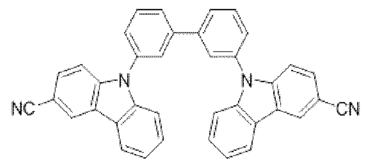

A6

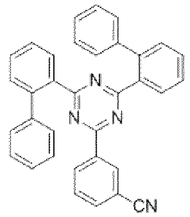

A7

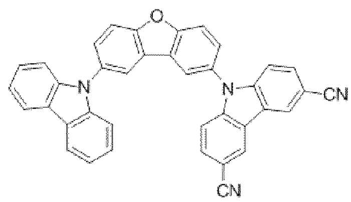

A8

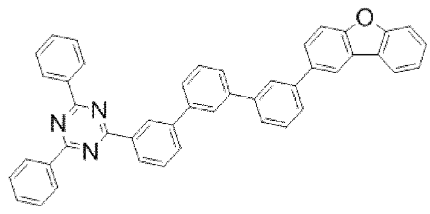

A9

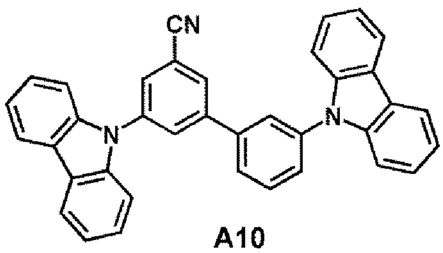

A10

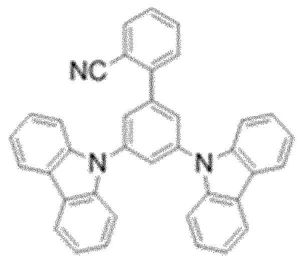

A11

The dopant in the emission layer includes a phosphorescent dopant.

The phosphorescent dopant may be any suitable dopant capable of emitting light in accordance with a phosphorescent emission mechanism.

The phosphorescent dopant may be selected from a red phosphorescent dopant, a green phosphorescent dopant, and a blue phosphorescent dopant.

In an embodiment, the phosphorescent dopant may be a green phosphorescent dopant or a blue phosphorescent dopant, but embodiments are not limited thereto.

In some embodiments, the phosphorescent dopant may include an organometallic compound represented by Formula 81:

Formula 81 $M(L_{81})_{n81}(L_{82})_{n82}$

Formula 81A

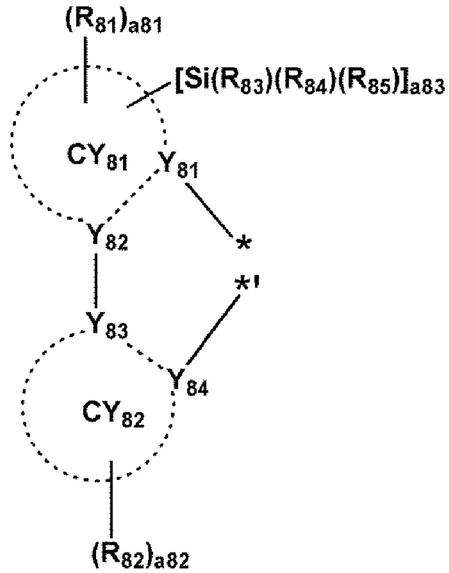

wherein, in Formulae 81 and 81A,

M may be selected from iridium (Ir), platinum (Pt), osmium (Os), titanium (Ti), zirconium (Zr), hafnium (Hf), europium (Eu), terbium (Tb), thulium (Tm), and rhodium (Rh),

$L_{81}$ may be a ligand represented by Formula 81A, n81 may be an integer from 1 to 3; when n81 is 2 or greater, at least two $L_{81}$ groups may be identical to or different from each other,

$L_{82}$ may be an organic ligand, n82 may be an integer from 0 to 4; when n82 is 2 or greater, at least two $L_{82}$ groups may be identical to or different from each other,

$Y_{81}$ to $Y_{84}$ may each independently be C or N,

$Y_{81}$ and $Y_{82}$ may be bound via a single bond or a double bond, $Y_{83}$ and $Y_{84}$ may be bound via a single bond or a double bond,

$CY_{81}$ and $CY_{82}$ may each independently be selected from a $C_5$-$C_{30}$ carbocyclic group and a $C_1$-$C_{30}$ heterocyclic group,

$CY_{81}$ and $CY_{82}$ may optionally and additionally be bound via an organic linking group,

$R_{81}$ to $R_{85}$ may each independently be selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, - $Si(Q_{81})(Q_{82})(Q_{83})$, -N(Q84)(Q85), -B(Q86)(Q87), and $-P(=O)(Q_{88})(Q_{89})$,

a81 to a83 may each independently be an integer selected from 0 to 5,

when a81 is 2 or greater, at least two $R_{81}$ groups may be identical to or different from each other,

when a82 is 2 or greater, at least two $R_{82}$ groups may be identical to or different from each other,

when a81 is 2 or greater, $R_{81}$ groups that are adjacent to each other may optionally be bound to form a saturated or unsaturated ring,

when a82 is 2 or greater, $R_{82}$ groups that are adjacent to each other may optionally be bound to form a saturated or unsaturated ring,

in Formula 81A, * and *' each indicate a binding site to M in Formula 81, and at least one substituent of the substituted $C_1$-$C_{60}$ alkyl group, substituted $C_2$-$C_{60}$ alkenyl group, substituted $C_2$-$C_{60}$ alkynyl group, substituted $C_1$-$C_{60}$ alkoxy group, substituted $C_3$-$C_{10}$ cycloalkyl group, substituted $C_1$-$C_{10}$ heterocycloalkyl group, substituted $C_3$-$C_{10}$ cycloalke-

nyl group, substituted $C_1$-$C_{10}$ heterocycloalkenyl group, substituted $C_6$-$C_{60}$ aryl group, substituted $C_6$-$C_{60}$ aryloxy group, substituted $C_6$-$C_{60}$ arylthio group, substituted $C_7$-$C_{60}$ arylalkyl group, substituted $C_1$-$C_{60}$ heteroaryl group, substituted $C_1$-$C_{60}$ heteroaryloxy group, substituted $C_1$-$C_{60}$ heteroarylthio group, substituted $C_2$-$C_{60}$ heteroarylalkyl group, substituted monovalent non-aromatic condensed polycyclic group, and substituted monovalent non-aromatic condensed heteropolycyclic group may be selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, and - $Si(Q_{91})(Q_{92})(Q_{93})$, wherein $Q_{81}$ to $Q_{89}$ and $Q_{91}$ to $Q_{93}$ may each independently be selected from hydrogen, deuterium, a $C_1$-$C_{60}$ alkyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group.

In an embodiment, in Formula 81A,

a83 may be 1 or 2, and
$R_{83}$ to $R_{85}$ may each independently be selected from:
$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, and - $CD_2CDH_2$;
an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group; and
an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group, each substituted with at least one selected from deuterium, a $C_1$-$C_{10}$ alkyl group, and a phenyl group, but embodiments are not limited thereto.

In one or more embodiments, in Formula 81A,

$Y_{81}$ may be N, $Y_{82}$ and $Y_{83}$ may each be C, $Y_{84}$ may be N or C, and
$CY_{81}$ and $CY_{82}$ may each independently be selected from a cyclopentadiene group, a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, an indazole group, a pyrazole group, an imidazole group, a triazole group, an oxazole group, an isoxazole group, an oxadiazole group, a thiazole group, an isothiazole group, a thiadiazole group, a purine group, a furan group, a thiophene group, a pyridine group, a pyrimidine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, a benzofuran group, a benzothiophene group, an iso-benzothiazole group, a benzoxazole group, an isobenzoxazole group, a benzocarbazole group, a dibenzocarbazole group, an imidazopyridine group, an imidazopyrimidine group, a dibenzofuran group, a dibenzothiophene group, a dibenzothiophene sulfone group, a carbazole group, a dibenzosilole group, a 2,3-dihydro-1H-imidazole group, and a 2,3-dihydro-1 H-imidazopyrazine group.

In one or more embodiments, in Formula 81A, $Y_{81}$ may be N, $Y_{82}$ to $Y_{84}$ may each be C, $CY_{81}$ may be selected from 5-membered rings including two N atoms as ring-forming atoms, and $CY_{82}$ may be selected from a benzene group, a naphthalene group, a fluorene group, a dibenzofuran group, and a dibenzothiophene group, but embodiments are not limited thereto.

In one or more embodiments, in Formula 81A, $Y_{81}$ may be N, $Y_{82}$ to $Y_{84}$ may each be C, $CY_{81}$ may be an imidazole group or a 2,3-dihydro-1H-imidazole group, and $CY_{82}$ may be selected from a benzene group, a naphthalene group a fluorene group, a dibenzofuran group, and a dibenzothiophene group, but embodiments are not limited thereto.

In one or more embodiments, in Formula 81A,

$Y_{81}$ may be N, $Y_{82}$ to $Y_{84}$ may each be C,
$CY_{81}$ may be selected from a pyrrole group, a pyrazole group, an imidazole group, a triazole group, an oxazole group, an isoxazole group, an oxadiazole group, a thiazole group, an isothiazole group, a thiadiazole group, a pyridine group, a pyrimidine group, a quinoline group, an isoquinoline group, a benzoquinoline group, a phthalazine group, a naphthyridine group, a quinoxaline group, a quinazoline group, a cinnoline group, a benzimidazole group, an iso-benzothiazole group, a benzoxazole group, and an isobenzoxazole group, and
$CY_{82}$ may be selected from a cyclopentadiene group, a benzene group, a naphthalene group, a fluorene group, a benzofluorene group, a dibenzofluorene group, a phenanthrene group, an anthracene group, a triphenylene group, a pyrene group, a chrysene group, a perylene group, a benzofuran group, a benzothiophene group, a benzocarbazole group, a dibenzocarbazole group, a dibenzofuran group, a dibenzothiophene group, a dibenzothiophene sulfone group, a carbazole group, and a dibenzosilole group.

In one or more embodiments, in Formula 81A, $Y_{81}$, $Y_{83}$, and $Y_{84}$ may each be C, $Y_{82}$ may be N, $CY_{81}$ may be selected from a) a condensed ring in which i) a 5-membered ring including at least one N as a ring-forming atom may be condensed with ii) a 6-membered ring selected from a benzene group, a pyridine group, a pyrazine group, a pyrimidine group, and a pyridazine group; and b) a 5-membered ring including at least one N as a ring-forming atom, and $CY_{82}$ may be selected from a benzene group, a naphthalene group, a fluorene group, a dibenzofuran group, a dibenzothiophene group, a pyridine group, a pyrimidine group, a quinoline group, and an isoquinoline group, but embodiments are not limited thereto.

In one or more embodiments, in Formula 81A,
$R_{81}$ and $R_{82}$ may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, and a $C_1$-$C_{20}$ alkoxy group;
a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric

acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and

-B(Q86)(Q87) and -P(=O)($Q_{88}$)($Q_{89}$),

wherein $Q_{86}$ to $Q_{89}$ may each independently be selected from:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, and - $CD_2CDH_2$;

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group; and

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group, each substituted with at least one selected from deuterium, a $C_1$-$C_{10}$ alkyl group, and a phenyl group.

In one or more embodiments, in Formula 81A, $R_{81}$ and $R_{82}$ may each independently be selected from

hydrogen, deuterium, -F, a cyano group, a nitro group, $-SF_5$, a methyl group, an ethyl group, an n-propyl group, an iso-propyl group, an n-butyl group, an iso-butyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzothiophenyl group, and a dibenzofuranyl group;

a methyl group, an ethyl group, an n-propyl group, an iso-propyl group, an n-butyl group, an iso-butyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzothiophenyl group, and a dibenzofuranyl group, each substituted with at least one selected from deuterium, -F, $-CD_3$, $-CD_2H$, $-CDH_2$, $-CF_3$, $-CF_2H$, - $CFH_2$, a cyano group, a nitro group, a $C_1$-$C_{10}$ alkyl group, a $C_1$-$C_{10}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzothiophenyl group, and a dibenzofuranyl group; and

-B(Q86)(Q87) and -P(=O)($Q_{88}$)($Q_{89}$),

wherein $Q_{86}$ to $Q_{89}$ may each independently be selected from:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, and - $CD_2CDH_2$;

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group; and

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group, each substituted with at least one selected from deuterium, a $C_1$-$C_{10}$ alkyl group, and a phenyl group.

In one or more embodiments, in Formula 81A, at least one $R_{81}$ in the number of a81, at least one $R_{82}$ in the number of a82, or any combination thereof may be a cyano group.

In one or more embodiments, in Formula 81A, $Y_{81}$ may be N; $Y_{82}$ to $Y_{84}$ may each be C; $CY_{81}$ may be an imidazole group or a 2,3-dihydro-1 H-imidazole group; $CY_{82}$ may be selected from a benzene group, a naphthalene group, a fluorene group, a dibenzofuran group, and a dibenzothiophene group; and at least one $R_{81}$ in the number of a81, at least one $R_{82}$ in the number of a82, or any combination thereof may be a cyano group.

In one or more embodiments, in Formula 81A, at least one $R_{82}$ in the number of a 82 may be a cyano group.

In one or more embodiments, in Formula 81A, at least one $R_{81}$ in the number of a81, at least one $R_{82}$ in the number of a82, or any combination thereof may be deuterium.

In one or more embodiments, in Formula 81A, $CY_{81}$ and $CY_{82}$ may additionally be bound via an organic linking group. Examples of the organic linking group may include a $C_2$-$C_5$ alkylene group, a $C_2$-$C_5$ alkenylene group,

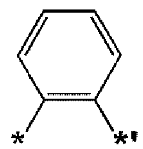

,

a $C_2$-$C_5$ alkylene group substituted with at least one $R_{81a}$, a $C_2$-$C_5$ alkenylene group substituted with at least one $R_{81a}$, and

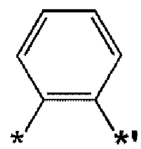

substituted with at least one $R_{81a}$, but embodiments are not limited thereto. $R_{81a}$ may be the same as described herein with reference to $R_{81}$.

In some embodiments, in Formula 81, $L_{81}$ may be selected from ligands represented by Formulae 81A-1 to 81A-8, but embodiments are not limited thereto:

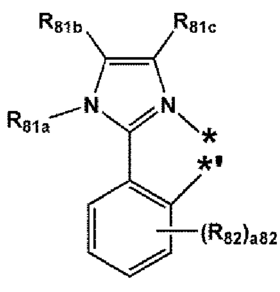

Formula 81A-1

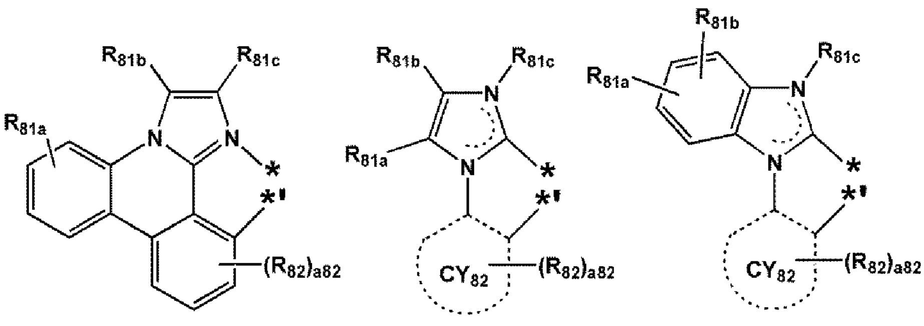

Formula 81A-2 Formula 81A-3 Formula 81A-4

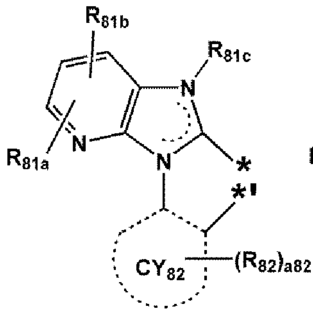
Formula 81A-5

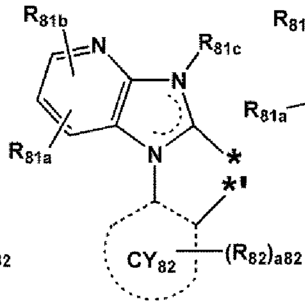
Formula 81A-6

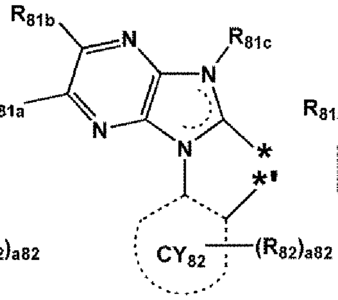
Formula 81A-7

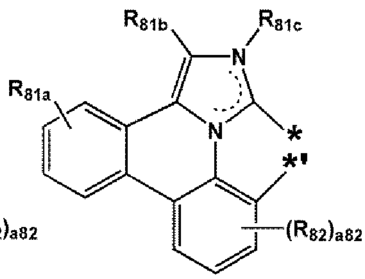
Formula 81A-8

wherein in Formulae 81A-1 to 81A-8,
$CY_{82}$, $R_{82}$, a82, *, and *' may be the same as those described herein, and $R_{81a}$, $R_{81b}$, and $R_{81c}$ may each be the same as described herein with reference to $R_{81}$.

In some embodiments, in Formulae 81A-1 to 81A-8, at least one of $R_{81a}$, $R_{81b}$, $R_{81c}$, and $R_{82}$ in the number of a82 may each be a cyano group, but embodiments are not limited thereto.

In one or more embodiments, in Formula 81, $L_{82}$ may be selected from ligands represented by Formulae 3-1(1) to 3-1(60), 3-1(61) to 3-1(69), 3-1(71) to 3-1(79), 3-1(81) to 3-1(88), 3-1(91) to 3-1(98), and 3-1(101) to 3-1(114):

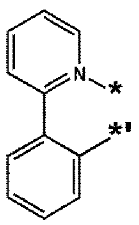
Formula 3-1(1)

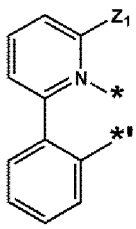
Formula 3-1(2)

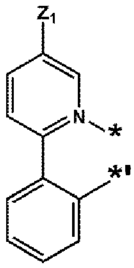
Formula 3-1(3)

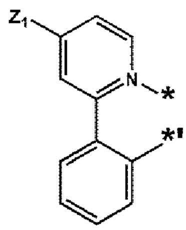
Formula 3-1(4)

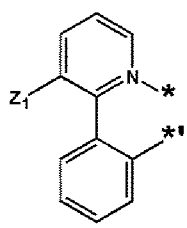
Formula 3-1(5)

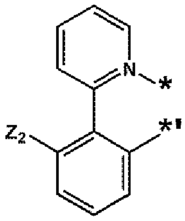
Formula 3-1(6)

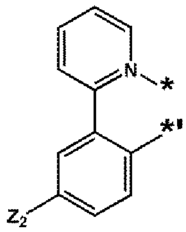
Formula 3-1(7)

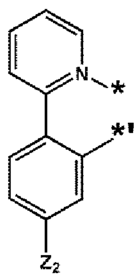
Formula 3-1(8)

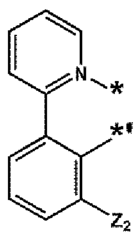
Formula 3-1(9)

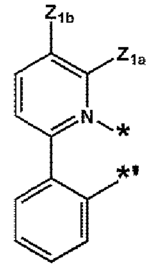
Formula 3-1(10)

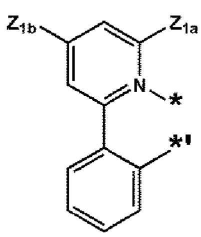
Formula 3-1(11)

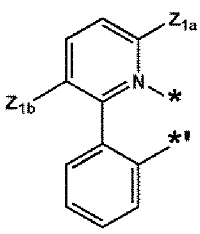
Formula 3-1(12)

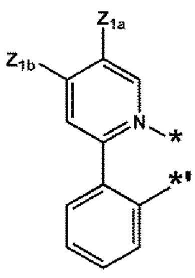
Formula 3-1(13)

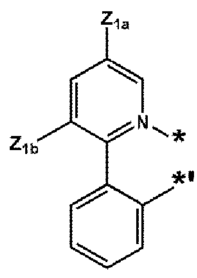
Formula 3-1(14)

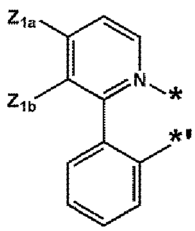
Formula 3-1(15)

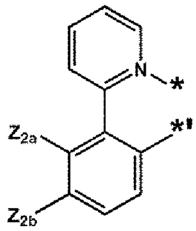
Formula 3-1(16)

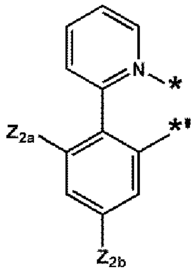
Formula 3-1(17)

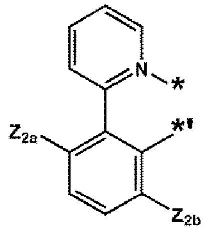
Formula 3-1(18)

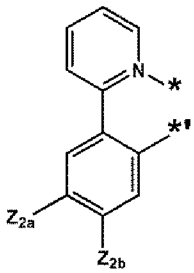
Formula 3-1(19)

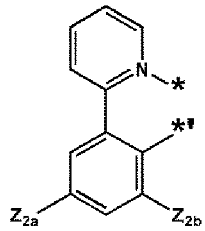
Formula 3-1(20)

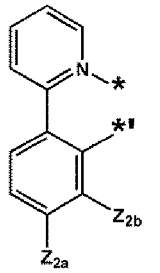
Formula 3-1(21)

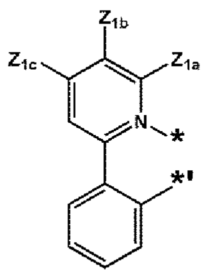
Formula 3-1(22)

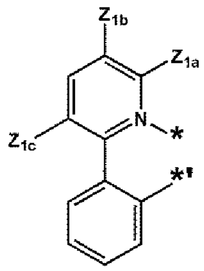
Formula 3-1(23)

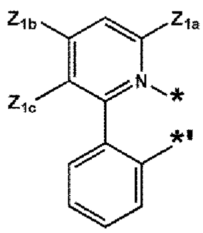
Formula 3-1(24)

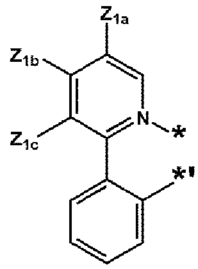
Formula 3-1(25)

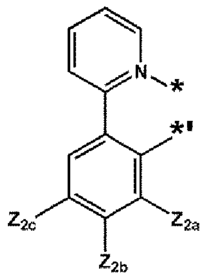
Formula 3-1(26)

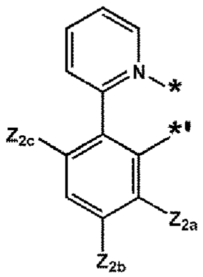
Formula 3-1(27)

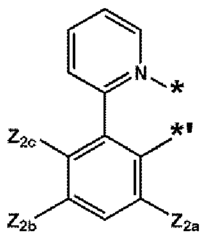
Formula 3-1(28)

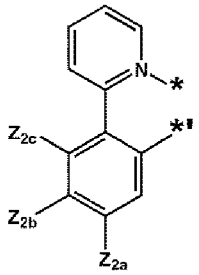
Formula 3-1(29)

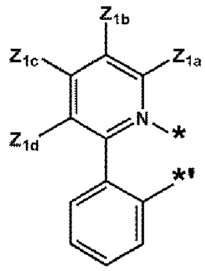
Formula 3-1(30)

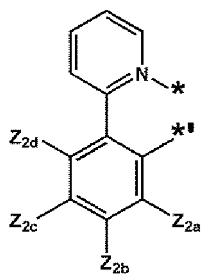
Formula 3-1(31)

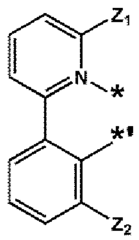
Formula 3-1(32)

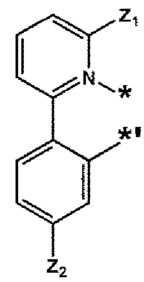
Formula 3-1(33)

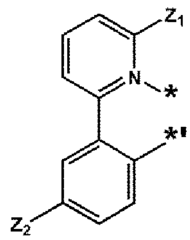
Formula 3-1(34)

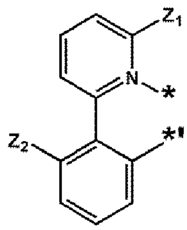
Formula 3-1(35)

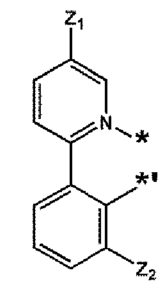
Formula 3-1(36)

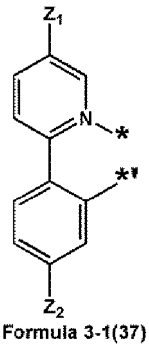
Formula 3-1(37)

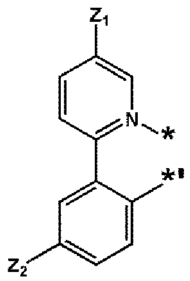
Formula 3-1(38)

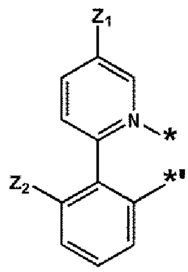
Formula3-1(39)

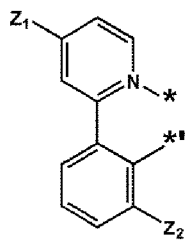
Formula 3-1(40)

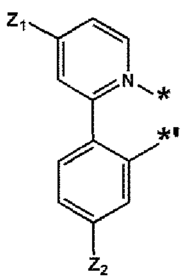
Formula 3-1(41)

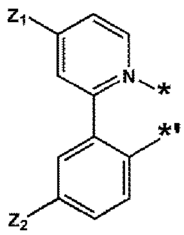
Formula 3-1(42)

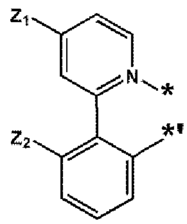
Formula 3-1(43)

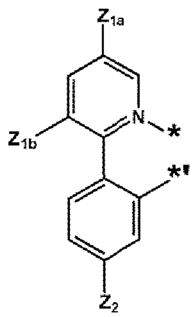
Formula 3-1(44)

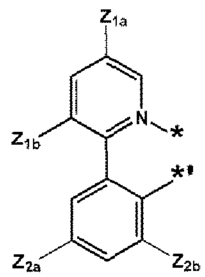
Formula 3-1(45)

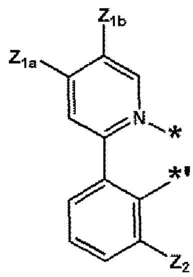
Formula 3-1(46)

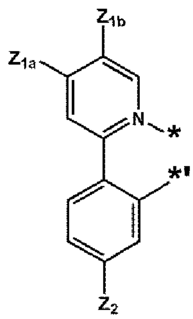
Formula 3-1(47)

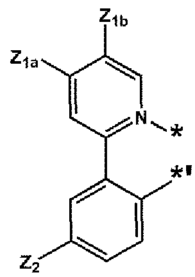
Formula 3-1(48)

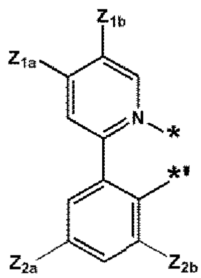
Formula 3-1(49)

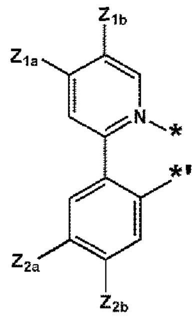
Formula 3-1(50)

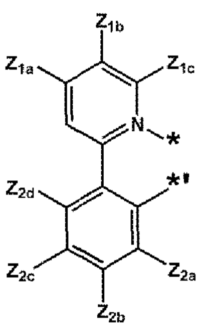
Formula 3-1(51)

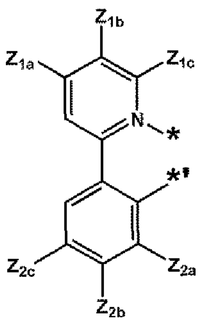
Formula 3-1(52)

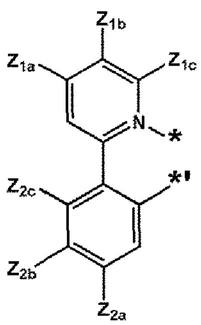
Formula 3-1(53)

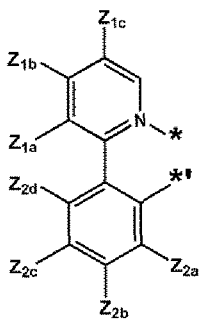
Formula 3-1(54)

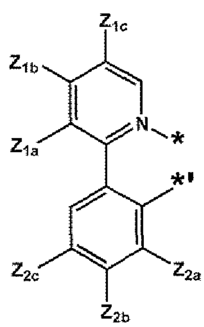
Formula 3-1(55)

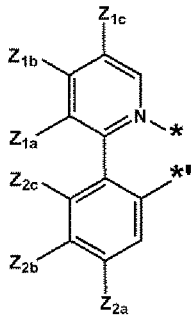

Formula 3-1(56)

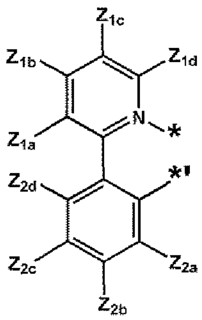

Formula 3-1(57)

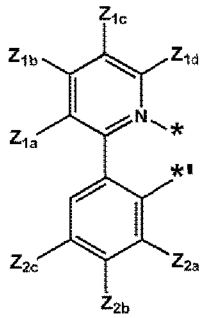

Formula 3-1(58)

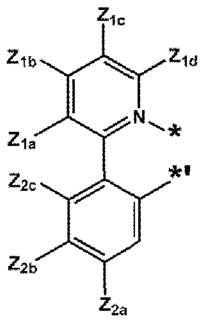

Formula 3-1(59)

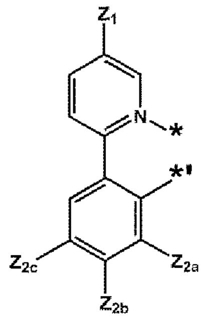

Formula 3-1(60)

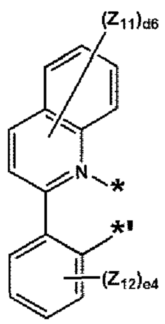

Formula 3-1(61)

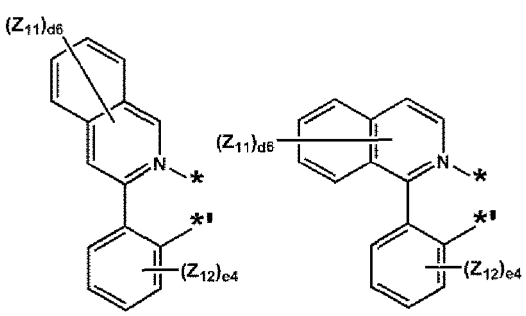

Formula 3-1(62)

Formula 3-1(63)

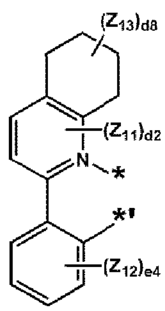

Formula 3-1(64)

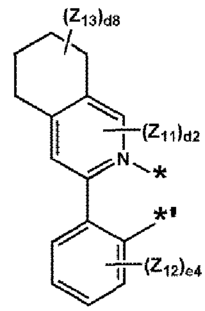

Formula 3-1(65)

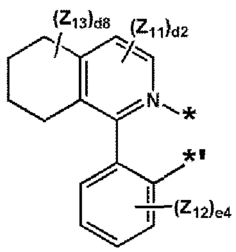

Formula 3-1(66)

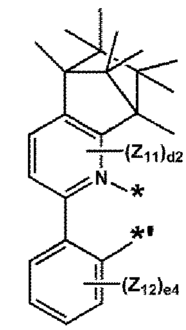

Formula 3-1(67)

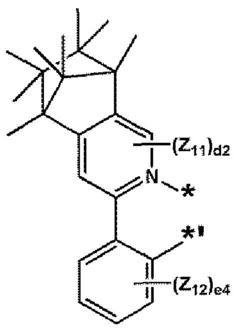

Formula 3-1(68)

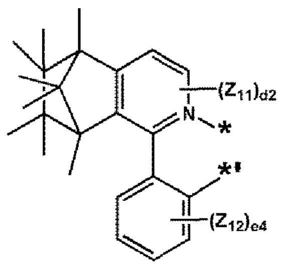

Formula 3-1(69)

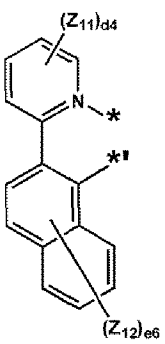

Formula 3-1(71)

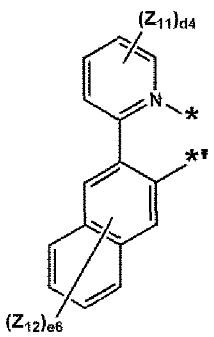

Formula 3-1(72)

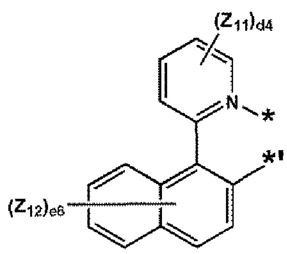

Formula 3-1(73)

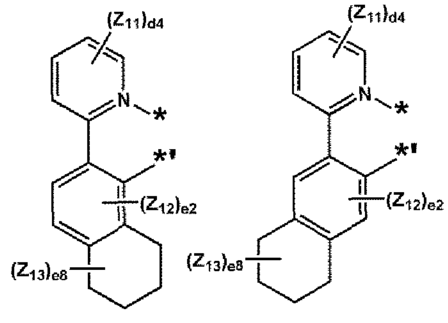

Formula 3-1(74)

Formula 3-1(75)

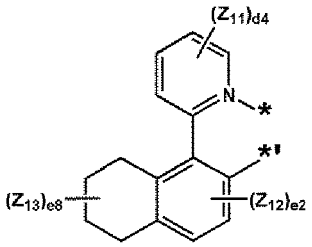
Formula 3-1(76)

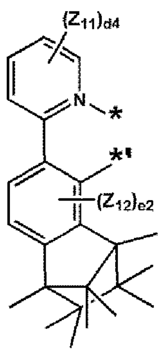
Formula 3-1(77)

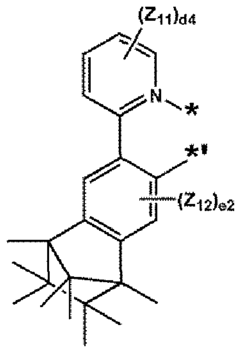
Formula 3-1(78)

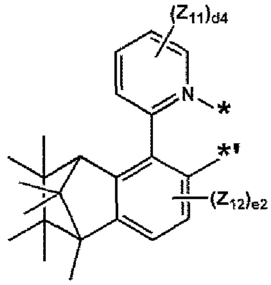
Formula 3-1(79)

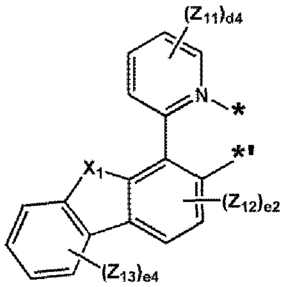
Formula 3-1(81)

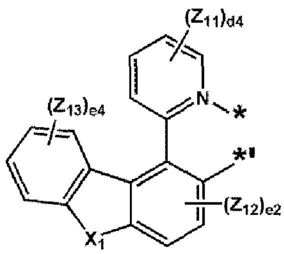
Formula 3-1(82)

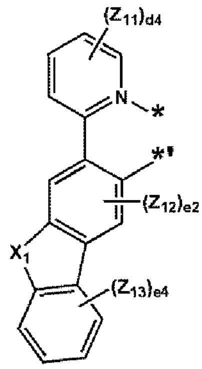
Formula 3-1(83)

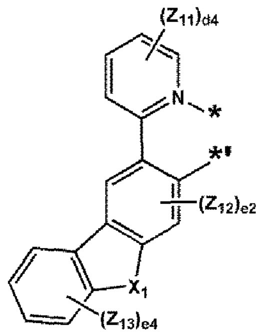
Formula 3-1(84)

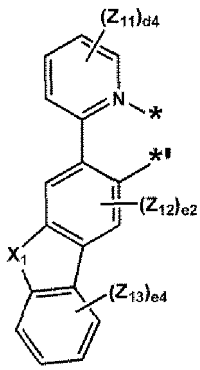
Formula 3-1(85)

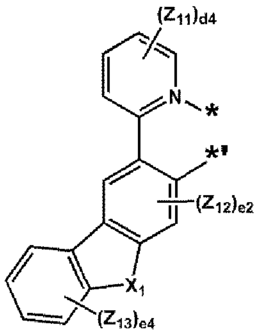
Formula 3-1(86)

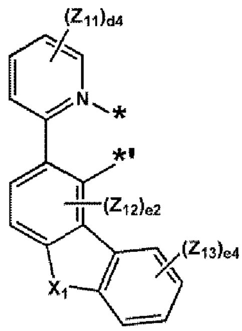
Formula 3-1(87)

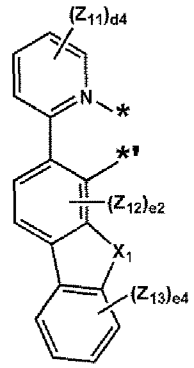
Formula 3-1(88)

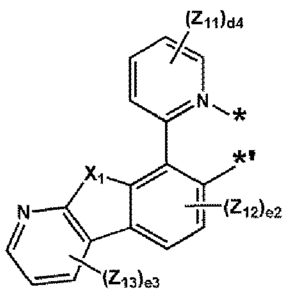
Formula 3-1(91)

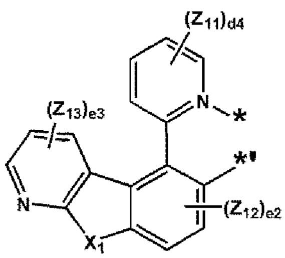
Formula 3-1(92)

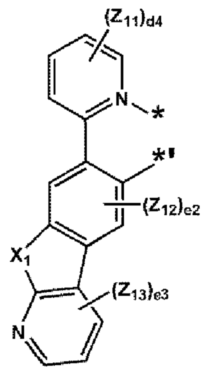
Formula 3-1(93)

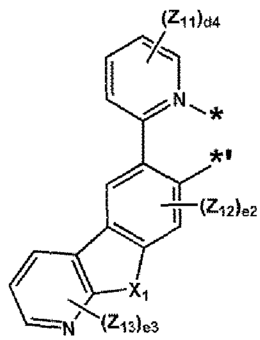
Formula 3-1(94)

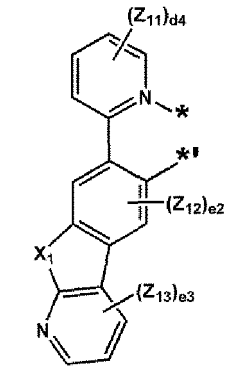

Formula 3-1(95)

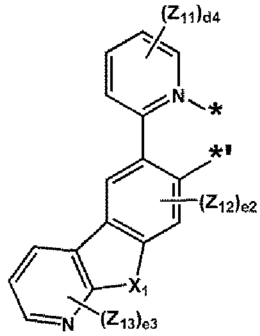

Formula 3-1(96)

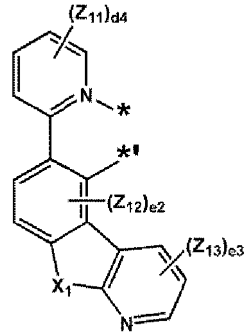

Formula 3-1(97)

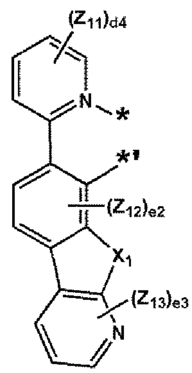

Formula 3-1(98)

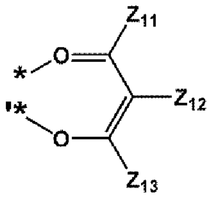

Formula 3-1(101)

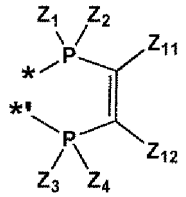

Formula 3-1(102)

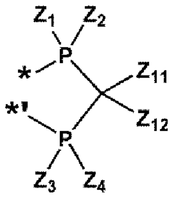

Formula 3-1(103)

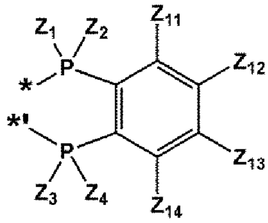

Formula 3-1(104)

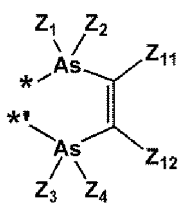

Formula 3-1(105)

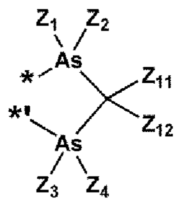

Formula 3-1(106)

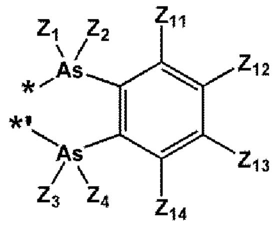

Formula 3-1(107)

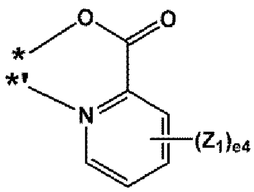

Formula 3-1(108)

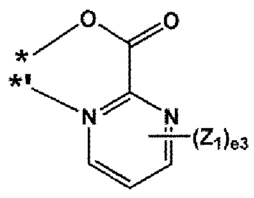

Formula 3-1(109)

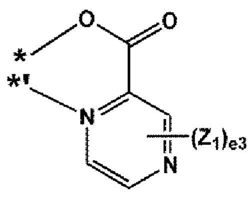

Formula 3-1(110)

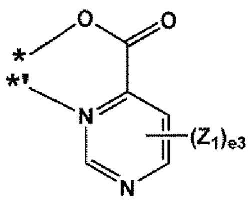

Formula 3-1(111)

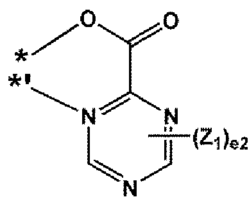

Formula 3-1(112)

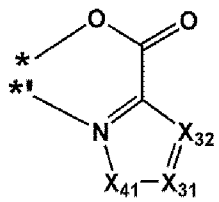

Formula 3-1(113)

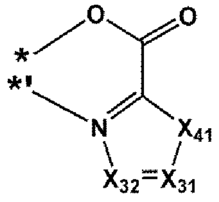

Formula 3-1(114)

wherein, in Formulae 3-1(1) to 3-1(60), 3-1(61) to 3-1(69), 3-1(71) to 3-1(79), 3-1(81) to 3-1(88), 3-1(91) to 3-1(98), and 3-1(101) to 3-1(114),

$X_1$ may be O, S, $C(Z_{21})(Z_{22})$, or $N(Z_{23})$,

$X_{31}$ may be N or $C(Z_{1a})$, $X_{32}$ may be N or $C(Z_{1b})$,

$X_{41}$ may be O, S, $N(Z_{1a})$, or $C(Z_{1a})(Z_{1b})$,

Z1 to Z4, $Z_{1a}$, $Z_{1b}$, $Z_{1c}$, $Z_{1d}$, $Z_{2a}$, $Z_{2b}$, $Z_{2c}$, $Z_{2d}$, $Z_{11}$ to $Z_{14}$, and $Z_{21}$ to $Z_{23}$ may each independently be selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, and a $C_1$-$C_{20}$ alkoxy group; a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and

-B(Q86)(Q87) and $-P(=O)(Q_{88})(Q_{89})$,

wherein $Q_{86}$ to $Q_{89}$ may each independently be selected from

$-CH_3$, $-CD_3$, $-CD_2H$, $-CDH_2$, $-CH_2CH_3$, $-CH_2CD_3$, $-CH_2CD_2H$, $-CH_2CDH_2$,$-CHDCH_3$, $-CHDCD_2H$, $-CHDCDH_2$, $-CHDCD_3$, $-CD_2CD_3$, $-CD_2CD_2H$, and$-CD_2CDH_2$;

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group; and

an n-propyl group, an iso-propyl group, an n-butyl group, an iso-butyl group, a sec-butyl group, a tert-butyl group,

an n-pentyl group, an iso-pentyl group, a sec-pentyl group, a tert-pentyl group, a phenyl group, and a naphthyl group, each substituted with at least one selected from deuterium, a $C_1$-$C_{10}$ alkyl group, and a phenyl group,
d2 and e2 may each independently be an integer selected from 0 to 4,
e3 may be an integer selected from 0 to 3,
d4 and e4 may each independently be an integer selected from 0 to 4,
d6 and e6 may each independently be an integer selected from 0 to 6,
d8 and e8 may each independently be an integer selected from 0 to 8, and
* and *' each indicate a binding site to M in Formula 1.

In one or more embodiments, in Formula 81, M may be Ir, and a sum of n81 and n82 may be 3. In one or more embodiments, in Formula 81, M may be Pt, and a sum of n81 and n82 may be 2.
In one or more embodiments, the organometallic compound represented by Formula 81 may be neutral, and may not include ion pairs of cations and anions.
In one or more embodiments, in Formula 81A,

$Y_{81}$ may be N,
$Y_{82}$ to $Y_{84}$ may each be N,
$CY_{81}$ may be an imidazole group, and
$CY_{82}$ may be a benzene group, but embodiments are not limited thereto.

In one or more embodiments, in Formulae 81 and 81A,

M may be Ir,
n81 may be 2 or 3,
a81 and a82 may each independently be an integer from 0 to 3,
a83 may be 0,
$R_{81}$ may be selected from
a $C_1$-$C_{10}$ alkyl group and a phenyl group; and
a $C_1$-$C_{10}$ alkyl group and a phenyl group, each substituted with at least one selected from deuterium and a $C_1$-$C_{10}$ alkyl group, and
at least one $R_{82}$ in the number of a82 may be a cyano group, but embodiments are not limited thereto.

In one or more embodiments, the dopant in the emission layer may include at least one selected from Compounds PD1 to PD83 and PD85 to PD116, but embodiments are not limited thereto:

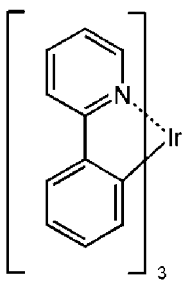

PD1

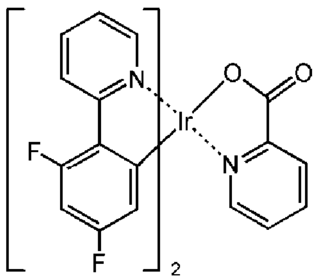

PD2

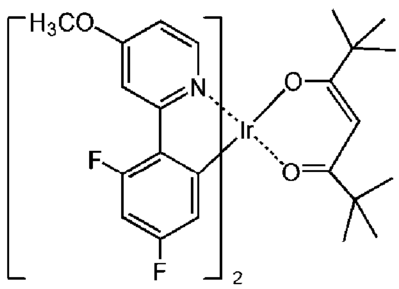

PD3

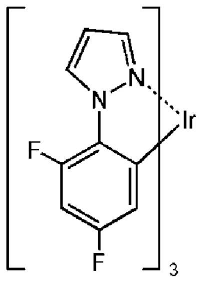

PD4

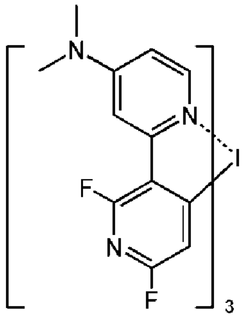

PD5

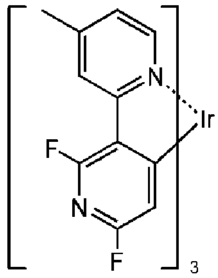

PD6

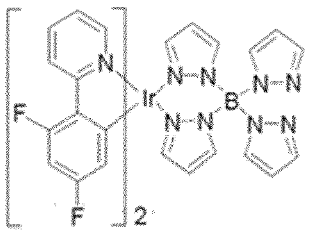

PD7

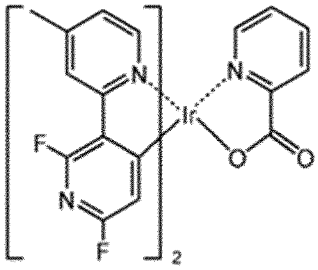

PD8

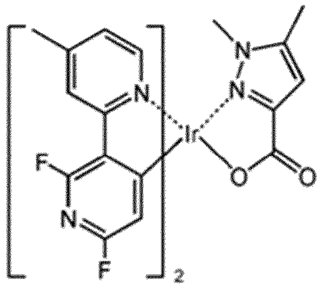

PD9

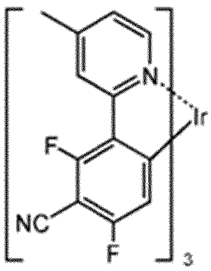

PD10

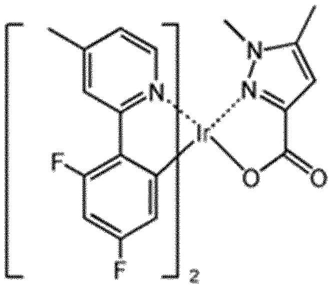

PD11

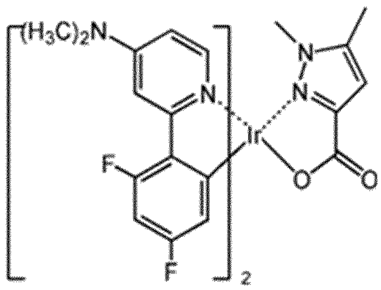

PD12

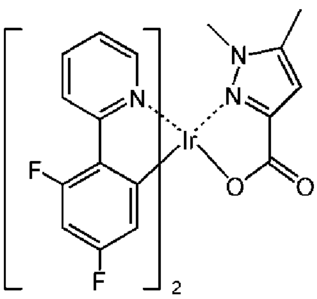

PD13

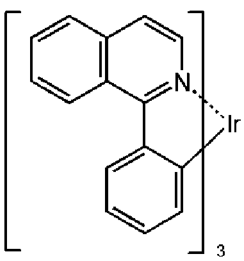

PD14

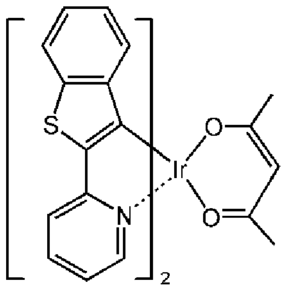

PD15

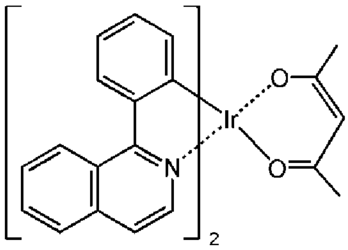

PD16

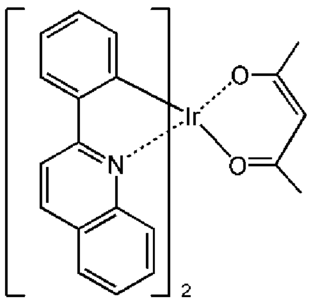

PD17

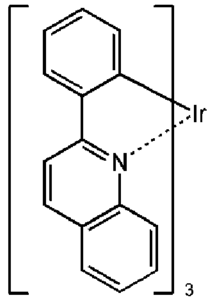

PD18

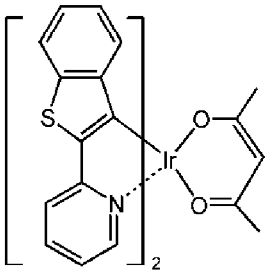

PD19

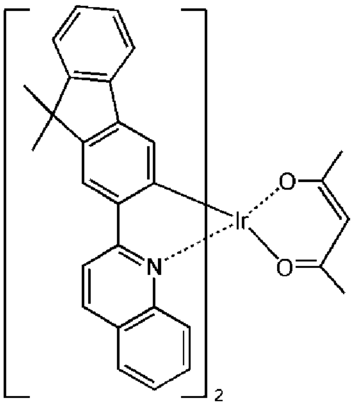

PD20

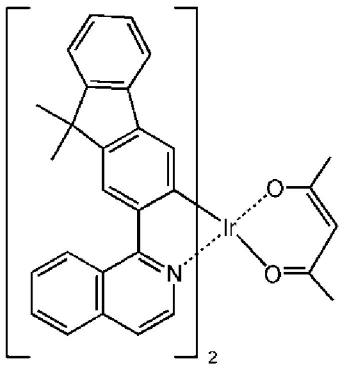

PD21

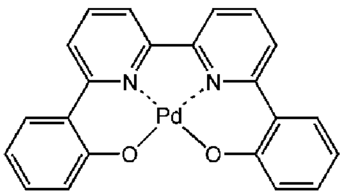

PD22

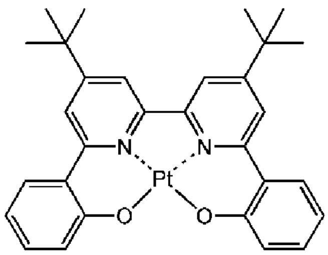

PD23

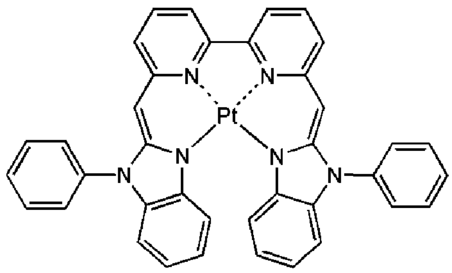

PD24

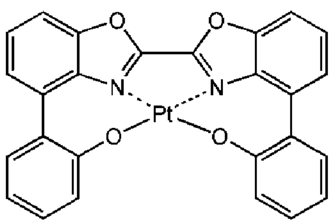

PD25

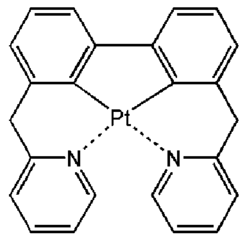

PD26

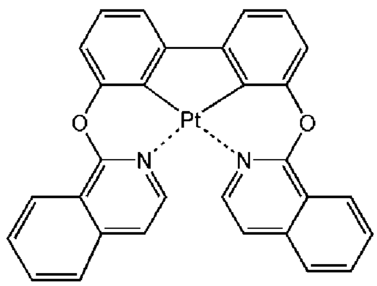

PD27

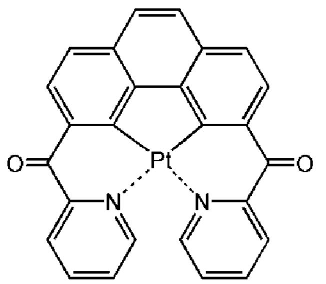

PD28

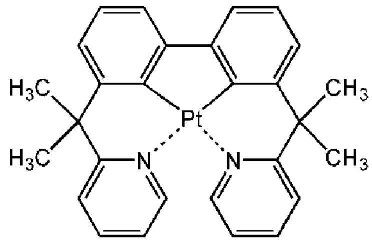

PD29

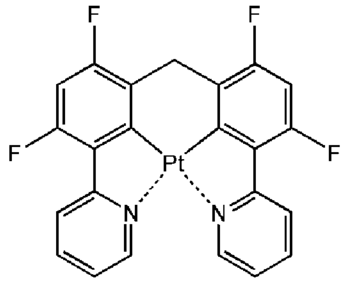

PD30

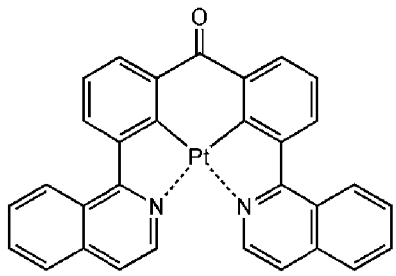

PD31

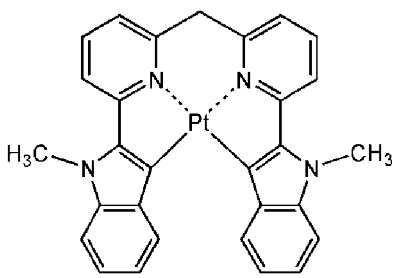

PD32

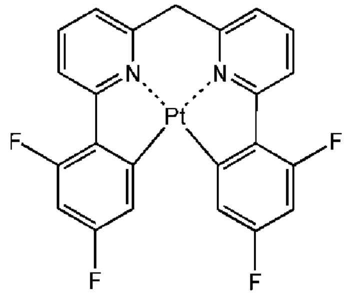

PD33

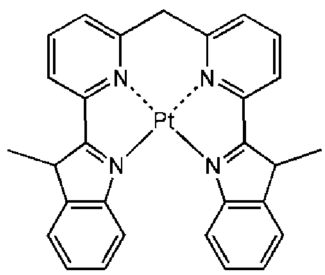

PD34

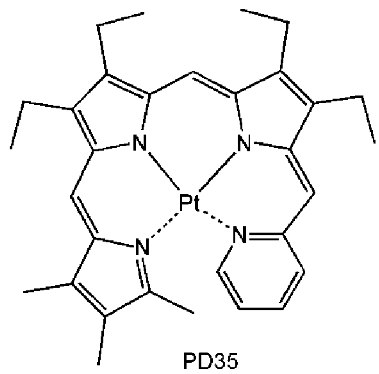

PD35

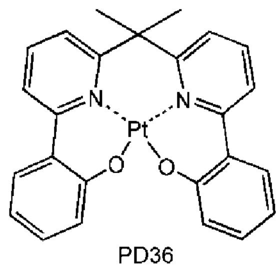

PD36

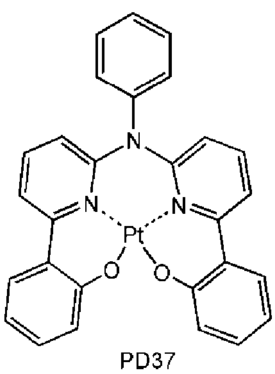

PD37

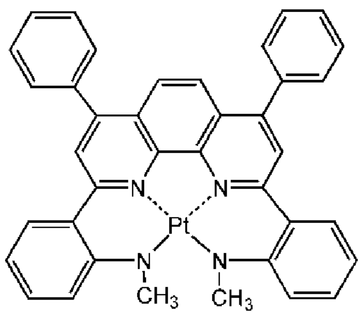

PD38

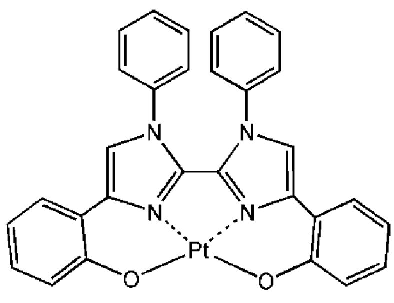

PD39

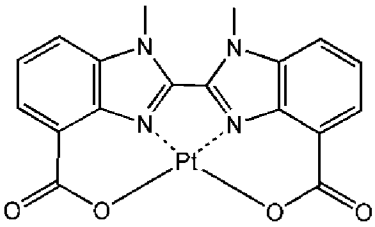

PD40

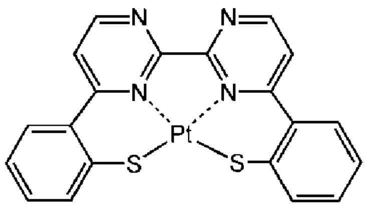

PD41

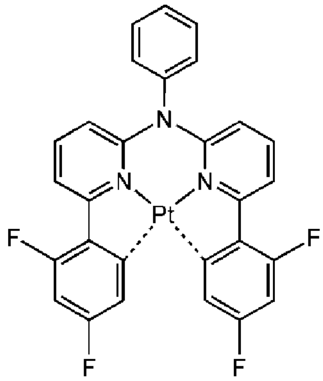

PD42

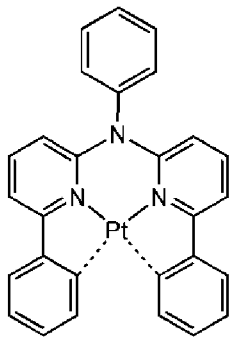

PD43

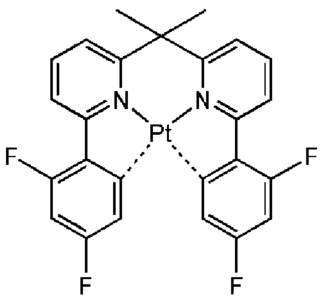

PD44

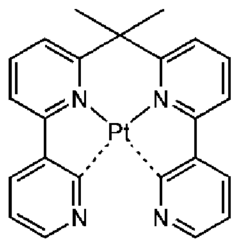

PD45

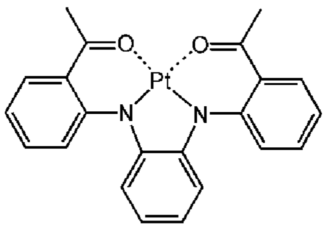

PD46

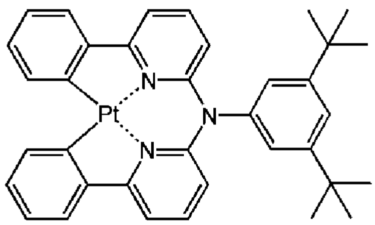

PD47

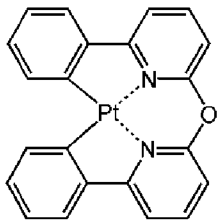

PD48

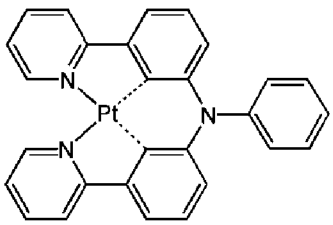

PD49

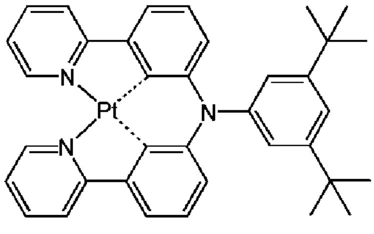

PD50

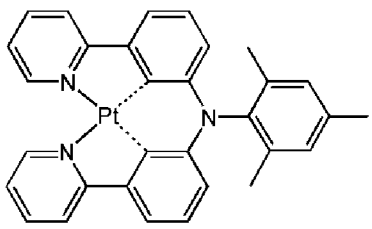

PD51

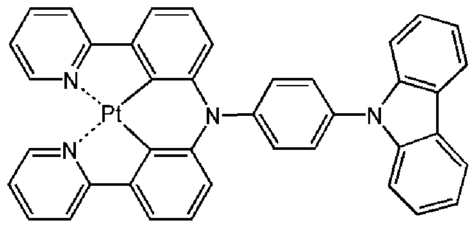

PD52

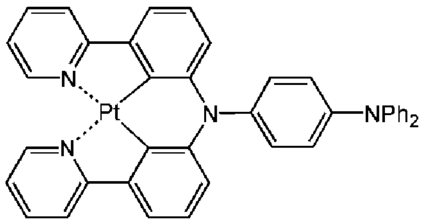

PD53

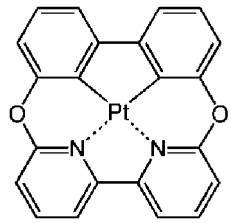

PD54

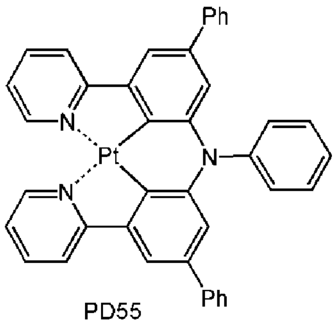

PD55

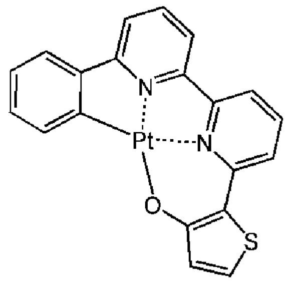

PD56

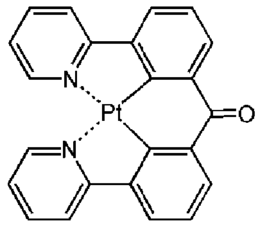

PD57

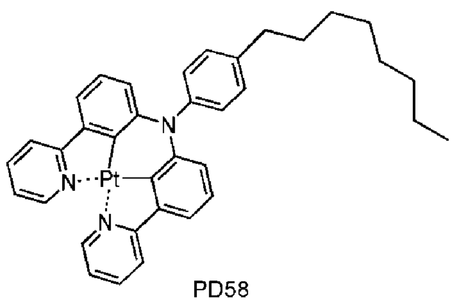

PD58

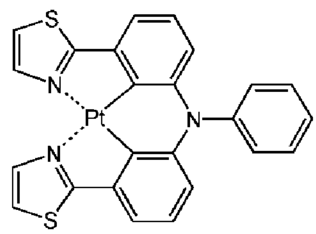

PD59

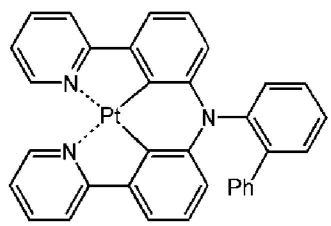

PD60

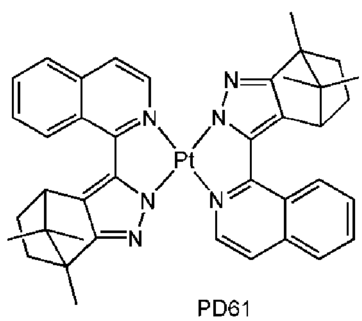

PD61

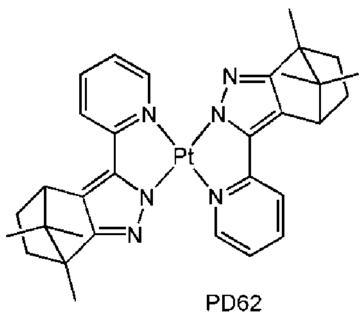

PD62

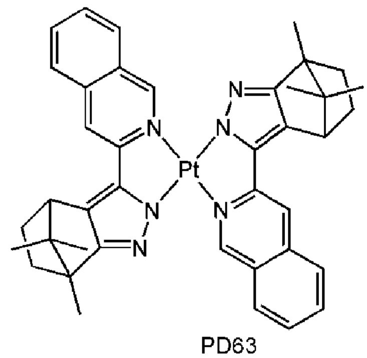

PD63

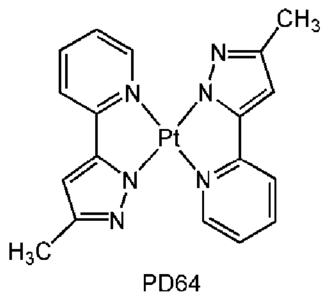

PD64

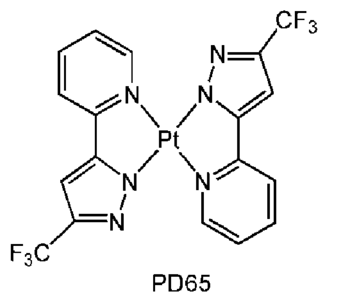

PD65

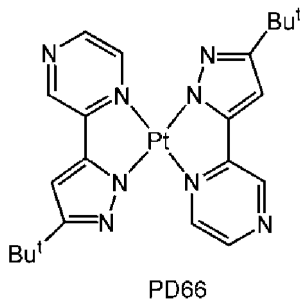

PD66

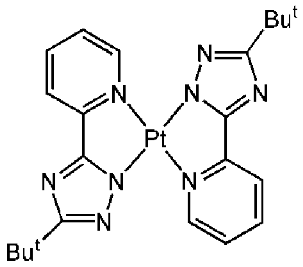
PD67

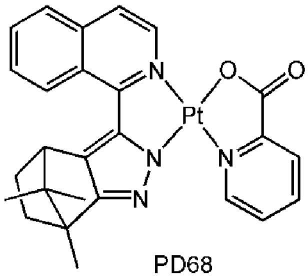
PD68

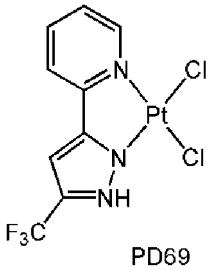
PD69

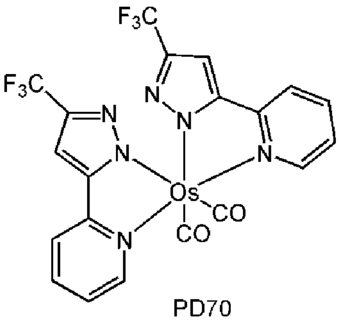
PD70

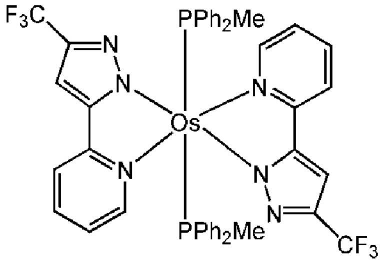
PD71

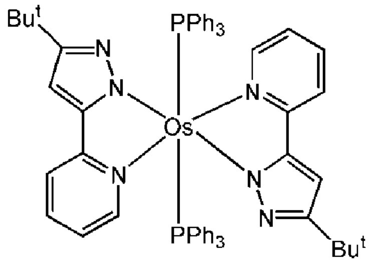
PD72

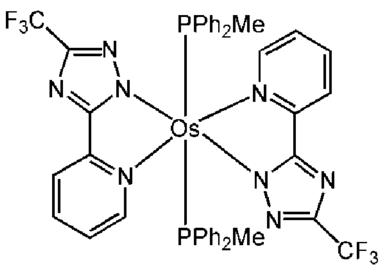
PD73

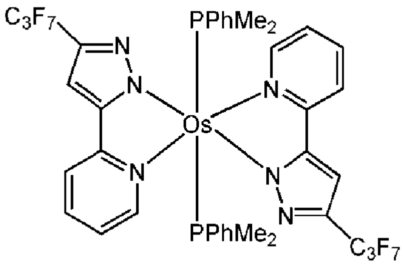
PD74

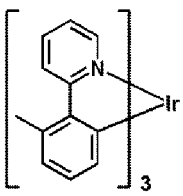
**PD75**

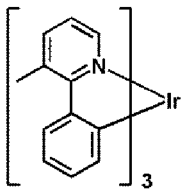
**PD76**

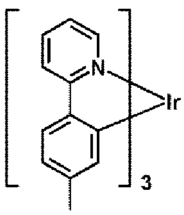
**PD77**

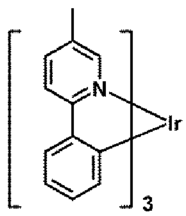
**PD78**

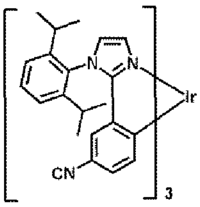
PD79

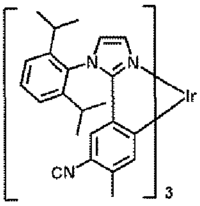
PD80

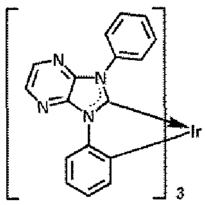
PD81

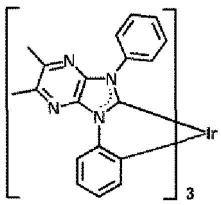
PD82

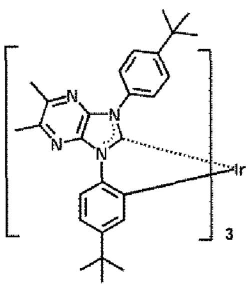
PD83

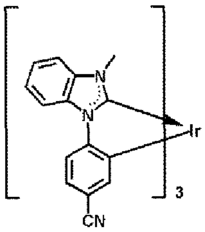
PD85

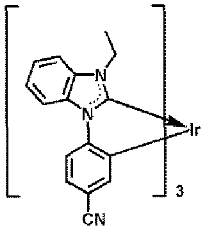
PD86

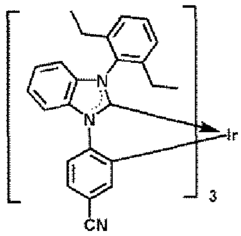
PD87

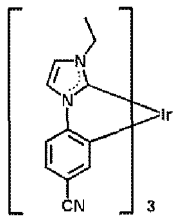
PD88

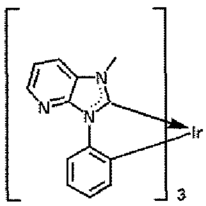
PD89

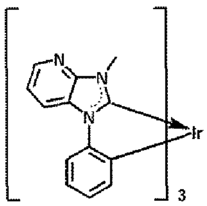
PD90

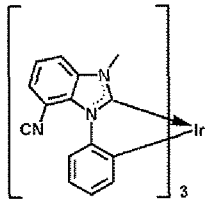
PD91

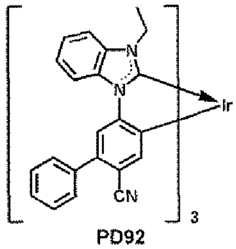
PD92

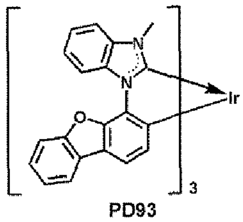
PD93

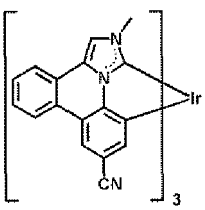
PD94

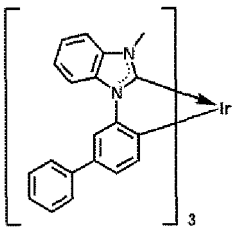
PD95

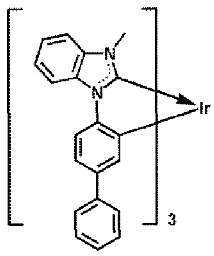
PD96

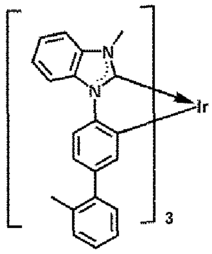
PD97

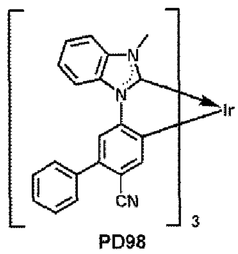
PD98

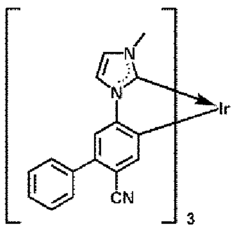
PD99

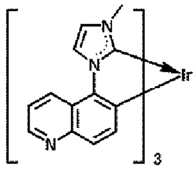
PD100

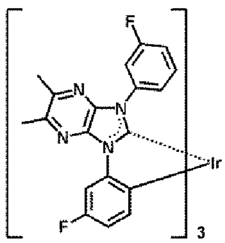
PD101

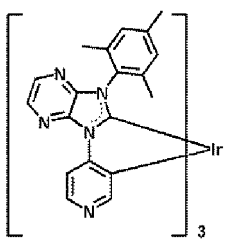
PD102

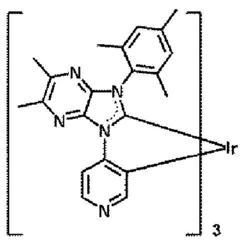
PD103

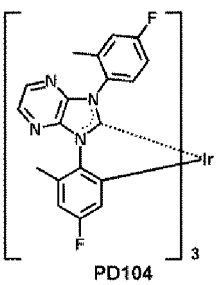
PD104

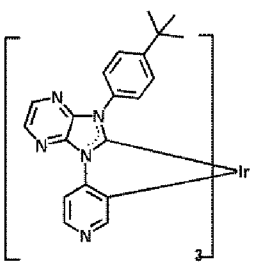
PD105

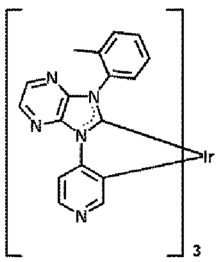
PD106

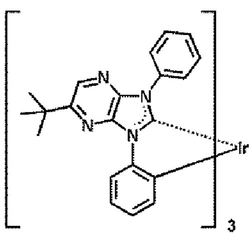
PD107

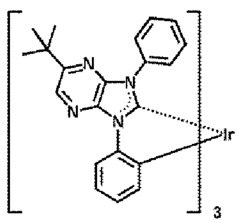
PD108

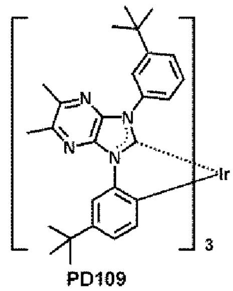
PD109

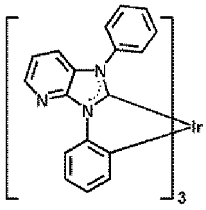
PD110

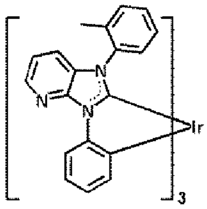
PD111

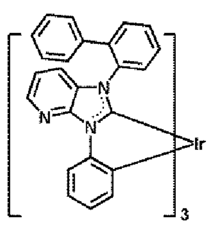
PD112

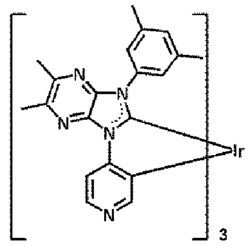
PD113

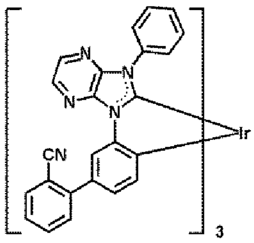
PD114

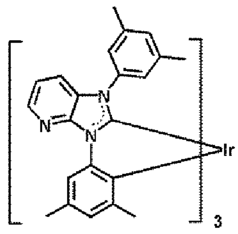
PD115

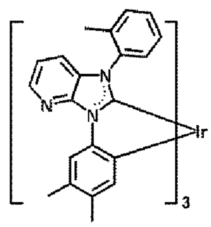
PD116

The amount of the dopant in the emission layer may be, in general, in a range of about 0.01 parts to about 20 parts by weight based on 100 parts by weight of the emission layer, but embodiments are not limited thereto. While not wishing to be bound by theory, it is understood that when the amount of the dopant is within this range, light emission without quenching may be realized.

The FIGURE illustrates a schematic view of an organic light-emitting device 10 according to an embodiment. Hereinafter, a structure of an organic light-emitting device according to one or more embodiments and a method of manufacturing the organic light-emitting device will be described with reference to the FIGURE. The organic light-emitting device 10 includes a first electrode 11, an organic layer 15, and a second electrode 19, which may be sequentially layered in this stated order.

A substrate may be additionally disposed under the first electrode 11 or on the second electrode 19. The substrate may be a conventional substrate used in organic light-emitting devices, *e.g.,* a glass substrate or a transparent plastic substrate, each having excellent mechanical strength, thermal stability, transparency, surface smoothness, ease of handling, and water repellency.

The first electrode 11 may be formed by vacuum-depositing or sputtering, onto the substrate, a material for forming the first electrode 11. The first electrode 11 may be an anode. The material for forming the first electrode 11 may be selected from materials with a high work function for easy hole injection. The first electrode 11 may be a reflective electrode, a semi-transmissive electrode, or a transmissive electrode. The material for forming the first electrode 11 may be selected from indium tin oxide (ITO), indium zinc oxide (IZO), tin oxide ($SnO_2$), and zinc oxide (ZnO). In some embodiments, the material for forming the first electrode 11 may be a metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. In some embodiments, the first electrode 11 may have a triple-layered structure of ITO/Ag/ITO, but embodiments are not limited thereto.

The organic layer 15 may be on the first electrode 11.

The organic layer 15 may include a hole transport region, an emission layer, and an electron transport region.

The hole transport region may be disposed between the first electrode 11 and the emission layer.

The hole transport region may include at least one selected from a hole injection layer, a hole transport layer, an electron blocking layer, and a buffer layer.

The hole transport region may include a hole injection layer only or a hole transport layer only. In some embodiments, the hole transport region may include a hole injection layer and a hole transport layer which are sequentially stacked on the first electrode 11. In some embodiments, the hole transport region may include a hole injection layer, a hole transport layer, and an electron blocking layer, which are sequentially stacked on the first electrode 11.

When the hole transport region includes a hole injection layer, the hole injection layer may be formed on the first electrode 11 by using one or more suitable methods, such as vacuum deposition, spin coating, casting, and Langmuir-Blodgett (LB) deposition.

When a hole injection layer is formed by vacuum deposition, for example, the vacuum deposition may be

performed at a deposition temperature in a range of about 100°C to about 500°C, at a vacuum pressure in a range of about $10^{-8}$ torr to about $10^{-3}$ torr, and at a deposition rate in a range of about 0.01 Angstroms per second (Å/sec) to about 100 Å/sec, though the conditions may vary depending on a compound that is used as a hole injection material and a structure and thermal properties of a desired hole injection layer, but conditions for the vacuum deposition are not limited thereto.

When a hole injection layer is formed by spin coating, the spin coating may be performed at a coating rate in a range of about 2,000 revolutions per minute (rpm) to about 5,000 rpm, and at a temperature in a range of about 80°C to 200°C, to facilitate removal of a solvent after the spin coating, though the conditions may vary depending on a compound that is used as a hole injection material and a structure and thermal properties of a desired hole injection layer, but conditions for the spin coating are not limited thereto.

The conditions for forming a hole transport layer and an electron blocking layer may be inferred from the conditions for forming the hole injection layer.

The hole transport region may include at least one selected from m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylenedioxythiophene)/poly(4-styrene sulfonate) (PEDOT/PSS), polyaniline/camphor sulfonic acid (PANI/CSA), (polyaniline)/poly(4-styrene sulfonate) (PANI/PSS), a compound represented by Formula 201, and a compound represented by Formula 202:

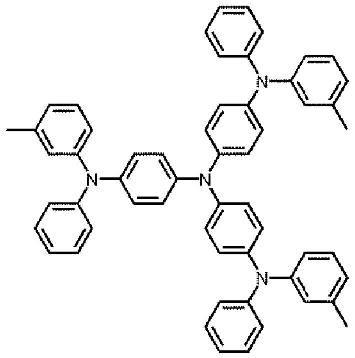

m-MTDATA

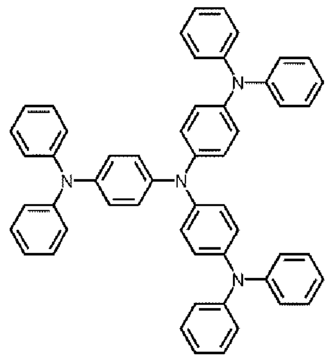

TDATA

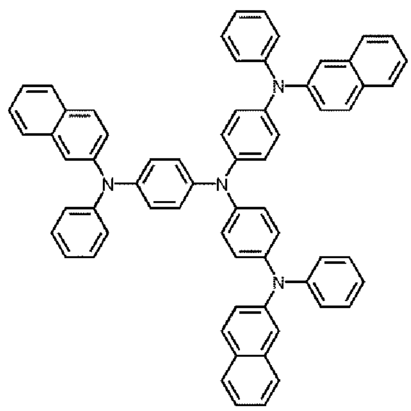

2-TNATA

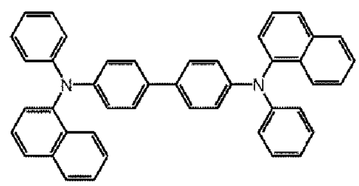

NPB

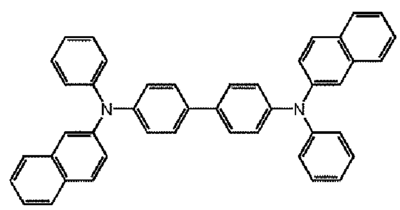

β-NPB

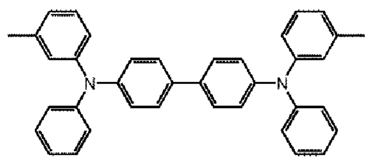

TPD

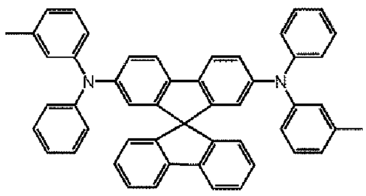

Spiro-TPD

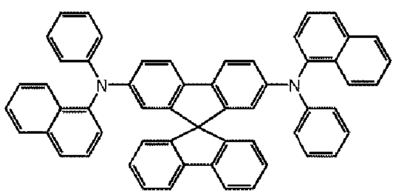

Spiro-NPB

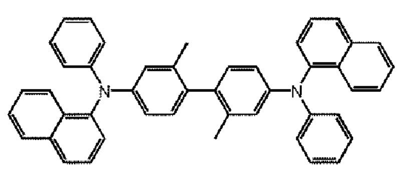

methylated NPB

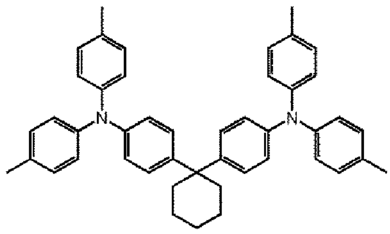

TAPC

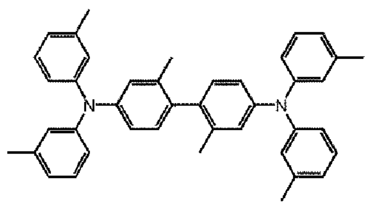

HMTPD

Formula 201

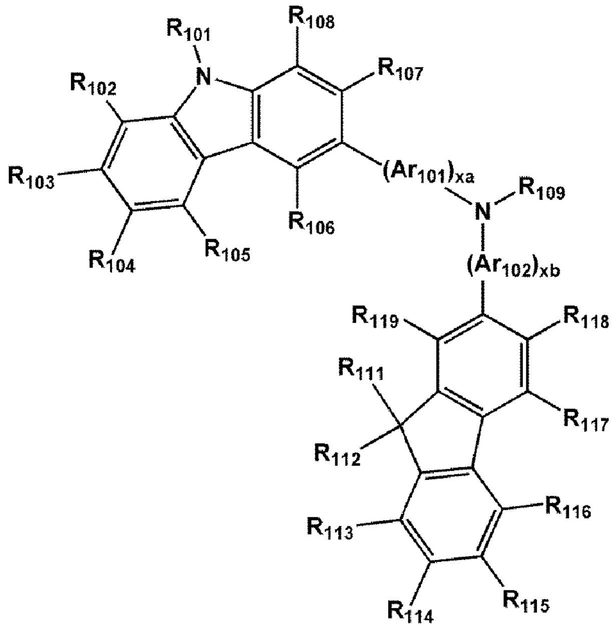

Formula 202

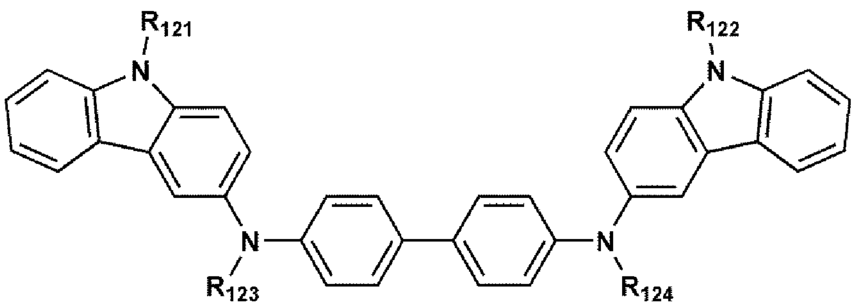

wherein, in Formula 201, $Ar_{101}$ and $Ar_{102}$ may each independently be selected from

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group,

each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group.

In Formula 201, xa and xb may each independently be an integer from 0 to 5. In some embodiments, xa and xb may each independently be an integer of 0, 1, or 2. In some embodiments, xa may be 1, and xb may be 0, but embodiments are not limited thereto.

In Formulae 201 and 202, $R_{101}$ to $R_{108}$, $R_{111}$ to $R_{119}$, and $R_{121}$ to $R_{124}$ may each independently be selected from

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (e.g., a methyl group, an ethyl group, a propyl group, a butyl group, pentyl group, or a hexyl group), and a $C_1$-$C_{10}$ alkoxy group (e.g., a methoxy group, an ethoxy group, a propoxy group, a butoxy group, or a pentoxy group);

a $C_1$-$C_{10}$ alkyl group and a $C_1$-$C_{10}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;

a phenyl group, a naphthyl group, an anthracenyl group, a fluorenyl group, and a pyrenyl group; and

a phenyl group, a naphthyl group, an anthracenyl group, a fluorenyl group, and a pyrenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, and a $C_1$-$C_{10}$ alkoxy group, but embodiments are not limited thereto.

In Formula 201, $R_{109}$ may be selected from

a phenyl group, a naphthyl group, an anthracenyl group, and a pyridinyl group; and

a phenyl group, a naphthyl group, an anthracenyl group, and a pyridinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, and a pyridinyl group.

In some embodiments, the compound represented by Formula 201 may be represented by Formula 201A, but embodiments are not limited thereto:

Formula 201A

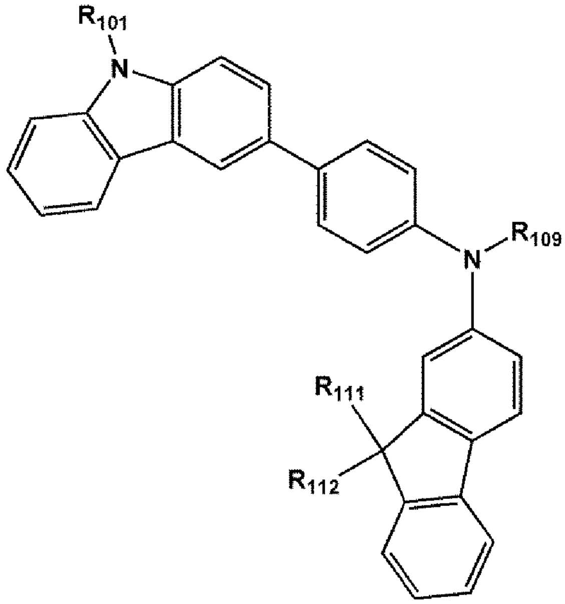

wherein, $R_{101}$, $R_{111}$, $R_{112}$, and $R_{109}$ in Formula 201A may be the same as those described above.

In some embodiments, the compounds represented by Formulae 201 and 202 may include Compounds HT1 to HT20, but embodiments are not limited thereto:

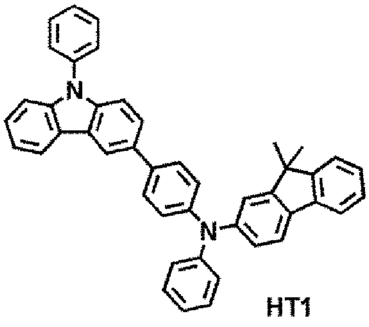

HT1

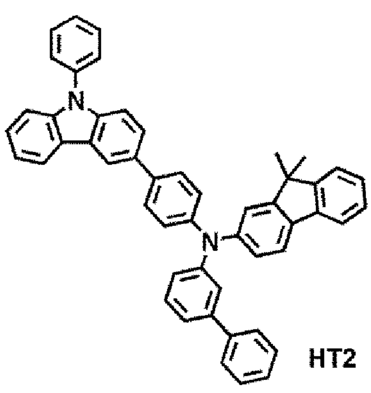

HT2

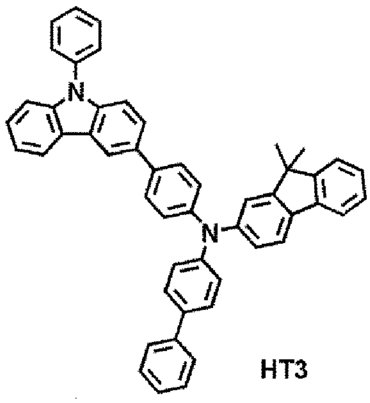

HT3

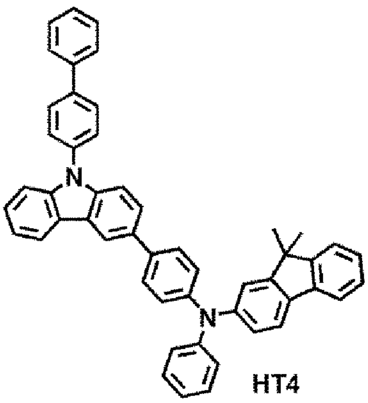

HT4

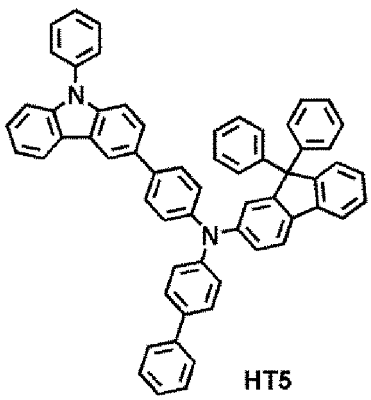

HT5

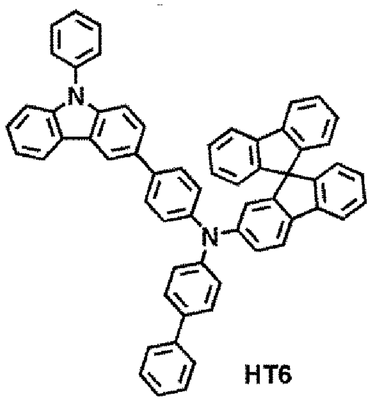

HT6

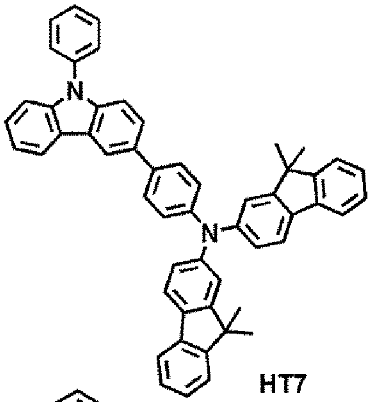
HT7

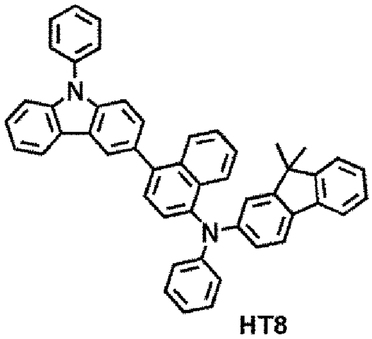
HT8

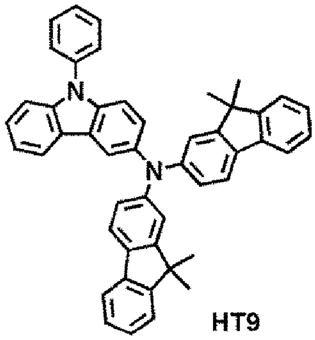
HT9

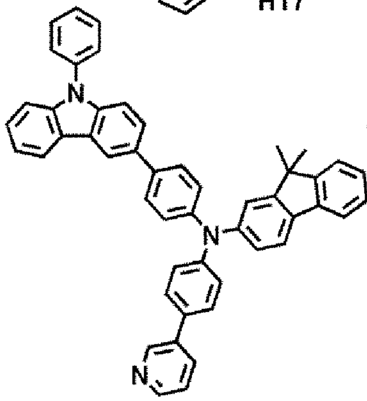
HT10

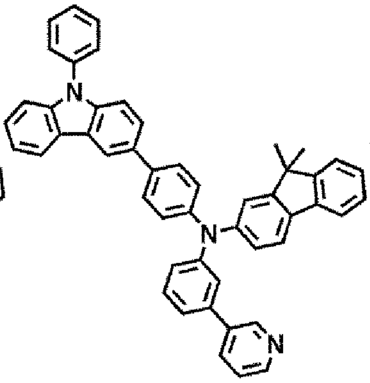
HT11

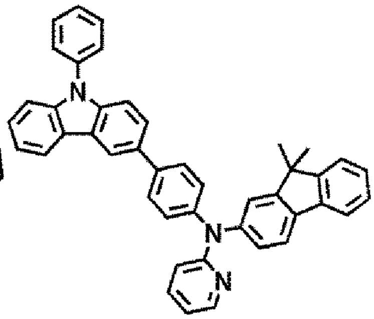
HT12

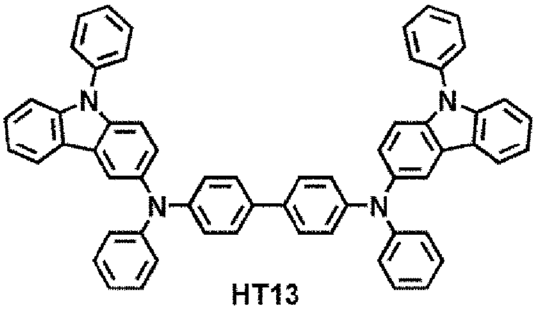
HT13

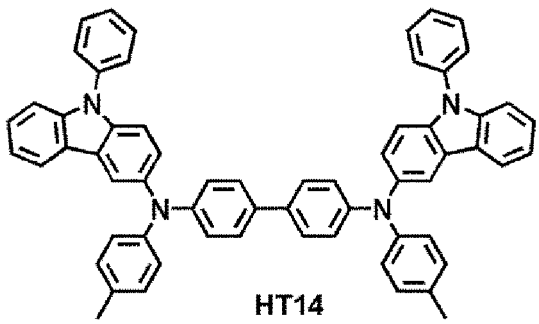
HT14

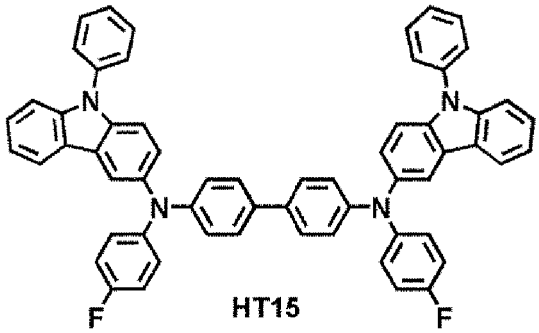
HT15

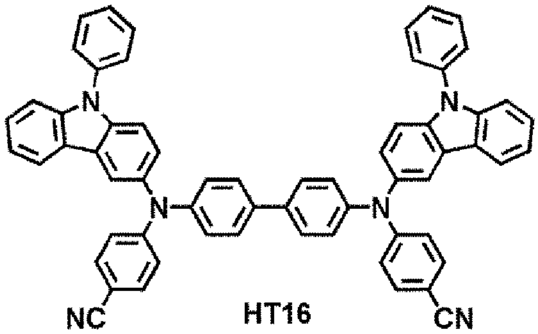
HT16

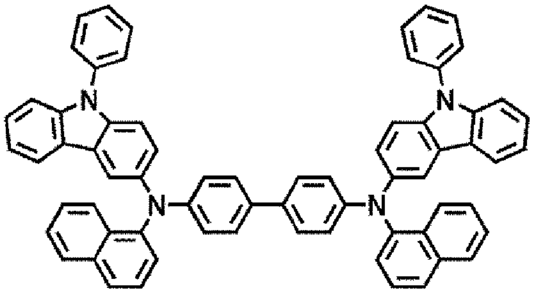

HT17

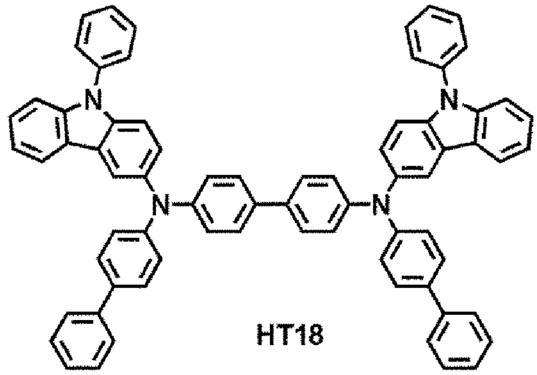

HT18

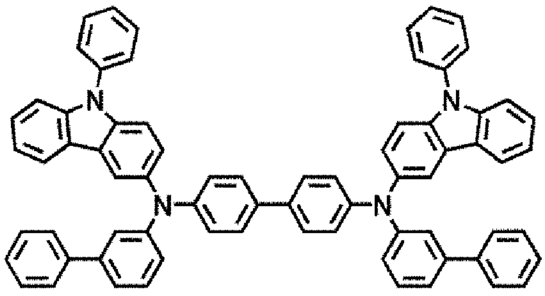

HT19

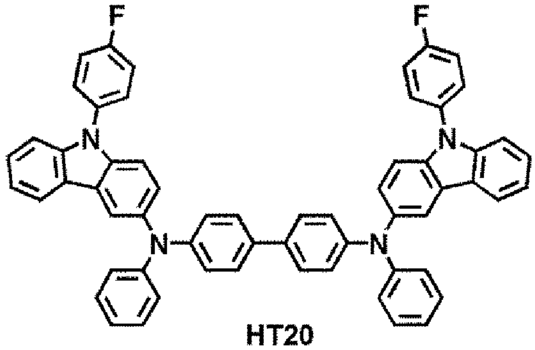

HT20

.

The thickness of the hole transport region may be in a range of about 100 Angstroms (Å) to about 10,000 Å, and in some embodiments, about 100 Å to about 1,000 Å. When the hole transport region includes at least one selected from a hole injection layer and a hole transport layer, the thickness of the hole injection layer may be in a range of about 100 Å to about 10,000 Å, and in some embodiments, about 100 Å to about 1,000 Å, and the thickness of the hole transport layer may be in a range of about 50 Å to about 2,000 Å, and in some embodiments, about 100 Å to about 1,500 Å. While not wishing to be bound by theory, it is understood that when the thicknesses of the hole transport region, the hole injection layer, and the hole transport layer are within any of these ranges, excellent hole transport characteristics may be obtained without a substantial increase in driving voltage.

The hole transport region may include a charge generating material as well as the aforementioned materials, to improve conductive properties of the hole transport region. The charge generating material may be substantially homogeneously or non-homogeneously dispersed in the hole transport region.

The charge generating material may include, for example, a p-dopant. The p-dopant may include one of a quinone derivative, a metal oxide, and a compound containing a cyano group, but embodiments are not limited thereto. For example, non-limiting examples of the p-dopant include a quinone derivative, such as tetracyanoquinodimethane (TCNQ) or 2,3,5,6-tetrafluoro-tetracyano-1,4-benzoquinonedimethane (F4-TCNQ); a metal oxide, such as a tungsten oxide or a molybdenum oxide; and a compound containing a cyano group, such as Compound HT-D1 or Compound HP-1, but embodiments are not limited thereto:

Compound HT-D1

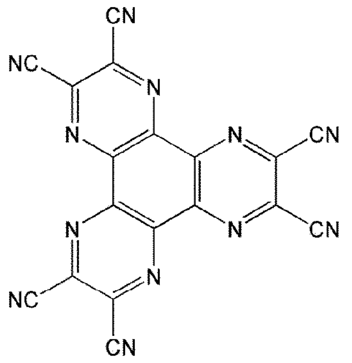

F4-TCNQ

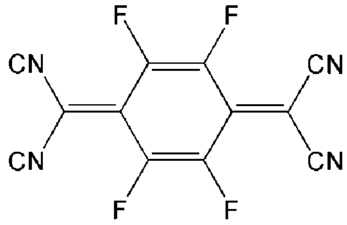

HP-1

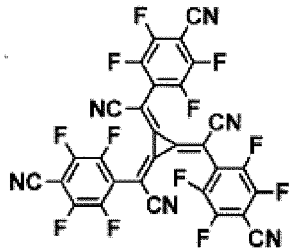

The hole transport region may further include a buffer layer.

The buffer layer may compensate for an optical resonance distance depending on a wavelength of light emitted from the emission layer, to improve the efficiency of an organic light-emitting device.

The hole transport region may further include an electron blocking layer. The electron blocking layer may include any suitable known material, e.g., mCP, but embodiments are not limited thereto:

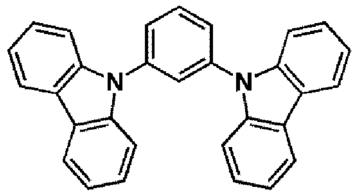

mCP

In some embodiments, a donor compound included in the emission layer may be used as a material for forming the electron blocking layer.

An emission layer may be formed on the hole transport region by using one or more suitable methods, such as vacuum deposition, spin coating, casting, or LB deposition. When the emission layer is formed by vacuum deposition or spin coating, vacuum deposition and coating conditions for forming the emission layer may be generally similar to the those conditions for forming a hole injection layer, though the conditions may vary depending on a compound that is used.

When the organic light-emitting device 10 is a full-color organic light-emitting device, the emission layer may be patterned into a red emission layer, a green emission layer, and a blue emission layer. In some embodiments, the emission layer may have a structure in which the red emission layer, the green emission layer, and/or the blue emission layer are layered to emit white light. In some embodiments, the structure of the emission layer may vary.

The emission layer includes a host and a dopant which satisfies the above-described conditions.

The thickness of the emission layer may be in a range of about 100 Å to about 1,000 Å, and in some embodiments, about 200 Å to about 600 Å. While not wishing to be bound by theory, it is understood that when the thickness of the emission layer is within any of these ranges, improved luminous characteristics may be obtained without a substantial increase in driving voltage.

Next, an electron transport region may be formed on the emission layer.

The electron transport region may include at least one selected from a hole blocking layer, an electron transport layer, and an electron injection layer.

In some embodiments, the electron transport region may have a hole blocking layer/an electron transport layer/an electron injection layer structure or an electron transport layer/an electron injection layer structure, but embodiments are not limited thereto. The electron transport layer may have a single-layered structure or a multi-layered structure including two or more different materials.

The conditions for forming a hole blocking layer, an electron transport layer, and an electron injection layer may be inferred based on the conditions for forming the hole injection layer.

When the electron transport region includes a hole blocking layer, the hole blocking layer, for example, may include at least one of BCP and Bphen, but embodiments are not limited thereto:

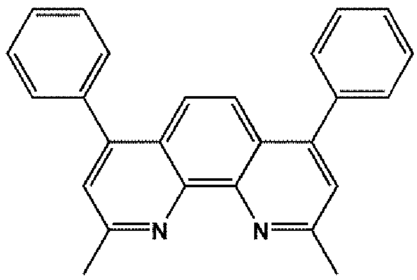
BCP

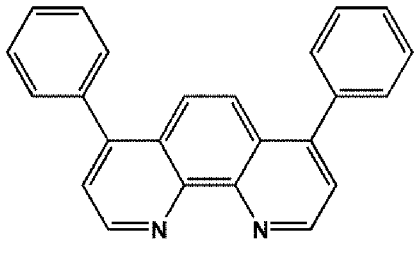
Bphen .

In some embodiments, the acceptor compound used in the emission layer may be used as a material for forming the hole blocking layer.

The thickness of the hole blocking layer may be in a range of about 20 Å to about 1,000 Å, and in some embodiments, about 30 Å to about 300 Å. While not wishing to be bound by theory, it is understood that when the thickness of the hole blocking layer is within these ranges, excellent hole blocking characteristics may be obtained without a substantial increase in driving voltage.

The electron transport layer may further include at least one selected from BCP, BPhen, $Alq_3$, BAlq, TAZ, and NTAZ:

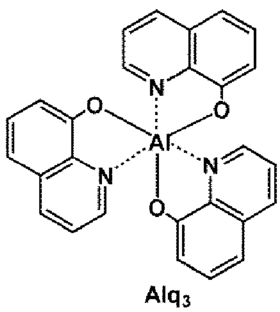
$Alq_3$

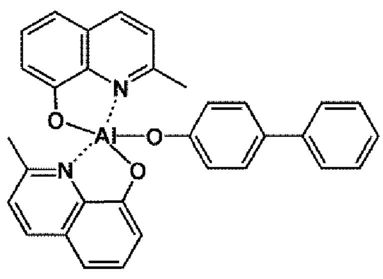
BAlq

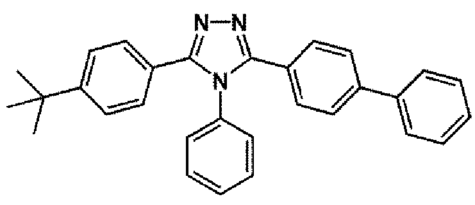
TAZ

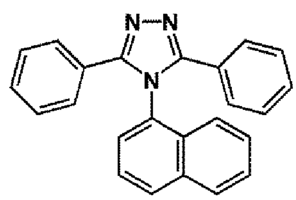
NTAZ .

In some embodiments, an electron transport material in the electron transport layer may include a compound represented by Formula 40 or a compound represented by Formula 41:

Formula 40

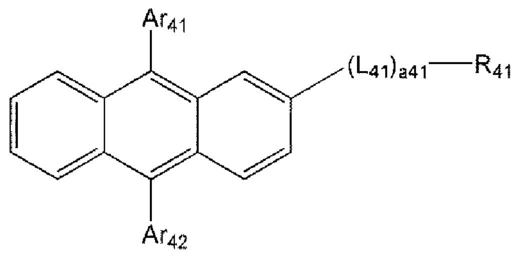

Formula 41

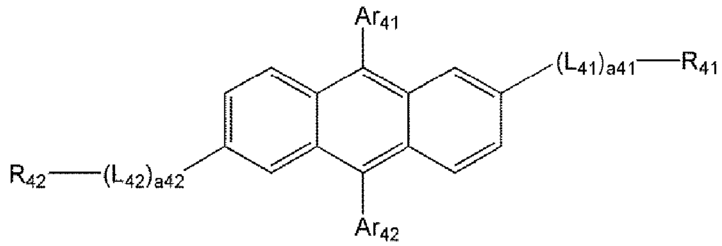

wherein, in Formulae 40 and 41,

$L_{41}$ and $L_{42}$ may each independently be selected from
a $C_6$-$C_{60}$ arylene group, a $C_1$-$C_{60}$ heteroarylene group, a divalent non-aromatic condensed polycyclic group, and a divalent non-aromatic condensed heteropolycyclic group; and
a $C_6$-$C_{60}$ arylene group, a $C_1$-$C_{60}$ heteroarylene group, a divalent non-aromatic condensed polycyclic group, and a divalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group,
a41 and a42 may each independently be an integer from 0 to 5,
$Ar_{41}$ and $Ar_{42}$ may each independently be selected from
a $C_6$-$C_{60}$ aryl group, a $C_1$-$C_{60}$ heteroaryl group, a monovalent non-aromatic condensed polycyclic group, and a monovalent non-aromatic condensed heteropolycyclic group; and
a $C_6$-$C_{60}$ aryl group, a $C_1$-$C_{60}$ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group, and
$R_{41}$ and $R_{42}$ may each independently be selected from
a benzimidazolyl group, a benzoxazolyl group, a benzothiazolyl group, a benzopyrimidinyl group, an imidazopyridinyl group, a quinolinyl group, an isoquinolinyl group, a quinazolinyl group, a pyridinyl group, a pyrimidinyl group, a pyrazinyl group, a phenyl group, a naphthyl group, a pyrenyl group, a chrysenyl group, a fluorenyl group, and a phenanthrenyl group; and
a benzimidazolyl group, a benzoxazolyl group, a benzothiazolyl group, a benzopyrimidinyl group, an imidazopyridinyl group, a quinolinyl group, an isoquinolinyl group, a quinazolinyl group, a pyridinyl group, a pyrimidinyl group, a pyrazinyl group, a phenyl group, a naphthyl group, a pyrenyl group, a chrysenyl group, a fluorenyl group, and a phenanthrenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a benzimidazolyl group, a benzoxazolyl group, a benzothiazolyl group, a benzopyrimidinyl group, an imidazopyridinyl group, a quinolinyl group, an isoquinolinyl group, a quinazolinyl group, a

pyridinyl group, a pyrimidinyl group, a pyrazinyl group, a phenyl group, a naphthyl group, a pyrenyl group, a chrysenyl group, a fluorenyl group, and a phenanthrenyl group.

In Formulae 40 and 41, $L_{41}$ and $L_{42}$ may be the same as described herein with reference to $L_{11}$.

In some embodiments, an electron transport material in the electron transport layer may include a compound represented by Formula 42:

Formula 42

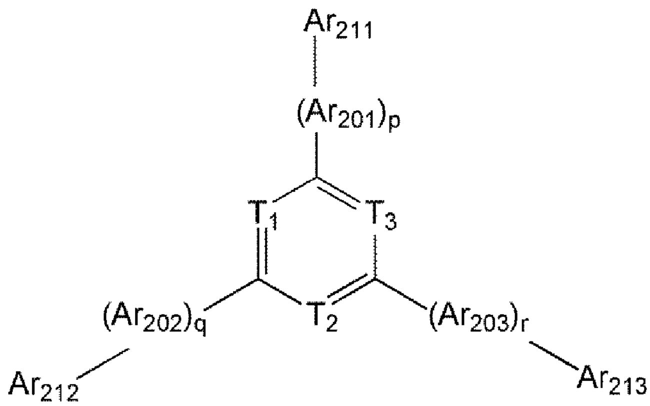

wherein, in Formula 42,

$T_1$ may be N or $C(R_{201})$, $T_2$ may be N or $C(R_{202})$, $T_3$ may be N or $C(R_{203})$, provided that at least one of $T_1$ to $T_3$ is N,
$R_{201}$ to $R_{203}$ may each independently be selected from
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group; and
a $C_6$-$C_{60}$ aryl group, a $C_1$-$C_{60}$ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group, and
$Ar_{201}$ to $Ar_{203}$ may each independently be selected from
a $C_6$-$C_{60}$ arylene group, a $C_1$-$C_{60}$ heteroarylene group, a divalent non-aromatic condensed polycyclic group, and a divalent non-aromatic condensed heteropolycyclic group; and
a $C_6$-$C_{60}$ arylene group, a $C_1$-$C_{60}$ heteroarylene group, a divalent non-aromatic condensed polycyclic group, and a divalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group,
p, q, and r may each independently be 0, 1, or 2, and
$Ar_{211}$ and $Ar_{213}$ may each independently be selected from
a $C_6$-$C_{60}$ aryl group, a $C_1$-$C_{60}$ heteroaryl group, a monovalent non-aromatic condensed polycyclic group, and a monovalent non-aromatic condensed heteropolycyclic group; and
a $C_6$-$C_{60}$ aryl group, a $C_1$-$C_{60}$ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a

fluorenyl group, a pyrenyl group, a chrysenyl group, a phenanthrenyl group, a pyridinyl group, a pyrimidinyl group, and a triazinyl group.

In an embodiment, in Formula 42, at least two of $T_1$ to $T_3$ may be N.
In one or more embodiments, in Formula 42, $T_1$ to $T_3$ may each be N.
In Formula 42, $Ar_{201}$ to $Ar_{203}$ may each independently be selected from

a phenylene group, a naphthylene group, an anthrylene group, a pyrenylene group, a fluorenylene group, a triphenylenylene group, a pyridinylene group, and a pyrimidinylene group; and
a phenylene group, a naphthylene group, an anthrylene group, a pyrenylene group, a fluorenylene group, a triphenylenylene group, a pyridinylene group, and a pyrimidinylene group, each substituted with at least one selected from a phenyl group, a naphthyl group, an anthryl group, a pyrenyl group, a fluorenyl group, a triphenylenyl group, a pyridinyl group, and a pyrimidinyl group, but embodiments are not limited thereto.

In Formula 42, p, q, and r may each independently be 0, 1, or 2. In some embodiments, in Formula 42, p, q, and r may each independently be 0 or 1, but embodiments are not limited thereto.
In Formula 42, $Ar_{211}$ to $Ar_{213}$ may each independently be selected from

a phenyl group, a naphthyl group, a pyrenyl group, a chrysenyl group, a fluorenyl group, a phenanthrenyl group, a benzimidazolyl group, a benzoxazolyl group, a benzothiazolyl group, a benzopyrimidinyl group, an imidazopyrimidinyl group, a quinolinyl group, an isoquinolinyl group, a quinazolinyl group, a pyridinyl group, a pyrimidinyl group, a pyrazinyl group, and a triazinyl group; and
a phenyl group, a naphthyl group, a pyrenyl group, a chrysenyl group, a fluorenyl group, a phenanthrenyl group, a benzimidazolyl group, a benzoxazolyl group, a benzothiazolyl group, a benzopyrimidinyl group, an imidazopyrimidinyl group, a quinolinyl group, an isoquinolinyl group, a quinazolinyl group, a pyridinyl group, a pyrimidinyl group, a pyrazinyl group, and a triazinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group, but embodiments are not limited thereto.

In an embodiment, in Formula 42, at least one selected from $Ar_{211}$ to $Ar_{213}$ may each independently be selected from

a benzimidazolyl group, a benzoxazolyl group, a benzothiazolyl group, a benzopyrimidinyl group, an imidazopyrimidinyl group, a quinolinyl group, an isoquinolinyl group, a quinazolinyl group, a pyridinyl group, a pyrimidinyl group, a pyrazinyl group, and a triazinyl group; and
a benzimidazolyl group, a benzoxazolyl group, a benzothiazolyl group, a benzopyrimidinyl group, an imidazopyrimidinyl group, a quinolinyl group, an isoquinolinyl group, a quinazolinyl group, a pyridinyl group, a pyrimidinyl group, a pyrazinyl group, and a triazinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group, but embodiments are not limited thereto.

In one or more embodiments, in Formula 20A, at least one selected from $Ar_{211}$ to $Ar_{213}$ may be a substituted or unsubstituted phenanthrenyl group.
In some embodiments, the electron transport layer may include at least one selected from Compounds ET1 to ET17, but embodiments are not limited thereto:

Compound ET1

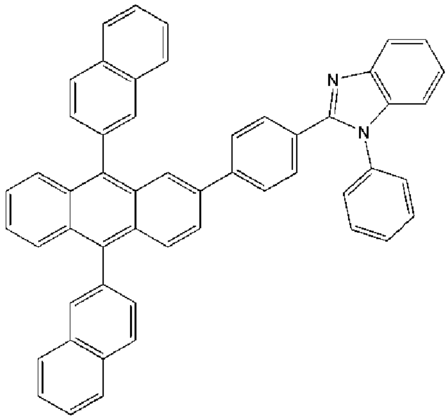

Compound ET2

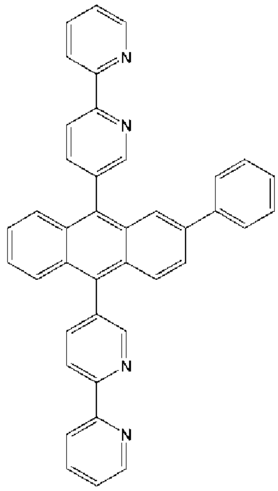

Compound ET3

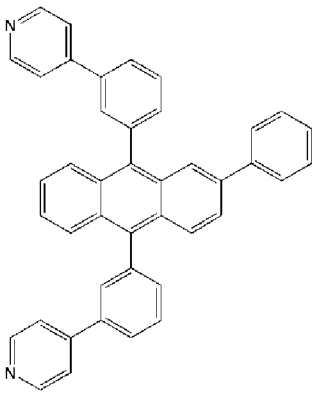

Compound ET4

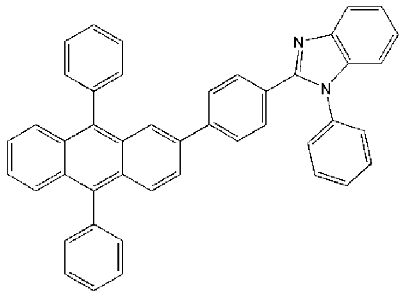

Compound ET5

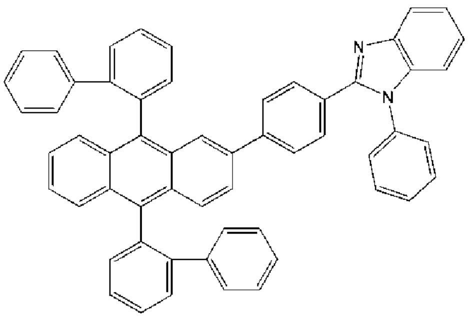

Compound ET6

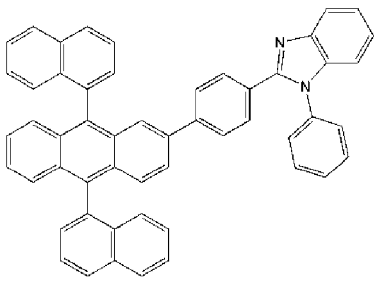

Compound ET7

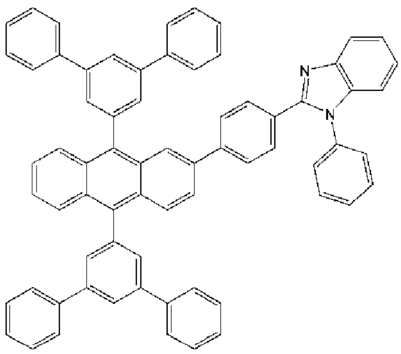

Compound ET8

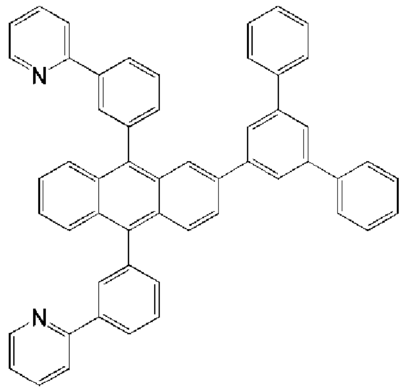

Compound ET8

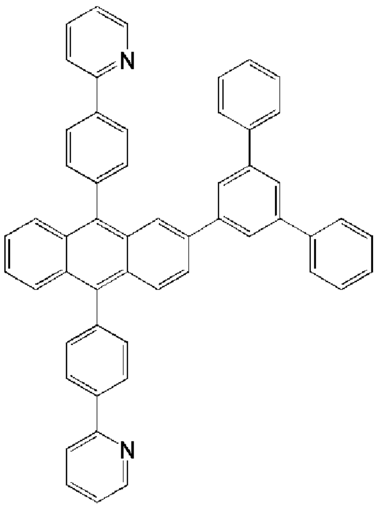

Compound ET10

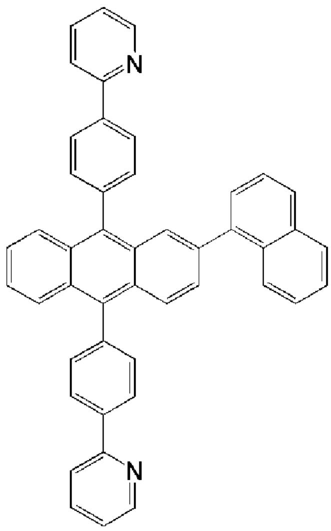

Compound ET11

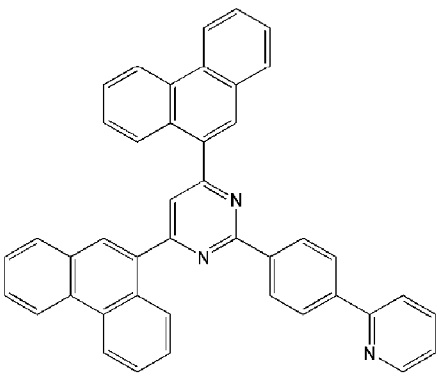

Compound ET12

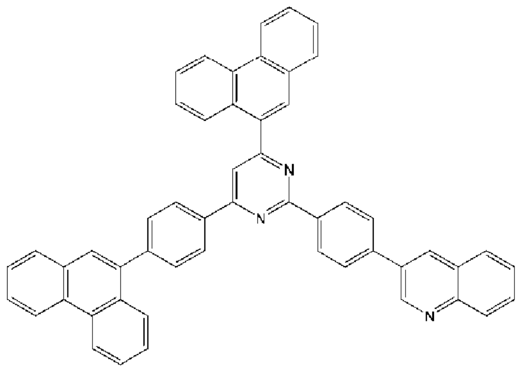

Compound ET13

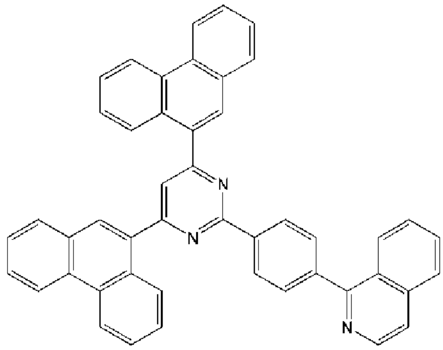

Compound ET14

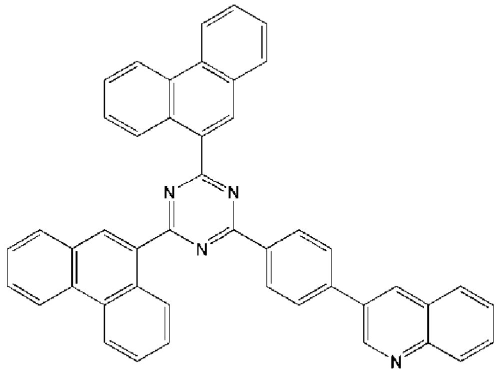

Compound ET15

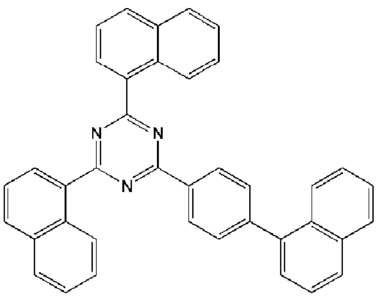

Compound ET16

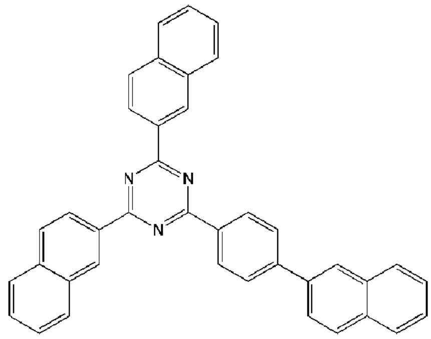

Compound ET17

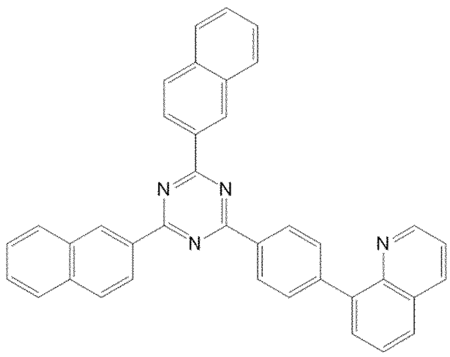

.

The thickness of the electron transport layer may be in a range of about 100 Å to about 1,000 Å, and in some embodiments, about 150 Å to about 500 Å. While not wishing to be bound by theory, it is understood that when the thickness of the electron transport layer is within any of these ranges, excellent electron transport characteristics may be obtained without a substantial increase in driving voltage.

The electron transport layer may further include a material containing metal, in addition to the materials described above.

The material containing metal may include a lithium (Li) complex. The Li complex may include, e.g., Compound ET-D1 (lithium 8-hydroxyquinolate, LiQ) or Compound ET-D2:

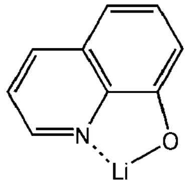

ET-D1

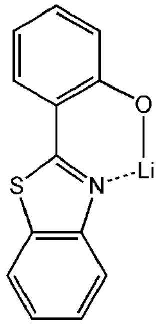

ET-D2 .

The electron transport region may include an electron injection layer that facilitates electron injection from the second electrode 19.

The electron injection layer may include at least one selected from LiF, NaCl, CsF, $Li_2O$, and BaO.

The thickness of the electron injection layer may be in a range of about 1 Å to about 100 Å, for example, about 3 Å to about 90 Å. While not wishing to be bound by theory, it is understood that when the thickness of the electron injection layer is within any of these ranges, excellent electron injection characteristics may be obtained without a substantial increase in driving voltage.

The second electrode 19 may be formed on the organic layer 15. The second electrode 19 may be a cathode. A material for forming the second electrode 19 may be a material with a relatively low work function, such as a metal, an alloy, an electrically conductive compound, and a mixture thereof. Examples of the material for forming the second electrode 19 may include lithium (Li), magnesium (Mg), aluminum (Al), aluminum-lithium (Al-Li), calcium (Ca), magnesium-indium (Mg-In), and magnesium-silver (Mg-Ag). In some embodiments, ITO or IZO may be used to form a transmissive second electrode 19 to manufacture a top emission light-emitting device. In some embodiments, the material for forming the second electrode 19 may vary.

Hereinbefore, the organic light-emitting device 10 has been described with reference to the FIGURE, but embodiments are not limited thereto.

The term "$C_1$-$C_{60}$ alkyl group" as used herein refers to a linear or branched aliphatic saturated hydrocarbon monovalent group having 1 to 60 carbon atoms. Examples thereof include a methyl group, an ethyl group, a propyl group, an iso-butyl group, a sec-butyl group, a tert-butyl group, a pentyl group, an iso-amyl group, and a hexyl group. The term "$C_1$-$C_{60}$ alkylene group" as used herein refers to a divalent group having substantially the same structure as the $C_1$-$C_{60}$ alkyl group.

The term "$C_1$-$C_{60}$ alkoxy group" as used herein refers to a monovalent group represented by $-OA_{101}$ (wherein $A_{101}$ is a $C_1$-$C_{60}$ alkyl group). Examples thereof include a methoxy group, an ethoxy group, and an iso-propyloxy group.

The term "$C_2$-$C_{60}$ alkenyl group" as used herein refers to a group formed by including at least one carbon-carbon double bond in the middle or at the terminus of the $C_2$-$C_{60}$ alkyl group. Examples thereof include an ethynyl group, a propynyl group, and a butenyl group. The term "$C_2$-$C_{60}$ alkenylene group" as used herein refers to a divalent group having substantially the same structure as the $C_2$-$C_{60}$ alkenyl group.

The term "$C_2$-$C_{60}$ alkynyl group" as used herein refers to a group formed by including at least one carbon-carbon triple bond in the middle or at the terminus of the $C_2$-$C_{60}$ alkyl group. Examples thereof include an ethenyl group and a propenyl group. The term "$C_2$-$C_{60}$ alkynylene group" as used herein refers to a divalent group having substantially the same structure as the $C_2$-$C_{60}$ alkynyl group.

The term "$C_3$-$C_{10}$ cycloalkyl group" as used herein refers to a monovalent monocyclic saturated hydrocarbon group including 3 to 10 carbon atoms. Examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having substantially the same structure as the $C_3$-$C_{10}$ cycloalkyl group.

The term "$C_1$-$C_{10}$ heterocycloalkyl group" as used herein refers to a saturated monovalent monocyclic group including at least one heteroatom selected from N, O, P, Si, and S as a ring-forming atom and 1 to 10 carbon atoms. Examples thereof include a tetrahydrofuranyl group and a tetrahydrothiophenyl group. The term "$C_1$-$C_{10}$ heterocycloalkylene group" as used herein refers to a divalent group having substantially the same structure as the $C_1$-$C_{10}$ heterocycloalkyl group.

The term "$C_3$-$C_{10}$ cycloalkenyl group" as used herein refers to a monovalent monocyclic hydrocarbon group including 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "$C_3$-$C_{10}$ cycloalkenylene group" as used herein refers to a divalent group having substantially the same structure as the $C_3$-$C_{10}$ cycloalkenyl group.

The term "$C_1$-$C_{10}$ heterocycloalkenyl group" as used herein refers to a monovalent monocyclic group including at least one heteroatom selected from N, O, P, Si and S as a ring-forming atom, 1 to 10 carbon atoms, and at least one double bond in its ring. Examples of the $C_1$-$C_{10}$ heterocycloalkenyl group include a 2,3-dihydrofuranyl group and a 2,3-dihydrothiophenyl group. The term "$C_1$-$C_{10}$ heterocycloalkylene group" as used herein refers to a divalent group having substantially the same structure as the $C_1$-$C_{10}$ heterocycloalkyl group.

The term "$C_6$-$C_{60}$ aryl group" as used herein refers to a monovalent group having a carbocyclic aromatic system having 6 to 60 carbon atoms. The term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and a $C_6$-$C_{60}$ arylene group each include at least two rings, the at least two rings may be fused.

The term "$C_1$-$C_{60}$ heteroaryl group" as used herein refers to a monovalent group having a heterocyclic aromatic system having at least one heteroatom selected from N, O, P, Si and S as a ring-forming atom and 1 to 60 carbon atoms. The term "$C_1$-$C_{60}$ heteroarylene group" as used herein refers to a divalent group having a heterocyclic aromatic system having at least one heteroatom selected from N, O, P, Si and S as a ring-forming atom and 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include at least two rings, the at least two rings may be fused.

The term "$C_6$-$C_{60}$ aryloxy group" as used herein refers to a group represented by $-OA_{102}$ (where $A_{102}$ is a $C_6$-$C_{60}$ aryl group), and the term "$C_7$-$C_{60}$ arylalkyl group" as used herein indicates $-A_{104}A_{105}$ (wherein $A_{105}$ is the $C_6$-$C_{59}$ aryl group and $A_{104}$ is the $C_1$-$C_{53}$ alkylene group). The term "$C_6$-$C_{60}$ arylthio group" as used herein refers to a group represented by $-SA_{103}$ (where $A_{103}$ is a $C_6$-$C_{60}$ aryl group).

The term "$C_1$-$C_{60}$ heteroaryloxy group" as used herein refers to $-OA_{106}$ (wherein $A_{106}$ is the $C_1$-$C_{60}$ heteroaryl group), and the term "$C_1$-$C_{60}$ heteroarylthio group" as used herein indicates $-SA_{107}$ (wherein $A_{107}$ is the $C_1$-$C_{60}$ heteroaryl group).

The term "$C_2$-$C_{60}$ heteroarylalkyl group" as used herein refers to $-A_{108}A_{109}$ ($A_{109}$ is a $C_1$-$C_{59}$ heteroaryl group, and $A_{108}$ is a $C_1$-$C_{59}$ alkylene group).

The term "monovalent non-aromatic condensed polycyclic group" as used herein refers to a monovalent group having two or more rings condensed and only carbon atoms (for example, the number of carbon atoms may be in a range of 8 to 60) as ring-forming atoms, wherein the molecular structure as a whole is non-aromatic. Examples of the non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group having at least two rings condensed and a heteroatom selected from N, O, P, Si and S as well as carbon atoms (for example, the number of carbon atoms may be in a range of 2 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

At least one substituent of the substituted $C_3$-$C_{10}$ cycloalkylene group, substituted $C_1$-$C_{10}$ heterocycloalkylene group, substituted $C_3$-$C_{10}$ cycloalkenylene group, substituted $C_1$-$C_{10}$ heterocycloalkenylene group, substituted $C_6$-$C_{60}$ arylene group, substituted $C_1$-$C_{60}$ heteroarylene group, substituted divalent non-aromatic condensed polycyclic group, substituted divalent non-aromatic condensed heteropolycyclic group, substituted $C_1$-$C_{60}$ alkyl group, substituted $C_2$-$C_{60}$ alkenyl group, substituted $C_2$-$C_{60}$ alkynyl group, substituted $C_1$-$C_{60}$ alkoxy group, substituted $C_3$-$C_{10}$ cycloalkyl group, substituted $C_1$-$C_{10}$ heterocycloalkyl group, substituted $C_3$-$C_{10}$ cycloalkenyl group, substituted $C_1$-$C_{10}$ heterocycloalkenyl group, substituted $C_6$-$C_{60}$ aryl group, substituted $C_6$-$C_{60}$ aryloxy group, substituted $C_6$-$C_{60}$ arylthio group, substituted $C_7$-$C_{60}$ arylalkyl group, substituted $C_1$-$C_{60}$ heteroaryl group, substituted $C_1$-$C_{60}$ heteroaryloxy group, substituted $C_1$-$C_{60}$ heteroarylthio group, substituted $C_2$-$C_{60}$ heteroarylalkyl group, substituted monovalent non-aromatic condensed polycyclic group, and substituted monovalent non-aromatic condensed heteropolycyclic group may be:

deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or $C_1$-$C_{60}$ alkoxy group, each substituted with at least one selected from deuterium, -F, - Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl

group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, -N($Q_{11}$)($Q_{12}$), -Si($Q_{13}$)($Q_{14}$)($Q_{15}$), and -B($Q_{16}$)($Q_{17}$);

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, or a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, -N($Q_{21}$)($Q_{22}$),-Si(Q23)(Q24)(Q25), and -B($Q_{26}$)($Q_{27}$); or

-N($Q_{31}$)($Q_{32}$), -Si($Q_{33}$)($Q_{34}$)($Q_{35}$), or -B($Q_{36}$)($Q_{37}$),

wherein $Q_1$ to $Q_7$, $Q_{11}$ to $Q_{17}$, $Q_{21}$ to $Q_{27}$, and $Q_{31}$ to $Q_{37}$ may each independently be hydrogen, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, or a monovalent non-aromatic condensed heteropolycyclic group.

The term "room temperature" as used herein refers to a temperature of about 25°C.

Hereinafter, a compound and an organic light-emitting device according to an embodiment will be described in detail with reference to Synthesis Examples and Examples, however, the present disclosure is not limited thereto. The wording "B was used instead of A" used in describing Synthesis Examples means that an amount of B used was identical to an amount of A used in terms of molar equivalents.

EXAMPLES

Evaluation Example 1

Referring to the methods shown in Table 1, T1, S1, $E_{ox}$, $E^*_{ox}$, $E_{red}$, and $E^*_{red}$ of Compounds PD79 to PD84, Compounds PD300 to PD303, and Compound A2 were evaluated. The results thereof are shown in Table 2.

Referring to Table 2, a value of $E^*_{ox}$ of each of Compounds PD79 to PD84 and PD300 to PD303 is equal to a value of $E_{ox}$-T1 of the corresponding compound. A value of $E^*_{ox}$ of Compound A2 is equal to a value of $E_{ox}$-S1 of Compound A2. A value of $E^*_{red}$ of each of Compounds PD79 to PD84 and PD300 to PD303 is equal to a value of $E_{red}$+T1 of the corresponding compound. A value of $E^*_{red}$ of Compound A2 is equal to a value of $E_{red}$+S1 of Compound A2.

Table 1

| | |
|---|---|
| T1 energy level evaluation method | A mixture of 2-Methyltetrahydrofuran (2-MeTHF) and each compound (in which each compound was dissolved in 3 milliliters (mL) of 2-MeTHF at a concentration of 10 micromolar, μM) was loaded into a quartz cell. Subsequently, the resulting quartz cell was loaded into a cryostat (available from Oxford Instruments, DN) including liquid nitrogen at a temperature of 77 Kelvins (K). A fluorescence spectrum thereof was measured by using a spectrofluorometer (available from PTI, QuantaMaster 400). A T1 energy level was calculated from the start wavelength of the short-wavelength side. |

(continued)

| | |
|---|---|
| S1 energy level evaluation method | A mixture of 2-MeTHF and each compound (in which each compound was dissolved in 3 mL of 2-MeTHF at a concentration of 10 μM) was loaded into a quartz cell. A fluorescence spectrum thereof was measured at room temperature by using a spectrofluorometer (available from PTI, QuantaMaster 400). An S1 energy level was calculated from the start wavelength of the short-wavelength side. |
| $E_{ox}$ evaluation method | A potential (Volts, V) versus current (Amperes, A) graph of each compound was obtained by using cyclic voltammetry (CHI630B available from CH Instruments, electrolyte: 0.1 molar (M) $Bu_4NPF_6$/ solvent: $CH_2Cl_2$/ electrode: 3-electrode system (working electrode: Pt disc (1 mm diameter), reference electrode: Pt wire, and auxiliary electrode: Pt wire)). Subsequently, $E_{ox}$ was calculated. |
| $E_{red}$ evaluation method | A potential (V) versus current (A) graph of each compound was obtained by using differential pulse voltammetry (DPV, CHI630B available from CH Instruments, electrolyte: 0.1 M $Bu_4NPF_6$/ solvent: $CH_2Cl_2$/ electrode: 3-electrode system (working electrode: Pt disc (1 mm diameter), reference electrode: Pt wire, and auxiliary electrode: Pt wire)). Subsequently, $E_{ox}$ was calculated. |

Table 2

| Compound No. | T1 (eV) | S1 (eV) | $E_{ox}$ (eV) | $E^*_{ox}$ (eV) | $E_{red}$ (eV) | $E^*_{red}$ (eV) |
|---|---|---|---|---|---|---|
| PD79 | 2.68 | - | 0.94 | -1.74 | -1.67 | 1.01 |
| PD80 | 2.72 | - | 0.87 | -1.85 | -1.77 | 0.95 |
| A2 | - | 2.86 | 1.23 | -1.63 | -1.65 | 1.21 |
| PD81 | 2.59 | - | 1.18 | -1.41 | -1.83 | 0.76 |
| PD82 | 2.68 | - | 0.97 | -1.71 | - | - |
| PD83 | 2.59 | - | 0.88 | -1.71 | - | - |
| PD84 | 2.86 | - | 0.96 | -1.90 | -1.21 | 1.65 |
| PD300 | 2.97 | - | 1.86 | -1.11 | -1.13 | 1.84 |
| PD301 | 2.90 | - | 1.02 | -1.88 | -1.14 | 1.76 |
| PD302 | 2.81 | - | 0.80 | -2.01 | -1.12 | 1.69 |
| PD303 | 2.81 | - | 2.24 | -0.57 | -1.10 | 1.71 |

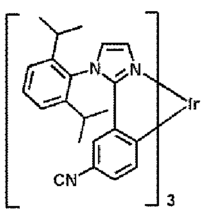
PD79

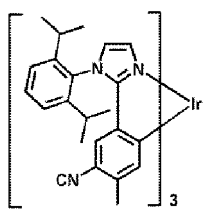
PD80

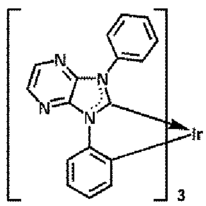
PD81

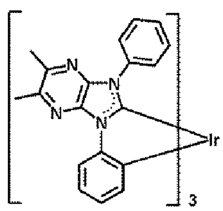
PD82

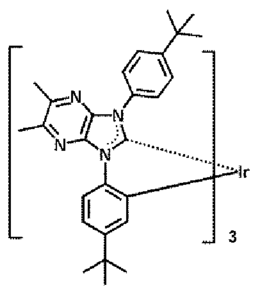
PD83

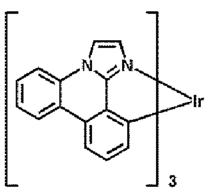
PD84

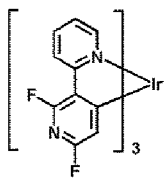
PD300

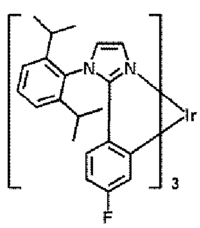
PD301

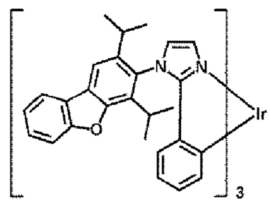
PD302

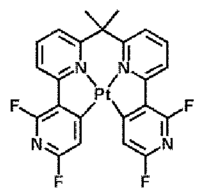
PD303

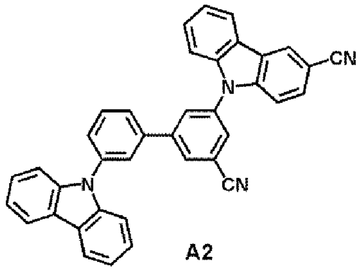

A2

Based on Table 2, it was identified whether Conditions 1, 2, 3, 4, 5-1, and 6-1 were satisfied in Combinations 1 to 10. The results thereof are shown in Tables 3 and 4.

Table 3

| Combination No. | Host | Dopant | Condition 1 | Condition 2 | Condition 3 | Condition 4 |
|---|---|---|---|---|---|---|
| Combination 1 | A2 | PD79 | X | ○ | X | ○ |
| Combination 2 | A2 | PD80 | X | ○ | X | ○ |
| Combination 3 | A2 | PD81 | O | O | X | ○ |
| Combination 4 | A2 | PD82 | X | N/A | X | N/A |
| Combination 5 | A2 | PD83 | X | N/A | X | N/A |
| Combination 6 | A2 | PD84 | X | X | X | X |
| Combination 7 | A2 | PD300 | O | X | ○ | X |
| Combination 8 | A2 | PD301 | X | X | X | X |
| Combination 9 | A2 | PD302 | X | X | X | X |
| Combination 10 | A2 | PD303 | O | X | O | X |

Table 4

| Combination No. | Host | Dopant | $T1_{dopant}$ - 0.4 eV | $\lvert E_{red,host}-E_{ox,dopant} \rvert$ | $\lvert E_{red,dopant}-E_{ox,host} \rvert$ | $T1_{dopant}$ + 0.3 eV | Condition 5-1 | Condition 6-1 |
|---|---|---|---|---|---|---|---|---|
| Combination 1 | A2 | PD79 | 2.28 | 2.59 | 2.9 | 2.98 | ○ | ○ |
| Combination 2 | A2 | PD80 | 2.32 | 2.52 | 3 | 3.02 | ○ | ○ |
| Combination 3 | A2 | PD81 | 2.19 | 2.83 | 3.06 | 2.89 | ○ | X |
| Combination 4 | A2 | PD82 | 2.28 | 2.62 | N/A | 2.98 | ○ | N/A |
| Combination 5 | A2 | PD83 | 2.19 | 2.53 | N/A | 2.89 | ○ | N/A |
| Combination 6 | A2 | PD84 | 2.46 | 2.61 | 2.44 | 3.16 | ○ | X |
| Combination 7 | A2 | PD300 | 2.57 | 3.51 | 2.36 | 3.27 | X | X |
| Combination 8 | A2 | PD301 | 2.50 | 2.67 | 2.37 | 3.20 | ○ | X |
| Combination 9 | A2 | PD302 | 2.41 | 2.45 | 2.35 | 3.11 | ○ | X |
| Combination 10 | A2 | PD303 | 2.41 | 3.89 | 2.33 | 3.11 | X | X |

"○" indicates that the combination satisfied the condition.
"X" indicates that the combination did not satisfy the condition.
"N/A" indicates that an evaluation could not be made because a measurement was not available.

Example 1

As an anode, a glass substrate having an ITO electrode thereon was cut to a size of 50 millimeters (mm) x 50 mm x 0.5 mm. Then the glass substrate was sonicated in acetone iso-propyl alcohol and pure water for about 15 minutes in each solvent, and cleaned by exposure to ultraviolet rays and ozone for 30 minutes.

Compounds HT3 and HP-1 (in which a concentration of Compound HP-1 was 3 percent by weight (wt%)) were co-deposited on the anode to form a hole injection layer having a thickness of 100 Angstroms (Å). Compound HT3 was deposited on the hole injection layer to form a hole transport layer. mCP was deposited on the hole transport layer to form an electron blocking layer having a thickness of 100 Å, thereby forming a hole transport region having a thickness of 1,700 Å.

Compound A2 (as a host) and Compound PD79 (as a dopant) were co-deposited on the hole transport region at a weight ratio of 9:1, thereby forming an emission layer having a thickness of 400 Å.

Compound A4 was vacuum-deposited on the emission layer to form a hole blocking layer having a thickness of 100 Å. Compound ET17 and LiQ were co-deposited on the hole blocking layer at a weight ratio of 5:5 to form an electron transport layer having a thickness of 360 Å. LiQ was deposited on the electron transport layer to form an electron injection layer having a thickness of 5 Å. Aluminum (Al) was deposited on the electron injection layer to form a layer of aluminum having a thickness of 120 Å, thereby completing the manufacture of an organic light-emitting device.

Examples 2 and 3 and Comparative Examples 1 to 3

Organic light-emitting devices were manufactured in substantially the same manner as in Example 1, except that the host and the dopant shown in Table 5 were used in the formation of an emission layer.

Evaluation Example 2

Relative lifespan ($T_{95}$) characteristics of the organic light-emitting devices manufactured in Examples 1 to 3 and Comparative Examples 1 and 2 were measured by using a current voltmeter (Keithley 2400) and a luminance meter (Minolta Cs-1000A). The evaluation results are shown in Table 5. In Table 5, the relative lifespan ($T_{95}$) represents lifespan data evaluating a period taken for the luminance (at 500 nit) to reach 95% with respect to 100% of the initial luminance.

Table 5

| | Host | Dopant | Weight ratio of host to dopant | Relative lifespan ($T_{95}$) (percent, %) |
|---|---|---|---|---|
| Example 1 (Combination 1) | A2 | PD79 | 9:1 | 231% |
| Example 2 (Combination 2) | A2 | PD80 | 9:1 | 100% |
| Example 3 (Combination 3) | A2 | PD81 | 9:1 | 77% |
| Comparative Example 1 (Combination 6) | A2 | PD84 | 9:1 | <1% |
| Comparative Example 2 (Combination 8) | A2 | PD301 | 9:1 | <1% |
| Comparative Example 3 (Combination 9) | A2 | PD302 | 9:1 | <1% |

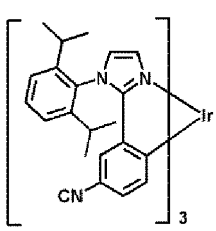
PD79

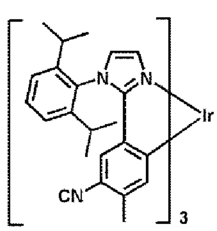
PD80

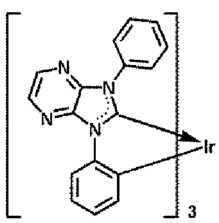
PD81

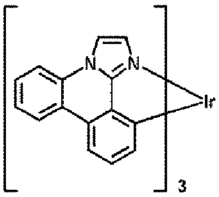
PD84

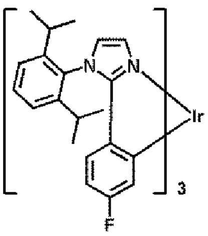
PD301

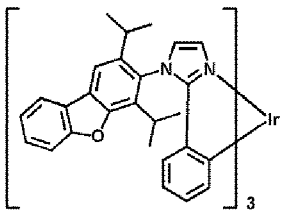
PD302

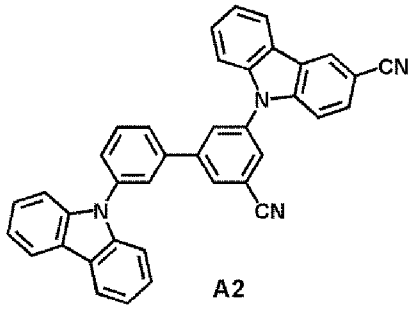
A2

Referring to the results of Table 5, it was found that the organic light-emitting device of Examples 1 to 3 have long lifespan characteristics, as compared with the organic light-emitting devices of Comparative Examples 1 to 3.

As apparent from the foregoing description, an organic light-emitting device, according to one or more embodiments, may include a host and a dopant satisfying the aforementioned conditions so as to have a long lifespan.

It should be understood that embodiments described herein should be considered in a descriptive sense only and not for purposes of limitation. Descriptions of features or aspects within each embodiment should typically be considered as available for other similar features or aspects in other embodiments.

## Claims

**1.** An organic light-emitting device comprising:

a first electrode;
a second electrode facing the first electrode; and
an organic layer disposed between the first electrode and the second electrode, wherein the organic layer includes an emission layer,
wherein the emission layer comprises a host and a dopant,
the dopant comprises a phosphorescent dopant, and **characterized by** that:

i) Conditions 1, 2, 3, and 4 are all satisfied; or
ii) when Conditions 1 and 4 are satisfied and at least one of Conditions 2 and 3 is not satisfied, Condition 5-1 is satisfied; or
iii) when at least one of Conditions 1 and 4 is not satisfied and Conditions 2 and 3 are satisfied, Condition 6-1 is satisfied; or
iv) when at least one of Conditions 1 and 4 is not satisfied and at least one of Conditions 2 and 3 is not satisfied, Conditions 5-1 and 6-1 are both satisfied:

Condition 1

$$E^{*}_{ox,dopant} \geq E_{red,host}$$

Condition 2

$$E^{*}_{red,dopant} \leq E_{ox,host}$$

Condition 3

$$E_{ox,dopant} \geq E^{*}_{red,host}$$

Condition 4

$$E_{red,dopant} \leq E^{*}_{ox,host}$$

Condition 5-1

$$T1_{dopant} - 0.4\ eV < |E_{red,host} - E_{ox,dopant}| < T1_{dopant} + 0.3\ eV$$

Condition 6-1

$$T1_{dopant}-0.4\ eV<\left|E_{red,dopant}-E_{ox,host}\right|<T1_{dopant}+0.3\ eV$$

wherein, "$E^*_{ox,dopant}$" represents an excited-state oxidation potential (eV) of the dopant,

"$E^*_{red,dopant}$" represents an excited-state reduction potential (eV) of the dopant,
"$E_{ox,dopant}$" represents a ground-state oxidation potential (eV) of the dopant,
"$E_{red,dopant}$" represents a ground-state reduction potential (eV) of the dopant,
"$E^*_{red,host}$" represents an excited-state reduction potential (eV) of the host,
"$E^*_{ox,host}$" represents an excited-state oxidation potential (eV) of the host,
"$E_{red,host}$" represents a ground-state reduction potential (eV) of the host,
"$E_{ox,host}$" represents a ground-state oxidation potential (eV) of the host,
$E^*_{ox,dopant}$ is identical to $E_{ox,dopant}-T1_{dopant}$,
$E^*_{red,dopant}$ is identical to $E_{red,dopant}+T1_{dopant}$,
$E^*_{ox,host}$ is identical to $E_{ox,host}-S1_{host}$,
$E^*_{red,host}$ is identical to $E_{red,host}+S1_{host}$,
"$T1_{dopant}$" represents the lowest triplet energy level (eV) of the dopant,
"$S1_{host}$" represents the lowest singlet energy level (eV) of the host,
$E_{ox,dopant}$ and $E_{ox,host}$ are measured by using cyclic voltammetry (CV),
$E_{red,dopant}$ and $E_{red,host}$ are measured by using differential pulse voltammetry,
$T1_{dopant}$ is calculated from a photoluminescence (PL) spectrum of the dopant in solution, and
$S1_{host}$ is calculated from a PL spectrum of the host in solution,
wherein "eV" denotes "electron volts".

**2.** The organic light-emitting device of claim 1, wherein

Conditions 1 and 3 are not satisfied, and
Conditions 2, 4, 5-1, and 6-1 are satisfied.

**3.** The organic light-emitting device of claim 1, wherein

Conditions 3 and 6-1 are not satisfied, and
Conditions 1, 2, 4, and 5-1 are satisfied.

**4.** The organic light-emitting device of any of claims 1-3, wherein

the host comprises i) a donor compound, or ii) an acceptor compound,
wherein the acceptor compound comprises a compound including at least one electron withdrawing group,
wherein the electron withdrawing group is selected from:
-F, $-CFH_2$, $-CF_2H$, $-CF_3$, -CN, and $-NO_2$;
a $C_1$-$C_{60}$ alkyl group substituted with at least one selected from -F, $-CFH_2$, - $CF_2H$, $-CF_3$, -CN, and $-NO_2$;
a $C_1$-$C_{60}$ heteroaryl group and a monovalent non-aromatic condensed polycyclic heterocyclic group, each including *=N-*' as a ring-forming moiety; and
a $C_1$-$C_{60}$ heteroaryl group and a monovalent non-aromatic condensed polycyclic heterocyclic group, each including *=N-*' as a ring-forming moiety and each substituted with at least one selected from deuterium, -F, $-CFH_2$, $-CF_2H$, $-CF_3$,-Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent

non-aromatic condensed polycyclic group, and a substituted or unsubstituted monovalent non-aromatic condensed heteropolycyclic group;

preferably wherein the acceptor compound comprises a compound represented by Formula A-1, a compound represented by Formula A-2, or any combination thereof:

Formula A-1 $Ar_{11}-(L_{11})_{a11}-Ar_{12}$

Formula A-2

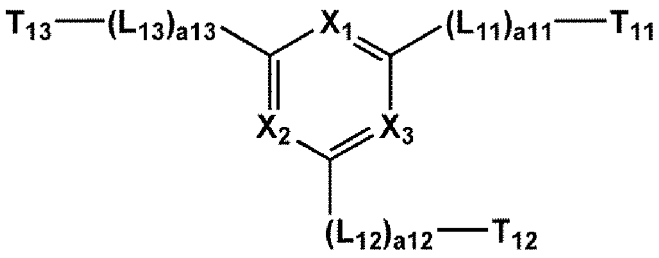

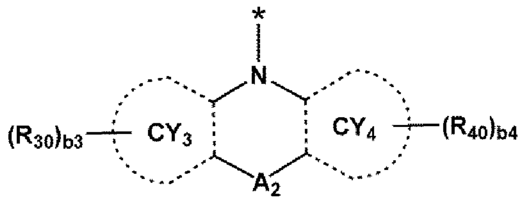

**Formula 13**

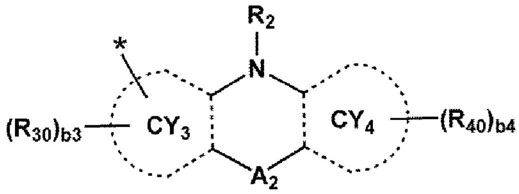

**Formula 14**

wherein, in Formulae A-1, A-2, 13, and 14,

$Ar_{11}$ and $Ar_{12}$ are each independently selected from groups represented by Formulae 13 and 14,

$X_1$ is N or $C(T_{14})$, $X_2$ is N or $C(T_{15})$, and $X_3$ is N or $C(T_{16})$, provided that at least one of $X_1$ to $X_3$ is N,

$L_{11}$ to $L_{13}$ are each independently selected from:

a single bond, a phenylene group, a pyridinylene group, a pyrimidinylene group, a pyrazinylene group, a pyridazinylene group, a triazinylene group, a naphthylene group, a fluorenylene group, a carbazolylene group, a dibenzofuranylene group, and a dibenzothiophenylene group; and

a phenylene group, a pyridinylene group, a pyrimidinylene group, a pyrazinylene group, a pyridazinylene group, a triazinylene group, a naphthylene group, a fluorenylene group, a carbazolylene group, a dibenzofuranylene group, and a dibenzothiophenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, $-CF_3$, $-CF_2H$, $- CFH_2$, a phenyl group, a phenyl group substituted with a cyano group, a naphthyl group, a pyridinyl group, a pyrimidinyl group, a pyrazinyl group, a pyridazinyl group, a triazinyl group, a fluorenyl group, a carbazolyl group, a dibenzofuranyl group, a dibenzothiophenyl group, and $-Si(Q_{11})(Q_{12})(Q_{13})$,

a11 to a13 are each independently an integer selected from 0 to 5; when a11 is 2 or greater, at least two $L_{11}$ groups are identical to or different from each other; when a12 is 2 or greater, at least two $L_{12}$ groups are identical to or different from each other; and when a13 is 2 or greater, at least two $L_{13}$ groups are identical to or different from each other,

$CY_3$ and $CY_4$ are each independently selected from a benzene group, a naphthalene group, a fluorene group, a carbazole group, a benzocarbazole group, an indolocarbazole group, a dibenzofuran group, and a dibenzothiophene group,

$A_2$ is selected from:

a single bond, a $C_1$-$C_4$ alkylene group, and a $C_2$-$C_4$ alkenylene group; and

a $C_1$-$C_4$ alkylene group and a $C_2$-$C_4$ alkenylene group, each substituted with at least one selected from deuterium, -F, -Cl, -Br, -I, a hydroxyl group, a cyano group, a nitro group, an amino group, an amidino

group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, a phenyl group, a naphthyl group, a pyridinyl group, a pyrimidinyl group, a pyrazinyl group, a pyridazinyl group, a triazinyl group, a fluorenyl group, a carbazolyl group, a dibenzofuranyl group, a dibenzothiophenyl group, and -Si($Q_{21}$)($Q_{22}$)($Q_{23}$),

$T_{11}$ to $T_{16}$, $R_2$, $R_{30}$, and $R_{40}$ are each independently selected from hydrogen, deuterium, -F, -Cl, -Br, -I, a hydroxyl group, a cyano group (CN), a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, and -Si($Q_1$)($Q_2$)($Q_3$),

b3 and b4 are each independently an integer selected from 0 to 10, and

at least one substituent of the substituted $C_1$-$C_{60}$ alkyl group, substituted $C_2$-$C_{60}$ alkenyl group, substituted $C_2$-$C_{60}$ alkynyl group, substituted $C_1$-$C_{60}$ alkoxy group, substituted $C_3$-$C_{10}$ cycloalkyl group, substituted $C_1$-$C_{10}$ heterocycloalkyl group, substituted $C_3$-$C_{10}$ cycloalkenyl group, substituted $C_1$-$C_{10}$ heterocycloalkenyl group, substituted $C_6$-$C_{60}$ aryl group, substituted $C_6$-$C_{60}$ aryloxy group, substituted $C_6$-$C_{60}$ arylthio group, substituted $C_7$-$C_{60}$ arylalkyl group, substituted $C_1$-$C_{60}$ heteroaryl group, substituted $C_1$-$C_{60}$ heteroaryloxy group, substituted $C_1$-$C_{60}$ heteroarylthio group, substituted $C_2$-$C_{60}$ heteroarylalkyl group, substituted monovalent non-aromatic condensed polycyclic group, and substituted monovalent non-aromatic condensed heteropolycyclic group is selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, and -Si($Q_{31}$)($Q_{32}$)($Q_{33}$),

wherein $Q_1$ to $Q_3$, $Q_{11}$ to $Q_{13}$, $Q_{21}$ to $Q_{23}$, and $Q_{31}$ to $Q_{33}$ are each independently selected from hydrogen, deuterium, a $C_1$-$C_{60}$ alkyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group.

**5.** The organic light-emitting device of claim 4, wherein $Ar_{11}$ and $Ar_{12}$ are each independently selected from groups represented by Formulae 13-1 to 13-8 and 14-1 to 14-8:

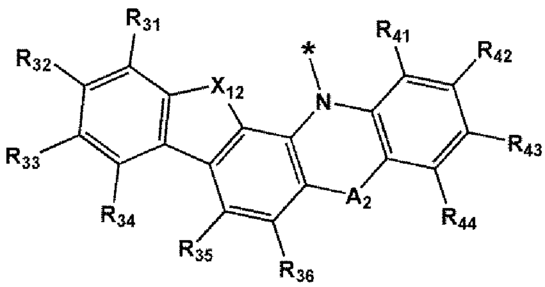

Formula 13-1

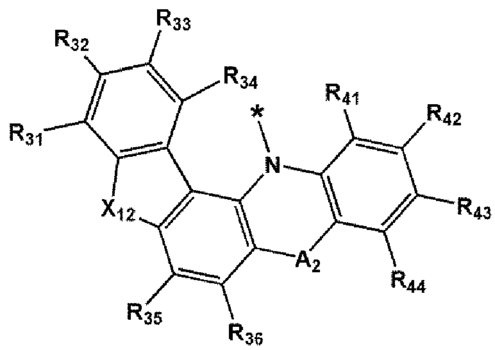

Formula 13-2

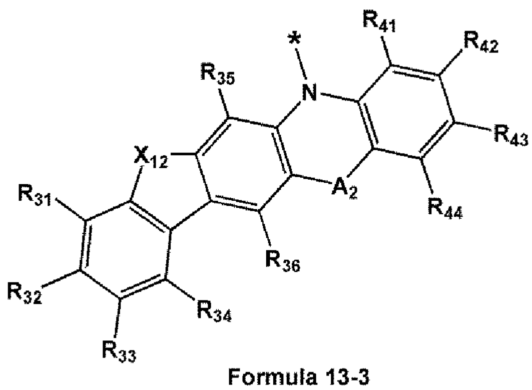

Formula 13-3

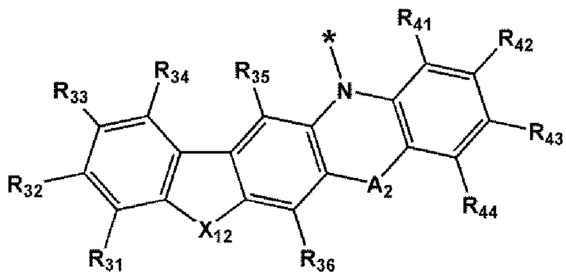

Formula 13-4

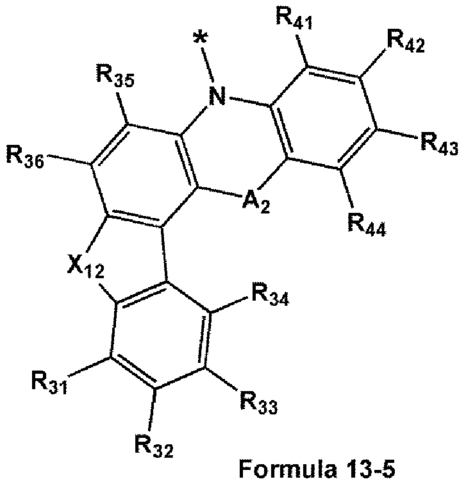

Formula 13-5

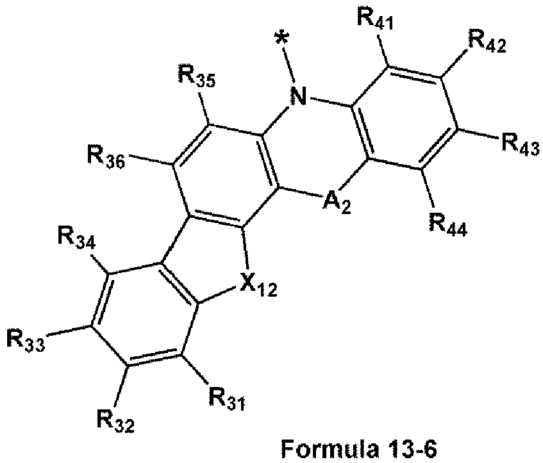

Formula 13-6

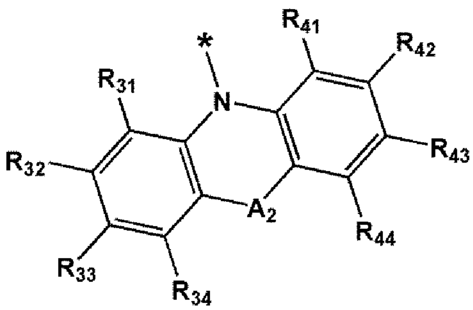

Formula 13-7

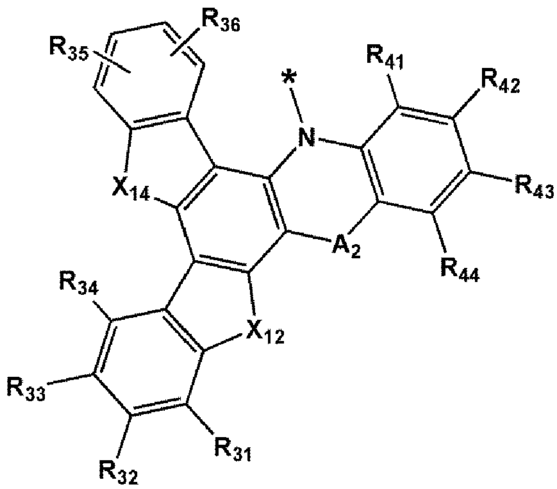

Formula 13-8

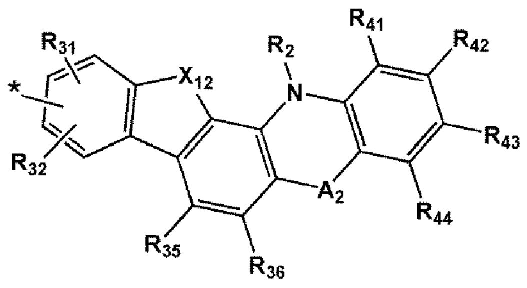

Formula 14-1

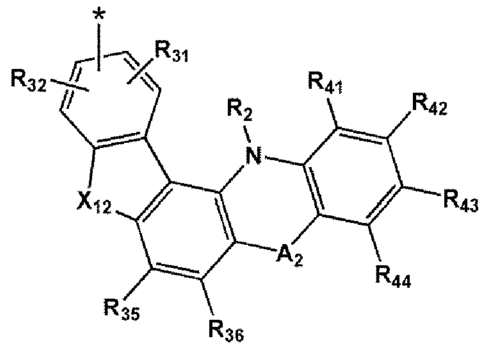

Formula 14-2

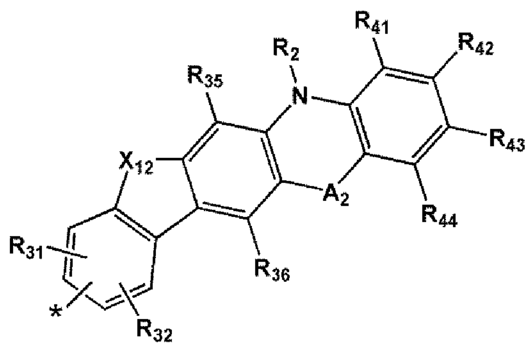

Formula 14-3

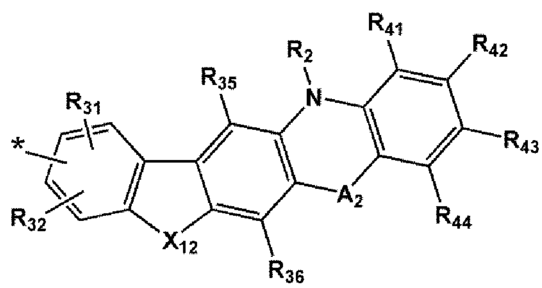

Formula 14-4

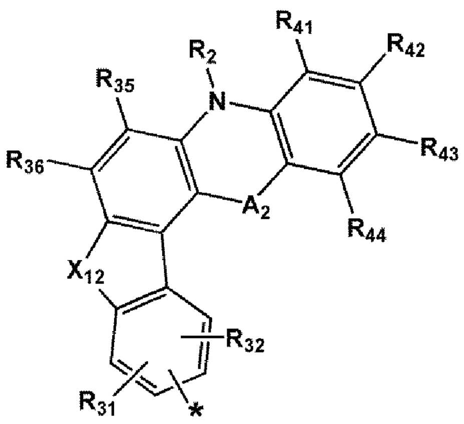

Formula 14-5

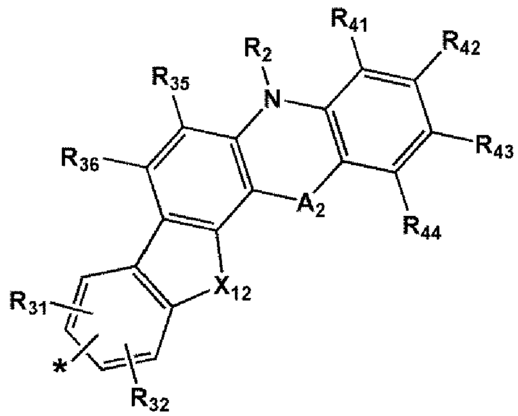

Formula 14-6

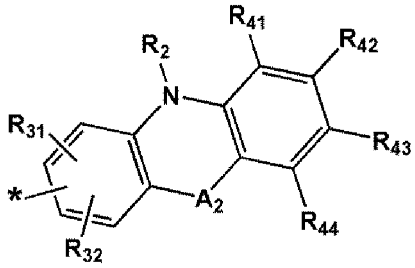

Formula 14-7

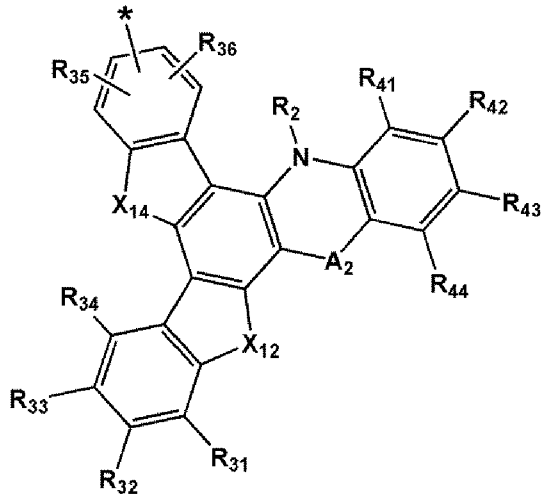

Formula 14-8

wherein, in Formulae 13-1 to 13-8 and 14-1 to 14-8,
$X_{12}$ and $X_{14}$ are each independently selected from $C(R_{37})(R_{38})$, $N(R_{39})$, O, and S,
$R_2$ and $A_2$ are the same as those defined in claim 5,
$R_{31}$ to $R_{39}$ are each independently the same as $R_{30}$ defined in claim 5,
$R_{41}$ to $R_{44}$ are each independently the same as $R_{40}$ defined in claim 5, and
* indicates a binding site to an adjacent atom.

**6.** The organic light-emitting device of claim 4, wherein $Ar_{11}$ and $Ar_{12}$ are each independently selected from groups represented by Formulae 17-1 to 17-3:

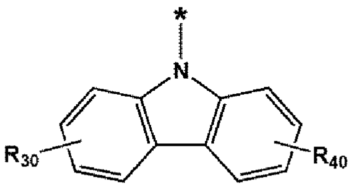

Formula 17-1

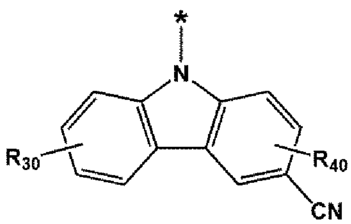

Formula 17-2

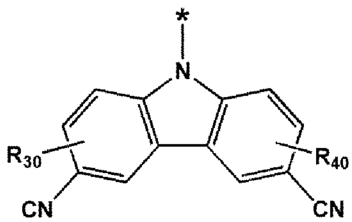

Formula 17-3

wherein, in Formulae 17-1 to 17-3,

$R_{30}$ and $R_{40}$ are each independently selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, - $CF_3$, $-CF_2H$, and $-CFH_2$;
a phenyl group, a pyridinyl group, a pyrimidinyl group, a pyrazinyl group, a pyridazinyl group, a triazinyl group, a naphthyl group, a fluorenyl group, a carbazolyl group, a dibenzofuranyl group, and a dibenzothiophenyl group;
a phenyl group, a pyridinyl group, a pyrimidinyl group, a pyrazinyl group, a pyridazinyl group, a triazinyl group, a naphthyl group, a fluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, $-CF_3$, $-CF_2H$, $-CFH_2$, a phenyl group, a pyridinyl group, a pyrimidinyl group, a pyrazinyl group, a pyridazinyl group, a triazinyl group, a naphthyl group, a fluorenyl group, a carbazolyl group, a dibenzofuranyl group, and a dibenzothiophenyl group; and

$-Si(Q_1)(Q_2)(Q_3)$,

wherein $Q_1$ to $Q_3$ are each independently selected from hydrogen, a $C_1$-$C_{10}$ alkyl group, a $C_1$-$C_{10}$ alkoxy group, a phenyl group, and a naphthyl group; and/or wherein $L_{11}$ to $L_{13}$ are each independently selected from groups represented by Formulae 3-1 to 3-56, provided that i) at least one $L_{11}$ in the number of a11, ii) at least one $L_{12}$ in the number of a12, and iii) at least one $L_{13}$ in the number of a13 are each independently selected from groups represented by Formulae 3-15 to 3-56:

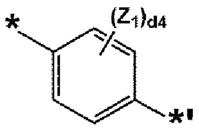
Formula 3-1

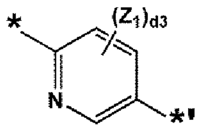
Formula 3-2

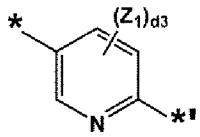
Formula 3-3

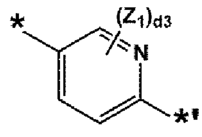
Formula 3-4

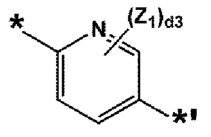
Formula 3-5

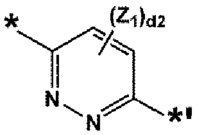
Formula 3-6

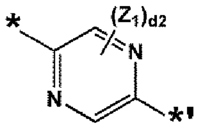
Formula 3-7

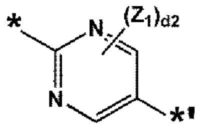
Formula 3-8

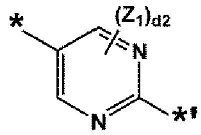
Formula 3-9

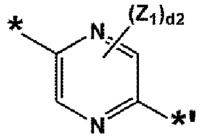
Formula 3-10

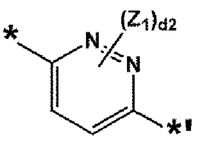
Formula 3-11

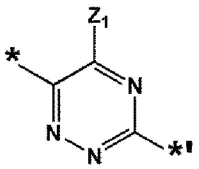
Formula 3-12

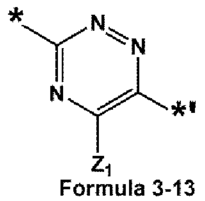
Formula 3-13

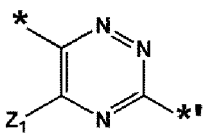
Formula 3-14

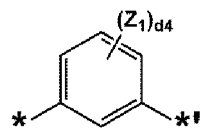
Formula 3-15

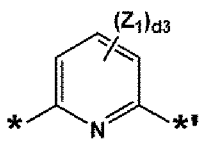
Formula 3-16

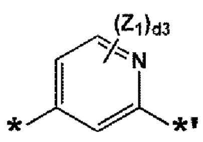
Formula 3-17

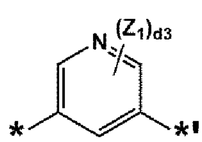
Formula 3-18

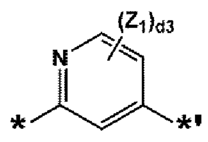
Formula 3-19

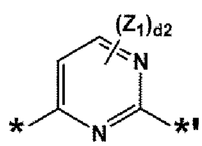
Formula 3-20

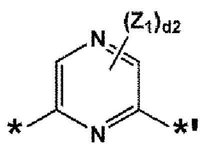
Formula 3-21

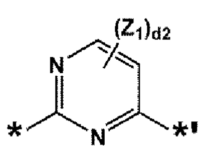
Formula 3-22

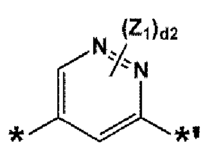
Formula 3-23

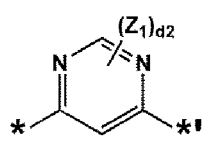
Formula 3-24

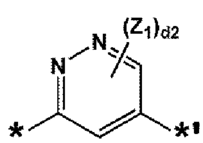
Formula 3-25

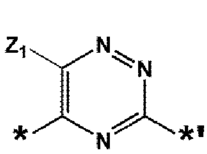
Formula 3-26

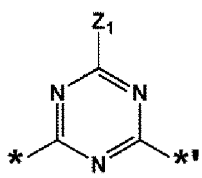
Formula 3-27

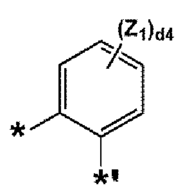
Formula 3-28

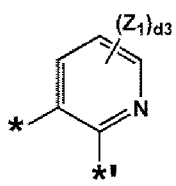
Formula 3-29

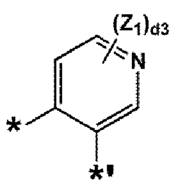
Formula 3-30

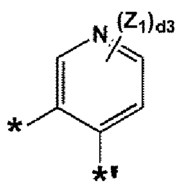
Formula 3-31

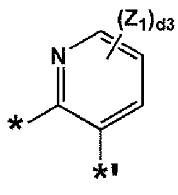
Formula 3-32

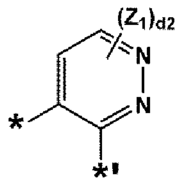
Formula 3-33

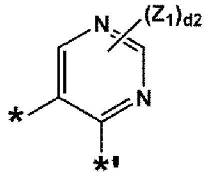
Formula 3-34

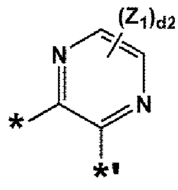
Formula 3-35

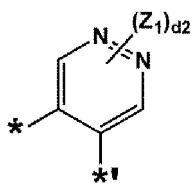
Formula 3-36

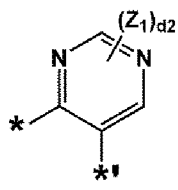
Formula 3-37

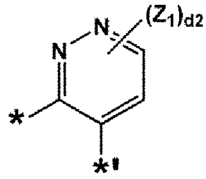
Formula 3-38

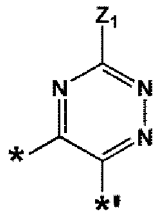
Formula 3-39

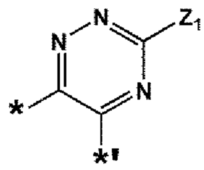
Formula 3-40

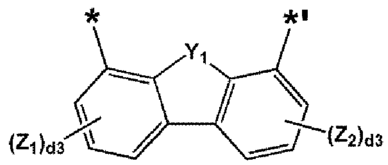
Formula 3-41

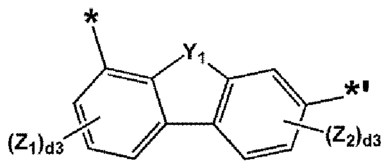
Formula 3-42

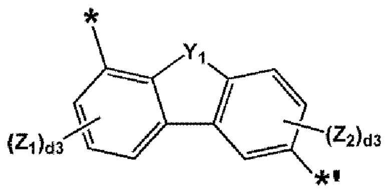
Formula 3-43

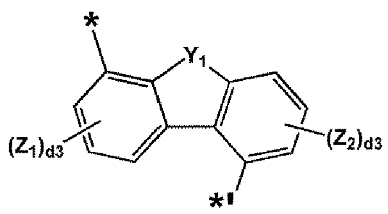
Formula 3-44

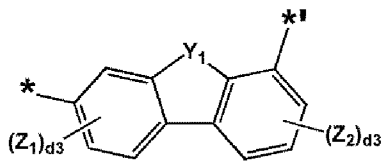
Formula 3-45

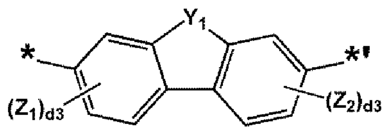
Formula 3-46

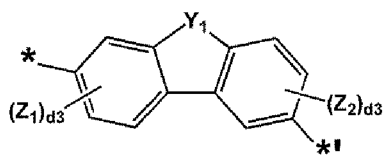
Formula 3-47

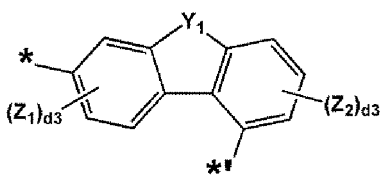
Formula 3-48

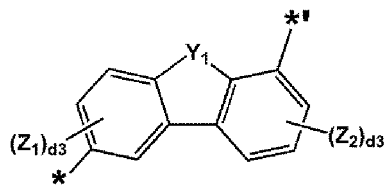
Formula 3-49

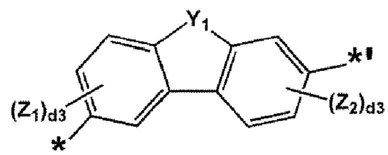
Formula 3-50

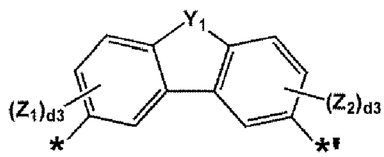
Formula 3-51

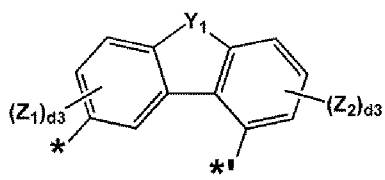
Formula 3-52

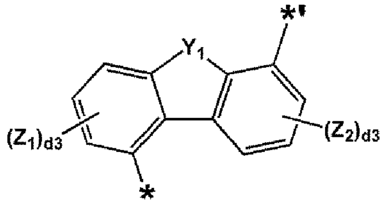

Formula 3-53

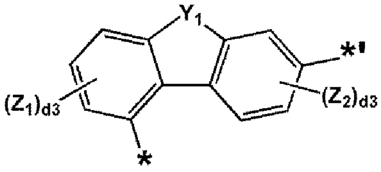

Formula 3-54

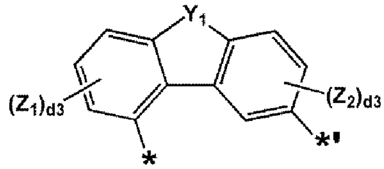

Formula 3-55

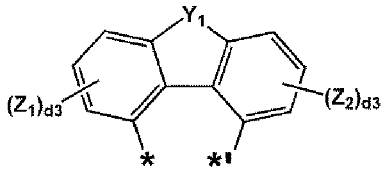

Formula 3-56

wherein, in Formulae 3-1 to 3-56,

$Y_1$ is selected from O, S, $C(Z_3)(Z_4)$, and $N(Z_5)$,
$Z_1$ to $Z_5$ are each independently selected from hydrogen, deuterium, -F, -Cl,-Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, $-CF_3$, $-CF_2H$, $-CFH_2$, a phenyl group, a phenyl group substituted with a cyano group, a naphthyl group, a pyridinyl group, a pyrimidinyl group, a pyrazinyl group, a pyridazinyl group, a triazinyl group, a fluorenyl group, a carbazolyl group, a dibenzofuranyl group, a dibenzothiophenyl group, and $-Si(Q_{11})(Q_{12})(Q_{13})$,
wherein $Q_{11}$ to $Q_{13}$ are each independently selected from hydrogen, a $C_1$-$C_{10}$ alkyl group, a $C_1$-$C_{10}$ alkoxy group, a phenyl group, a naphthyl group, a pyridinyl group, a pyrimidinyl group, a pyrazinyl group, a pyridazinyl group, a triazinyl group, a fluorenyl group, a carbazolyl group, a dibenzofuranyl group, and a dibenzothiophenyl group,
d4 is an integer selected from 0 to 4,
d3 is an integer selected from 0 to 3,
d2 is an integer selected from 0 to 2, and
* and *' each indicate a binding site to an adjacent atom.

7. The organic light-emitting device of claim 4, wherein groups represented by $*-(L_{11})_{a11}-*'$, $*-(L_{12})_{a12}-*'$, and $*-(L_{13})_{a13}-*'$ are selected from groups represented by Formulae 4-1 to 4-39:

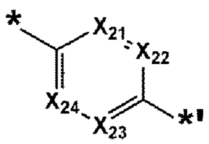

Formula 4-1

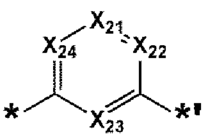

Formula 4-2

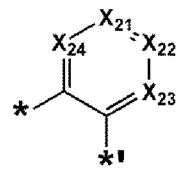

Formula 4-3

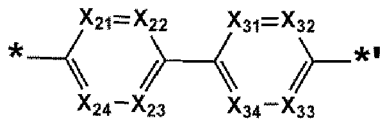

Formula 4-4

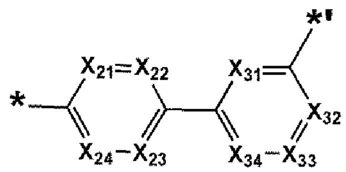

Formula 4-5

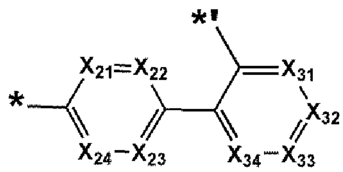

Formula 4-6

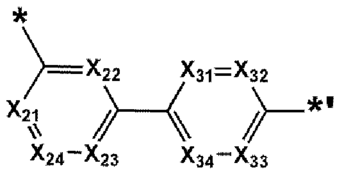

Formula 4-7

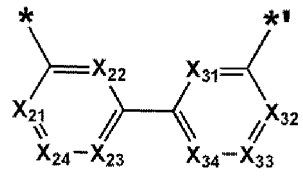

Formula 4-8

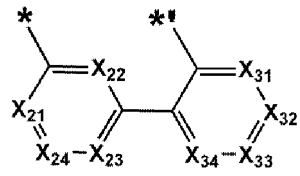

Formula 4-9

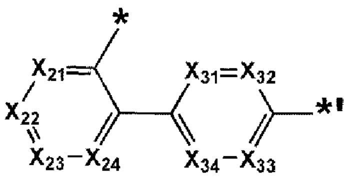

Formula 4-10

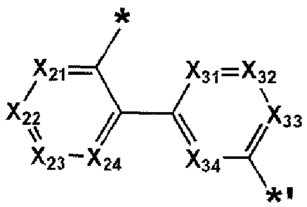

Formula 4-11

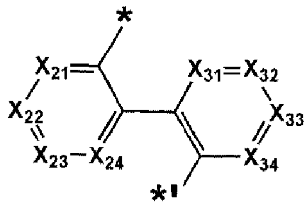

Formula 4-12

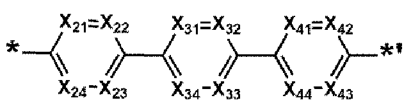

Formula 4-13

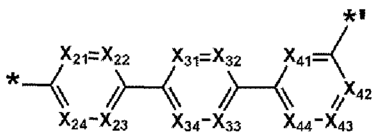

Formula 4-14

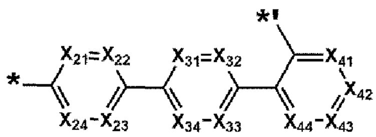

Formula 4-15

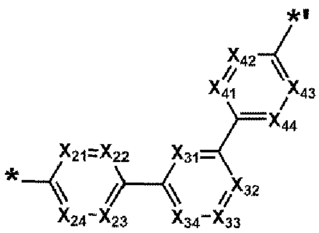

Formula 4-16

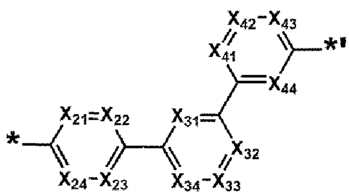

Formula 4-17

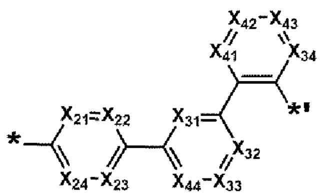

Formula 4-18

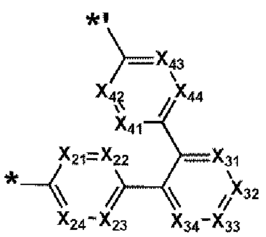

Formula 4-19

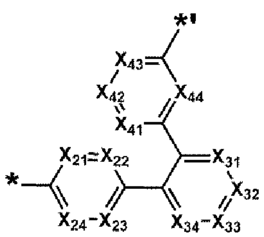

Formula 4-20

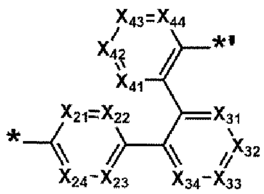

Formula 4-21

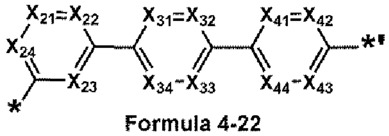

Formula 4-22

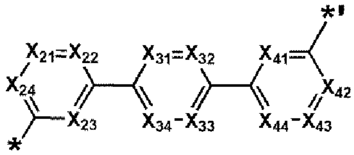

Formula 4-23

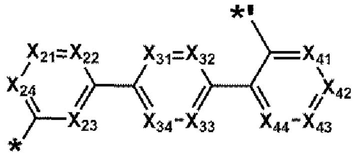

Formula 4-24

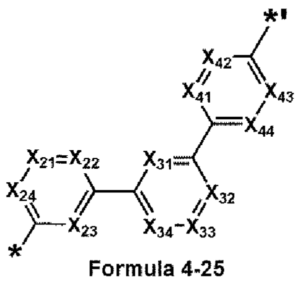

Formula 4-25

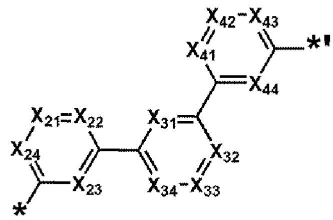

Formula 4-26

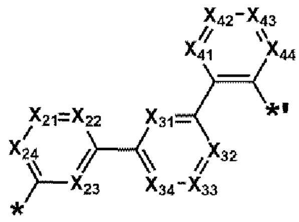

Formula 4-27

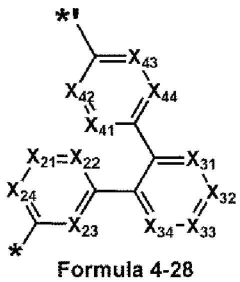

Formula 4-28

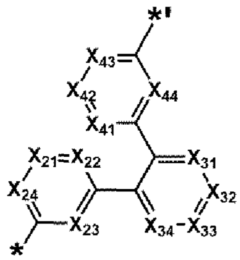

Formula 4-29

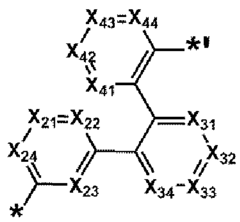

Formula 4-30

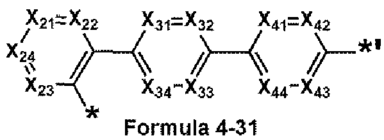

Formula 4-31

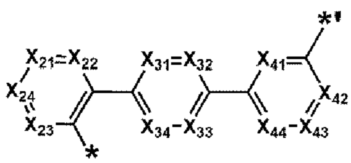

Formula 4-32

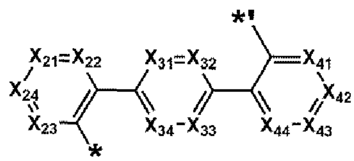

Formula 4-33

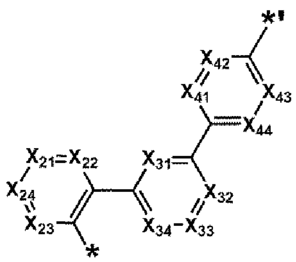

Formula 4-34

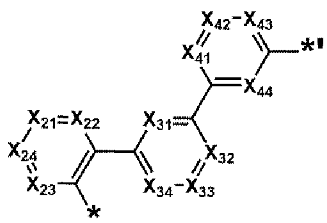

Formula 4-35

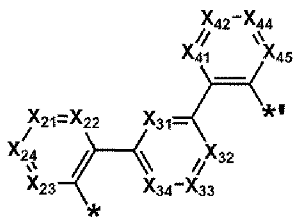

Formula 4-36

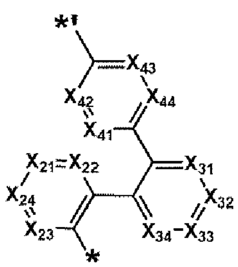

Formula 4-37

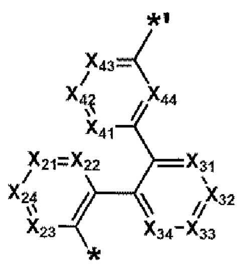

Formula 4-38

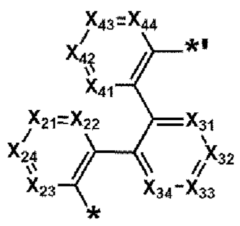

Formula 4-39

wherein, in Formulae 4-1 to 4-39,

$X_{21}$ is N or C($Z_{21}$), $X_{22}$ is N or C($Z_{22}$), $X_{23}$ is N or C($Z_{23}$), $X_{24}$ is N or C($Z_{24}$), $X_{31}$ is N or C($Z_{31}$), $X_{32}$ is N or C($Z_{32}$), $X_{33}$ is N or C($Z_{33}$), $X_{34}$ is N or C($Z_{34}$), $X_{41}$ is N or C($Z_{41}$), $X_{42}$ is N or C($Z_{42}$), $X_{43}$ is N or C($Z_{43}$), and $X_{44}$ is N or C($Z_{44}$), provided that at least one of $X_{21}$ to $X_{24}$ is not N, at least one of $X_{31}$ to $X_{34}$ is not N, and at least one of $X_{41}$ to $X_{44}$ is not N,

$Z_{21}$ to $Z_{24}$, $Z_{31}$ to $Z_{34}$, and $Z_{41}$ to $Z_{44}$ are each independently selected from hydrogen, deuterium, -F, -Cl, -Br,

-I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, - $CF_3$, $-CF_2H$, $-CFH_2$, a phenyl group, a phenyl group substituted with a cyano group, a naphthyl group, a pyridinyl group, a pyrimidinyl group, a pyrazinyl group, a pyridazinyl group, a triazinyl group, a fluorenyl group, a carbazolyl group, a dibenzofuranyl group, a dibenzothiophenyl group, and $-Si(Q_{11})(Q_{12})(Q_{13})$,
wherein $Q_{11}$ to $Q_{13}$ are each independently selected from hydrogen, a $C_1$-$C_{10}$ alkyl group, a $C_1$-$C_{10}$ alkoxy group, a phenyl group, a naphthyl group, a pyridinyl group, a pyrimidinyl group, a pyrazinyl group, a pyridazinyl group, a triazinyl group, a fluorenyl group, a carbazolyl group, a dibenzofuranyl group, and a dibenzothiophenyl group, and
* and *' each indicate a binding site to an adjacent atom; or
wherein

i) the acceptor compound is represented by Formula A-1 in which $Ar_{11}$ and $Ar_{12}$ are each independently selected from groups represented by Formulae 17-1 to 17-3, and at least one of $Ar_{11}$ and $Ar_{12}$ is selected from groups represented by Formulae 17-2 and 17-3;
ii) the acceptor compound is represented by Formula A-1 in which $L_{11}$ is selected from groups represented by Formulae 3-15 and 3-28, and at least one $L_{11}$ in the number of a11 is selected from groups represented by Formulae 6-1 to 6-4; or
iii) the acceptor compound is represented by Formula A-2 in which $X_1$ to $X_3$ are each N:

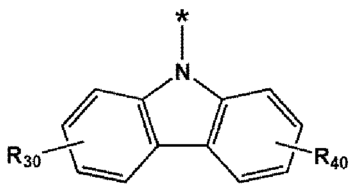
Formula 17-1

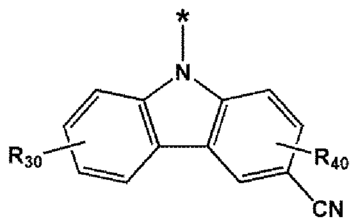
Formula 17-2

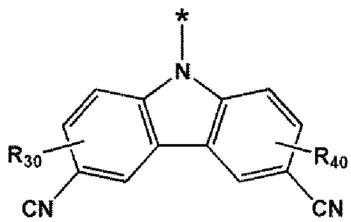
Formula 17-3

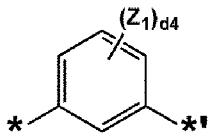
Formula 3-15

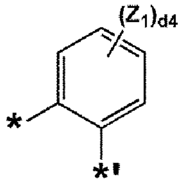
Formula 3-28

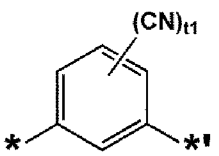
Formula 6-1

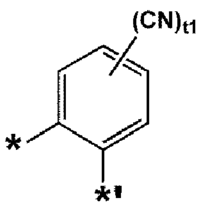
Formula 6-2

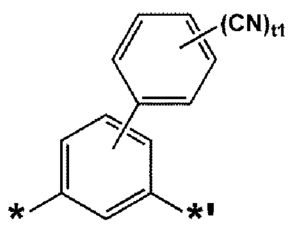
Formula 6-3

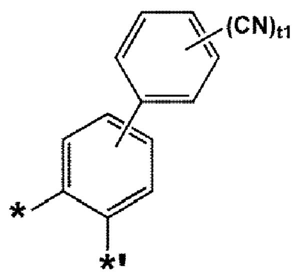
Formula 6-4

wherein, in Formula 17-1 to 17-3, 3-15, 3-28, and 6-1 to 6-4,

$R_{30}$ and $R_{40}$ are each independently selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, - $CF_3$, $-CF_2H$, and $-CFH_2$;

a phenyl group, a pyridinyl group, a pyrimidinyl group, a pyrazinyl group, a pyridazinyl group, a triazinyl group, a naphthyl group, a fluorenyl group, a carbazolyl group, a dibenzofuranyl group, and a dibenzothiophenyl group;

a phenyl group, a pyridinyl group, a pyrimidinyl group, a pyrazinyl group, a pyridazinyl group, a triazinyl group, a naphthyl group, a fluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, $-CF_3$, $-CF_2H$, $-CFH_2$, a phenyl group, a pyridinyl group, a pyrimidinyl group, a pyrazinyl group, a pyridazinyl group, a triazinyl group, a naphthyl group, a fluorenyl group, a carbazolyl group, a dibenzofuranyl group, and a dibenzothiophenyl group; and

$-Si(Q_1)(Q_2)(Q_3)$,

$Z_1$ is selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, $-CF_3$, $-CF_2H$, $-CFH_2$, a phenyl group, a phenyl group substituted with a cyano group, a naphthyl group, a pyridinyl group, a pyrimidinyl group, a pyrazinyl group, a pyridazinyl group, a triazinyl group, a fluorenyl group, a carbazolyl group, a dibenzofuranyl group, a dibenzothiophenyl group, and $-Si(Q_{11})(Q_{12})(Q_{13})$,

d4 is an integer selected from 0 to 4,

t1 is 1 or 2,

wherein $Q_1$ to $Q_3$ and $Q_{11}$ to $Q_{13}$ are each independently selected from hydrogen, a $C_1$-$C_{10}$ alkyl group, a $C_1$-$C_{10}$ alkoxy group, a phenyl group, and a naphthyl group, and

* and *' each indicate a binding site to an adjacent atom.

**8.** The organic light-emitting device of any of claims 1-7, wherein the host comprises one selected from Compounds A1 to A11:

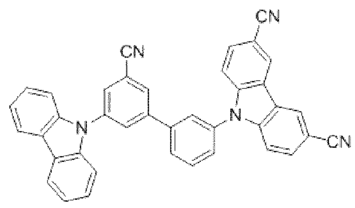
A1

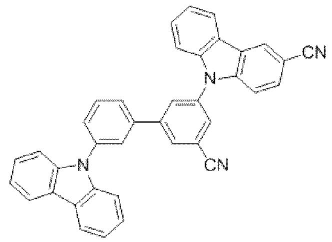
A2

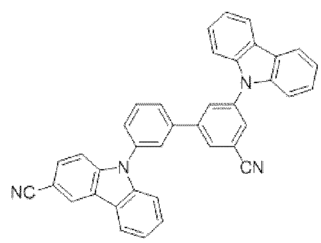
A3

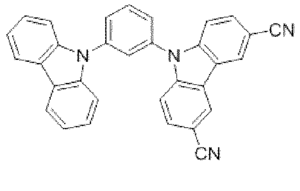
A4

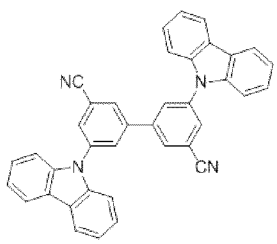
A5

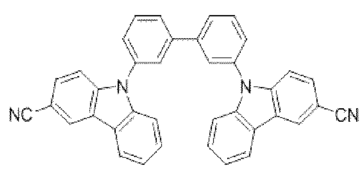
A6

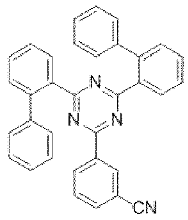

A7

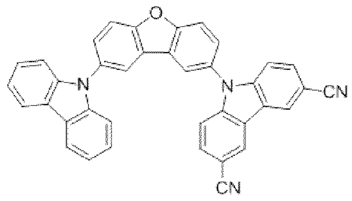

A8

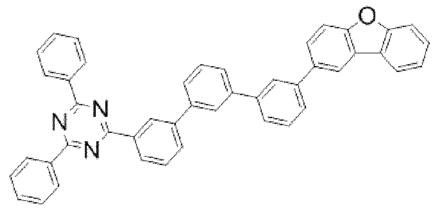

A9

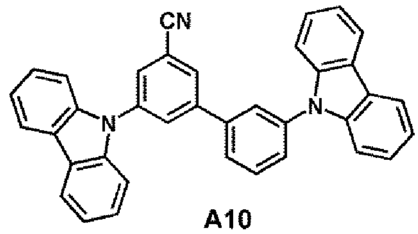

A10

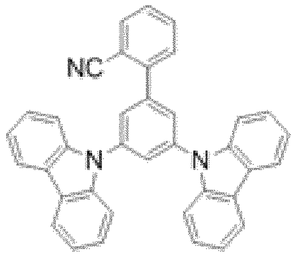

A11

9. The organic light-emitting device of any of claims 1-8, wherein the phosphorescent dopant comprises an organometallic compound represented by Formula 81:

Formula 81 $M(L_{81})n_{81}(L_{82})_{n82}$

Formula 81A

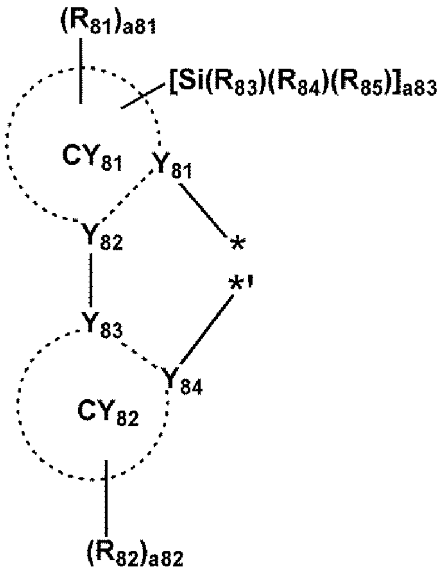

wherein, in Formulae 81 and 81A,

M is selected from iridium (Ir), platinum (Pt), osmium (Os), titanium (Ti), zirconium (Zr), hafnium (Hf), europium (Eu), terbium (Tb), thulium (Tm), and rhodium (Rh),

$L_{81}$ is a ligand represented by Formula 81A, n81 is an integer selected from 1 to 3; when n81 is 2 or greater, at least two $L_{81}$ groups are identical to or different from each other,

$L_{82}$ is an organic ligand, n82 is an integer selected from 0 to 4; when n82 is 2 or greater, at least two $L_{82}$ groups are identical to or different from each other,
$Y_{81}$ to $Y_{84}$ are each independently carbon (C) or nitrogen (N),
$Y_{81}$ and $Y_{82}$ are bound via a single bond or a double bond, $Y_{83}$ and $Y_{84}$ are bound via a single bond or a double bond,
$CY_{81}$ and $CY_{82}$ are each independently selected from a $C_5$-$C_{30}$ carbocyclic group and a $C_1$-$C_{30}$ heterocyclic group,
$CY_{81}$ and $CY_{82}$ are optionally and additionally bound via an organic linking group,
$R_{81}$ to $R_{85}$ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-Si(Q_{81})(Q_{82})(Q_{83})$, $-N(Q_{84})(Q_{85})$, $-B(Q_{88})(Q_{87})$, and $-P(=O)(Q_{88})(Q_{89})$,
a81 to a83 are each independently an integer selected from 0 to 5,
when a81 is 2 or greater, at least two $R_{81}$ groups are identical to or different from each other,
when a82 is 2 or greater, at least two $R_{82}$ groups are identical to or different from each other,
when a81 is 2 or greater, $R_{81}$ groups that are adjacent to each other are optionally bound to form a saturated or unsaturated ring,
when a82 is 2 or greater, $R_{82}$ groups that are adjacent to each other are optionally bound to form a saturated or unsaturated ring,
in Formula 81A, * and *' each indicate a binding site to M in Formula 81, and
at least one substituent of the substituted $C_1$-$C_{60}$ alkyl group, substituted $C_2$-$C_{60}$ alkenyl group, substituted $C_2$-$C_{60}$ alkynyl group, substituted $C_1$-$C_{60}$ alkoxy group, substituted $C_3$-$C_{10}$ cycloalkyl group, substituted $C_1$-$C_{10}$ heterocycloalkyl group, substituted $C_3$-$C_{10}$ cycloalkenyl group, substituted $C_1$-$C_{10}$ heterocycloalkenyl group, substituted $C_6$-$C_{60}$ aryl group, substituted $C_6$-$C_{60}$ aryloxy group, substituted $C_6$-$C_{60}$ arylthio group, substituted $C_7$-$C_{60}$ arylalkyl group, substituted $C_1$-$C_{60}$ heteroaryl group, substituted $C_1$-$C_{60}$ heteroaryloxy group, substituted $C_1$-$C_{60}$ heteroarylthio group, substituted $C_2$-$C_{60}$ heteroarylalkyl group, substituted monovalent non-aromatic condensed polycyclic group, and substituted monovalent non-aromatic condensed heteropolycyclic group is selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, and $-Si(Q_{91})(Q_{92})(Q_{93})$,
wherein $Q_{81}$ to $Q_{89}$ and $Q_{91}$ to $Q_{93}$ are each independently selected from hydrogen, deuterium, a $C_1$-$C_{60}$ alkyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group.

**10.** The organic light-emitting device of claim 9, wherein

$Y_{81}$ is N, $Y_{82}$ and $Y_{83}$ are each C, $Y_{84}$ is N or C, and
$CY_{81}$ and $CY_{82}$ are each independently selected from a cyclopentadiene group, a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene

group, a pentaphene group, a rubicene group, a coronene group, an ovalene group, a pyrrole group, an isoindole group, an indole group, an indazole group, a pyrazole group, an imidazole group, a triazole group, an oxazole group, an isoxazole group, an oxadiazole group, a thiazole group, an isothiazole group, a thiadiazole group, a purine group, a furan group, a thiophene group, a pyridine group, a pyrimidine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, a benzofuran group, a benzothiophene group, an iso-benzothiazole group, a benzoxazole group, an isobenzoxazole group, a benzocarbazole group, a dibenzocarbazole group, an imidazopyridine group, an imidazopyrimidine group, a dibenzofuran group, a dibenzothiophene group, a dibenzothiophene sulfone group, a carbazole group, a dibenzosilole group, a 2,3-dihydro-1H-imidazole group, and a 2,3-dihydro-1H-imidazopyrazine group; or

wherein, in Formula 81A,

$Y_{81}$, $Y_{83}$, and $Y_{84}$ are each C,

$Y_{82}$ is N,

$CY_{81}$ is selected from a) a condensed ring in which i) a 5-membered ring including at least one N as a ring-forming atom is condensed with ii) a 6-membered ring selected from a benzene group, a pyridine group, a pyrazine group, a pyrimidine group, and a pyridazine group; and b) a 5-membered ring including at least one N as a ring-forming atom, and

$CY_{82}$ is selected from a benzene group, a naphthalene group, a fluorene group, a dibenzofuran group, a dibenzothiophene group, a pyridine group, a pyrimidine group, a quinoline group, and an isoquinoline group.

**11.** The organic light-emitting device of claims 9 or 10, wherein $R_{81}$ and $R_{82}$ are each independently selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, and a $C_1$-$C_{20}$ alkoxy group;

a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$,$-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a

cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and

$-B(Q_{86})(Q_{87})$ and $-P(=O)(Q_{88})(Q_{89})$,

wherein $Q_{86}$ to $Q_{89}$ are each independently selected from

$-CH_3$, $-CD_3$, $-CD_2H$, $-CDH_2$, $-CH_2CH_3$, $-CH_2CD_3$, $-CH_2CD_2H$, $-CH_2CDH_2$,$-CHDCH_3$, $-CHDCD_2H$, $-CHDCDH_2$, $-CHDCD_3$, $-CD_2CD_3$, $-CD_2CD_2H$, and $-CD_2CDH_2$;

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group; and

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group, each substituted with at least one selected from deuterium, a $C_1$-$C_{10}$ alkyl group, and a phenyl group; or

wherein, in Formula 81A, at least one $R_{81}$ in the number of a81, at least one $R_{82}$ in the number of a82, or any combination thereof is a cyano group.

12. The organic light-emitting device of any of claims 9-11, wherein, in Formula 81, $L_{81}$ is selected from ligands represented by Formulae 81A-1 to 81A-8:

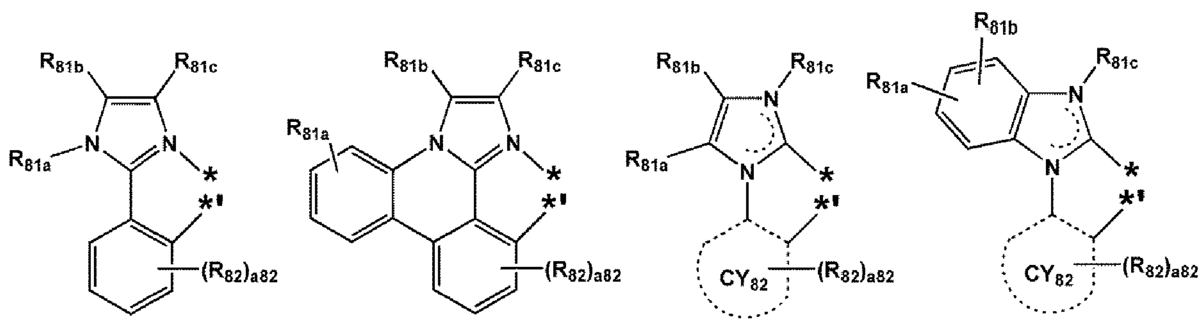

Formula 81A-1 Formula 81A-2 Formula 81A-3 Formula 81A-4

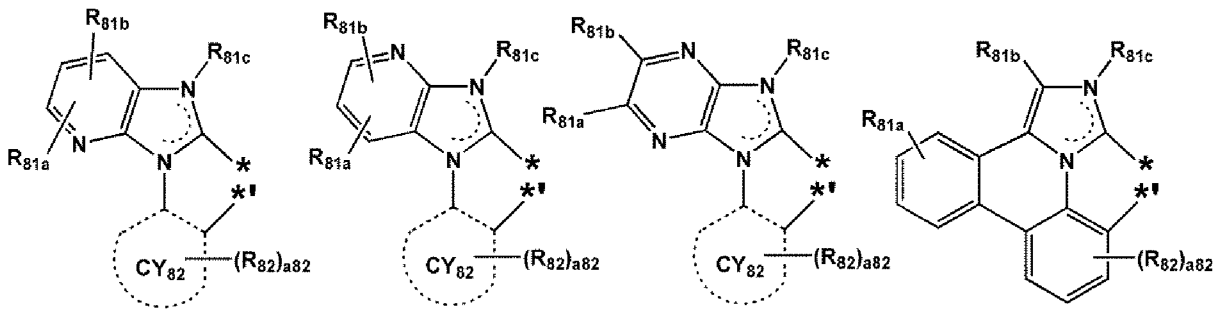

Formula 81A-5 Formula 81A-6 Formula 81A-7 Formula 81A-8

wherein, in Formulae 81A-1 to 81A-8,

$CY_{82}$, $R_{82}$, a82, *, and *' are the same as those defined in claim 9, and
$R_{81a}$, $R_{81b}$, and $R_{81c}$ are each the same as $R_{81}$ as defined in claim 9.

**13.** The organic light-emitting device of claim 12, wherein, in Formulae 81A-1 to 81A-8, $CY_{82}$ is selected from a benzene group, a naphthalene group, a fluorene group, a dibenzofuran group, a dibenzothiophene group, a pyridine group, a pyrimidine group, a quinoline group, and an isoquinoline group.

**14.** The organic light-emitting device of claim 12, wherein, in Formulae 81A-1 to 81A-8, at least one of $R_{81a}$, $R_{81b}$, $R_{81c}$, and $R_{82}$ in the number of a82 is each a cyano group.

**15.** The organic light-emitting device of any of claims 1-14, wherein, the dopant is selected from following compounds:

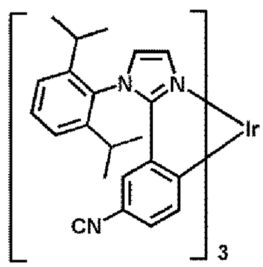

PD79

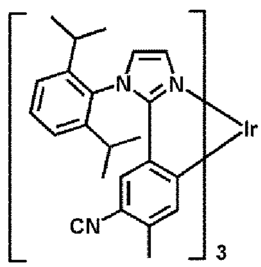

PD80

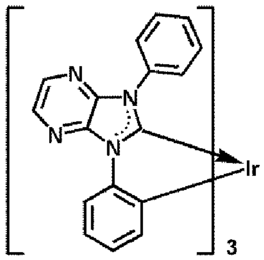

PD81

**Patentansprüche**

**1.** Organische lichtemittierende Vorrichtung, umfassend:

eine erste Elektrode;
eine zweite Elektrode, die der ersten Elektrode zugewandt ist; und
eine organische Schicht, die zwischen der ersten Elektrode und der zweiten Elektrode angeordnet ist, wobei die organische Schicht eine Emissionsschicht beinhaltet,
wobei die Emissionsschicht einen Wirt und einen Dotierstoff umfasst,
der Dotierstoff einen phosphoreszierenden Dotierstoff umfasst, und **dadurch gekennzeichnet, dass**:

i) Bedingung 1, 2, 3 und 4 alle erfüllt sind; oder
ii) wenn Bedingung 1 und 4 erfüllt sind und mindestens eine von Bedingung 2 und 3 nicht erfüllt ist, Bedingung 5-1 erfüllt ist; oder
iii) wenn mindestens eine von Bedingung 1 und 4 nicht erfüllt ist und Bedingung 2 und 3 erfüllt sind, Bedingung 6-1 erfüllt ist; oder
iv) wenn mindestens eine von Bedingung 1 und 4 nicht erfüllt ist und mindestens eine von Bedingung 2 und 3 nicht erfüllt ist, Bedingung 5-1 und 6-1 beide erfüllt sind:

Bedingung 1

$$E^*_{ox,Dotierstoff} \geq E_{red,Wirt}$$

Bedingung 2

$$E^*_{red,Dotierstoff} \leq E_{ox,Wirt}$$

Bedingung 3

$$E_{ox,Dotierstoff} \geq E^*_{red,Wirt}$$

Bedingung 4

$$E_{red,Dotierstoff} \leq E^*_{ox,Wirt}$$

Bedingung 5-1

$$T1_{Dotierstoff}-0,4\ eV < |E_{red,Wirt}-E_{ox,Dotierstoff}| < T1_{Dotierstoff}+0,3\ eV$$

Bedingung 6-1

$$T1_{Dotierstoff}-0,4\ eV < |E_{red,Dotierstoff}-E_{ox,Wirt}| < T1_{Dotierstoff}+0,3\ eV$$

wobei "$E^*_{ox,Dotierstoff}$" ein Erregungszustand-Oxidationspotential (eV) des Dotierstoffs darstellt,

"$E^*_{red,Dotierstoff}$" ein Erregungszustand-Reduktionspotential (eV) des Dotierstoffs darstellt,
"$E_{ox,Dotierstoff}$" ein Grundzustand-Oxidationspotential (eV) des Dotierstoffs darstellt,
"$E_{red,Dotierstoff}$" ein Grundzustand-Reduktionspotential (eV) des Dotierstoffs darstellt,
"$E^*_{red,Wirt}$" ein Erregungszustand-Reduktionspotential (eV) des Wirts darstellt,
"$E^*_{ox,Wirt}$" ein Erregungszustand-Oxidationspotential (eV) des Wirts darstellt,
"$E_{red,Wirt}$" ein Grundzustand-Reduktionspotential (eV) des Wirts darstellt,
"$E_{ox,Wirt}$" ein Grundzustand-Oxidationspotential (eV) des Wirts darstellt,
$E^*_{ox,Dotierstoff}$ gleich wie $E_{ox,Dotierstoff}$-$T1_{Dotierstoff}$ ist,
$E^*_{red,Dotierstoff}$ gleich wie $E_{red,Dotierstoff}$+$T1_{Dotierstoff}$ ist,
$E^*_{ox,Wirt}$ gleich wie $E_{ox,Wirt}$-$S1_{Wirt}$ ist,
$E^*_{red,Wirt}$ gleich wie $E_{red,Wirt}$+$S1_{Wirt}$ ist,
"$T1_{Dotierstoff}$" das niedrigste Triplett-Energieniveau (eV) des Dotierstoffs darstellt,
"$S1_{Wirt}$" das niedrigste Singlett-Energieniveau (eV) des Wirts darstellt, $E_{ox,Dotierstoff}$ und $E_{ox,Wirt}$ unter Verwendung von cyclischer Voltammetrie (CV) gemessen werden,
$E_{red,Dotierstoff}$ und $E_{red,Wirt}$ unter Verwendung von Differenzimpuls-Voltammetrie gemessen werden,
$T1_{Dotierstoff}$ aus einem Photolumineszenzspektrum (PL) des Dotierstoffs in Lösung berechnet wird, und
$S1_{Wirt}$ aus einem PL-Spektrum des Wirts in Lösung berechnet wird,

wobei "eV" für "Elektronenvolt" steht.

**2.** Organische lichtemittierende Vorrichtung nach Anspruch 1, wobei

Bedingung 1 und 3 nicht erfüllt sind, und
Bedingung 2, 4, 5-1, und 6-1 erfüllt sind.

**3.** Organische lichtemittierende Vorrichtung nach Anspruch 1, wobei

Bedingung 3 und 6-1 nicht erfüllt sind, und
Bedingung 1, 2, 4 und 5-1 erfüllt sind.

**4.** Organische lichtemittierende Vorrichtung nach einem der Ansprüche 1-3, wobei

der Wirt i) eine Donorverbindung oder ii) eine Akzeptorverbindung umfasst,
wobei die Akzeptorverbindung eine Verbindung umfasst, die mindestens eine elektronenziehende Gruppe beinhaltet,
wobei die elektronenziehende Gruppe ausgewählt ist aus:

-F, $-CFH_2$, $-CF_2H$, $-CF_3$, -CN und $-NO_2$;
einer $C_1$-$C_{60}$-Alkylgruppe, substituiert mit mindestens einer Gruppe, ausgewählt aus -F, - $CFH_2$, $-CF_2H$, $-CF_3$, -CN und $-NO_2$;
einer $C_1$-$C_{60}$-Heteroarylgruppe und einer einwertigen nicht-aromatischen kondensierten polycyclischen heterocyclischen Gruppe, die jeweils *=N-*' als ringbildende Gruppierung beinhalten; und
einer $C_1$-$C_{60}$-Heteroarylgruppe und einer einwertigen nichtaromatischen kondensierten polyzyklischen heterozyklischen Gruppierung, die jeweils *=N-*' als ringbildende Gruppierung beinhalten und jeweils mit mindestens einem substituiert sind, ausgewählt aus Deuterium, -F, - $CFH_2$, $-CF_2H$, $-CF_3$, -Cl, -Br, I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkinylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_7$-$C_{60}$-Arylalkylgruppe, einer substituierten oder unsubstituierten $C_1$-$C_{60}$-Heteroarylgruppe, einer substituierten oder unsubstituierten $C_1$-$C_{60}$-Heteroaryloxygruppe, einer substituierten oder unsubstituierten $C_1$-$C_{60}$-Heteroarylthiogruppe, einer substituierten oder unsubstituierten $C_2$-$C_{60}$-Heteroarylalkylgruppe, einer substituierten oder unsubstituierten einwertigen nicht-aromatischen kondensierten polycyclischen Gruppe und einer substituierten oder unsubstituierten einwertigen nicht-aromatischen kondensierten heteropolycyclischen Gruppe;
vorzugsweise wobei die Akzeptorverbindung eine durch Formel A-1 dargestellte Verbindung, eine durch Formel A-2 dargestellte Verbindung oder eine beliebige Kombination davon umfasst:

Formel A-1 $Ar_{11}$-$(L_{11})_{a11}$-$Ar_{12}$

Formel A-2

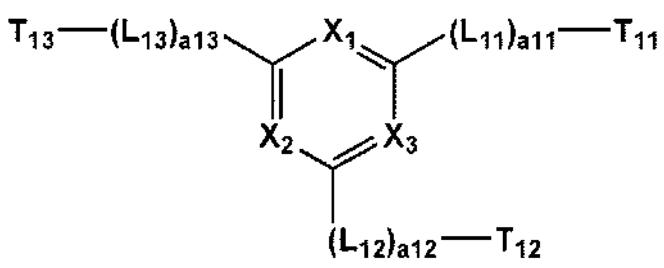

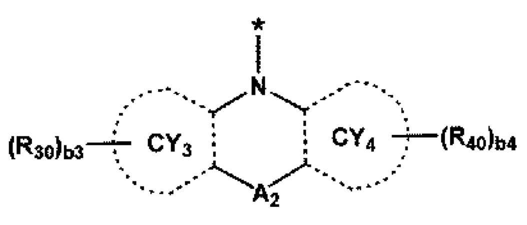

Formel 13

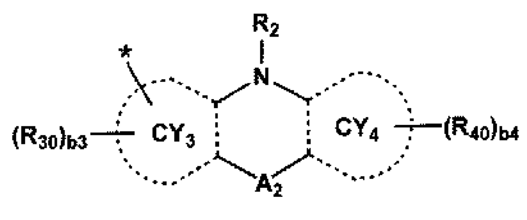

Formel 14

wobei, in Formel A-1, A-2, 13 und 14,
$Ar_{11}$ und $Ar_{12}$ jeweils unabhängig ausgewählt sind aus Gruppen, die durch Formel 13 und 14 dargestellt sind, $X_1$ N oder $C(T_{14})$ ist, $X_2$ N oder $C(T_{15})$ ist und $X_3$ N oder $C(T_{16})$ ist, vorausgesetzt, dass mindestens eines von $X_1$ bis $X_3$ N ist,
$L_{11}$ bis $L_{13}$ jeweils unabhängig ausgewählt sind aus:

einer Einfachbindung, einer Phenylengruppe, einer Pyridinylengruppe, einer Pyrimidinylengruppe, einer Pyrazinylengruppe, einer Pyridazinylengruppe, einer Triazinylengruppe, einer Naphthylengruppe, einer

Fluorenylengruppe, einer Carbazolylengruppe, einer Dibenzofuranylengruppe und einer Dibenzothiophenylengruppe; und

einer Phenylengruppe, einer Pyridinylengruppe, einer Pyrimidinylengruppe, einer Pyrazinylengruppe, einer Pyridazinylengruppe, einer Triazinylengruppe, einer Naphthylengruppe, einer Fluorenylengruppe, einer Carbazolylengruppe, einer Dibenzofuranylengruppe, und einer Dibenzothiophenylengruppe, jeweils substituiert mit mindestens einer Gruppe, ausgewählt aus Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe einer Carbonsäuregruppe oder einem Salz davon, einer Sulfonsäuregruppe oder einem Salz davon, einer Phosphorsäuregruppe oder einem Salz davon, einer $C_1$-$C_{10}$-Alkylgruppe, einer $C_1$-$C_{10}$-Alkoxygruppe, $-CF_3$, $-CF_2H$, $-CFH_2$, einer Phenylgruppe, einer mit einer Cyanogruppe substituierten Phenylgruppe, einer Naphthylgruppe, einer Pyridinylgruppe, einer Pyrimidinylgruppe, einer Pyrazinylgruppe, einer Pyridazinylgruppe, einer Triazinylgruppe, einer Fluorenylgruppe, einer Carbazolylgruppe, einer Dibenzofuranylgruppe, einer Dibenzothiophenylgruppe und $-Si(Q_{11})(Q_{12})(Q_{13})$,

a11 bis a13 jeweils unabhängig eine ganze Zahl sind, ausgewählt aus 0 bis 5; wenn a11 2 oder größer ist, mindestens zwei $L_{11}$-Gruppen identisch oder voneinander verschieden sind; wenn a12 2 oder größer ist, mindestens zwei $L_{12}$-Gruppen identisch oder voneinander verschieden sind; und wenn a13 2 oder größer ist, mindestens zwei $L_{13}$-Gruppen identisch oder voneinander verschieden sind,

$CY_3$ und $CY_4$ jeweils unabhängig ausgewählt sind aus einer Benzolgruppe, einer Naphthalingruppe, einer Fluorengruppe, einer Carbazolgruppe, einer Benzocarbazolgruppe, einer Indolocarbazolgruppe, einer Dibenzofurangruppe und einer Dibenzothiophengruppe,

$A_2$ ausgewählt ist aus:

einer Einfachbindung, einer $C_1$-$C_4$-Alkylengruppe und einer $C_2$-$C_4$-Alkenylengruppe; und

einer $C_1$-$C_4$-Alkylengruppe und einer $C_2$-$C_4$-Alkenylengruppe, jeweils substituiert mit mindestens einem, ausgewählt aus Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe einer Carbonsäuregruppe oder einem Salz davon, einer Sulfonsäuregruppe oder einem Salz davon, einer Phosphorsäuregruppe oder einem Salz davon, einer $C_1$-$C_{10}$-Alkylgruppe, einer $C_1$-$C_{10}$-Alkoxygruppe, einer Phenylgruppe, einer Naphthylgruppe, einer Pyridinylgruppe, einer Pyrimidinylgruppe, einer Pyrazinylgruppe, einer Pyridazinylgruppe, einer Triazinylgruppe, einer Fluorenylgruppe, einer Carbazolylgruppe, einer Dibenzofuranylgruppe, einer Dibenzothiophenylgruppe und $-Si(Q_{21})(Q_{22})(Q_{23})$,

Tu bis $T_{16}$, $R_2$, $R_{30}$ und $R_{40}$ jeweils unabhängig ausgewählt sind aus Wasserstoff, Deuterium, -F, -Cl, -Br, -I, einer Hydroxylgruppe, einer Cyanogruppe (CN), einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkinylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_7$-$C_{60}$-Arylalkylgruppe, einer substituierten oder unsubstituierten $C_1$-$C_{60}$-Heteroarylgruppe, einer substituierten oder unsubstituierten $C_1$-$C_{60}$-Heteroaryloxygruppe, einer substituierten oder unsubstituierten $C_1$-$C_{60}$-Heteroarylthiogruppe, einer substituierten oder unsubstituierten $C_2$-$C_{60}$-Heteroarylalkylgruppe, einer substituierten oder unsubstituierten einwertigen nicht-aromatischen kondensierten polycyclischen Gruppe, einer substituierten oder unsubstituierten einwertigen nicht-aromatischen kondensierten heteropolycyclischen Gruppe und $-Si(Q_1)(Q_2)(Q_3)$,

b3 und b4 jeweils unabhängig eine ganze Zahl ausgewählt aus 0 bis 10 sind, und

mindestens ein Substituent der substituierten $C_1$-$C_{60}$-Alkylgruppe, substituierten $C_2$-$C_{60}$-Alkenylgruppe, substituierten $C_2$-$C_{60}$-Alkinylgruppe, substituierten $C_1$-$C_{60}$-Alkoxygruppe, substituierten $C_3$-$C_{10}$-Cycloalkylgruppe, substituierten $C_1$-$C_{10}$-Heterocycloalkylgruppe, substituierten $C_3$-$C_{10}$-Cycloalkenylgruppe, substituierten $C_1$-$C_{10}$-Heterocycloalkenylgruppe, substituierten $C_6$-$C_{60}$-Arylgruppe, substituierten $C_6$-$C_{60}$-Aryloxygruppe, substituierten $C_6$-$C_{60}$-Arylthiogruppe, substituierten $C_7$-$C_{60}$-Arylalkylgruppe, substituierten $C_1$-$C_{60}$-Heteroarylgruppe, substituierten $C_1$-$C_{60}$-Heteroaryloxygruppe, substituierten $C_1$-$C_{60}$-Heteroarylthiogruppe, substituierten $C_2$-$C_{60}$-Heteroarylalkylgruppe, substituierten einwertigen nicht-aromatischen kondensierten polycyclischen Gruppe und substituierten einwertigen nicht-aromatischen kondensierten heteropolycyclischen Gruppe ausgewählt ist aus Deuterium, -F, -Cl, -Br, -I, einer Hydroxylgruppe, einer Cyanogruppe, einer Nitrogruppe, einer Aminogruppe, an Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer einwertigen nicht-aromatischen kondensierten polycyclischen Gruppe, einer einwertigen nicht-aromatischen kondensierten heteropolycyclischen Gruppe und -Si($Q_{31}$)($Q_{32}$)($Q_{33}$),

wobei $Q_1$ bis $Q_3$, $Q_{11}$ bis $Q_{13}$, $Q_{21}$ bis $Q_{23}$ und $Q_{31}$ bis $Q_{33}$ jeweils unabhängig ausgewählt sind aus Wasserstoff, Deuterium, einer $C_1$-$C_6$-Alkylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_1$-$C_{60}$-Heteroarylgruppe, einer einwertigen nicht-aromatischen kondensierten polycyclischen Gruppe und einer einwertigen nicht-aromatischen kondensierten heteropolycyclischen Gruppe.

**5.** Organische lichtemittierende Vorrichtung nach Anspruch 4, wobei $Ar_{11}$ und $Ar_{12}$ jeweils unabhängig ausgewählt sind aus Gruppen, die in Formel 13-1 bis 13-8 und 14-1 bis 14-8 dargestellt sind:

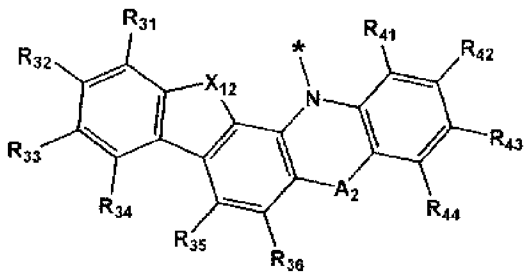

Formel 13-1

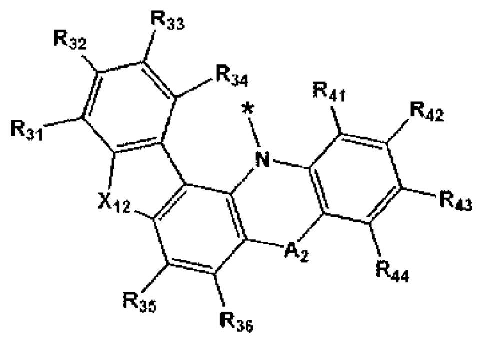

Formel 13-2

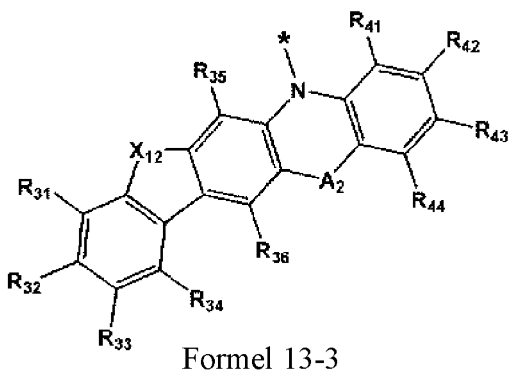

Formel 13-3

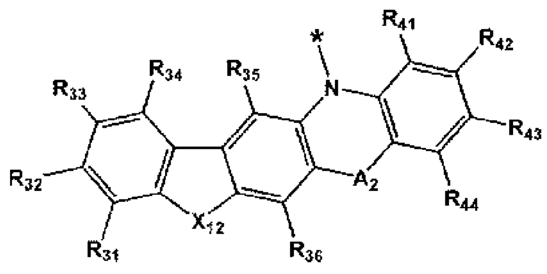

Formel 13-4

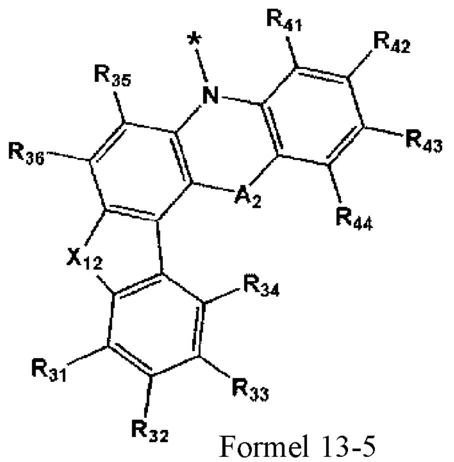

Formel 13-5

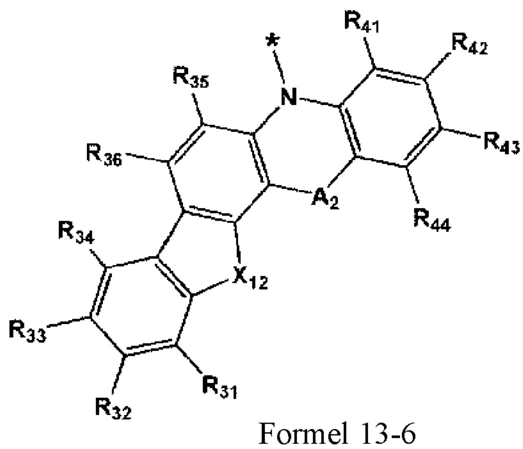

Formel 13-6

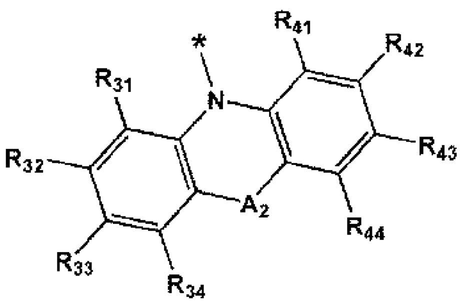

Formel 13-7

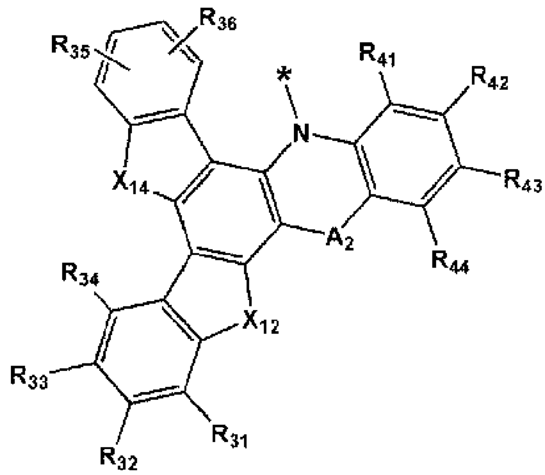

Formel 13-8

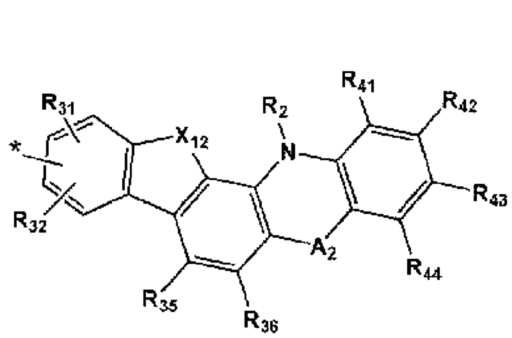

Formel 14-1

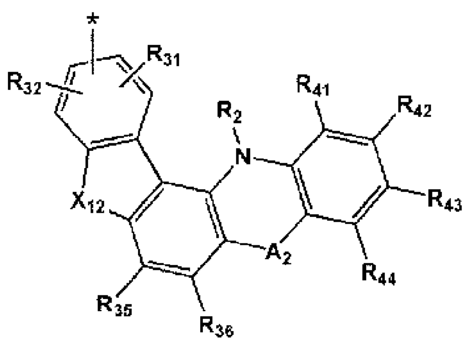

Formel 14-2

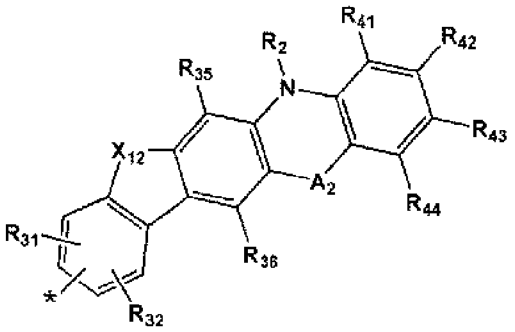

Formel 14-3

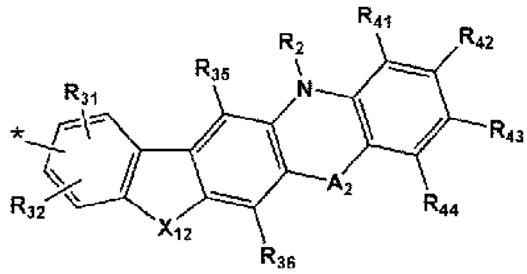

Formel 14-4

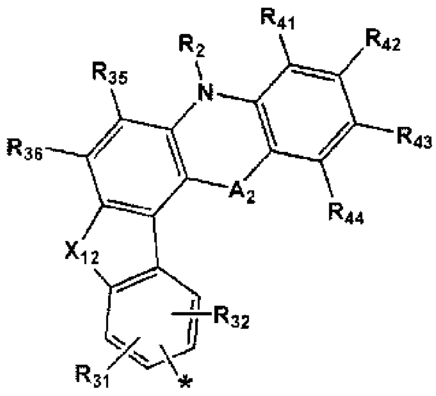

Formel 14-5

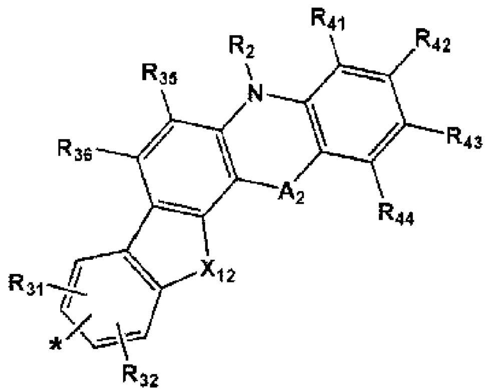

Formel 14-6

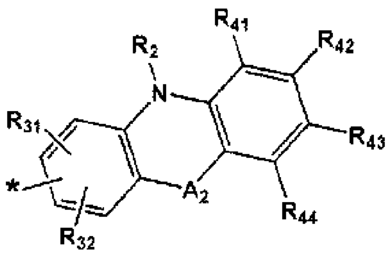

Formel 14-7

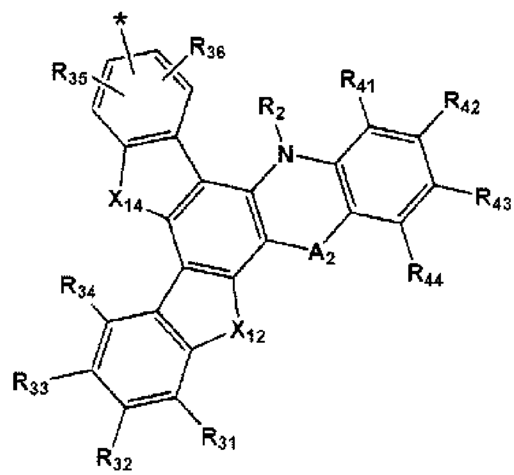

Formel 14-8

wobei, in Formel 13-1 bis 13-8 und 14-1 bis 14-8,
$X_{12}$ und $X_{14}$ jeweils unabhängig ausgewählt sind aus $C(R_{37})(R_{38})$, $N(R_{39})$, O und S,
$R_2$ und $A_2$ jeweils gleich wie jene sind, die in Anspruch 5 definiert sind,
$R_{31}$ bis $R_{39}$ jeweils unabhängig gleich sind, wie $R_{30}$ definiert in Anspruch 5 sind,
$R_{41}$ bis $R_{44}$ jeweils unabhängig gleich sind, wie $R_{40}$ definiert in Anspruch 5 sind, und
* eine Bindungsstelle zu einem benachbarten Atom angibt.

**6.** Organische lichtemittierende Vorrichtung nach Anspruch 4, wobei $Ar_{11}$ und $Ar_{12}$ jeweils unabhängig ausgewählt sind aus Gruppen, die in Formel 17-1 bis 17-3 dargestellt sind:

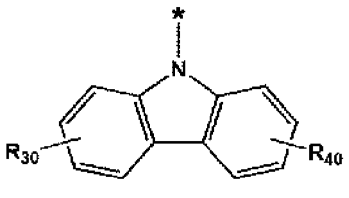
Formel 17-1

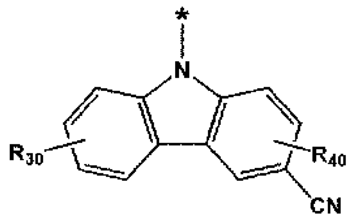
Formel 17-2

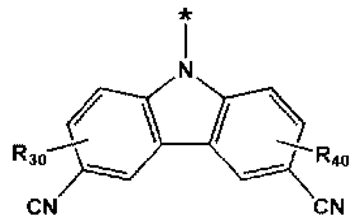
Formel 17-3

wobei, in Formel 17-1 bis 17-3,
$R_{30}$ und $R_{40}$ jeweils unabhängig ausgewählt sind aus:

Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{10}$-Alkylgruppe, einer $C_1$-$C_{10}$-Alkoxygruppe, $-CF_3$, $-CF_2H$ und $-CFH_2$;
einer Phenylgruppe, einer Pyridinylgruppe, einer Pyrimidinylgruppe, einer Pyrazinylgruppe, einer Pyridazinylgruppe, einer Triazinylgruppe, einer Naphthylgruppe, einer Fluorenylgruppe, einer Carbazolylgruppe, einer Dibenzofuranylgruppe und einer Dibenzothiophenylgruppe;
einer Phenylgruppe, einer Pyridinylgruppe, einer Pyrimidinylgruppe, einer Pyrazinylgruppe, einer Pyridazinylgruppe, einer Triazinylgruppe, einer Naphthylgruppe, einer Fluorenylgruppe, einer Carbazolylgruppe, einer Dibenzofuranylgruppe und einer Dibenzothiophenylgruppe, jeweils substituiert mit mindestens einem, ausgewählt aus Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe einer Carbonsäuregruppe oder einem Salz davon, einer Sulfonsäuregruppe oder einem Salz davon, einer Phosphorsäuregruppe oder einem Salz davon, einer $C_1$-$C_{10}$-Alkylgruppe, einer $C_1$-$C_{10}$-Alkoxygruppe, $-CF_3$, $-CF_2H$, $-CFH_2$, einer Phenylgruppe, einer Pyridinylgruppe, einer Pyrimidinylgruppe, einer Pyrazinylgruppe, einer Pyridazinylgruppe, einer Triazinylgruppe, einer Naphthylgruppe, einer Fluorenylgruppe, einer Carbazolylgruppe, einer Dibenzofuranylgruppe, und einer Dibenzothiophenylgruppe; und
$-Si(Q_1)(Q_2)(Q_3)$,

wobei $Q_1$ bis $Q_3$ jeweils unabhängig ausgewählt sind aus Wasserstoff, einer $C_1$-$C_{10}$-Alkylgruppe, einer $C_1$-$C_{10}$-Alkoxygruppe, einer Phenylgruppe und einer Naphthylgruppe; und/oder
wobei $L_{11}$ bis $L_{13}$ jeweils unabhängig ausgewählt sind aus Gruppen, dargestellt durch Formeln 3-1 bis 3-56, vorausgesetzt, dass i) mindestens ein $L_{11}$ in der Anzahl von a11, ii) mindestens ein $L_{12}$ in der Anzahl von a12 und iii) mindestens ein $L_{13}$ in der Anzahl von a13 jeweils unabhängig ausgewählt sind aus Gruppen, dargestellt durch Formel 3-15 bis 3-56:

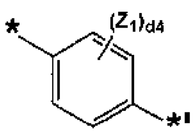
Formel 3-1

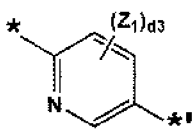
Formel 3-2

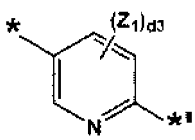
Formel 3-3

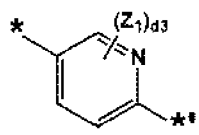
Formel 3-4

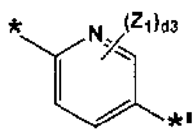
Formel 3-5

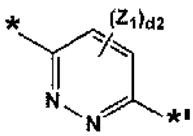
Formel 3-6

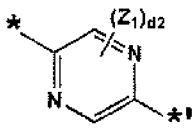
Formel 3-7

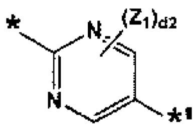
Formel 3-8

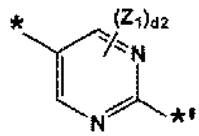
Formel 3-9

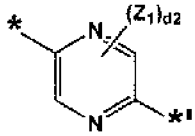
Formel 3-10

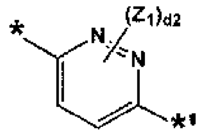
Formel 3-11

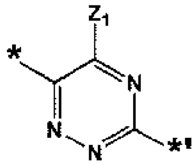
Formel 3-12

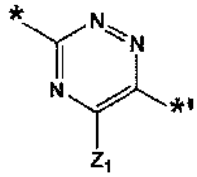
Formel 3-13

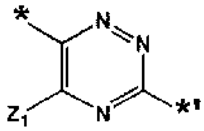
Formel 3-14

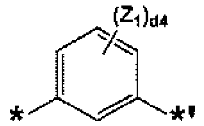
Formel 3-15

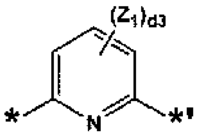
Formel 3-16

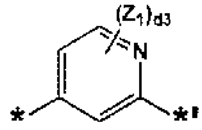
Formel 3-17

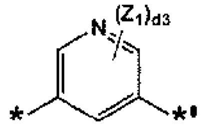
Formel 3-18

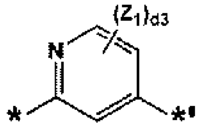
Formel 3-19

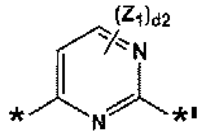
Formel 3-20

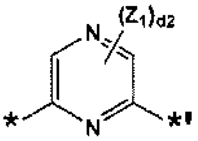
Formel 3-21

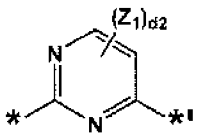
Formel 3-22

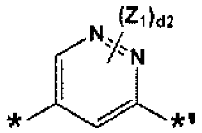
Formel 3-23

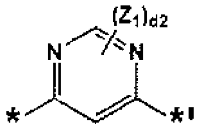
Formel 3-24

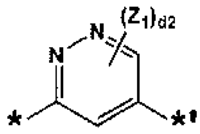
Formel 3-25

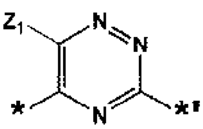
Formel 3-26

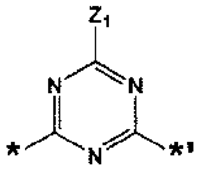
Formel 3-27

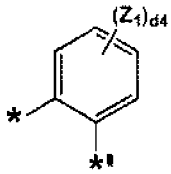
Formel 3-28

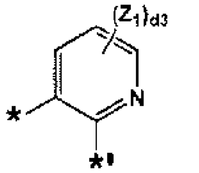
Formel 3-29

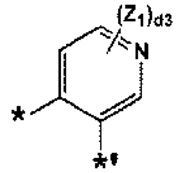
Formel 3-30

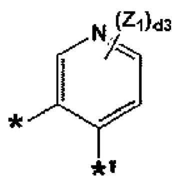
Formel 3-31

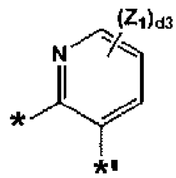
Formel 3-32

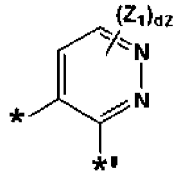
Formel 3-33

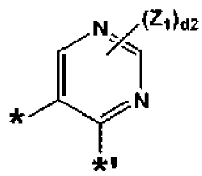
Formel 3-34

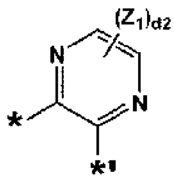
Formel 3-35

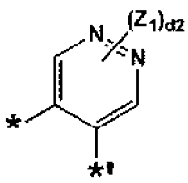
Formel 3-36

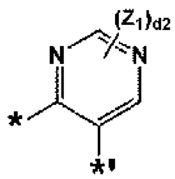
Formel 3-37

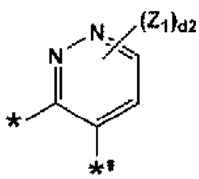
Formel 3-38

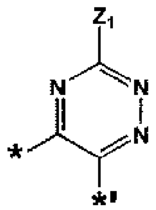
Formel 3-39

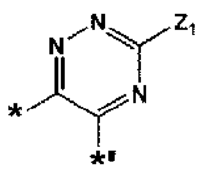
Formel 3-40

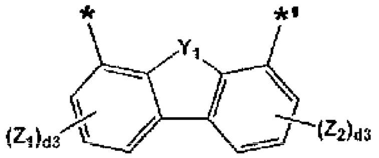

Formel 3-41

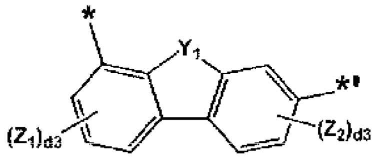

Formel 3-42

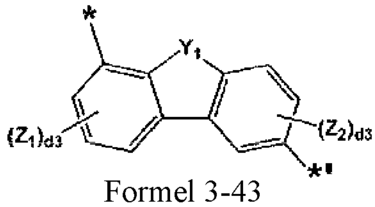

Formel 3-43

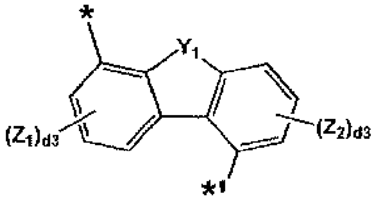

Formel 3-44

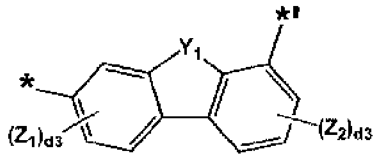

Formel 3-45

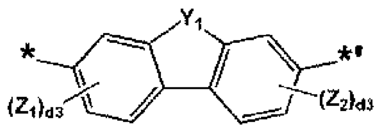

Formel 3-46

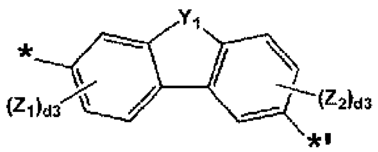

Formel 3-47

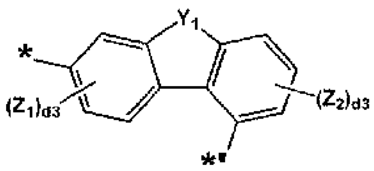

Formel 3-48

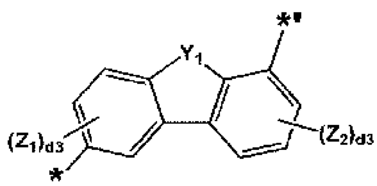

Formel 3-49

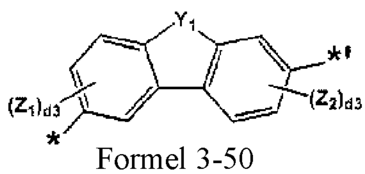

Formel 3-50

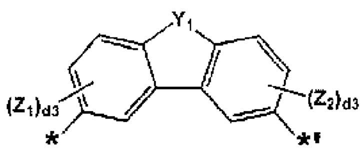

Formel 3-51

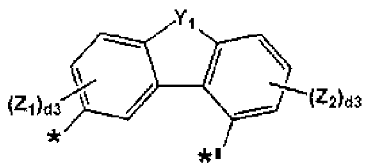

Formel 3-52

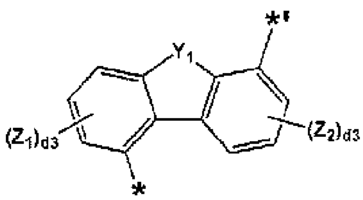

Formel 3-53

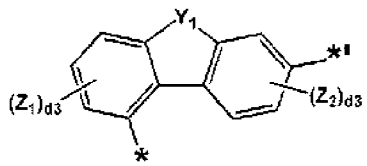

Formel 3-54

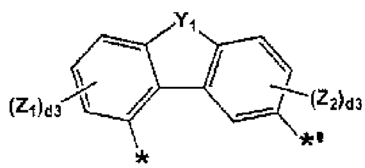

Formel 3-55

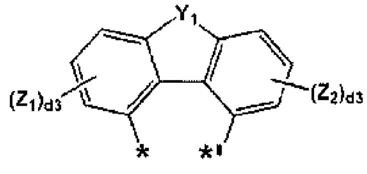

Formel 3-56

wobei, in Formel 3-1 bis 3-56,

$Y_1$ ist ausgewählt aus O, S, $C(Z_3)(Z_4)$ und $N(Z_5)$,
$Z_1$ bis $Z_5$ jeweils unabhängig ausgewählt sind aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe einer Carbonsäuregruppe oder einem Salz davon, einer Sulfonsäuregruppe oder einem Salz

davon, einer Phosphorsäuregruppe oder einem Salz davon, einer $C_1$-$C_{10}$-Alkylgruppe, einer $C_1$-$C_{10}$-Alkoxygruppe, -$CF_3$, -$CF_2H$,-$CFH_2$, einer Phenylgruppe, einer mit einer Cyanogruppe substituierten Phenylgruppe, einer Naphthylgruppe, einer Pyridinylgruppe, einer Pyrimidinylgruppe, einer Pyrazinylgruppe, einer Pyridazinylgruppe, einer Triazinylgruppe, einer Fluorenylgruppe, einer Carbazolylgruppe, einer Dibenzofuranylgruppe, einer Dibenzothiophenylgruppe und -Si($Q_{11}$)($Q_{12}$)($Q_{13}$),
wobei $Q_{11}$ bis $Q_{13}$ jeweils unabhängig ausgewählt sind aus Wasserstoff, einer $C_1$-$C_{10}$-Alkylgruppe, einer $C_1$-$C_{10}$-Alkoxygruppe, einer Phenylgruppe, einer Naphthylgruppe, einer Pyridinylgruppe, einer Pyrimidinylgruppe, einer Pyrazinylgruppe, einer Pyridazinylgruppe, einer Triazinylgruppe, einer Fluorenylgruppe, einer Carbazolylgruppe, einer Dibenzofuranylgruppe und einer Dibenzothiophenylgruppe,
d4 eine ganze Zahl ausgewählt aus 0 bis 4 ist,
d3 eine ganze Zahl ausgewählt aus 0 bis 3 ist,
d2 eine ganze Zahl ausgewählt aus 0 bis 2 ist, und
* und *' jeweils eine Bindungsstelle zu einem benachbarten Atom angeben.

7. Organische lichtemittierende Vorrichtung nach Anspruch 4, wobei Gruppen, dargestellt durch *-($L_{11}$)$_{a11}$-*', *-($L_{12}$)$a_{12}$-*' und *-($L_{13}$)$a_{13}$-*', ausgewählt sind aus Gruppen, dargestellt durch Formel 4-1 bis 4-39:

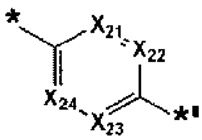
Formel 4-1

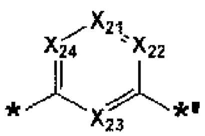
Formel 4-2

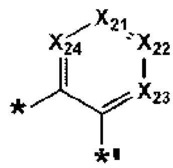
Formel 4-3

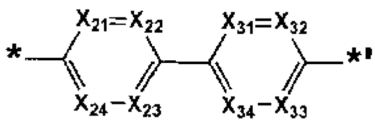
Formel 4-4

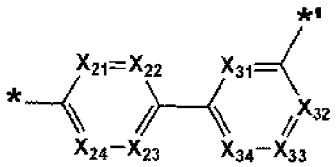
Formel 4-5

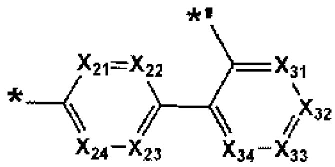
Formel 4-6

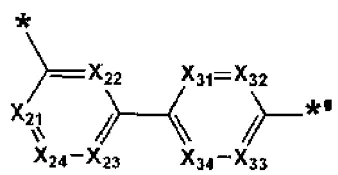
Formel 4-7

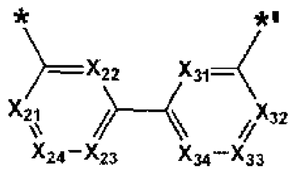
Formel 4-8

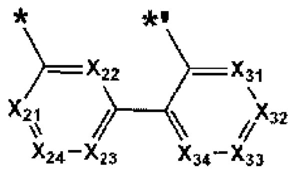
Formel 4-9

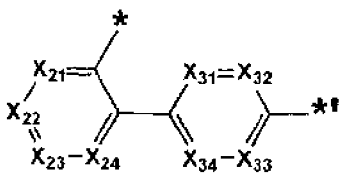
Formel 4-10

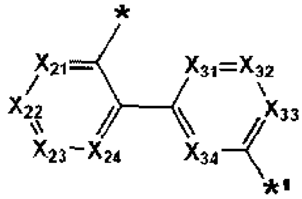
Formel 4-11

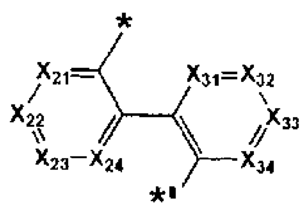
Formel 4-12

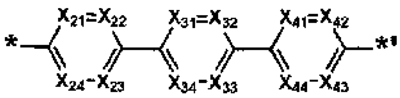
Formel 4-13

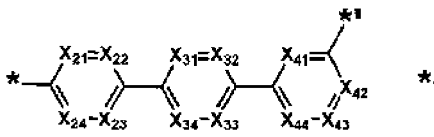
Formel 4-14

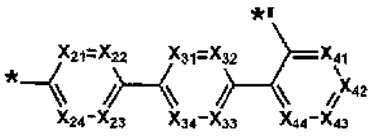
Formel 4-15

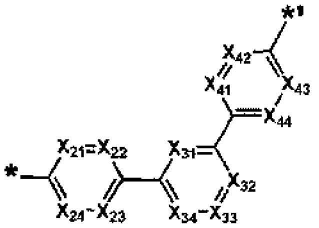
Formel 4-16

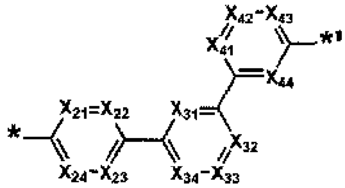
Formel 4-17

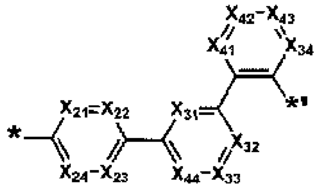
Formel 4-18

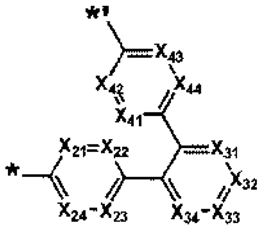
Formel 4-19

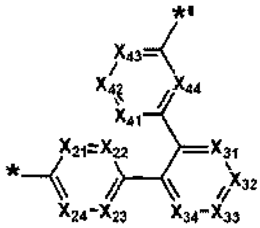
Formel 4-20

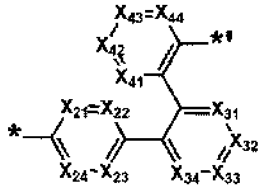
Formel 4-21

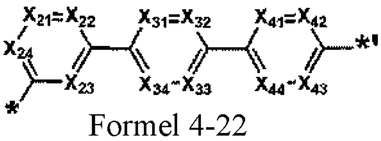
Formel 4-22

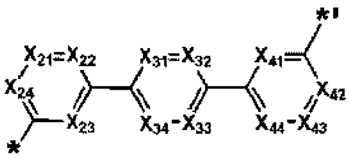
Formel 4-23

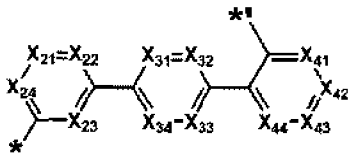
Formel 4-24

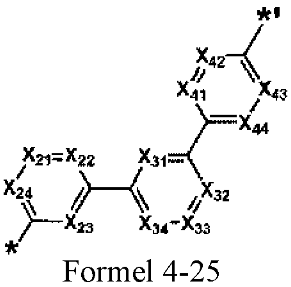
Formel 4-25

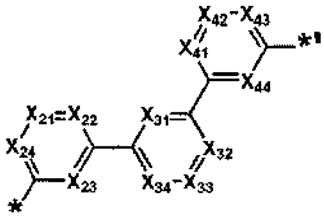
Formel 4-26

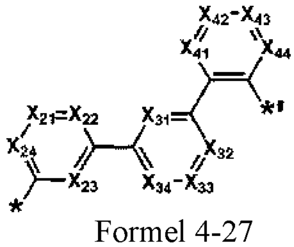
Formel 4-27

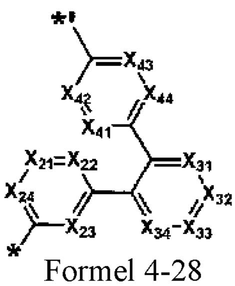
Formel 4-28

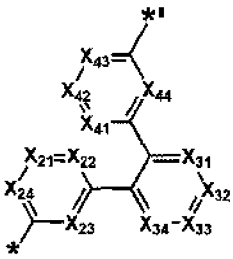
Formel 4-29

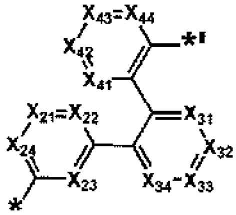
Formel 4-30

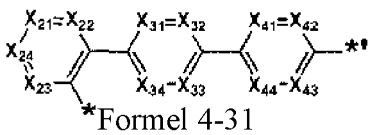
Formel 4-31

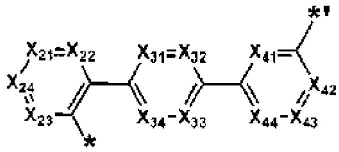
Formel 4-32

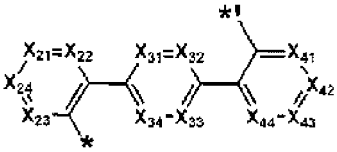
Formel 4-33

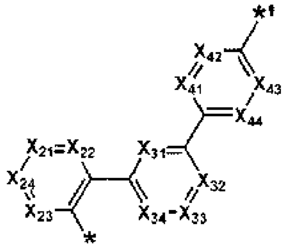
Formel 4-34

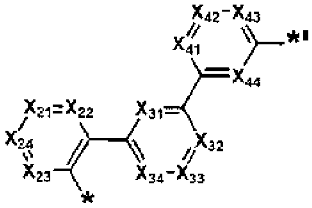
Formel 4-35

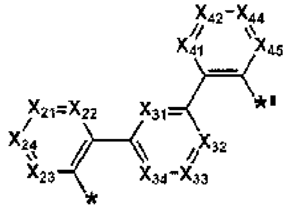
Formel 4-36

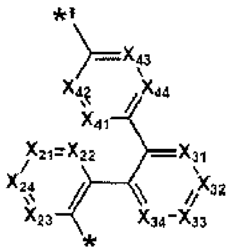
Formel 4-37

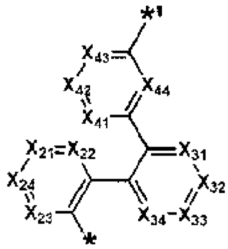
Formel 4-38

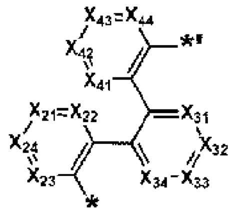
Formel 4-39

wobei, in Formel 4-1 bis 4-39,

$X_{21}$ N oder $C(Z_{21})$ ist, $X_{22}$ N oder $C(Z_{22})$ ist, $X_{23}$ N oder $C(Z_{23})$ ist, $X_{24}$ N oder $C(Z_{24})$ ist, $X_{31}$ N oder $C(Z_{31})$ ist, $X_{32}$ N oder $C(Z_{32})$ ist, $X_{33}$ N oder $C(Z_{33})$ ist, $X_{34}$ N oder $C(Z_{34})$ ist, $X_{41}$ N oder $C(Z_{41})$ ist, $X_{42}$ N oder $C(Z_{42})$ ist, $X_{43}$ N oder $C(Z_{43})$ ist und $X_{44}$ N oder $C(Z_{44})$ ist, vorausgesetzt, dass mindestens eines von $X_{21}$ bis $X_{24}$ nicht N ist, mindestens eines von $X_{31}$ bis $X_{34}$ nicht N ist und mindestens eines von $X_{41}$ bis $X_{44}$ nicht N ist,
$Z_{21}$ bis $Z_{24}$, $Z_{31}$ bis $Z_{34}$ und $Z_{41}$ bis $Z_{44}$ jeweils unabhängig ausgewählt sind aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe einer Carbonsäuregruppe oder einem Salz davon, einer Sulfonsäuregruppe oder einem Salz davon, einer Phosphorsäuregruppe oder einem Salz davon, einer $C_1$-$C_{10}$-Alkylgruppe, einer $C_1$-$C_{10}$-Alkoxygruppe, $-CF_3$, $-CF_2H$, $-CFH_2$, einer Phenylgruppe, einer mit einer Cyanogruppe substituierten Phenylgruppe, einer Naphthylgruppe, einer Pyridinylgruppe, einer Pyrimidinylgruppe, einer Pyrazinylgruppe, einer Pyridazinylgruppe, einer Triazinylgruppe, einer Fluorenylgruppe, einer Carbazolylgruppe, einer Dibenzofuranylgruppe, einer Dibenzothiophenylgruppe und $-Si(Q_{11})(Q_{12})(Q_{13})$,
wobei $Q_{11}$ bis $Q_{13}$ jeweils unabhängig ausgewählt sind aus Wasserstoff, einer $C_1$-$C_{10}$-Alkylgruppe, einer $C_1$-$C_{10}$-Alkoxygruppe, einer Phenylgruppe, einer Naphthylgruppe, einer Pyridinylgruppe, einer Pyrimidinylgruppe, einer Pyrazinylgruppe, einer Pyridazinylgruppe, einer Triazinylgruppe, einer Fluorenylgruppe, einer Carbazolylgruppe, einer Dibenzofuranylgruppe und einer Dibenzothiophenylgruppe, und
* und *' jeweils eine Bindungsstelle zu einem benachbarten Atom angeben; oder
wobei

i) die Akzeptorverbindung dargestellt ist durch Formel A-1, in der $Ar_{11}$ und $Ar_{12}$ jeweils unabhängig ausgewählt sind aus Gruppen, dargestellt durch Formeln 17-1 bis 17-3, und mindestens eines von $Ar_{11}$ und $Ar_{12}$ ausgewählt ist aus Gruppen, dargestellt durch Formeln 17-2 und 17-3;
ii) die Akzeptorverbindung dargestellt ist durch Formel A-1, in der $L_{11}$ ausgewählt ist aus Gruppen, dargestellt durch Formeln 3-15 und 3-28, und mindestens ein $L_{11}$ in der Anzahl von a11 ausgewählt ist aus Gruppen, dargestellt durch Formeln 6-1 bis 6-4; oder
iii) die Akzeptorverbindung durch Formel A-2 dargestellt ist, in der $X_1$ bis $X_3$ jeweils N sind:

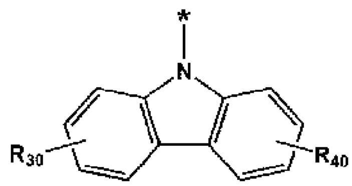

Formel 17-1

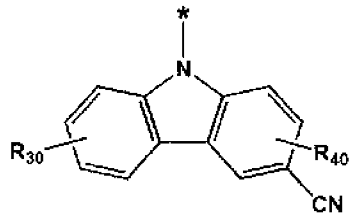

Formel 17-2

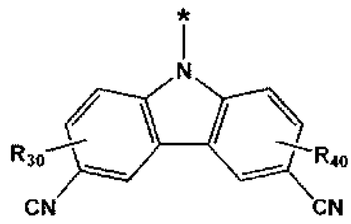

Formel 17-3

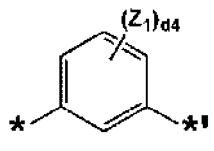

Formel 3-15

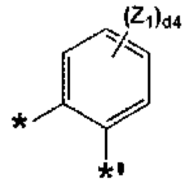

Formel 3-28

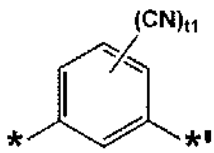

Formel 6-1

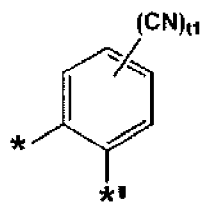

Formel 6-2

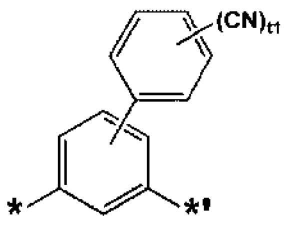

Formel 6-3

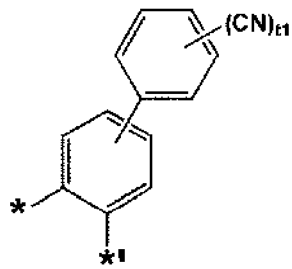

Formel 6-4

wobei, in Formel 17-1 bis 17-3, 3-15, 3-28 und 6-1 bis 6-4,

$R_{30}$ und $R_{40}$ jeweils unabhängig ausgewählt sind aus:

Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{10}$-Alkylgruppe, einer $C_1$-$C_{10}$-Alkoxygruppe, $-CF_3$, $-CF_2H$ und $-CFH_2$;
einer Phenylgruppe, einer Pyridinylgruppe, einer Pyrimidinylgruppe, einer Pyrazinylgruppe, einer Pyridazinylgruppe, einer Triazinylgruppe, einer Naphthylgruppe, einer Fluorenylgruppe, einer Carbazolylgruppe, einer Dibenzofuranylgruppe und einer Dibenzothiophenylgruppe;
einer Phenylgruppe, einer Pyridinylgruppe, einer Pyrimidinylgruppe, einer Pyrazinylgruppe, einer Pyridazinylgruppe, einer Triazinylgruppe, einer Naphthylgruppe, einer Fluorenylgruppe, einer Carbazolylgruppe, einer Dibenzofuranylgruppe und einer Dibenzothiophenylgruppe, jeweils substituiert mit mindestens einem, ausgewählt aus Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe einer Carbonsäuregruppe oder einem Salz davon, einer Sulfonsäuregruppe oder einem Salz davon, einer Phosphorsäuregruppe oder einem Salz davon, einer $C_1$-$C_{10}$-Alkylgruppe, einer $C_1$-$C_{10}$-Alkoxygruppe, $-CF_3$, $-CF_2H$, $-CFH_2$, einer Phenylgruppe, einer Pyridinylgruppe, einer Pyrimidinylgruppe, einer Pyrazinylgruppe, einer Pyridazinylgruppe, einer Triazinylgruppe, einer Naphthylgruppe, einer Fluorenylgruppe, einer Carbazolylgruppe, einer Dibenzofuranylgruppe, und einer Dibenzothiophenylgruppe; und
$-Si(Q_1)(Q_2)(Q_3)$,

$Z_1$ ausgewählt ist aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe einer Carbonsäuregruppe oder einem Salz davon, einer Sulfonsäuregruppe oder einem Salz

davon, einer Phosphorsäuregruppe oder einem Salz davon, einer $C_1$-$C_{10}$-Alkylgruppe, einer $C_1$-$C_{10}$-Alkoxygruppe, $-CF_3$, $-CF_2H$, $-CFH_2$, einer Phenylgruppe, einer mit einer Cyanogruppe substituierten Phenylgruppe, einer Naphthylgruppe, einer Pyridinylgruppe, einer Pyrimidinylgruppe, einer Pyrazinylgruppe, einer Pyridazinylgruppe, einer Triazinylgruppe, einer Fluorenylgruppe, einer Carbazolylgruppe, einer Dibenzofuranylgruppe, einer Dibenzothiophenylgruppe und $-Si(Q_{11})(Q_{12})(Q_{13})$,
d4 eine ganze Zahl ausgewählt aus 0 bis 4 ist,
t1 1 oder 2 ist,
wobei $Q_1$ bis $Q_3$ und $Q_{11}$ bis $Q_{13}$ jeweils unabhängig ausgewählt sind aus Wasserstoff, einer $C_1$-$C_{10}$-Alkylgruppe, einer $C_1$-$C_{10}$-Alkoxygruppe, einer Phenylgruppe und einer Naphthylgruppe, und
* und *' jeweils eine Bindungsstelle zu einem benachbarten Atom angeben.

8. Organische lichtemittierende Vorrichtung nach einem der Ansprüche 1-7, wobei der Wirt eines ausgewählt aus den Verbindungen A1 bis A11 umfasst:

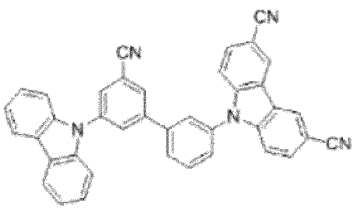
A1

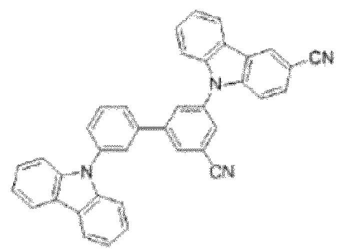
A2

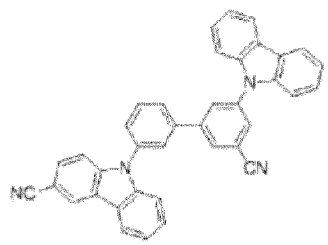
A3

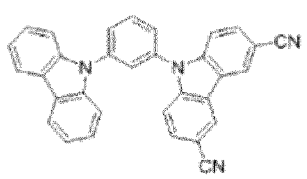
A4

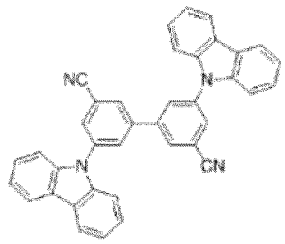
A5

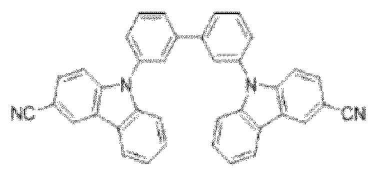
A6

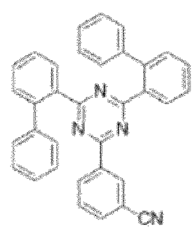
A7

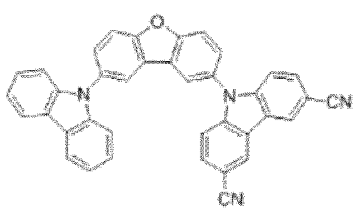
A8

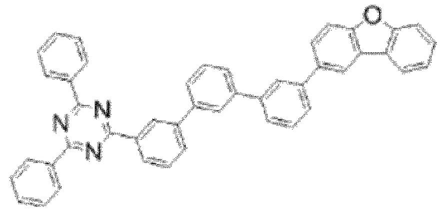
A9

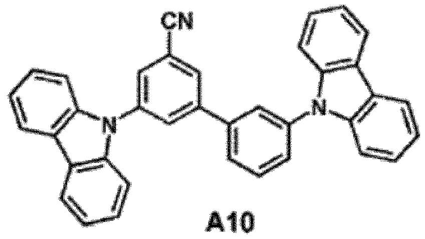

A10

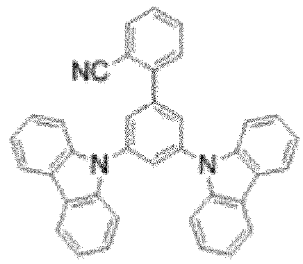

A11

9. Organische lichtemittierende Vorrichtung nach einem der Ansprüche 1-8, wobei der phosphoreszierende Dotierstoff eine organometallische Verbindung umfasst, dargestellt von Formel 81:

Formel 81 $M(L_{81})_{n81}(L_{82})_{n82}$

Formel 81A

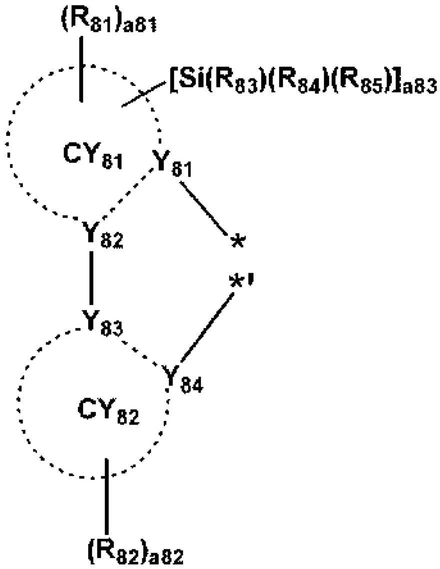

wobei, in Formel 81 und 81A,

M ausgewählt ist aus Iridium (Ir), Platin (Pt), Osmium (Os), Titan (Ti), Zirkonium (Zr), Hafnium (Hf), Europium (Eu), Terbium (Tb), Thulium (Tm) und Rhodium (Rh),
$L_{81}$ ein Ligand ist, dargestellt durch Formel 81A, n81 eine ganze Zahl ist, ausgewählt aus 1 bis 3; wenn n81 2 oder größer ist, mindestens zwei $L_{81}$-Gruppen identisch oder voneinander verschieden sind,
$L_{82}$ ein organischer Ligand ist, n82 eine ganze Zahl ist, ausgewählt aus 0 bis 4; wenn n82 2 oder größer ist, mindestens zwei $L_{82}$-Gruppen identisch oder voneinander verschieden sind, $Y_{81}$ bis $Y_{84}$ jeweils unabhängig Kohlenstoff (C) oder Stickstoff (N) sind,
$Y_{81}$ und $Y_{82}$ über eine Einfachbindung oder eine Doppelbindung gebunden sind, $Y_{83}$ und $Y_{84}$ über eine Einfachbindung oder eine Doppelbindung gebunden sind,
$CY_{81}$ und $CY_{82}$ jeweils unabhängig ausgewählt sind aus einer carbocyclischen $C_5$-$C_{30}$-Gruppe und einer heterocyclischen $C_1$-$C_{30}$-Gruppe,
$CY_{81}$ und $CY_{82}$ optional und zusätzlich über eine organische Verbindungsgruppe gebunden sind,
$R_{81}$ bis $R_{85}$ jeweils unabhängig Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer

Phosphorsäuregruppe oder einem Salz davon, $-SF_5$, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkinylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_7$-$C_{60}$-Arylalkylgruppe, einer substituierten oder unsubstituierten $C_1$-$C_{60}$-Heteroarylgruppe, einer substituierten oder unsubstituierten $C_1$-$C_{60}$-Heteroaryloxygruppe, einer substituierten oder unsubstituierten $C_1$-$C_{60}$-Heteroarylthiogruppe, einer substituierten oder unsubstituierten $C_2$-$C_{60}$-Heteroarylalkylgruppe, einer substituierten oder unsubstituierten einwertigen nicht-aromatischen kondensierten polycyclischen Gruppe, einer substituierten oder unsubstituierten einwertigen nicht-aromatischen kondensierten heteropolycyclischen Gruppe, $-Si(Q_{81})(Q_{82})(Q_{83})$,$-N(Q_{84})(Q_{85})$, $-B(Q_{86})(Q_{87})$ und $-P(=O)(Q_{88})(Q_{89})$,

a81 bis a83 jeweils unabhängig eine ganze Zahl ausgewählt aus 0 bis 5 sind,

wenn a81 2 oder größer ist, mindestens zwei $R_{81}$-Gruppen gleich oder voneinander verschieden sind,

wenn a82 2 oder größer ist, mindestens zwei $R_{82}$-Gruppen gleich oder voneinander verschieden sind,

wenn a81 2 oder größer ist, $R_{81}$-Gruppen, die zueinander benachbart sind, optional gebunden sind, um einen gesättigten oder ungesättigten Ring zu bilden,

wenn a82 2 oder größer ist, $R_{82}$-Gruppen, die zueinander benachbart sind, optional gebunden sind, um einen gesättigten oder ungesättigten Ring zu bilden,

in Formel 81A * und *' jeweils eine Bindungsstelle zu M in Formel 81 angeben, und

mindestens ein Substituent der substituierten $C_1$-$C_{60}$-Alkylgruppe, substituierten $C_2$-$C_{60}$-Alkenylgruppe, substituierten $C_2$-$C_{60}$-Alkinylgruppe, substituierten $C_1$-$C_{60}$-Alkoxygruppe, substituierten $C_3$-$C_{10}$-Cycloalkylgruppe, substituierten $C_1$-$C_{10}$-Heterocycloalkylgruppe, substituierten $C_3$-$C_{10}$-Cycloalkenylgruppe, substituierten $C_1$-$C_{10}$-Heterocycloalkenylgruppe, substituierten $C_6$-$C_{60}$-Arylgruppe, substituierten $C_6$-$C_{60}$-Aryloxygruppe, substituierten $C_6$-$C_{60}$-Arylthiogruppe, substituierten $C_7$-$C_{60}$-Arylalkylgruppe, substituierten $C_1$-$C_{60}$-Heteroarylgruppe, substituierten $C_1$-$C_{60}$-Heteroaryloxygruppe, substituierten $C_1$-$C_{60}$-Heteroarylthiogruppe, substituierten $C_2$-$C_{60}$-Heteroarylalkylgruppe, substituierten einwertigen nicht-aromatischen kondensierten polycyclischen Gruppe und substituierten einwertigen nicht-aromatischen kondensierten heteropolycyclischen Gruppe ausgewählt ist aus Deuterium, -F, -Cl, -Br, -I, einer Hydroxylgruppe, einer Cyanogruppe, einer Nitrogruppe, einer Aminogruppe, an Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer einwertigen nicht-aromatischen kondensierten polycyclischen Gruppe, einer einwertigen nicht-aromatischen kondensierten heteropolycyclischen Gruppe und $-Si(Q_{91})(Q_{92})(Q_{93})$,

wobei $Q_{81}$ bis $Q_{89}$ und $Q_{91}$ bis $Q_{93}$ jeweils unabhängig ausgewählt sind aus Wasserstoff, Deuterium, einer $C_1$-$C_6$-Alkylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_1$-$C_{60}$-Heteroarylgruppe, einer einwertigen nicht-aromatischen kondensierten polycyclischen Gruppe und einer einwertigen nicht-aromatischen kondensierten heteropolycyclischen Gruppe.

**10.** Organische lichtemittierende Vorrichtung nach Anspruch 9, wobei

$Y_{81}$ N ist, $Y_{82}$ und $Y_{83}$ jeweils C sind, $Y_{84}$ N oder C ist, und

$CY_{81}$ und $CY_{82}$ jeweils unabhängig ausgewählt sind aus einer Cyclopentadiengruppe, einer Benzolgruppe, einer Heptalengruppe, einer Indengruppe, einer Naphthalingruppe, einer Azulengruppe, einer Indacengruppe, einer Acenaphthylengruppe, einer Fluorengruppe, einer Spiro-Bifluorengruppe, einer Benzofluorengruppe, einer Dibenzofluorengruppe, einer Phenalenegruppe, einer Phenanthrengruppe, einer Anthracengruppe, einer Fluoranthengruppe, einer Triphenylengruppe, einer Pyrengruppe, einer Chrysengruppe, einer Naphthacengruppe, einer Pinengruppe, einer Perylengruppe, einer Pentacengruppe, einer Hexacengruppe, einer Pentaphengruppe, einer Rubicengruppe, einer Coronengruppe, einer Ovalengruppe, einer Pyrrolgruppe, einer Isoindolgruppe, einer Indolgruppe, einer Indazolgruppe, einer Pyrazolgruppe, einer Imidazolgruppe, einer Triazolgruppe, einer Oxazolgruppe, einer Isoxazolgruppe, einer Oxadiazolgruppe, einer Thiazolgruppe, einer Isothiazolgruppe, einer Thiadiazolgruppe, einer Puringruppe, einer Furangruppe, einer Thiophengruppe, einer Pyridingruppe, einer Pyrimidingruppe, einer Chinolingruppe, einer Isochinolingruppe, einer Benzochinolingruppe, einer Phthalazingruppe, einer Naphthyridingruppe, einer Chinoxalingruppe, einer Chinazolingruppe, einer Cinnolingruppe, einer Phenanthridingruppe, einer Acridingruppe, einer Phenanthrolingruppe, einer Phenazingruppe, einer Benzimidazolgruppe, einer Benzofurangruppe, einer Benzothiophengruppe, einer Iso-Benzothiazolgruppe, einer Benzoxazolgruppe, einer Isobenzoxazolgruppe, einer Benzocarbazolgruppe, einer Dibenzocarbazolgruppe, einer Imidazopyridingruppe, einer Imidazopyrimidingruppe, einer Dibenzofurangruppe, einer Dibenzothiophengruppe, einer Dibenzothiophensulfongruppe, einer Carbazolgruppe, einer Dibenzosilolgruppe, einer 2,3-Dihydro-1H-imidazolgruppe und einer 2,3-Dihydro-1H-imidazopyrazingruppe; oder
wobei, in Formel 81A,
$Y_{81}$, $Y_{83}$ und $Y_{84}$ jeweils C sind,
$Y_{82}$ N ist;
$CY_{81}$ ausgewählt ist aus a) einem kondensierten Ring, in dem i) ein 5-gliedriger Ring, der mindestens ein N als ringbildendes Atom beinhaltet, kondensiert ist mit ii) einem 6-gliedrigen Ring, ausgewählt aus einer Benzolgruppe, einer Pyridingruppe, einer Pyrazingruppe, einer Pyrimidingruppe und einer Pyridazingruppe; und b) einem 5-gliedrigen Ring, der mindestens ein N als ringbildendes Atom beinhaltet, und
$CY_{82}$ ausgewählt ist aus einer Benzolgruppe, einer Naphthalingruppe, einer Fluorengruppe, einer Dibenzofurangruppe, einer Dibenzothiophengruppe, einer Pyridingruppe, einer Pyrimidingruppe, einer Chinolingruppe und einer Isochinolingruppe.

**11.** Organische lichtemittierende Vorrichtung nach Anspruch 9 oder 10, wobei $R_{81}$ und $R_{82}$ jeweils unabhängig ausgewählt sind aus:

Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, $-SF_5$, einer $C_1$-$C_{20}$-Alkylgruppe und einer $C_1$-$C_{20}$-Alkoxygruppe;
einer $C_1$-$C_{20}$-Alkylgruppe und einer $C_1$-$C_{20}$-Alkoxygruppe, jeweils substituiert mit mindestens einem, ausgewählt aus Deuterium, -F, -Cl, -Br, -I, $-CD_3$, $-CD_2H$, $-CDH_2$, $-CF_3$, $-CF_2H$, - $CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{10}$-Alkylgruppe, einer Cyclopentylgruppe, einer Cyclohexylgruppe, einer Cycloheptylgruppe, einer Cyclooctylgruppe, einer Adamantylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe,

einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe, jeweils substituiert mit mindestens einem, ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe; und

$-B(Q_{86})(Q_{87})$ und $-P(=O)(Q_{88})(Q_{89})$,

wobei $Q_{86}$ bis $Q_{89}$ jeweils unabhängig ausgewählt sind aus

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$,$-CHDCD_2H$, $-CHDCDH_2$, $-CHDCD_3$, $-CD_2CD_3$, $-CD_2CD_2H$ und $-CD_2CDH_2$;

einer n-Propylgruppe, einer Isopropylgruppe, einer n-Butylgruppe, einer Isobutylgruppe, einer sec-Butylgruppe, einer tert-Butylgruppe, einer n-Pentylgruppe, einer iso-Pentylgruppe, einer sec-Pentylgruppe, einer tert-Pentylgruppe, einer Phenylgruppe und einer Naphthylgruppe; und

einer n-Propylgruppe, einer iso-Propylgruppe, einer n-Butylgruppe, einer iso-Butylgruppe, einer sec-Butylgruppe, einer tert-Butylgruppe, einer n-Pentylgruppe, einer iso-Pentylgruppe, einer sec-Pentylgruppe, einer tert-Pentylgruppe, einer Phenylgruppe und einer Naphthylgruppe, jeweils substituiert mit mindestens einem, ausgewählt aus Deuterium, einer $C_1$-$C_{10}$-Alkylgruppe und einer Phenylgruppe; oder

wobei in Formel 81A mindestens ein $R_{81}$ in der Anzahl von a81, mindestens ein $R_{82}$ in der Anzahl von a82 oder eine beliebige Kombination davon eine Cyanogruppe ist.

**12.** Organische lichtemittierende Vorrichtung nach einem der Ansprüche 9-11, wobei in Formel 81 $L_{81}$ ausgewählt ist aus Liganden, dargestellt durch Formeln 81A-1 bis 81A-8:

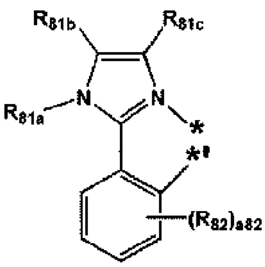
Formel 81A-1

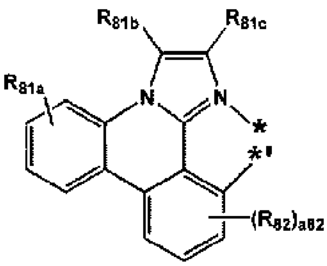
Formel 81A-2

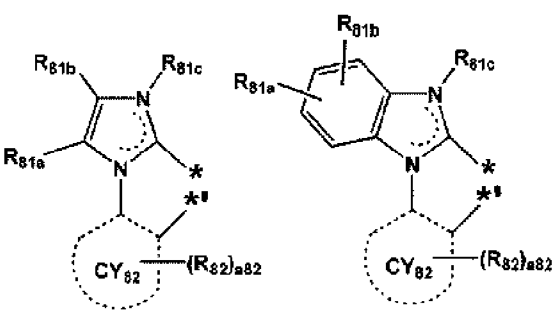
Formel 81A-3

Formel 81A-4

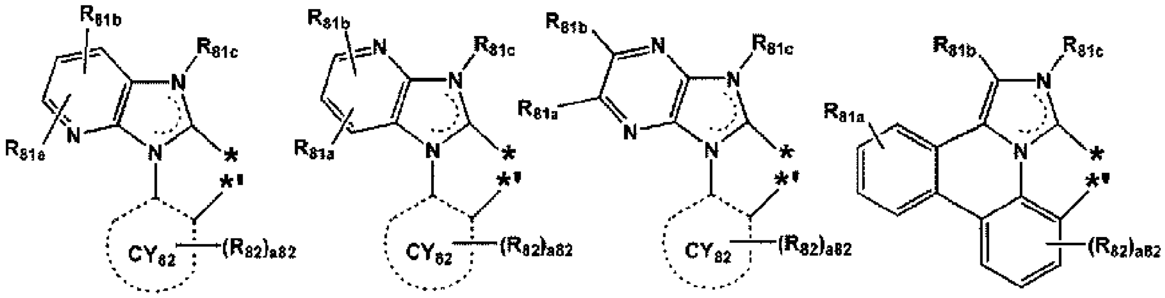

Formel 81A-5 Formel 81A-6 Formel 81A-7 Formel 81A-8

wobei in Formeln 81A-1 bis 81A-8,

$CY_{82}$, $R_{82}$, a82, * und *' gleich sind wie jene, die in Anspruch 9 definiert sind, und $R_{81a}$, $R_{81b}$, and $R_{81c}$ jeweils gleich sind wie $R_{81}$ wie definiert in Anspruch 9.

**13.** Organische lichtemittierende Vorrichtung nach Anspruch 12, wobei in Formeln 81A-1 bis 81A-8 $CY_{82}$ ausgewählt ist aus einer Benzolgruppe, einer Naphthalingruppe, einer Fluorengruppe, einer Dibenzofurangruppe, einer Dibenzothiophengruppe, einer Pyridingruppe, einer Pyrimidingruppe, einer Chinolingruppe und einer Isochinolingruppe.

**14.** Organische lichtemittierende Vorrichtung nach Anspruch 12, wobei in Formeln 81A-1 bis 81A-8 mindestens eines von $R_{81a}$, $R_{81b}$, $R_{81c}$ und $R_{82}$ in der Anzahl von a82 jeweils eine Cyanogruppe ist.

**15.** Organische lichtemittierende Vorrichtung nach einem der Ansprüche 1-14, wobei der Dotierstoff ausgewählt ist aus folgenden Verbindungen:

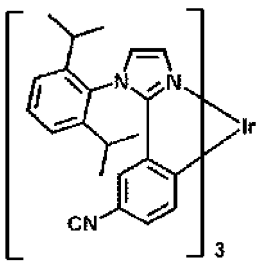

PD79

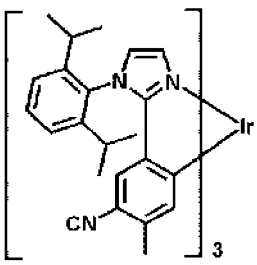

PD80

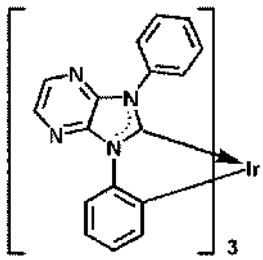

PD81

## Revendications

**1.** Dispositif électroluminescent organique comprenant :

une première électrode ;
une seconde électrode faisant face à la première électrode ; et
une couche organique disposée entre la première électrode et la seconde électrode, ladite couche organique comprenant une couche d'émission,
ladite couche d'émission comprenant un hôte et un dopant,
ledit dopant comprenant un dopant phosphorescent, et
**caractérisé en ce que** :

i) les conditions 1, 2, 3 et 4 sont toutes satisfaites ; ou
ii) lorsque les conditions 1 et 4 sont satisfaites et qu'au moins l'une des conditions 2 et 3 n'est pas satisfaite, la condition 5-1 est satisfaite ; ou
iii) lorsqu'au moins l'une des conditions 1 et 4 n'est pas satisfaite et que les conditions 2 et 3 sont satisfaites, la condition 6-1 est satisfaite ; ou
iv) lorsqu'au moins l'une des conditions 1 et 4 n'est pas satisfaite et qu'au moins l'une des conditions 2 et 3 n'est pas satisfaite, les conditions 5-1 et 6-1 sont toutes les deux satisfaites :

Condition 1

$$E^*_{ox,dopant} \geq E_{red,hôte}$$

Condition 2

$$E^*_{red,dopant} \leq E_{ox,hôte}$$

Condition 3

$$E_{ox,dopant} \geq E^*_{red,hôte}$$

Condition 4

$$E_{red,dopant} \leq E^*_{ox,hôte}$$

Condition 5-1

$$T1_{dopant}\text{-0,4 eV} < | E_{red,hôte} - E_{ox,dopant} | < T1_{dopant}\text{+0,3 eV}$$

Condition 6-1

$$T1_{dopant}\text{-0,4 eV} < | E_{red,dopant} - E_{ox,hôte} | < T1_{dopant}\text{+0,3 eV}$$

dans lesquelles, « $E^*_{ox,dopant}$ » représente le potentiel d'oxydation à l'état excité (eV) du dopant,

« $E^*_{red,dopant}$ » représente le potentiel de réduction à l'état excité (eV) du dopant,
« $E_{ox,dopant}$ » représente le potentiel d'oxydation à l'état fondamental (eV) du dopant,
« $E_{red,dopant}$ » représente le potentiel de réduction à l'état fondamental (eV) du dopant,
« $E^*_{red,hôte}$ » représente le potentiel de réduction à l'état excité (eV) de l'hôte,
« $E^*_{ox,host}$ » représente le potentiel d'oxydation à l'état excité (eV) de l'hôte,
« $E_{red,hôte}$ » représente le potentiel de réduction à l'état fondamental (eV) de l'hôte,
« $E_{ox,hôte}$ » représente le potentiel d'oxydation à l'état fondamental (eV) de l'hôte,
$E^*_{ox,dopant}$ est identique à $E_{ox,dopant}$-$T1_{dopant}$,
$E^*_{red,dopant}$ est identique à $E_{red,dopant}$+$T1_{dopant}$,
$E^*_{ox,hôte}$ est identique à $E_{ox,hôte}$-$S1_{hôte}$,
$E^*_{red,host}$ est identique à $E_{red,hôte}$+$S1_{hôte}$,
« $T1_{dopant}$ » représente le niveau d'énergie triplet le plus bas (eV) du dopant,
« $S1_{hôte}$ » représente le niveau d'énergie singlet le plus bas (eV) de l'hôte,
$E_{ox,dopant}$ et $E_{ox,hôte}$ sont mesurés en utilisant la voltamétrie cyclique (CV),
$E_{red,dopant}$ et $E_{red,hôte}$ sont mesurés en utilisant la voltamétrie à impulsions différentielles,
$T1_{dopant}$ est calculé à partir du spectre de photoluminescence (PL) du dopant en solution, et
$S1_{hôte}$ est calculé à partir du spectre de PL de l'hôte en solution,
« eV » signifiant « électron-Volts ».

**2.** Dispositif électroluminescent organique selon la revendication 1,

lesdites conditions 1 et 3 n'étant pas satisfaites, et
lesdites conditions 2, 4, 5-1 et 6-1 étant satisfaites.

**3.** Dispositif électroluminescent organique selon la revendication 1,

lesdites conditions 3 et 6-1 n'étant pas satisfaites, et
lesdites conditions 1, 2, 4 et 5-1 étant satisfaites.

**4.** Dispositif électroluminescent organique selon l'une quelconque des revendications 1 à 3,

ledit hôte comprenant i) un composé donneur, ou ii) un composé accepteur,
ledit composé accepteur comprenant un composé comprenant au moins un groupe de retrait d'électrons,
ledit groupe de retrait d'électrons étant choisi parmi :

les groupes -F, $-CFH_2$, $-CF_2H$, $-CF_3$, -CN et $-NO_2$ ;
un groupe $C_1$-$C_{60}$ alkyle substitué par au moins un groupe choisi parmi les groupes -F, - $CFH_2$, $-CF_2H$, $-CF_3$, -CN et $-NO_2$ ;
un groupe $C_1$-$C_{60}$ hétéroaryle et un groupe hétérocyclique polycyclique condensé non aromatique monovalent, chacun incluant *=N-*' en tant que groupement de formation de noyau ; et
un groupe $C_1$-$C_{60}$ hétéroaryle et un groupe hétérocyclique polycyclique condensé non aromatique monovalent, chacun incluant *=N-*' en tant que groupement de formation de noyau et chacun étant substitué par au moins un élément choisi parmi un atome de deutérium, un groupe - F, $-CFH_2$, $-CF_2H$, $-CF_3$, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle substitué ou non substitué, un groupe $C_2$-$C_{60}$ alcényle substitué ou non substitué, un groupe $C_2$-$C_{60}$ alcynyle substitué ou non substitué, un groupe $C_1$-$C_{60}$ alcoxy substitué ou non substitué, un groupe $C_3$-$C_{10}$ cycloalkyle substitué ou non substitué, un groupe $C_1$-$C_{10}$ hétérocycloalkyle substitué ou non substitué, un groupe $C_3$-$C_{10}$ cycloalcényle substitué ou non substitué, un groupe $C_1$-$C_{10}$ hétérocycloalcényle substitué ou non substitué, un groupe $C_6$-$C_{60}$ aryle substitué ou non substitué, un groupe $C_6$-$C_{60}$ aryloxy substitué ou non substitué, un groupe $C_6$-$C_{60}$ arylthio substitué ou non substitué, un groupe $C_7$-$C_{60}$ arylalkyle substitué ou non substitué, un groupe $C_1$-$C_{60}$ hétéroaryle substitué ou non substitué, un groupe $C_1$-$C_{60}$ hétéroaryloxy substitué ou non substitué, un groupe $C_1$-$C_{60}$ hétéroarylthio substitué ou non substitué, un groupe $C_2$-$C_{60}$ hétéroarylalkyle substitué ou non substitué, un groupe polycyclique condensé non aromatique monovalent substitué ou non substitué, et un groupe hétéropolycyclique condensé non aromatique monovalent substitué ou non substitué ;

de préférence ledit composé accepteur comprenant un composé représenté par la formule A-1, un composé représenté par la formule A-2, ou toute combinaison de ceux-ci ;

Formule A-1 $Ar_{11}$-$(L_{11})_{a11}$-$Ar_{12}$

Formule A-2

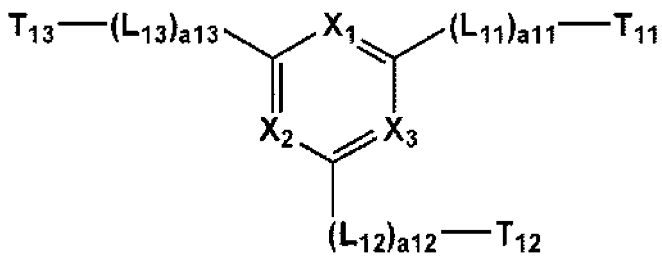

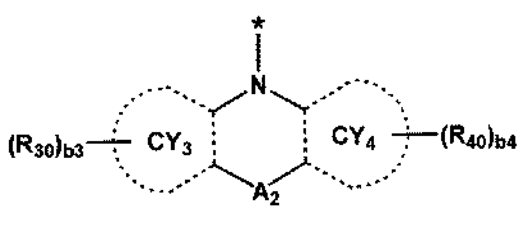

Formule 13

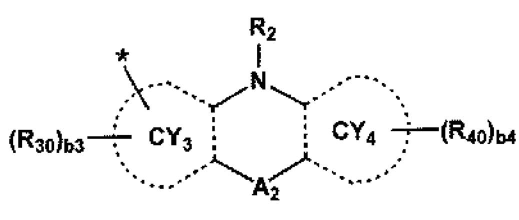

Formule 14

dans lesquelles, dans les formules A-1, A-2, 13 et 14,
$Ar_{11}$ et $Ar_{12}$ sont chacun indépendamment choisis parmi les groupes représentés par les formules 13 et 14,

$X_1$ représente un atome N ou un groupe $C(T_{14})$, $X_2$ représente un atome N ou un groupe $C(T_{15})$, et $X_3$ représente un atome N ou un groupe $C(T_{16})$, à condition qu'au moins l'un des groupes $X_1$ à $X_3$ représente un atome N, Lu à $L_{13}$ sont chacun indépendamment choisis parmi :

une liaison simple, un groupe phénylène, un groupe pyridinylène, un groupe pyrimidinylène, un groupe pyrazinylène, un groupe pyridazinylène, un groupe triazinylène, un groupe naphtylène, un groupe fluorénylène, un groupe carbazolylène, un groupe dibenzofuranylène, et un groupe dibenzothiophénylène ;
un groupe phénylène, un groupe pyridinylène, un groupe pyrimidinylène, un groupe pyrazinylène, un groupe pyridazinylène, un groupe triazinylène, un groupe naphtylène, un groupe fluorénylène, un groupe carbazolylène, un groupe dibenzofuranylène, et un groupe dibenzothiophénylène, chacun substitué par au moins un élément choisi parmi un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{10}$ alkyle, un groupe $C_1$-$C_{10}$ alcoxy, $-CF_3$, $-CF_2H$, $-CFH_2$, un groupe phényle, un groupe phényle substitué par un groupe cyano, un groupe naphtyle, un groupe pyridinyle, un groupe pyrimidinyle, un groupe pyrazinyle, un groupe pyridazinyle, un groupe triazinyle, un groupe fluorényle, un groupe carbazolyle, un groupe dibenzofuranyle, un groupe dibenzothiophényle, et $-Si(Q_{11})(Q_{12})(Q_{13})$,
a11 à a13 représentent chacun indépendamment un entier choisi parmi 0 à 5 ; lorsque a11 vaut 2 ou plus, au moins deux groupes Lu sont identiques l'un à l'autre ou différents l'un de l'autre ; lorsque a12 vaut 2 ou plus, au moins deux groupes $L_{12}$ sont identiques l'un à l'autre ou différents l'un de l'autre ; et lorsque a13 vaut 2 ou plus, au moins deux groupes $L_{13}$ sont identiques l'un à l'autre ou différents l'un de l'autre,
$CY_3$ et $CY_4$ sont chacun indépendamment choisis parmi un groupe benzène, un groupe naphtalène, un groupe fluorène, un groupe carbazole, un groupe benzocarbazole, un groupe indolocarbazole, un groupe dibenzofurane, et un groupe dibenzothiophène,

$A_2$ est choisi parmi :

une liaison simple, un groupe $C_1$-$C_4$ alkylène, et un groupe $C_2$-$C_4$ alcénylène ; et
un groupe $C_1$-$C_4$ alkylène et un groupe $C_2$-$C_4$ alcénylène, chacun substitué par au moins un élément choisi parmi un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{10}$ alkyle, un groupe $C_1$-$C_{10}$ alcoxy, un groupe phényle, un groupe naphtyle, un groupe pyridinyle, un groupe pyrimidinyle, un groupe pyrazinyle, un groupe pyridazinyle, un groupe triazinyle, un groupe fluorényle, un groupe carbazolyle, un groupe dibenzofuranyle, un groupe dibenzothiophényle, et $-Si(Q_{21})(Q_{22})(Q_{23})$,

Tu à $T_{16}$, $R_2$, $R_{30}$ et $R_{40}$ sont chacun indépendamment choisis parmi un atome d'hydrogène, un atome de deutérium, un groupe -F, -Cl, -Br, -I, un groupe hydroxy, un groupe cyano (CN), un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle substitué ou non substitué, un groupe $C_2$-$C_{60}$ alcényle substitué ou non substitué, un groupe $C_2$-$C_{60}$ alcynyle substitué ou non substitué, un groupe $C_1$-$C_{60}$ alcoxy substitué ou non substitué, un groupe $C_3$-$C_{10}$ cycloalkyle substitué ou non substitué, un groupe $C_1$-$C_{10}$ hétérocycloalkyle substitué ou non substitué, un groupe $C_3$-$C_{10}$ cycloalcényle substitué ou non substitué, un groupe $C_1$-$C_{10}$ hétérocycloalcényle substitué ou non substitué, un groupe $C_6$-$C_{60}$ aryle substitué ou non substitué, un groupe $C_6$-$C_{60}$ aryloxy substitué ou non substitué, un groupe $C_6$-$C_{60}$ arylthio substitué ou non substitué, un groupe $C_7$-$C_{60}$ arylalkyle substitué ou non substitué, un groupe $C_1$-$C_{60}$ hétéroaryle substitué ou non substitué, un groupe $C_1$-$C_{60}$ hétéroaryloxy substitué ou non substitué, un groupe $C_1$-$C_{60}$ hétéroarylthio substitué ou non substitué, un groupe $C_2$-$C_{60}$ hétéroarylalkyle substitué ou non substitué, un groupe polycyclique condensé non aromatique monovalent substitué ou non substitué, un groupe hétéropolycyclique condensé non aromatique monovalent substitué ou non substitué, et $-Si(Q_1)(Q_2)(C_3)$,
b3 et b4 représentent chacun indépendamment un entier choisi parmi 0 à 10, et
au moins un substituant du groupe $C_1$-$C_{60}$ alkyle substitué, du groupe $C_2$-$C_{60}$ alcényle substitué, du groupe $C_2$-$C_{60}$ alcynyle substitué, du groupe $C_1$-$C_{60}$ alcoxy substitué, du groupe $C_3$-$C_{10}$ cycloalkyle substitué, du groupe $C_1$-$C_{10}$ hétérocycloalkyle substitué, du groupe $C_3$-$C_{10}$ cycloalcényle substitué, du groupe $C_1$-$C_{10}$ hétérocycloalcényle substitué, du groupe $C_6$-$C_{60}$ aryle substitué, du groupe $C_6$-$C_{60}$ aryloxy substitué, du groupe $C_6$-$C_{60}$

arylthio substitué, du groupe $C_7$-$C_{60}$ arylalkyle substitué, du groupe $C_1$-$C_{60}$ hétéroaryle substitué, du groupe $C_1$-$C_{60}$ hétéroaryloxy substitué, du groupe $C_1$-$C_{60}$ hétéroarylthio substitué, du groupe $C_2$-$C_{60}$ hétéroarylalkyle substitué, du groupe polycyclique condensé non aromatique monovalent substitué, et du groupe hétéropolycyclique condensé non aromatique monovalent substitué est choisi parmi un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle, un groupe $C_2$-$C_{60}$ alcényle, un groupe $C_2$-$C_{60}$ alcynyle, un groupe $C_1$-$C_{60}$ alcoxy, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_6$-$C_{60}$ aryloxy, un groupe $C_6$-$C_{60}$ arylthio, un groupe $C_7$-$C_{60}$ arylalkyle, un groupe $C_1$-$C_{60}$ hétéroaryle, un groupe $C_1$-$C_{60}$ hétéroaryloxy, un groupe $C_1$-$C_{60}$ hétéroarylthio, un groupe $C_2$-$C_{60}$ hétéroarylalkyle, un groupe polycyclique condensé non aromatique monovalent, un groupe hétéropolycyclique condensé non aromatique monovalent, et - $Si(Q_{31})(Q_{32})(Q_{33})$,

$Q_1$ à Q3, $Q_{11}$ à $Q_{13}$, $Q_{21}$ à $Q_{23}$, et $Q_{31}$ à $Q_{33}$ étant chacun indépendamment choisis parmi un atome d'hydrogène, un atome de deutérium, un groupe $C_1$-$C_{60}$ alkyle, un groupe $C_1$-$C_{60}$ alcoxy, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_1$-$C_{60}$ hétéroaryle, un groupe polycyclique condensé non aromatique monovalent, et un groupe hétéropolycyclique condensé non aromatique monovalent.

**5.** Dispositif électroluminescent organique selon la revendication 4, $Ar_{11}$ et $Ar_{12}$ étant chacun indépendamment choisis parmi les groupes représentés par les formules 13-1 à 13-8 et 14-1 à 14-8 :

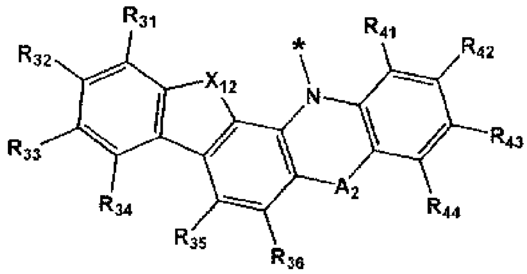

Formule 13-1

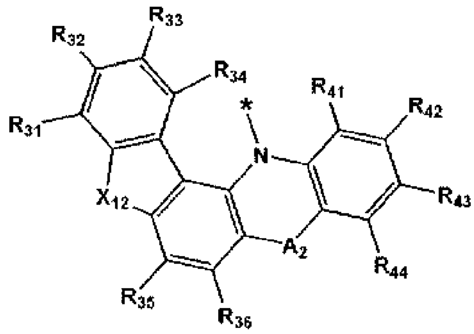

Formule 13-2

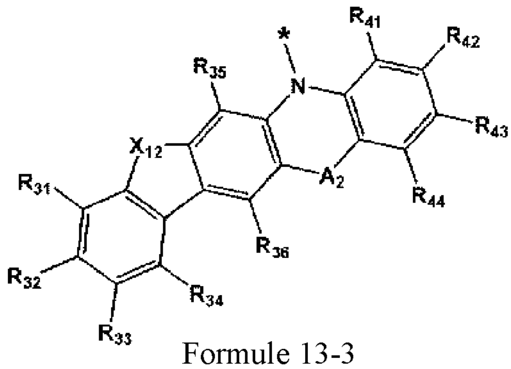

Formule 13-3

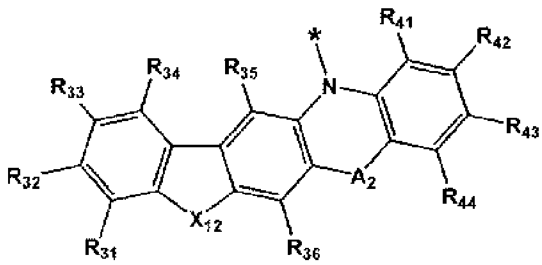

Formule 13-4

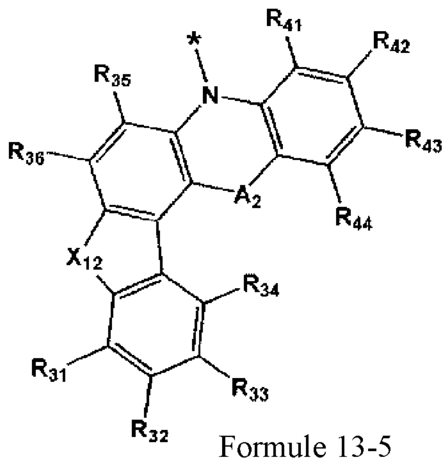

Formule 13-5

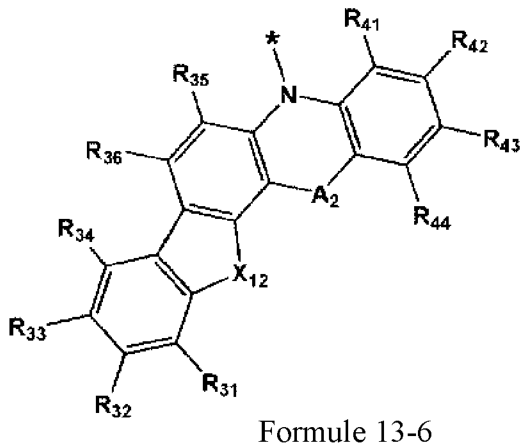

Formule 13-6

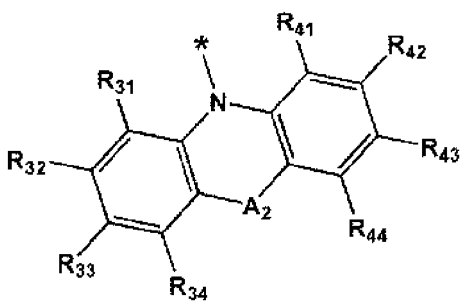

Formule 13-7

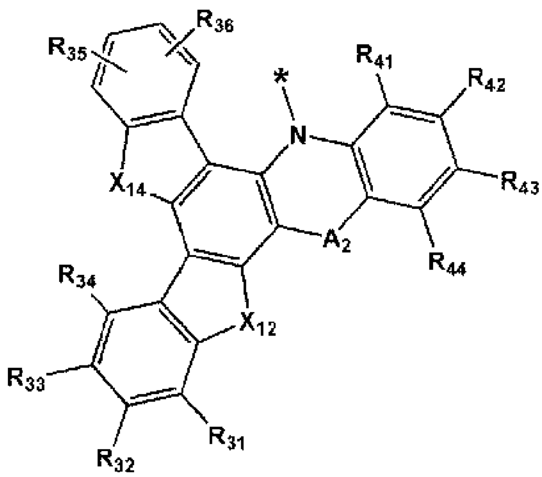

Formule 13-8

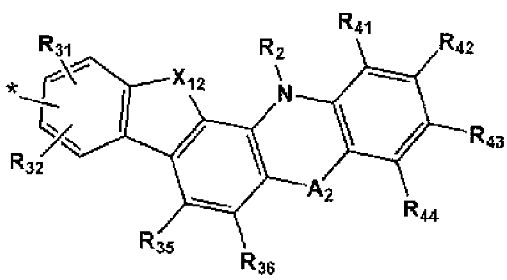

Formule 14-1

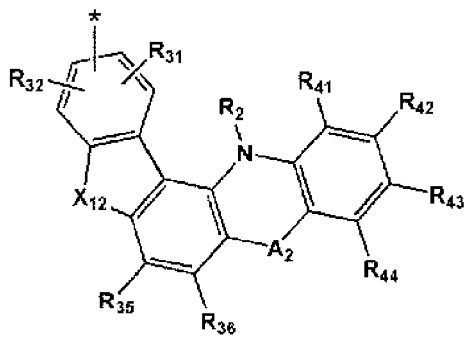

Formule 14-2

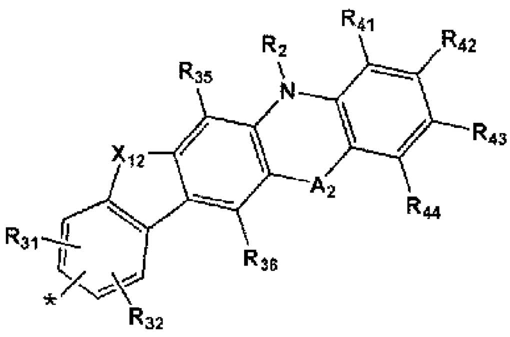

Formule 14-3

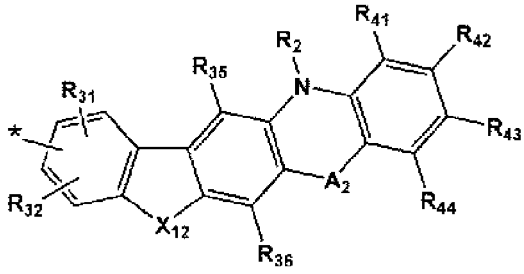

Formule 14-4

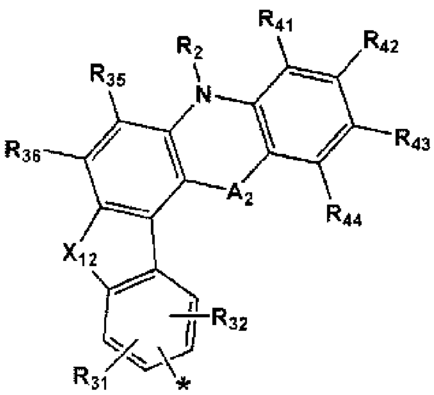

Formule 14-5

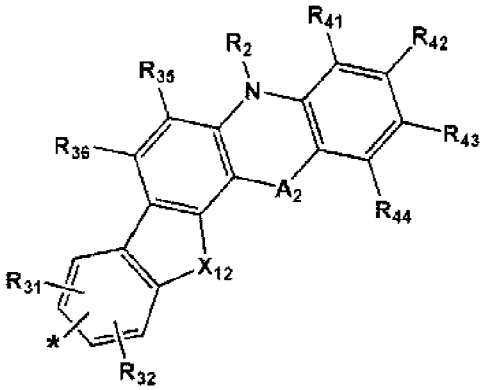

Formule 14-6

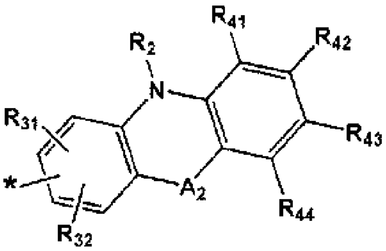

Formule 14-7

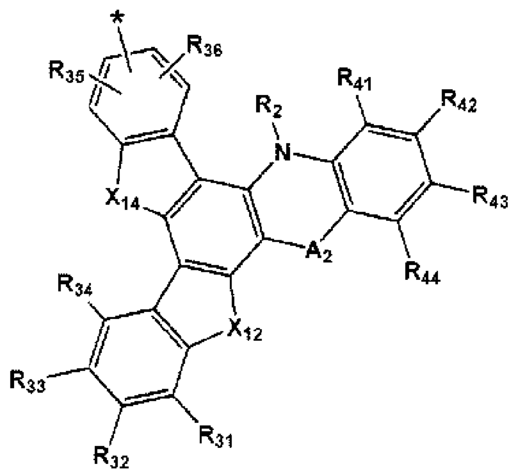

Formule 14-8

dans lesquelles, dans les formules 13-1 à 13-8 et 14-1 à 14-8,
$X_{12}$ et $X_{14}$ sont chacun indépendamment choisis parmi $C(R_{37})(R_{38})$, $N(R_{39})$, un atome O, et un atome S,
$R_2$ et $A_2$ sont identique à ceux définis dans la revendication 5,
$R_{31}$ à $R_{39}$ sont chacun indépendamment identiques à $R_{30}$ défini dans la revendication 5,
$R_{41}$ à $R_{44}$ sont chacun indépendamment identiques à $R_{40}$ défini dans la revendication 5, et
* indique un site de liaison à un atome adjacent.

**6.** Dispositif électroluminescent organique selon la revendication 4, $Ar_{11}$ et $Ar_{12}$ étant chacun indépendamment choisis parmi les groupes représentés par les formules 17-1 à 17-3 :

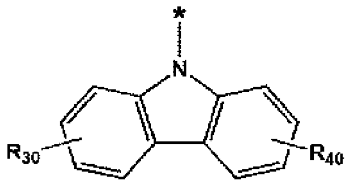

Formule 17-1

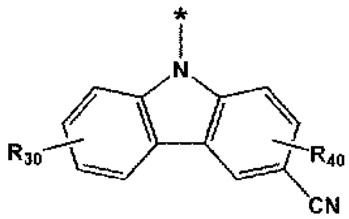

Formule 17-2

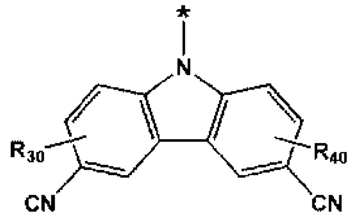

Formule 17-3

dans lesquelles, dans les formules 17-1 à 17-3,
$R_{30}$ et $R_{40}$ sont chacun indépendamment choisis parmi :

un atome d'hydrogène, un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{10}$ alkyle, un groupe $C_1$-$C_{10}$ alcoxy, $-CF_3$, $-CF_2H$, et -CFH2 ; un groupe phényle, un groupe pyridinyle, un groupe pyrimidinyle, un groupe pyrazinyle, un groupe pyridazinyle, un groupe triazinyle, un groupe naphtyle, un groupe fluorényle, un groupe carbazolyle, un groupe dibenzofuranyle, et un groupe dibenzothiophényle ;
un groupe phényle, un groupe pyridinyle, un groupe pyrimidinyle, un groupe pyrazinyle, un groupe pyridazinyle, un groupe triazinyle, un groupe naphtyle, un groupe fluorényle, un groupe carbazolyle, un groupe dibenzofuranyle, et un groupe dibenzothiophényle, chacun substitué par au moins un élément choisi parmi un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{10}$ alkyle, un groupe $C_1$-$C_{10}$ alcoxy, $-CF_3$, $-CF_2H$, $-CFH_2$, un groupe phényle, un groupe pyridinyle, un groupe pyrimidinyle, un groupe pyrazinyle, un groupe pyridazinyle, un groupe triazinyle, un groupe naphtyle, un groupe fluorényle, un groupe carbazolyle, un groupe dibenzofuranyle, et un groupe dibenzothiophényle ; et

$-Si(Q_1)(Q_2)(Q_3)$,

$Q_1$ à $Q_3$ étant chacun indépendamment choisis parmi un atome d'hydrogène, un groupe $C_1$-$C_{10}$ alkyle, un groupe $C_1$-$C_{10}$ alcoxy, un groupe phényle, et un groupe naphtyle ; et/ou
dans lesquelles Lu à $L_{13}$ sont chacun indépendamment choisis parmi les groupes représentés par les formules 3-1 à 3-56, à condition que i) au moins un groupe Lu au nombre de a11, ii) au moins un groupe $L_{12}$ au nombre de a12, et iii) au moins un groupe $L_{13}$ au nombre de a13 sont chacun indépendamment choisis parmi les groupes représentés par les formules 3-15 à 3-56 :

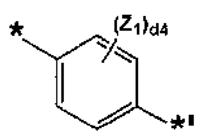

Formule 3-1

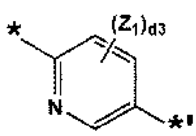

Formule 3-2

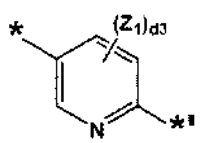

Formule 3-3

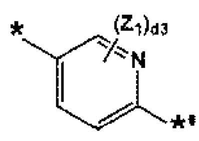

Formule 3-4

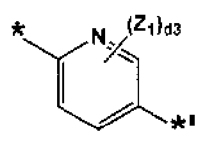

Formule 3-5

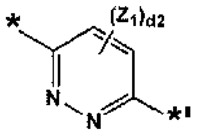

Formule 3-6

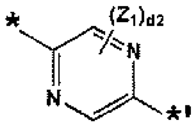

Formule 3-7

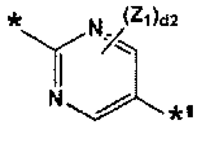

Formule 3-8

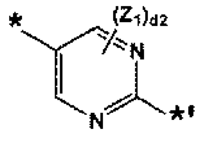

Formule 3-9

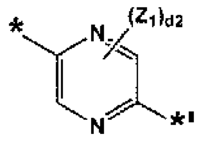

Formule 3-10

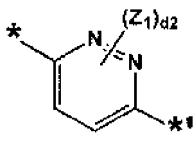
Formule 3-11

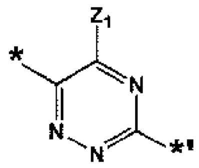
Formule 3-12

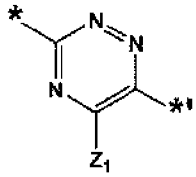
Formule 3-13

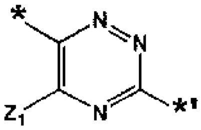
Formule 3-14

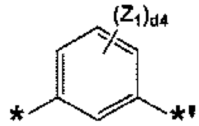
Formule 3-15

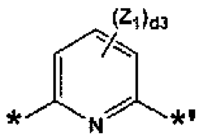
Formule 3-16

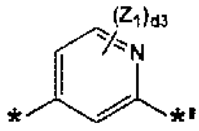
Formule 3-17

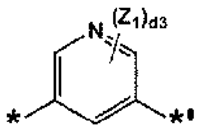
Formule 3-18

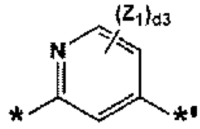
Formule 3-19

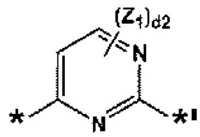
Formule 3-20

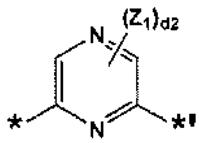
Formule 3-21

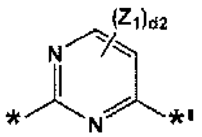
Formule 3-22

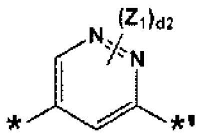
Formule 3-23

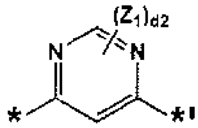
Formule 3-24

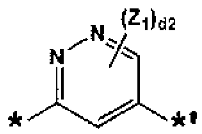
Formule 3-25

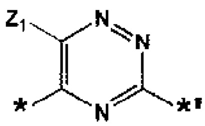
Formule 3-26

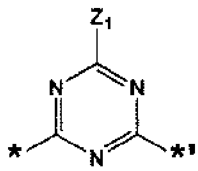
Formule 3-27

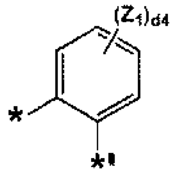
Formule 3-28

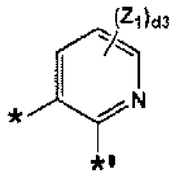
Formule 3-29

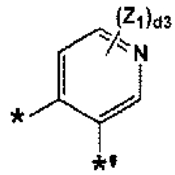
Formule 3-30

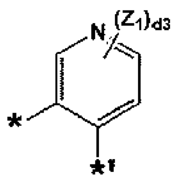
Formule 3-31

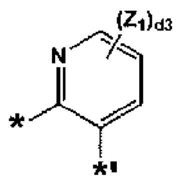
Formule 3-32

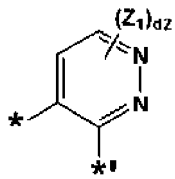
Formule 3-33

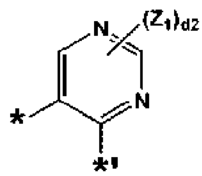
Formule 3-34

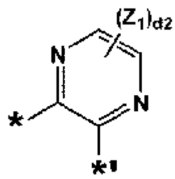
Formule 3-35

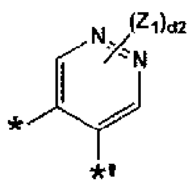
Formule 3-36

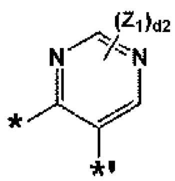
Formule 3-37

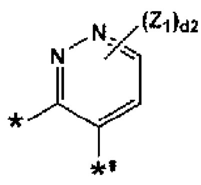
Formule 3-38

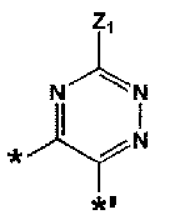
Formule 3-39

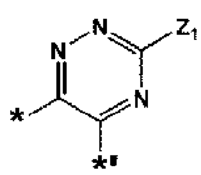
Formule 3-40

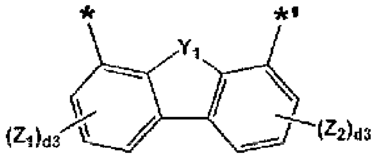
Formule 3-41

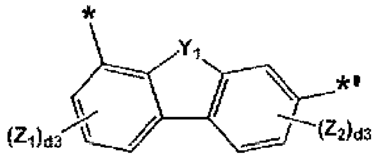
Formule 3-42

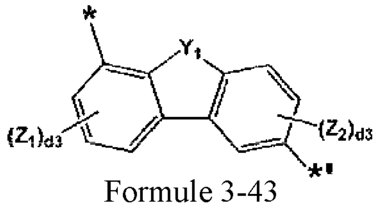
Formule 3-43

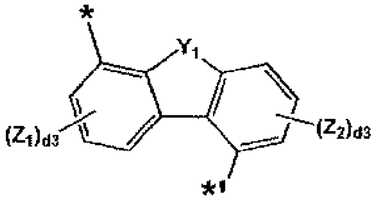
Formule 3-44

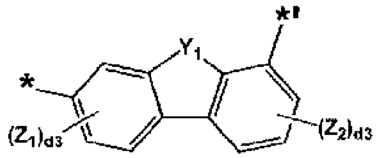
Formule 3-45

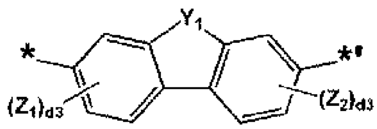
Formule 3-46

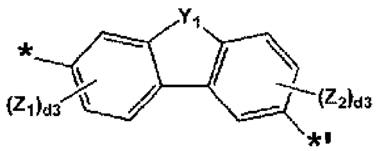
Formule 3-47

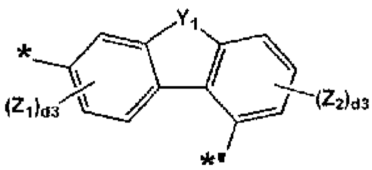
Formule 3-48

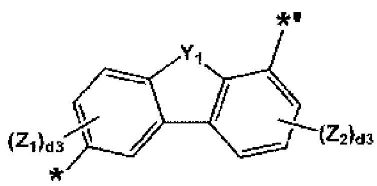
Formule 3-49

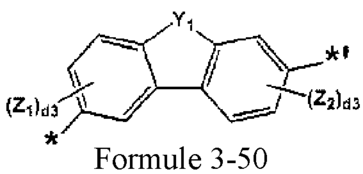
Formule 3-50

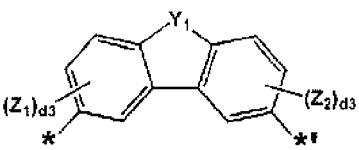
Formule 3-51

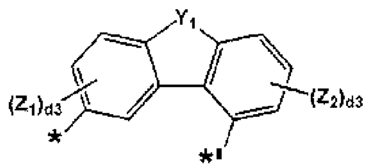
Formule 3-52

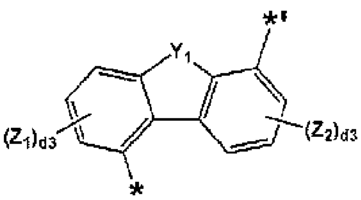
Formule 3-53

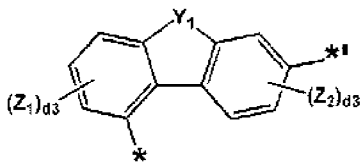
Formule 3-54

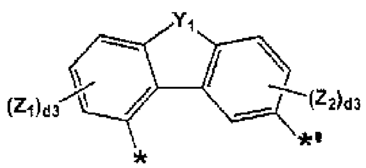
Formule 3-55

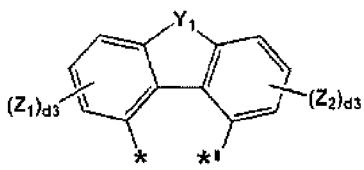
Formule 3-56

dans lesquelles, dans les formules 3-1 à 3-56,

$Y_1$ est choisi parmi un atome O, un atome S, un groupe $C(Z_3)(Z_4)$ et un groupe $N(Z_5)$,
$Z_1$ à $Z_5$ sont chacun indépendamment choisis parmi un atome d'hydrogène, un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide

sulfonique ou un sel de celui-ci, un groupe acide phosphorique ou un sel de celui-ci, un groupe $C_1$-$C_{10}$ alkyle, un groupe $C_1$-$C_{10}$ alcoxy, -$CF_3$, -$CF_2H$, -$CFH_2$, un groupe phényle, un groupe phényle substitué par un groupe cyano, un groupe naphtyle, un groupe pyridinyle, un groupe pyrimidinyle, un groupe pyrazinyle, un groupe pyridazinyle, un groupe triazinyle, un groupe fluorényle, un groupe carbazolyle, un groupe dibenzofuranyle, un groupe dibenzothiophényle, et -Si($Q_{11}$)($Q_{12}$)($Q_{13}$),

$Q_{11}$ à $Q_{13}$ étant chacun indépendamment choisis parmi un atome d'hydrogène, un groupe $C_1$-$C_{10}$ alkyle, un groupe $C_1$-$C_{10}$ alcoxy, un groupe phényle, un groupe naphtyle, un groupe pyridinyle, un groupe pyrimidinyle, un groupe pyrazinyle, un groupe pyridazinyle, un groupe triazinyle, un groupe fluorényle, un groupe carbazolyle, un groupe dibenzofuranyle, et un groupe dibenzothiophényle,

d4 représente un entier choisi parmi 0 à 4,

d3 représente un entier choisi parmi 0 à 3,

d2 représente un entier choisi parmi 0 à 2, et

* et *' indiquent chacun un site de liaison à un atome adjacent.

**7.** Dispositif électroluminescent organique selon la revendication 4, lesdits groupes représentés par *-($L_{11}$)$_{a11}$-*', *-($L_{12}$)a$_{12}$-*', et *-($L_{13}$)a$_{13}$-*' étant choisis parmi les groupes représentés par les formules 4-1 à 4-39 :

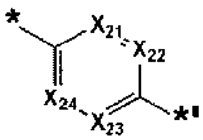

Formule 4-1

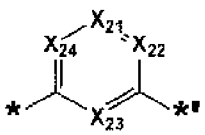

Formule 4-2

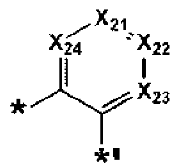

Formule 4-3

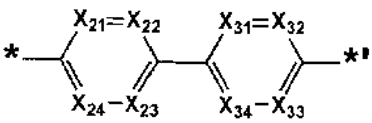

Formule 4-4

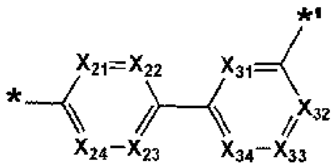

Formule 4-5

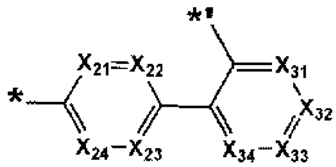

Formule 4-6

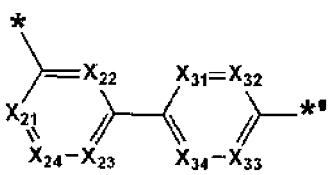

Formule 4-7

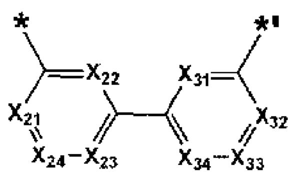

Formule 4-8

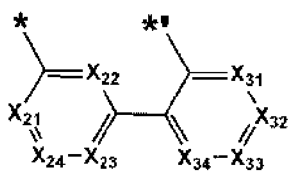

Formule 4-9

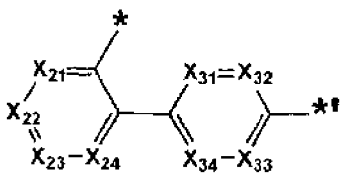

Formule 4-10

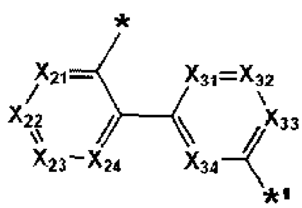

Formule 4-11

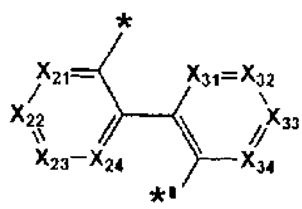

Formule 4-12

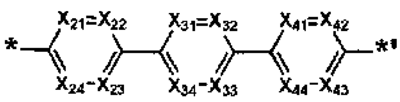

Formule 4-13

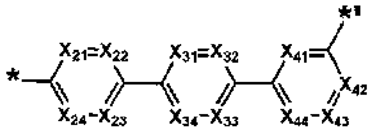

Formule 4-14

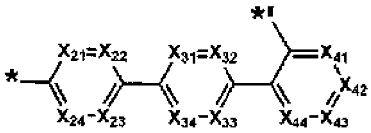

Formule 4-15

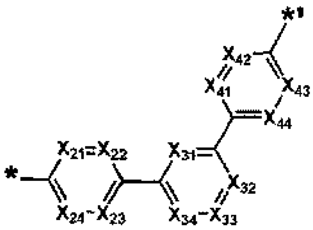

Formule 4-16

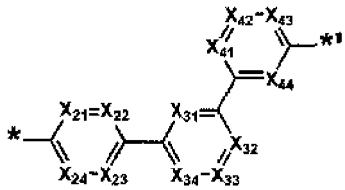

Formule 4-17

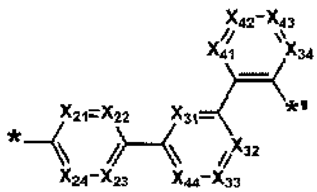

Formule 4-18

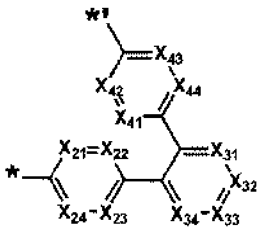

Formule 4-19

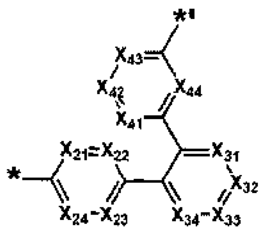

Formule 4-20

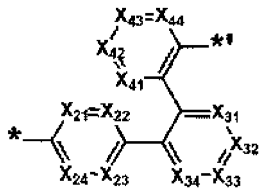

Formule 4-21

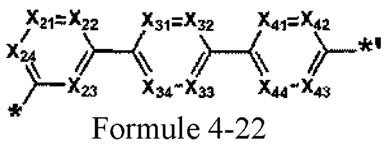

Formule 4-22

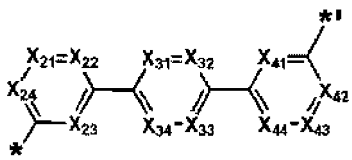

Formule 4-23

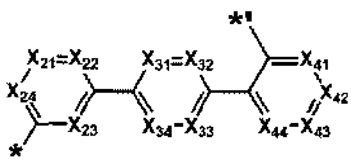

Formule 4-24

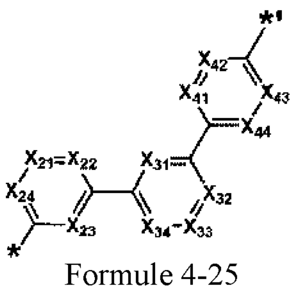

Formule 4-25

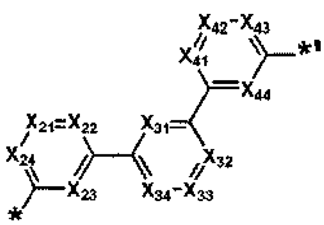

Formule 4-26

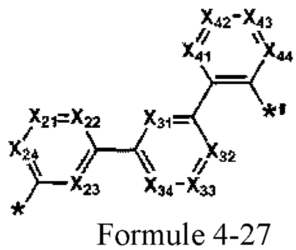

Formule 4-27

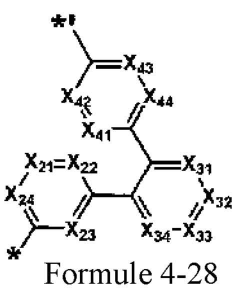

Formule 4-28

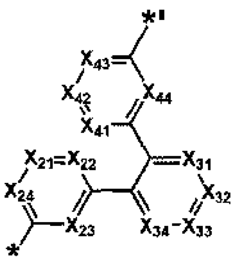

Formule 4-29

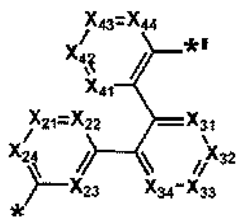

Formule 4-30

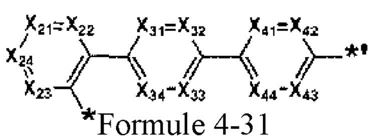

Formule 4-31

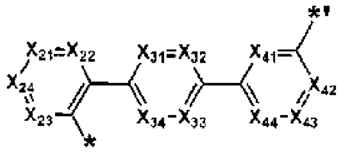

Formule 4-32

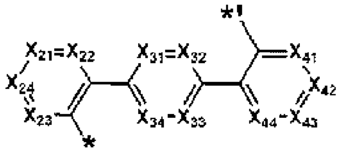

Formule 4-33

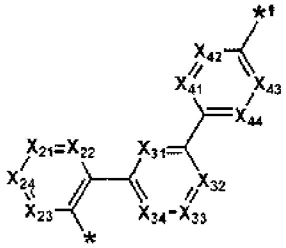

Formule 4-34

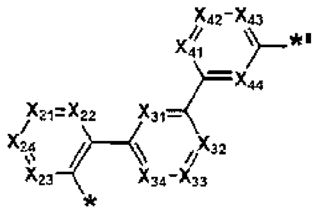

Formule 4-35

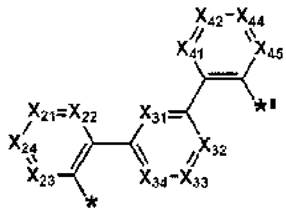

Formule 4-36

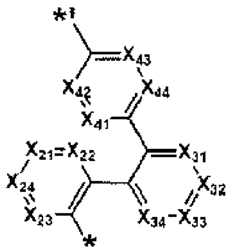

Formule 4-37

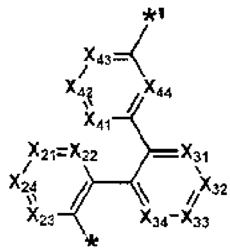

Formule 4-38

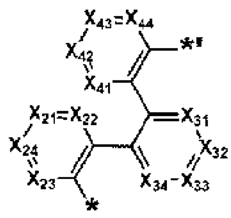

Formule 4-39

dans lesquelles, dans les formules 4-1 à 4-39,

$X_{21}$ représente un atome N ou un groupe $C(Z_{21})$, $X_{22}$ représente un atome N ou un groupe $C(Z_{22})$, $X_{23}$ représente un atome N ou un groupe $C(Z_{23})$, $X_{24}$ représente un atome N ou un groupe $C(Z_{24})$, $X_{31}$ représente un atome N ou un groupe $C(Z_{31})$, $X_{32}$ représente un atome N ou un groupe $C(Z_{32})$, $X_{33}$ représente un atome N ou un groupe $C(Z_{33})$, $X_{34}$ représente un atome N ou un groupe $C(Z_{34})$, $X_{41}$ représente un atome N ou un groupe $C(Z_{41})$, $X_{42}$ représente un atome N ou un groupe $C(Z_{42})$, $X_{43}$ représente un atome N ou un groupe $C(Z_{43})$, et $X_{44}$ représente un atome N ou un groupe $C(Z_{44})$, à condition qu'au moins l'un des groupes $X_{21}$ à $X_{24}$ ne représente pas un atome N, qu'au moins l'un des groupes $X_{31}$ à $X_{34}$ ne représente pas un atome N, et qu'au moins l'un des groupes $X_{41}$ à $X_{44}$ ne représente pas un atome N,

$Z_{21}$ à $Z_{24}$, $Z_{31}$ à $Z_{34}$, et $Z_{41}$ à $Z_{44}$ sont chacun indépendamment choisis parmi un atome d'hydrogène, un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{10}$ alkyle, un groupe $C_1$-$C_{10}$ alcoxy, $-CF_3$, $-CF_2H$, $-CFH_2$, un groupe phényle, un groupe phényle substitué par un groupe cyano, un groupe naphtyle, un groupe pyridinyle, un groupe pyrimidinyle, un groupe pyrazinyle, un groupe pyridazinyle, un groupe triazinyle, un groupe fluorényle, un groupe carbazolyle, un groupe dibenzofuranyle, un groupe dibenzothiophényle, et $-Si(Q_{11})(Q_{12})(Q_{13})$,

$Q_{11}$ à $Q_{13}$ étant chacun indépendamment choisis parmi un atome d'hydrogène, un groupe $C_1$-$C_{10}$ alkyle, un groupe $C_1$-$C_{10}$ alcoxy, un groupe phényle, un groupe naphtyle, un groupe pyridinyle, un groupe pyrimidinyle, un groupe pyrazinyle, un groupe pyridazinyle, un groupe triazinyle, un groupe fluorényle, un groupe carbazolyle, un groupe dibenzofuranyle, et un groupe dibenzothiophényle, et

* et *' indiquent chacun un site de liaison à un atome adjacent ; ou

i) ledit composé accepteur étant représenté par la formule A-1 dans laquelle $Ar_{11}$ et $Ar_{12}$ sont chacun indépendamment choisis parmi les groupes représentés par les formules 17-1 à 17-3, et au moins l'un des groupes $Ar_{11}$ et $Ar_{12}$ est choisi parmi les groupes représentés par les formules 17-2 et 17-3 ;

ii) ledit composé accepteur étant représenté par la formule A-1 dans laquelle Lu est choisi parmi les groupes représentés par les formules 3-15 et 3-28, et au moins un groupe Lu au nombre de a11 est choisi parmi les groupes représentés par les formules 6-1 à 6-4 ; ou

iii) ledit composé accepteur étant représenté par la formule A-2 dans laquelle $X_1$ à $X_3$ représentent chacun un atome N :

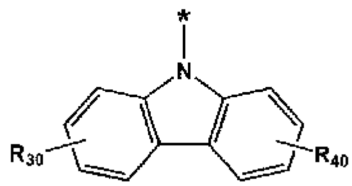

Formule 17-1

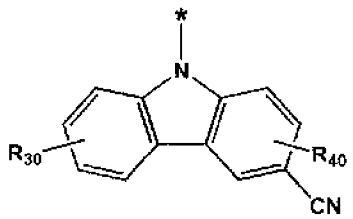

Formule 17-2

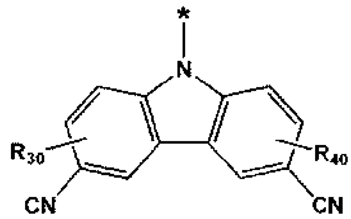

Formule 17-3

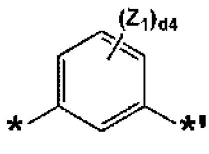

Formule 3-15

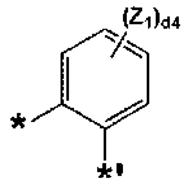

Formule 3-28

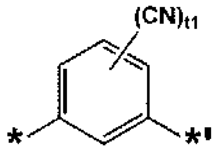

Formule 6-1

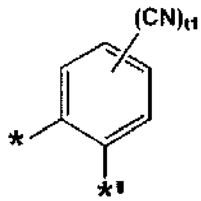

Formule 6-2

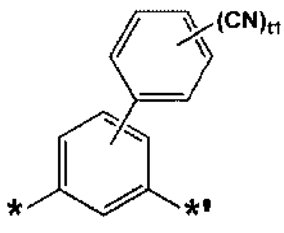

Formule 6-3

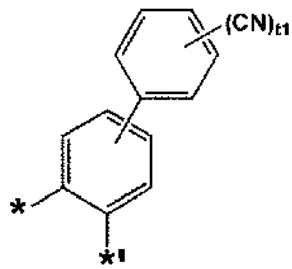

Formule 6-4

dans lesquelles, dans les formules 17-1 à 17-3, 3-15, 3-28, et 6-1 à 6-4,
$R_{30}$ et $R_{40}$ sont chacun indépendamment choisis parmi :

un atome d'hydrogène, un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{10}$ alkyle, un groupe $C_1$-$C_{10}$ alcoxy, $-CF_3$, $-CF_2H$, et $-CFH_2$ ;
un groupe phényle, un groupe pyridinyle, un groupe pyrimidinyle, un groupe pyrazinyle, un groupe pyridazinyle, un groupe triazinyle, un groupe naphtyle, un groupe fluorényle, un groupe carbazolyle, un groupe dibenzofuranyle, et un groupe dibenzothiophényle ;
un groupe phényle, un groupe pyridinyle, un groupe pyrimidinyle, un groupe pyrazinyle, un groupe pyridazinyle, un groupe triazinyle, un groupe naphtyle, un groupe fluorényle, un groupe carbazolyle, un groupe dibenzofuranyle, et un groupe dibenzothiophényle, chacun substitué par au moins un élément choisi parmi un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{10}$ alkyle, un groupe $C_1$-$C_{10}$ alcoxy, $-CF_3$, $-CF_2H$, $-CFH_2$, un groupe phényle, un groupe pyridinyle, un groupe pyrimidinyle, un groupe pyrazinyle, un groupe pyridazinyle, un groupe triazinyle, un groupe naphtyle, un groupe fluorényle, un groupe carbazolyle, un groupe dibenzofuranyle, et un groupe dibenzothiophényle ; et

$$-Si(Q_1)(Q_2)(Q_3),$$

$Z_1$ est choisi parmi un atome d'hydrogène, un atome de deutérium, un groupe -F, -Cl, -Br, -I, un groupe hydroxy, un groupe cyano, un groupe nitro, un groupe amino, un groupe amidino, un groupe hydrazine,

un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{10}$ alkyle, un groupe $C_1$-$C_{10}$ alcoxy, $-CF_3$, $-CF_2H$, $-CFH_2$, un groupe phényle, un groupe phényle substitué par un groupe cyano, un groupe naphtyle, un groupe pyridinyle, un groupe pyrimidinyle, un groupe pyrazinyle, un groupe pyridazinyle, un groupe triazinyle, un groupe fluorényle, un groupe carbazolyle, un groupe dibenzofuranyle, un groupe dibenzothiophényle, et $-Si(Q_{11})(Q_{12})(Q_{13})$,

d4 représente un entier choisi parmi 0 à 4,

t1 vaut 1 ou 2,

$Q_1$ à $Q_3$ et $Q_{11}$ à $Q_{13}$ étant chacun indépendamment choisis parmi un atome d'hydrogène, un groupe $C_1$-$C_{10}$ alkyle, un groupe $C_1$-$C_{10}$ alcoxy, un groupe phényle, et un groupe naphtyle, et

* et *' indiquent chacun un site de liaison à un atome adjacent.

**8.** Dispositif électroluminescent organique selon l'une quelconque des revendications 1 à 7, ledit hôte comprenant un composé choisi parmi les composés A1 à A11 :

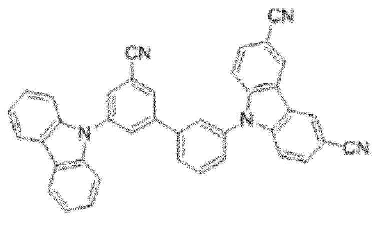

A1

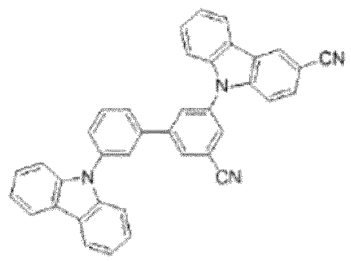

A2

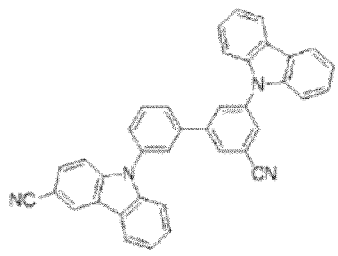

A3

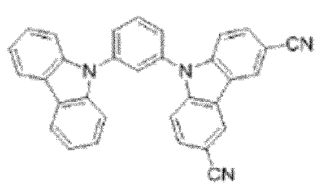

A4

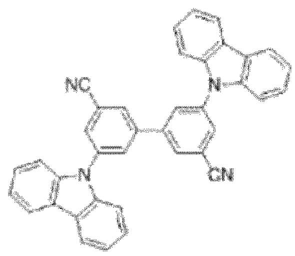

A5

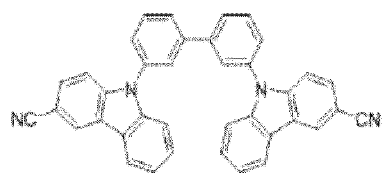

A6

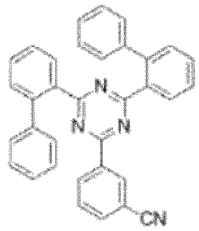

A7

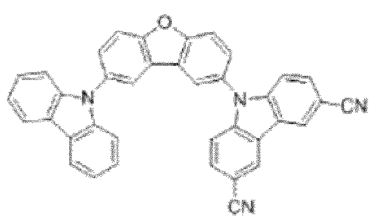

A8

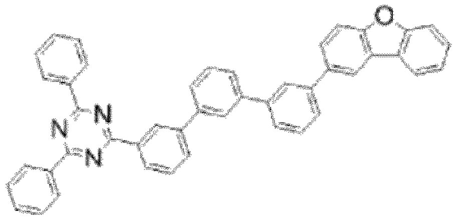

A9

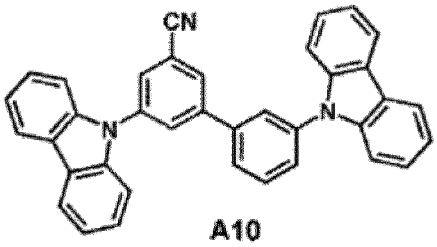

A10

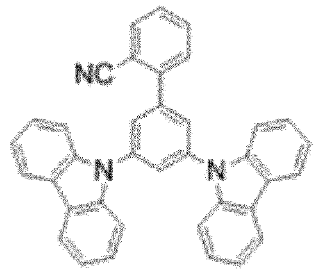

A11

**9.** Dispositif électroluminescent organique selon l'une quelconque des revendications 1 à 8, ledit dopant phosphorescent comprenant un composé organométallique représenté par la formule 81 :

Formule 81 $M(L_{81})_{n81}(L_{82})_{n82}$

Formule 81A

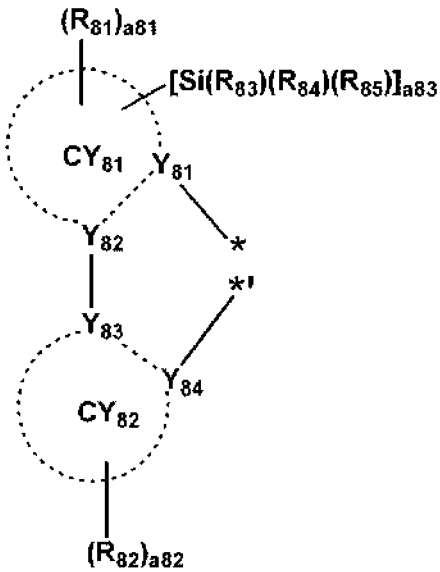

dans lesquelles, dans les formules 81 et 81A,

M est choisi parmi l'iridium (Ir), le platine (Pt), l'osmium (Os), le titane (Ti), le zirconium (Zr), le hafnium (Hf), l'europium (Eu), le terbium (Tb), le thulium (Tm), et le rhodium (Rh),
$L_{81}$ est un ligand représenté par la formule 81A, n81 représente un entier choisi parmi 1 à 3 ; lorsque n81 vaut 2 ou plus, au moins deux groupes $L_{81}$ sont identiques l'un à l'autre ou différents l'un de l'autre,
$L_{82}$ est un ligand organique, n82 représente un entier choisi parmi 0 à 4 ; lorsque n82 vaut 2 ou plus, au moins deux groupes $L_{82}$ sont identiques l'un à l'autre ou différents l'un de l'autre,
$Y_{81}$ à $Y_{84}$ représentent chacun indépendamment un atome de carbone (C) ou un atome d'azote (N),
$Y_{81}$ et $Y_{82}$ sont liés par l'intermédiaire d'une liaison simple ou d'une double liaison, $Y_{83}$ et $Y_{84}$ sont liés par l'intermédiaire d'une liaison simple ou d'une double liaison,
$CY_{81}$ et $CY_{82}$ sont chacun indépendamment choisis parmi un groupe carboxylique en $C_5$ à $C_{30}$ et un groupe hétérocyclique en $C_1$ à $C_{30}$,
$CY_{81}$ et $CY_{82}$ sont éventuellement et en outre lié par l'intermédiaire d'un groupe de liaison organique,
$R_{81}$ à $R_{85}$ sont chacun indépendamment choisis parmi un atome d'hydrogène, un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un

groupe acide sulfonique ou un sel de celui-ci, un groupe acide phosphorique ou un sel de celui-ci, $-SF_5$, un groupe $C_1$-$C_{60}$ alkyle substitué ou non substitué, un groupe $C_2$-$C_{60}$ alcényle substitué ou non substitué, un groupe $C_2$-$C_{60}$ alcynyle substitué ou non substitué, un groupe $C_1$-$C_{60}$ alcoxy substitué ou non substitué, un groupe $C_3$-$C_{10}$ cycloalkyle substitué ou non substitué, un groupe $C_1$-$C_{10}$ hétérocycloalkyle substitué ou non substitué, un groupe $C_3$-$C_{10}$ cycloalcényle substitué ou non substitué, un groupe $C_1$-$C_{10}$ hétérocycloalcényle substitué ou non substitué, un groupe $C_6$-$C_{60}$ aryle substitué ou non substitué, un groupe $C_6$-$C_{60}$ aryloxy substitué ou non substitué, un groupe $C_6$-$C_{60}$ arylthio substitué ou non substitué, un groupe $C_7$-$C_{60}$ arylalkyle substitué ou non substitué, un groupe $C_1$-$C_{60}$ hétéroaryle substitué ou non substitué, un groupe $C_1$-$C_{60}$ hétéroaryloxy substitué ou non substitué, un groupe $C_1$-$C_{60}$ hétéroarylthio substitué ou non substitué, un groupe $C_2$-$C_{60}$ hétéroarylalkyle substitué ou non substitué, un groupe polycyclique condensé non aromatique monovalent substitué ou non substitué, un groupe hétéropolycyclique condensé non aromatique monovalent substitué ou non substitué, $-Si(Q_{81})(Q_{82})(Q_{83})$, $-N(Q_{84})(Q_{85})$, $-B(Q_{86})(Q_{87})$, et $-P(=O)(Q_{88})(Q_{89})$,

a81 à a83 représentent chacun indépendamment un entier choisi parmi 0 à 5,

lorsque a81 vaut 2 ou plus, au moins deux groupes $R_{81}$ sont identiques l'un à l'autre ou différents l'un de l'autre,

lorsque a82 vaut 2 ou plus, au moins deux groupes $R_{82}$ sont identiques l'un à l'autre ou différents l'un de l'autre,

lorsque a81 vaut 2 ou plus, les groupes $R_{81}$ qui sont adjacents les uns aux autres sont éventuellement liés pour former un noyau saturé ou insaturé,

lorsque a82 vaut 2 ou plus, les groupes $R_{82}$ qui sont adjacents les uns aux autres sont éventuellement liés pour former un noyau saturé ou insaturé,

dans la formule 81A, * et *' indiquent chacun un site de liaison à M dans la formule 81, et

au moins un substituant du groupe $C_1$-$C_{60}$ alkyle substitué, du groupe $C_2$-$C_{60}$ alcényle substitué, du groupe $C_2$-$C_{60}$ alcynyle substitué, du groupe $C_1$-$C_{60}$ alcoxy substitué, du groupe $C_3$-$C_{10}$ cycloalkyle substitué, du groupe $C_1$-$C_{10}$ hétérocycloalkyle substitué, du groupe $C_3$-$C_{10}$ cycloalcényle substitué, du groupe $C_1$-$C_{10}$ hétérocycloalcényle substitué, du groupe $C_6$-$C_{60}$ aryle substitué, du groupe $C_6$-$C_{60}$ aryloxy substitué, du groupe $C_6$-$C_{60}$ arylthio substitué, du groupe $C_7$-$C_{60}$ arylalkyle substitué, du groupe $C_1$-$C_{60}$ hétéroaryle substitué, du groupe $C_1$-$C_{60}$ hétéroaryloxy substitué, du groupe $C_1$-$C_{60}$ hétéroarylthio substitué, du groupe $C_2$-$C_{60}$ hétéroarylalkyle substitué, du groupe polycyclique condensé non aromatique monovalent substitué, et du groupe hétéropolycyclique condensé non aromatique monovalent substitué est choisi parmi un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle, un groupe $C_2$-$C_{60}$ alcényle, un groupe $C_2$-$C_{60}$ alcynyle, un groupe $C_1$-$C_{60}$ alcoxy, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_6$-$C_{60}$ aryloxy, un groupe $C_6$-$C_{60}$ arylthio, un groupe $C_7$-$C_{60}$ arylalkyle, un groupe $C_1$-$C_{60}$ hétéroaryle, un groupe $C_1$-$C_{60}$ hétéroaryloxy, un groupe $C_1$-$C_{60}$ hétéroarylthio, un groupe $C_2$-$C_{60}$ hétéroarylalkyle, un groupe polycyclique condensé non aromatique monovalent, un groupe hétéropolycyclique condensé non aromatique monovalent, et $-Si(Q_{91})(Q_{92})(Q_{93})$,

$Q_{81}$ à $Q_{89}$ et $Q_{91}$ à $Q_{93}$ étant chacun indépendamment choisis parmi un atome d'hydrogène, un atome de deutérium, un groupe $C_1$-$C_{60}$ alkyle, un groupe $C_1$-$C_{60}$ alcoxy, un groupe $C_3$-$C_{10}$ cycloalkyle, un groupe $C_1$-$C_{10}$ hétérocycloalkyle, un groupe $C_3$-$C_{10}$ cycloalcényle, un groupe Ci-$C_{10}$ hétérocycloalcényle, un groupe $C_6$-$C_{60}$ aryle, un groupe $C_1$-$C_{60}$ hétéroaryle, un groupe polycyclique condensé non aromatique monovalent, et un groupe hétéropolycyclique condensé non aromatique monovalent.

**10.** Dispositif électroluminescent organique selon la revendication 9,

$Y_{81}$ représentant un atome N, $Y_{82}$ et $Y_{83}$ représentant chacun un atome C, $Y_{84}$ représentant un atome N ou C, et $CY_{81}$ et $CY_{82}$ étant chacun indépendamment choisis parmi un groupe cyclopentadiène, un groupe benzène, un groupe heptalène, un groupe indène, un groupe naphtalène, un groupe azulène, un groupe indacène, un groupe acénaphtylène, un groupe fluorène, un groupe spiro-bifluorène, un groupe benzofluorène, un groupe dibenzofluorène, un groupe phénalène, un groupe phénanthrène, un groupe anthracène, un groupe fluoranthène, un groupe triphénylène, un groupe pyrène, un groupe chrysène, un groupe naphtacène, un groupe picène, un groupe pérylène, un groupe pentacène, un groupe hexacène, un groupe pentaphène, un groupe rubicène, un groupe coronène, un groupe ovalène, un groupe pyrrole, un groupe isoindole, un groupe indole, un groupe indazole, un groupe pyrazole, un groupe imidazole, un groupe triazole, un groupe oxazole, un groupe isoxazole, un groupe oxadiazole, un groupe thiazole, un groupe isothiazole, un groupe thiadiazole, un groupe purine, un groupe furane, un groupe thiophène, un groupe pyridine, un groupe pyrimidine, un groupe quinoline, un groupe isoquinoline, un groupe benzoquinoline, un groupe phtalazine, un groupe naphtyridine, un groupe quinoxaline, un groupe quinazoline, un groupe cinnoline, un groupe phénanthridine, un groupe acridine, un

groupe phénanthroline, un groupe phénazine, un groupe benzimidazole, un groupe benzofurane, un groupe benzothiophène, un groupe iso-benzothiazole, un groupe benzoxazole, un groupe isobenzoxazole, un groupe benzocarbazole, un groupe dibenzocarbazole, un groupe imidazopyridine, un groupe imidazopyrimidine, un groupe dibenzofurane, un groupe dibenzothiophène, un groupe sulfone de dibenzothiophène, un groupe carbazole, un groupe dibenzosilole, un groupe 2,3-dihydro-1H-imidazole, et un groupe 2,3-dihydro-1H-imidazopyrazine ; ou
dans la formule 81A,
$Y_{81}$, $Y_{83}$ et $Y_{84}$ représentant chacun un atome C,
$Y_{82}$ représentant un atome N,
$CY_{81}$ étant choisi parmi a) un noyau condensé dans lequel i) un noyau à 5 chaînons comprenant au moins un atome N en tant qu'atome de formation de noyau est condensé avec ii) un noyau à 6 chaînons choisi parmi un groupe benzène, un groupe pyridine, un groupe pyrazine, un groupe pyrimidine, et un groupe pyridazine ; et b) un noyau à 5 chaînons comprenant au moins un atome N en tant qu'atome de formation de noyau, et
$CY_{82}$ étant choisi parmi un groupe benzène, un groupe naphtalène, un groupe fluorène, un groupe dibenzofurane, un groupe dibenzothiophène, un groupe pyridine, un groupe pyrimidine, un groupe quinoline, et un groupe isoquinoline.

**11.** Dispositif électroluminescent organique selon la revendication 9 ou 10, $R_{81}$ et $R_{82}$ étant chacun indépendamment choisis parmi :

un atome d'hydrogène, un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, $-SF_5$, un groupe $C_1$-$C_{20}$ alkyle, et un groupe $C_1$-$C_{20}$ alcoxy ;
un groupe $C_1$-$C_{20}$ alkyle et un groupe $C_1$-$C_{20}$ alcoxy, chacun substitué par au moins un élément choisi parmi un atome de deutérium, un groupe -F, -Cl, -Br, -I, $-CD_3$, $-CD_2H$, $-CDH_2$, $- CF_3$, $-CF_2H$, $-CFH_2$, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celuici, un groupe acide phosphorique ou un sel de celui-ci, un groupe $C_1$-$C_{10}$ alkyle, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe pyridinyle, et un groupe pyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un

groupe dibenzofuranyle, un groupe dibenzothiophényle, un groupe benzocarbazolyle, un groupe dibenzocarbazolyle, un groupe imidazopyridinyle, et un groupe imidazopyrimidinyle, chacun substitué par au moins un élément choisi parmi un atome de deutérium, un groupe -F, -Cl, -Br, -I, $-CD_3$, $-CD_2H$, $-CDH_2$, $-CF_3$, $-CF_2H$, $-CFH_2$, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{20}$ alkyle, un groupe $C_1$-$C_{20}$ alcoxy, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle ; et
$-B(Q_{86})(Q_{87})$ and $-P(=O)(Q_{88})(Q_{89})$,
$Q_{86}$ à $Q_{89}$ étant chacun indépendamment choisis parmi les groupes $-CH_3$, $-CD_3$, $-CD_2H$, $- CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $- CHDCD_3$, $-CD_2CD_3$, $-CD_2CD_2H$, et $-CD_2CDH_2$ ;
un groupe n-propyle, un groupe iso-propyle, un groupe n-butyle, un groupe iso-butyle, un groupe sec-butyle, un groupe tert-butyle, un groupe n-pentyle, un groupe iso-pentyle, un groupe sec-pentyle, un groupe tert-pentyle, un groupe phényle, et un groupe naphtyle ; et
un groupe n-propyle, un groupe iso-propyle, un groupe n-butyle, un groupe iso-butyle, un groupe sec-butyle, un groupe tert-butyle, un groupe n-pentyle, un groupe iso-pentyle, un groupe sec-pentyle, un groupe tert-pentyle, un groupe phényle, et un groupe naphtyle, chacun substitué par au moins un élément choisi parmi un atome de deutérium, un groupe $C_1$-$C_{10}$ alkyle, et un groupe phényle ; ou
dans la formule 81A, au moins un groupe $R_{81}$ au nombre de a81, au moins un groupe $R_{82}$ au nombre de a82, ou toute combinaison de ceux-ci représentant un groupe cyano.

12. Dispositif électroluminescent organique selon l'une quelconque des revendications 9 à 11, dans la formule 81, $L_{81}$ étant choisi parmi les ligands représentés par les formules 81A-1 à 81A-8 :

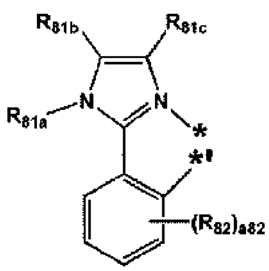
Formule 81A-1

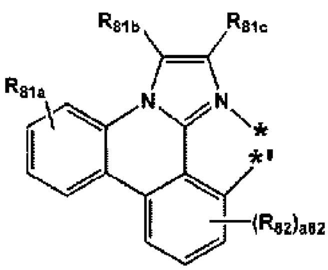
Formule 81A-2

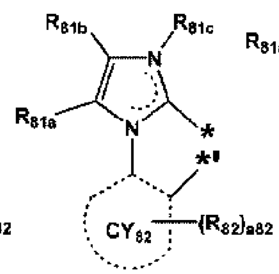
Formule 81A-3

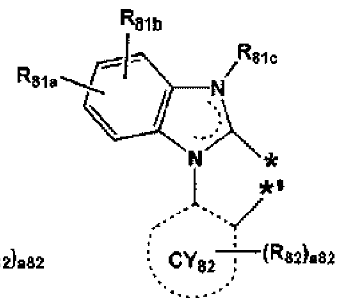
Formule 81A-4

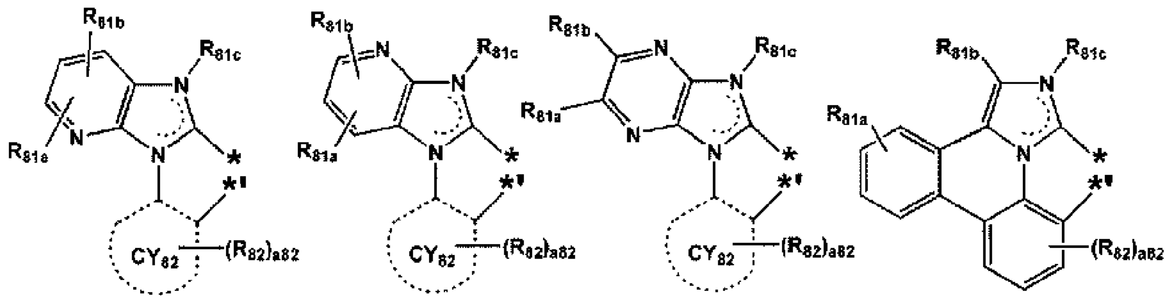

Formule 81A-5 Formule 81A-6 Formule 81A-7 Formule 81A-8

dans lesquelles, dans les formules 81A-1 à 81A-8,
$CY_{82}$, $R_{82}$, a82, * et *' sont identiques à ceux définis dans la revendication 9, et
$R_{81a}$, $R_{81b}$ et $R_{81c}$ sont chacun identiques à $R_{81}$ tel que défini dans la revendication 9.

**13.** Dispositif électroluminescent organique selon la revendication 12, dans les formules 81A-1 à 81A-8, $CY_{82}$ étant choisi parmi un groupe benzène, un groupe naphtalène, un groupe fluorène, un groupe dibenzofurane, un groupe dibenzothiophène, un groupe pyridine, un groupe pyrimidine, un groupe quinoline, et un groupe isoquinoline.

**14.** Dispositif électroluminescent organique selon la revendication 12, dans les formules 81A-1 à 81A-8, au moins l'un des groupes $R_{81a}$, $R_{81b}$, $R_{81c}$ et $R_{82}$ au nombre de a82 représentant chacun un groupe cyano.

**15.** Dispositif électroluminescent organique selon l'une quelconque des revendications 1 à 14, ledit dopant étant choisi parmi les composés suivants :

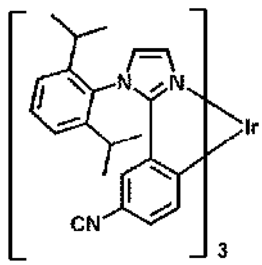

**PD79**

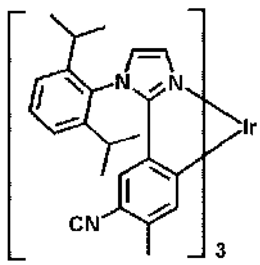

**PD80**

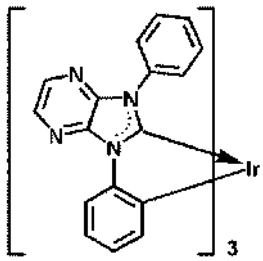

**PD81**

FIGURE

10

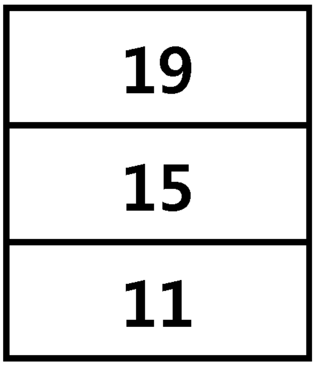

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011176250 A
- JP 2012175025 A
- US 2016093823 A
- EP 2966146 A